# EUROPEAN PATENT SPECIFICATION

(11) **EP 4 282 933 B1**
(45) Date of publication and mention of the grant of the patent: **19.11.2025**
(21) Application number: 23174496.2
(22) Date of filing: 22.05.2023
(51) Int. Cl.: C09K 11/06, H10K 50/11, H10K 85/30, H10K 85/40, H10K 85/60, H10K 101/10

(54) **ORGANOMETALLIC COMPOUND, ORGANIC LIGHT-EMITTING DEVICE INCLUDING THE SAME, AND ELECTRONIC APPARATUS INCLUDING THE ORGANIC LIGHT-EMITTING DEVICE**
ORGANOMETALLISCHE VERBINDUNG, ORGANISCHE LICHTEMITTIERENDE VORRICHTUNG DAMIT UND ELEKTRONISCHE VORRICHTUNG MIT DER ORGANISCHEN LICHTEMITTIERENDEN VORRICHTUNG
COMPOSÉ ORGANOMÉTALLIQUE, DISPOSITIF ÉLECTROLUMINESCENT ORGANIQUE LE COMPRENANT ET APPAREIL ÉLECTRONIQUE COMPRENANT LE DISPOSITIF ÉLECTROLUMINESCENT ORGANIQUE

(30) Priority: 27.05.2022 KR 20220065551
(43) Date of publication of application: 29.11.2023
(73) Proprietor: Samsung Display Co., Ltd., Yongin-si, Gyeonggi-do 17113 (KR)
(72) Inventor: LEE, Kum Hee, 16678 Suwon-si (KR); KANG, Byungjoon, 16678 Suwon-si (KR); LEE, Banglin, 16678 Suwon-si (KR); ISHIHARA, Shingo, 16678 Suwon-si (KR); LEE, Yong Joo, 16678 Suwon-si (KR); CHOI, Byoungki, 16678 Suwon-si (KR); KOISHIKAWA, Yasushi, 16678 Suwon-si (KR); HWANG, Kyuyoung, 16678 Suwon-si (KR)
(74) Representative: Elkington and Fife LLP

(56) References cited:
- EP-A1- 3 792 270
- EP-A1- 3 798 225
- EP-A1- 3 912 983
- EP-A1- 3 974 494
- EP-A1- 4 016 656
- CN-A- 114 437 137
- US-A1- 2018 273 563

## Description

### FIELD OF THE INVENTION

The disclosure relates to an organometallic compound, an organic light-emitting device including the same, and an electronic apparatus including the organic light-emitting device.

### BACKGROUND OF THE INVENTION

Organic light-emitting devices (OLEDs) are self-emissive devices, which have improved characteristics in terms of viewing angles, response time, brightness, driving voltage, and response speed. In addition, OLEDs can produce full-color images.

In an example, a typical organic light-emitting device includes an anode, a cathode, and an organic layer that is located between the anode and the cathode, wherein the organic layer includes an emission layer. A hole transport region may be located between the anode and the emission layer, and an electron transport region may be located between the emission layer and the cathode. Holes provided from the anode may move toward the emission layer through the hole transport region, and electrons provided from the cathode may move toward the emission layer through the electron transport region. The holes and the electrons may recombine in the emission layer to produce excitons. The excitons may transition from an excited state to a ground state, thus generating light.

EP 4 016 656 and CN 114 437 137 disclose organometallic compounds for use in OLEDs.

### SUMMARY OF THE INVENTION

Aspects are directed to an organometallic compound, an organic light-emitting device including the same, and an electronic apparatus including the organic light-emitting device.

Additional aspects will be set forth in part in the detailed description that follows and, in part, will be apparent from the detailed description, or may be learned by practice of the presented exemplary embodiments.

According to the invention, an organometallic compound is provided in accordance with claim 1.

According to an embodiment, an organic light-emitting device includes a first electrode, a second electrode, and an organic layer located between the first electrode and the second electrode, wherein the organic layer includes an emission layer, and wherein the organic layer includes at least one organometallic compound represented by Formula 1.

The organometallic compound may be included in an emission layer, and the organometallic compound included in the emission layer may act as a dopant.

According to another embodiment, an electronic apparatus includes the organic light-emitting device described herein.

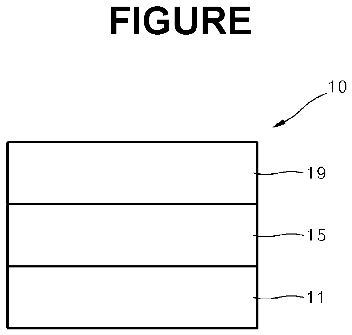

### BRIEF DESCRIPTION OF THE DRAWING

These and/or other aspects will become apparent and more readily appreciated from the following detailed description of the exemplary embodiments, taken in conjunction with the FIGURE, which is a schematic cross-sectional view of an organic light-emitting device according to one or more embodiments.

### DETAILED DESCRIPTION OF THE EMBODIMENTS

Reference will now be made in further detail to exemplary embodiments, examples of which are illustrated in the accompanying drawing. In this regard, the exemplary embodiments may have different forms and should not be construed as being limited to the descriptions set forth herein. Accordingly, the exemplary embodiments are merely described in further detail below by referring to the figure, to explain aspects. The term "and/or" used herein includes any and all combinations of one or more of the associated listed items. Expressions such as "at least one of," when preceding a list of elements, modify the entire list of elements and do not modify the individual elements of the list.

The terminology used herein is for the purpose of describing one or more exemplary embodiments only and is not intended to be limiting. As used herein, the singular forms "a," "an," and "the" are intended to include the plural forms as well, unless the context clearly indicates otherwise. The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

It will be understood that when an element is referred to as being "on" another element, it can be directly in contact with the other element or intervening elements may be present therebetween. In contrast, when an element is referred to as being "directly on" another element, there are no intervening elements present.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

Hereinafter, a work function or a highest occupied molecular orbital (HOMO) energy level is expressed as an absolute value from a vacuum level. In addition, when the work function or the HOMO energy level is referred to be "deep," "high" or "large," the work function or the HOMO energy level has a large absolute value based on "0 electron Volt (eV)" of the vacuum level, while when the work function or the HOMO energy level is referred to be "shallow," "low," or "small," the work function or HOMO energy level has a small absolute value based on "0 eV" of the vacuum level.

An organometallic compound is represented by Formula 1:

Formula 1 M(L₁)ₙ₁(L₂)ₙ₂

wherein M in Formula 1 is a transition metal.

For example, M may be a Period 1 transition metal of the Periodic Table of Elements, a Period 2 transition metal of the Periodic Table of Elements, or a Period 3 transition metal of the Periodic Table of Elements.

In one or more embodiments, M may be iridium, platinum, osmium, titanium, zirconium, hafnium, europium, terbium, thulium, or rhodium.

In one or more embodiments, M may be iridium, platinum, osmium, or rhodium.

In Formula 1, L₁ is a ligand represented by Formula 2-1, and L₂ is a ligand represented by Formula 2-2: 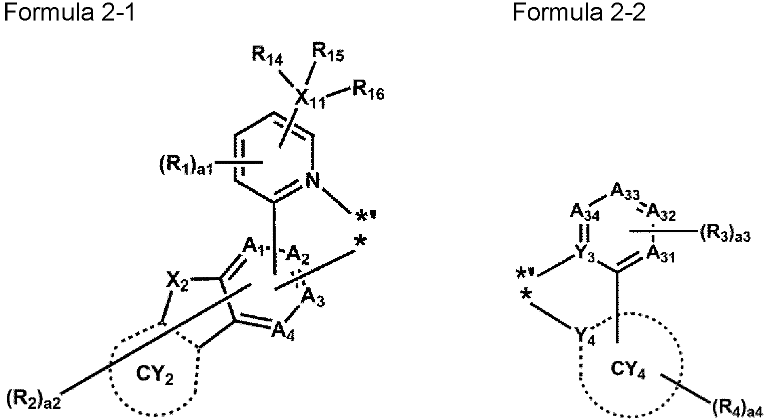 wherein, Formulae 2-1 and 2-2 are as described herein.
n1 and n2 in Formula 1 respectively indicate the number of ligands L₁ and the number of ligands L₂, and n1 and n2 are each independently 1 or 2. When n1 is 2, two L₁ are identical to or different from each other, and when n2 is 2, two L₂ are identical to or different from each other.

For example, regarding Formula 1, i) n1 may be 2, and n2 may be 1; or ii) n1 may be 1, and n2 may be 2, but embodiments are not limited thereto.

In one or more embodiments, in Formula 1, i) M may be iridium or osmium, and a sum of n1 and n2 may be 3; or ii) M may be platinum, and a sum of n1 and n2 may be 2.

L₁ and L₂ in Formula 1 are different from each other. Accordingly, the organometallic compound represented by Formula 1 is a heteroleptic complex.

X₁₁ in Formula 2-1 is Ge.

X₂ in Formula 2-1 is O, S, Se, N(R₂₉), C(R₂₉ₐ)(R_{29b}), or Si(R₂₉ₐ)(R_{29b}), wherein R₂₉, R₂₉ₐ, and R_{29b} are each as defined herein.

In one or more embodiments, X₂ may be O or S.

In Formula 2-1, A₁ is C or N, A₂ is C or N, A₃ is C or N, and A₄ is C or N, wherein one of A₁ to A₄ is C bonded to a neighboring pyridine group, and another of A₁ to A₄ is C bonded to M in Formula 1.

In one or more embodiments, in Formula 2-1,
i) A₁ may be C bonded to a neighboring pyridine group, A₂ may be C bonded to M in Formula 1, and A₃ and A₄ may each independently be C or N,
ii) A₂ may be C bonded to a neighboring pyridine group, A₃ may be C bonded to M in Formula 1, and A₁ and A₄ may each independently be C or N,
iii) A₃ may be C bonded to a neighboring pyridine group, A₄ may be C bonded to M in Formula 1, and A₁ and A₂ may each independently be C or N,
iv) A₂ may be C bonded to a neighboring pyridine group, A₁ may be C bonded to M in Formula 1, and A₃ and A₄ may each independently be C or N,
v) A₃ may be C bonded to a neighboring pyridine group, A₂ may be C bonded to M in Formula 1, and A₁ and A₄ may each independently be C or N, or
vi) A₄ may be C bonded to a neighboring pyridine group, A₃ may be C bonded to M in Formula 1, and A₁ and A₂ may each independently be C or N.

In one or more embodiments, a group represented by 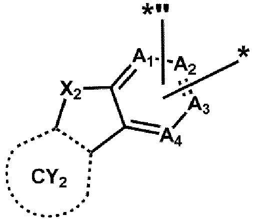 of Formula 2-1 may be a group represented by one of Formulae CY2-A to CY2-F: 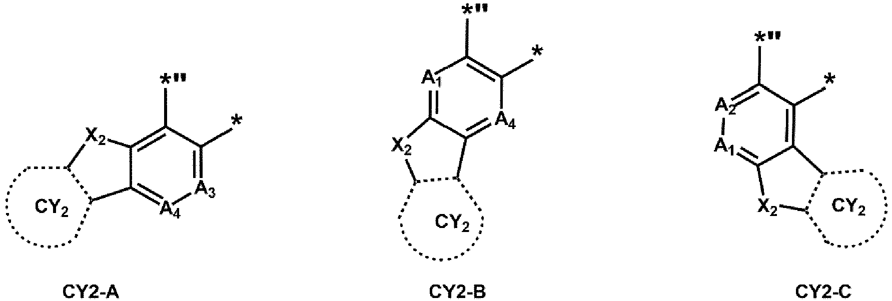 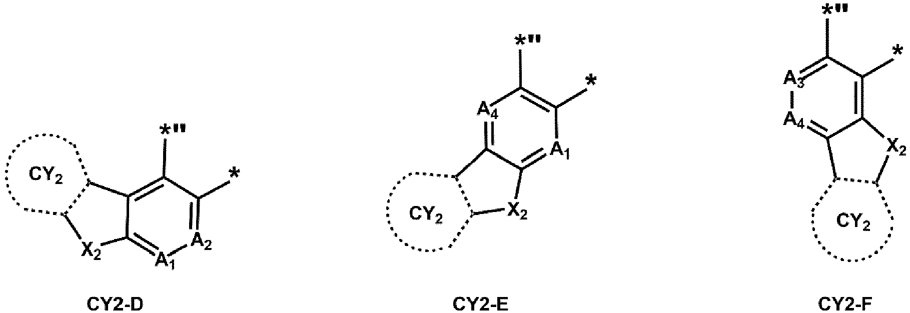 wherein, in Formulae CY2-A to CY2-F,
X₂ and ring CY₂ are each as described herein,
A₁ is C or N, A₂ is C or N, A₃ is C or N, and A₄ is C or N,
*" indicates a binding site to a neighboring pyridine group in Formula 2-1, and
* is a binding site to M in Formula 1.

Y₃ in Formula 2-2 is N.

In Formula 2-2, A₃₁ is C or N, A₃₂ is C or N, A₃₃ is C or N, and A₃₄ is C or N. In one or more embodiments, each of A₃₁ to A₃₄ may be C.

Y₄ in Formula 2-2 is C or N.

In one or more embodiments, Y₄ may be C.

In Formulae 2-1 and 2-2, ring CY₂ and ring CY₄ are each independently a C₅-C₃₀ carbocyclic group or a C₁-C₃₀ heterocyclic group, wherein i) ring CY₂ is a C₃-C₃₀ heterocyclic group including at least one N as a ring-forming atom (for example, including, as a ring-forming moiety, one, two, or three *=N-*', wherein * and *' each indicate a binding site to an adjacent atom); ii) at least one of A₁ to A₄ is N; or iii) ring CY₂ is a C₃-C₃₀ heterocyclic group including at least one N as a ring-forming atom (for example, including, as a ring-forming moiety, one, two, or three *=N-*', wherein * and *' each indicate a binding site to an adjacent atom), and at least one of A₁ to A₄ is N.

For example, ring CY₂ and ring CY₄ may each independently be i) a first ring, ii) a second ring, iii) a condensed ring group in which at least two first rings are condensed to each other, iv) a condensed ring group in which at least two second rings are condensed to each other, or v) a condensed ring group in which at least one first ring and at least one second ring are condensed to each other,
the first ring may be a cyclopentane group, a cyclopentadiene group, a furan group, a thiophene group, a pyrrole group, a silole group, a germole group, a borole group, a selenophene group, a phosphole group, an oxazole group, an oxadiazole group, an oxatriazole group, a thiazole group, a thiadiazole group, a thiatriazole group, a pyrazole group, an imidazole group, a triazole group, a tetrazole group, an azasilole group, an azagermole group, an azaborole group, an azaselenophene group, or an azaphosphole group, and
the second ring may be an adamantane group, a norbornane group (a bicyclo[2.2.1]heptane group), a norbornene group, a bicyclo[1.1.1]pentane group, a bicyclo[2.1.1]hexane group, a bicyclo[2.2.2]octane group, a cyclohexane group, a cyclohexene group, a benzene group, a pyridine group, a pyrimidine group, a pyrazine group, a pyridazine group, or a triazine group.

In one or more embodiments, ring CY₂ and ring CY₄ may each independently be a cyclopentane group, a cyclohexane group, a cyclohexene group, a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, a benzocarbazole group, a benzofluorene group, a naphthobenzosilole group, a naphthobenzothiophene group, a naphthobenzofuran group, a naphthobenzoselenophene group, a dibenzocarbazole group, a dibenzofluorene group, a dinaphthosilole group, a dinaphthothiophene group, a dinaphthofuran group, a dinaphthoselenophene group, a naphthocarbazole group, a naphthofluorene group, a phenanthrobenzosilole group, a phenanthrobenzothiophene group, a phenanthrobenzofuran group, a phenanthrobenzoselenophene group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, an azacarbazole group, an azafluorene group, an azadibenzosilole group, an azadibenzothiophene group, an azadibenzofuran group, an azadibenzoselenophene group, an azabenzocarbazole group, an azabenzofluorene group, an azanaphthobenzosilole group, an azanaphthobenzothiophene group, an azanaphthobenzofuran group, an azanaphthobenzoselenophene group, an azadibenzocarbazole group, an azadibenzofluorene group, an azadinaphthosilole group, an azadinaphthothiophene group, an azadinaphthofuran group, an azadinaphthoselenophene group, an azanaphthocarbazole group, an azanaphthofluorene group, an azaphenanthrobenzosilole group, an azaphenanthrobenzothiophene group, an azaphenanthrobenzofuran group, an azaphenanthrobenzoselenophene group, a pyridine group, a pyrimidine group, a pyrazine group, a pyridazine group, a triazine group, a quinoline group, an isoquinoline group, a quinoxaline group, a quinazoline group, a phenanthridine group, a phenanthroline group, a benzoquinoline group, a benzoisoquinoline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, an adamantane group, a norbornane group, a norbornene group, a benzene group condensed with an adamantane group, a benzene group that is condensed with a norbornane group, a benzene group that is condensed with a norbornene group, a pyridine group that is condensed with an adamantane group, a pyridine group that is condensed with a norbornane group, or a pyridine group that is condensed with a norbornene group.

In one or more embodiments, ring CY₂ may be a benzene group, a naphthalene group, a phenanthrene group, an anthracene group, a carbazole group, a fluorene group, a dibenzosilole group, a dibenzothiophene group, a dibenzofuran group, a dibenzoselenophene group, a pyridine group, a pyrimidine group, a pyridazine group, a pyrazine group, a quinoline group, an isoquinoline group, a quinoxaline group, a quinazoline group, a phenanthridine group, a phenanthroline group, a benzoquinoline group, a benzoisoquinoline group, an azacarbazole group, an azafluorene group, an azadibenzosilole group, an azadibenzothiophene group, an azadibenzofuran group, or an azadibenzoselenophene group.

In one or more embodiments, ring CY₂ may be a pyridine group, a pyrimidine group, a pyridazine group, a pyrazine group, a quinoline group, an isoquinoline group, a quinoxaline group, a quinazoline group, a phenanthridine group, a phenanthroline group, a benzoquinoline group, a benzoisoquinoline group, an azacarbazole group, an azafluorene group, an azadibenzosilole group, an azadibenzothiophene group, an azadibenzofuran group, or an azadibenzoselenophene group. In one or more embodiments, ring CY₂ may be a benzene group, a naphthalene group, a phenanthrene group, an anthracene group, a carbazole group, a fluorene group, a dibenzosilole group, a dibenzothiophene group, a dibenzofuran group, or a dibenzoselenophene group, and at least one of A₁ to A₄ in Formula 2-1 may be N.

In one or more embodiments, ring CY₂ may be a pyridine group, a pyrimidine group, a pyridazine group, a pyrazine group, a quinoline group, an isoquinoline group, a quinoxaline group, a quinazoline group, a phenanthridine group, a phenanthroline group, a benzoquinoline group, a benzoisoquinoline group, an azacarbazole group, an azafluorene group, an azadibenzosilole group, an azadibenzothiophene group, an azadibenzofuran group, or an azadibenzoselenophene group, and at least one of A₁ to A₄ in Formula 2-1 may be N. In one or more embodiments, ring CY₂ may be a pyridine group, a pyrimidine group, a pyridazine group, a pyrazine group, a quinoline group, an isoquinoline group, a quinoxaline group, a quinazoline group, a phenanthridine group, a phenanthroline group, a benzoquinoline group, a benzoisoquinoline group, an azacarbazole group, an azafluorene group, an azadibenzosilole group, an azadibenzothiophene group, an azadibenzofuran group, or an azadibenzoselenophene group, and all of A₁ to A₄ in Formula 2-1 may C.

In one or more embodiments, ring CY₄ may be a benzene group, a naphthalene group, an anthracene group, a phenanthrene group, a 1,2,3,4-tetrahydronaphthalene group, a benzene group that is condensed with a norbornane group, a carbazole group, a fluorene group, a dibenzosilole group, a dibenzothiophene group, a dibenzofuran group, a dibenzoselenophene group, a benzocarbazole group, a benzofluorene group, a naphthobenzosilole group, a naphthobenzothiophene group, a naphthobenzofuran group, a naphthobenzoselenophene group, a dibenzocarbazole group, a dibenzofluorene group, a dinaphthosilole group, a dinaphthothiophene group, a dinaphthofuran group, a dinaphthoselenophene group, a naphthocarbazole group, a naphthofluorene group, a phenanthrobenzosilole group, a phenanthrobenzothiophene group, a phenanthrobenzofuran group, a phenanthrobenzoselenophene group, an azacarbazole group, an azafluorene group, an azadibenzosilole group, an azadibenzothiophene group, an azadibenzofuran group, an azadibenzoselenophene group, an azabenzocarbazole group, an azabenzofluorene group, an azanaphthobenzosilole group, an azanaphthobenzothiophene group, an azanaphthobenzofuran group, an azanaphthobenzoselenophene group, an azadibenzocarbazole group, an azadibenzofluorene group, an azadinaphthosilole group, an azadinaphthothiophene group, an azadinaphthofuran group, an azadinaphthoselenophene group, an azanaphthocarbazole group, an azanaphthofluorene group, an azaphenanthrobenzosilole group, an azaphenanthrobenzothiophene group, an azaphenanthrobenzofuran group, or an azaphenanthrobenzoselenophene group.

R₁ to R₄, R₁₄ to R₁₆, R₂₉, R₂₉ₐ, and R_{29b} in Formulae 2-1 and 2-2 are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), -B(Q₆)(Q₇), -P(=O)(Q₃)(Q₉), or -P(Q₈)(Q₉). Q₁ to Q₉ are each as described herein. R₂ represents a substituent group that may be bonded to any one or more of A₁ to A₄, and/or ring CY₂.

In one or more embodiments, each of R₁ to R₄, R₁₄ to R₁₆, R₂₉, R₂₉ₐ, and R_{29b} may not be -Ge(Q₃)(Q₄)(Q₅), wherein Q₃ to Q₅ are each as described herein.

In one or more embodiments, each of R₁ to R₄, R₁₄ to R₁₆, R₂₉, R₂₉ₐ, and R_{29b} may not include germanium (Ge).

In one or more embodiments, each of R₁ to R₄, R₁₄ to R₁₆, R₂₉, R₂₉ₐ, and R_{29b} may not be -Si(Q₃)(Q₄)(Q₅), wherein Q₃ to Q₅ are each as described herein.

In one or more embodiments, each of R₁ to R₄, R₁₄ to R₁₆, R₂₉, R₂₉ₐ, and R_{29b} may not include silicon (Si).

In one or more embodiments, in Formula 2-2, a3 may not be 0, at least one of R₃ in the number of a3 may be -Si(Q₃)(Q₄)(Q₅), and each of R₁, R₂, R₄, R₁₄ to R₁₆, R₂₉, R₂₉ₐ, and R_{29b} may not include germanium (Ge) or silicon (Si), wherein Q₃ to Q₅ are each as described herein.

For example, R₁ to R₄, R₁₄ to R₁₆, R₂₉, R₂₉ₐ, and R_{29b} may each independently be:
hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, or a C₁-C₂₀ alkylthio group;
a C₁-C₂₀ alkyl group, a C₁-C₂₀ alkoxy group, or a C₁-C₂₀ alkylthio group, each substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a deuterated C₁-C₂₀ alkyl group, a cyclopentyl group, a cyclohexyl group, a cycloheptyl group, a cyclooctyl group, an adamantanyl group, a norbornanyl group (a bicyclo[2.2.1]heptyl group), a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a 1,2,3,4-tetrahydronaphthyl group, a pyridinyl group, a pyrimidinyl group, or a combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a phenyl group, a (C₁-C₂₀ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with at least one of deuterium, -F, -Cl, - Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a deuterated C₁-C₂₀ alkyl group, a C₁-C₂₀ alkoxy group, a C₁-C₂₀ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzoisothiazolyl group, a benzoxazolyl group, a benzoisoxazolyl group, triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, -Si(Q₃₃)(Q₃₄)(Q₃₅), -Ge(Q₃₃)(Q₃₄)(Q₃₅), or a combination thereof; or
-N(Q₁)(Q₂), -Si(Q₃)(Q₄)(Q₅), -Ge(Q₃)(Q₄)(Q₅), -B(Q₆)(Q₇), -P(=O)(Q₈)(Q₉), or -P(Q₃)(Q₉),
wherein Q₁ to Q₉ and Q₃₃ to Q₃₅ are each independently:
   -CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or - CD₂CDH₂; or
   an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, a C₁-C₂₀ alkyl group, a phenyl group, or a combination thereof.

In one or more embodiments, R₁ to R₄, R₂₉, R₂₉ₐ, and R_{29b} may each independently be:
hydrogen, deuterium, -F, or a cyano group;
a C₁-C₂₀ alkyl group, a C₃-C₁₀ cycloalkyl group, a phenyl group, a naphthyl group, a pyridinyl group, a furanyl group, a thiophenyl group, a benzofuranyl group, a benzothiophenyl group, a dibenzofuranyl group, or a dibenzothiophenyl group, each unsubstituted or substituted with at least one of deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, -Si(Q₃₃)(Q₃₄)(Q₃₅), - Ge(Q₃₃)(Q₃₄)(Q₃₅), or a combination thereof; or

   -Si(Q₃)(Q₄)(Q₅),
wherein Q₃ to Q₅ and Q₃₃ to Q₃₅ are each independently as described herein.

In one or more embodiments, R₁₄ to R₁₆ may each independently be a C₁-C₂₀ alkyl group, a C₃-C₁₀ cycloalkyl group, a phenyl group, a naphthyl group, a pyridinyl group, a furanyl group, a thiophenyl group, a benzofuranyl group, a benzothiophenyl group, a dibenzofuranyl group, or a dibenzothiophenyl group, each unsubstituted or substituted with at least one of deuterium, -F, cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or a combination thereof.

In one or more embodiments, R₁₄ to R₁₆ in Formula 2-1 may each independently be -CH₃, -CH₂CH₃, -CD₃, -CD₂H, -CDH₂, -CH₂CD₃, -CD₂CH₃, or a phenyl group.

In one or more embodiments, R₁₄ to R₁₆ in Formula 2-1 may be identical to or different from each other.

In one or more embodiments, R₁ to R₄, R₁₄ to R₁₆, R₂₉, R₂₉ₐ, and R_{29b} in Formulae 2-1 and 2-2 may each independently be hydrogen, deuterium, -F, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, -CH₃, -CD₃, -CD₂H, -CDH₂, -CF₃, -CF₂H, -CFH₂, -OCH₃, -OCDH₂, -OCD₂H, -OCD₃, -SCH₃, -SCDH₂, -SCD₂H, -SCD₃, a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-230, a group represented by one of Formulae 9-201 to 9-230 in which at least one hydrogen is substituted with deuterium, a group represented by one of Formulae 9-201 to 9-230 in which at least one hydrogen is substituted with -F, a group represented by one of Formulae 10-1 to 10-145, a group represented by one of Formulae 10-1 to 10-145 in which at least one hydrogen is substituted with deuterium, a group represented by one of Formulae 10-1 to 10-145 in which at least one hydrogen is substituted with -F, a group represented by one of Formulae 10-201 to 10-354, a group represented by one of Formulae 10-201 to 10-354 in which at least one hydrogen is substituted with deuterium, a group represented by one of Formulae 10-201 to 10-354 in which at least one hydrogen is substituted with -F, - Si(Q₃)(Q₄)(Q₅), or -Ge(Q₃)(Q₄)(Q₅), wherein Q₃ to Q₅ are each independently as described herein.

In one or more embodiments, at least one of R₁ in the number of a1 in Formula 2-1 (for example, R₁₁ of Formula CY1-1) may be a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-230, a group represented by one of Formulae 9-201 to 9-230 in which at least one hydrogen is substituted with deuterium, a group represented by one of Formulae 9-201 to 9-230 in which at least one hydrogen is substituted with -F, a group represented by one of Formulae 10-1 to 10-145, a group represented by one of Formulae 10-1 to 10-145 in which at least one hydrogen is substituted with deuterium, a group represented by one of Formulae 10-1 to 10-145 in which at least one hydrogen is substituted with -F, a group represented by one of Formulae 10-201 to 10-354, a group represented by one of Formulae 10-201 to 10-354 in which at least one hydrogen is substituted with deuterium, or a group represented by one of Formulae 10-201 to 10-354 in which at least one hydrogen is substituted with -F:

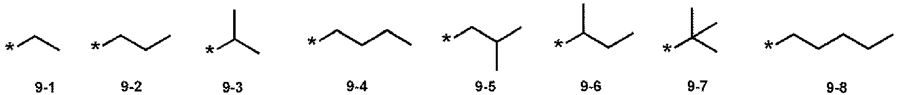

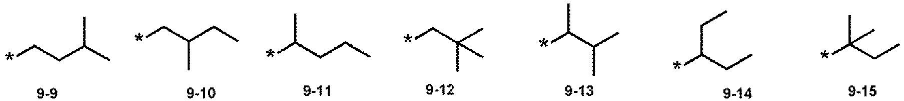

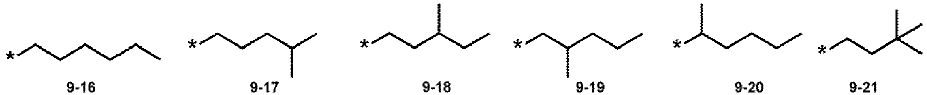

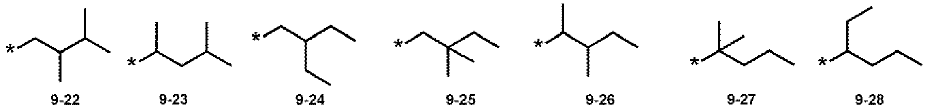

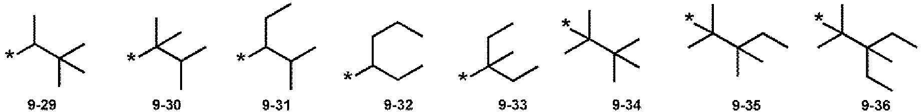

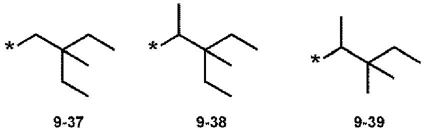

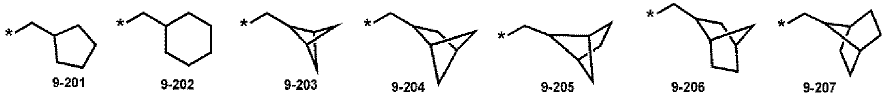

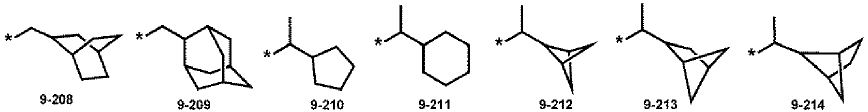

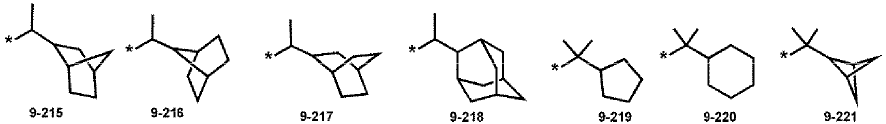

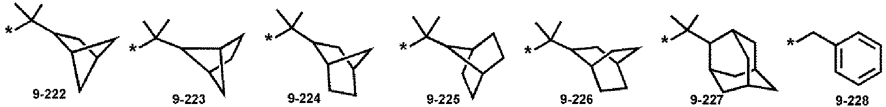

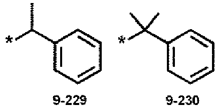

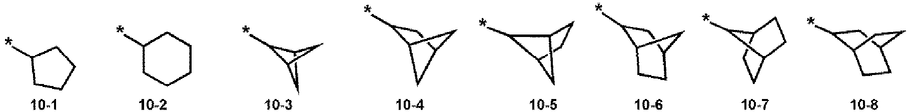

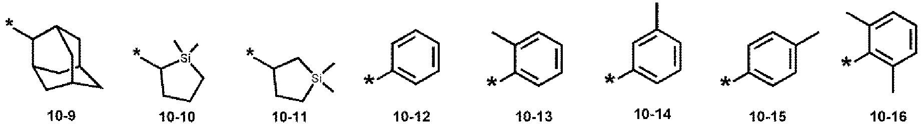

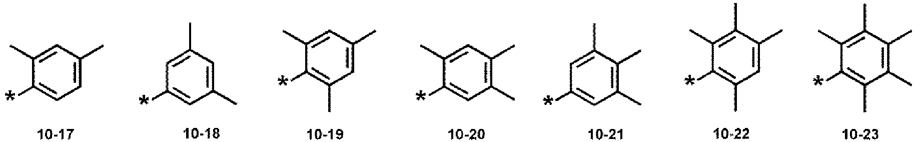

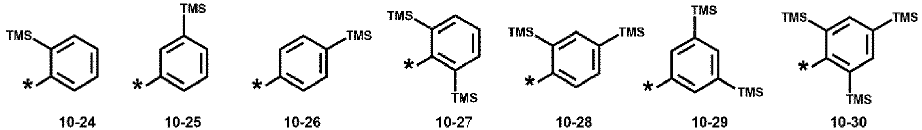

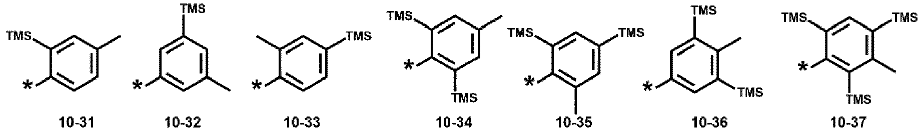

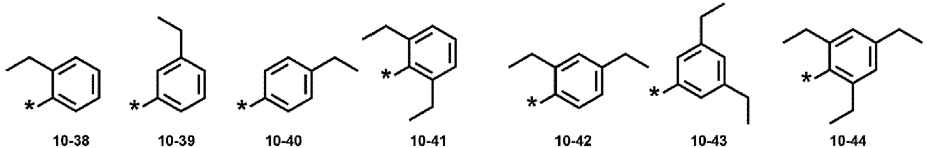

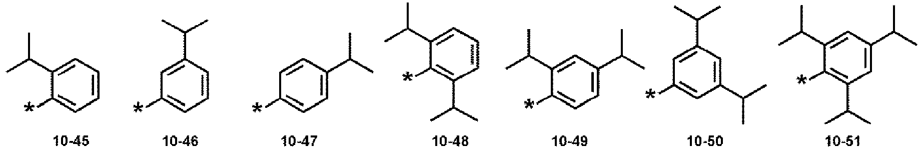

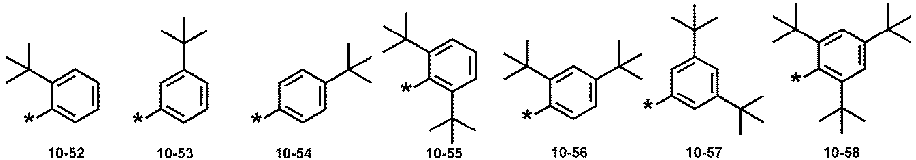

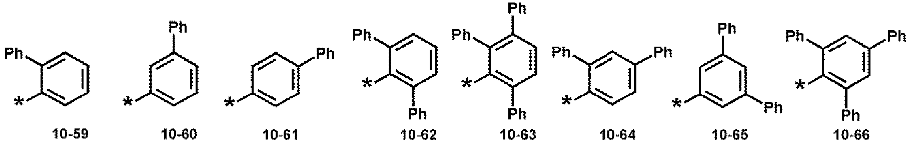

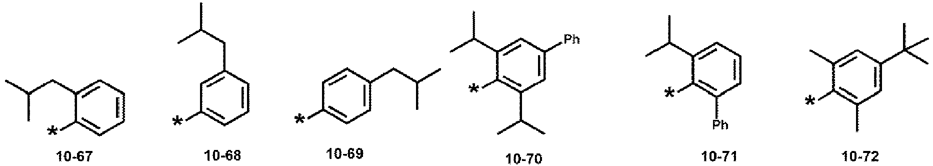

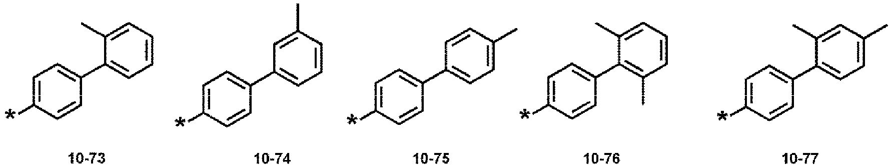

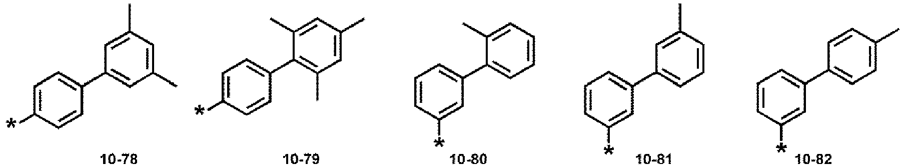

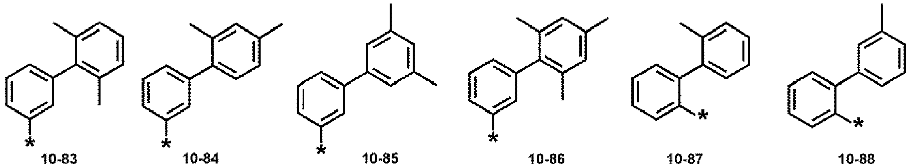

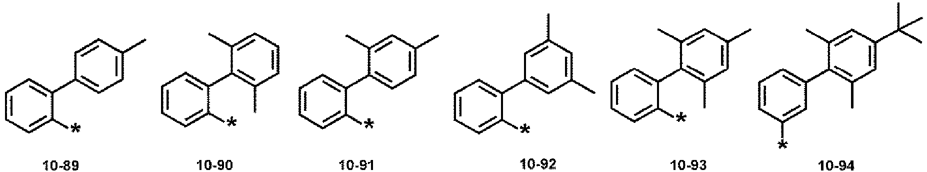

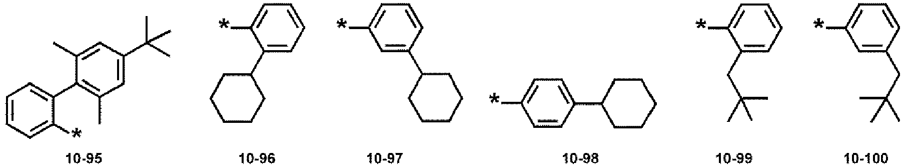

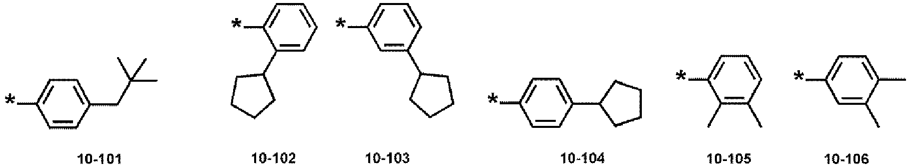

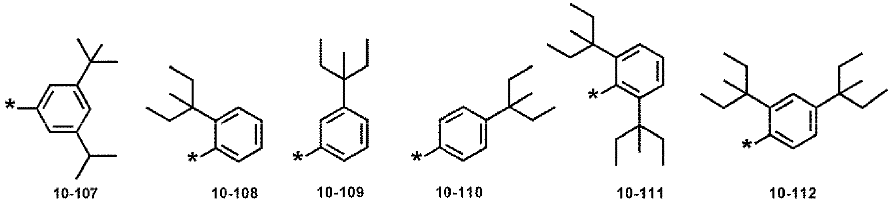

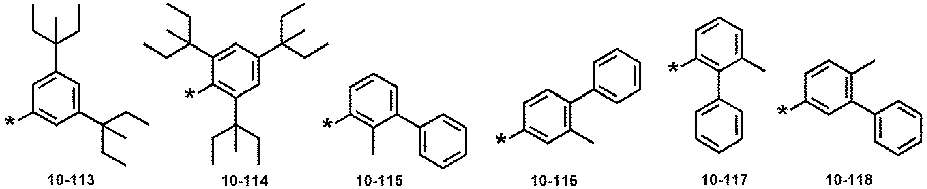

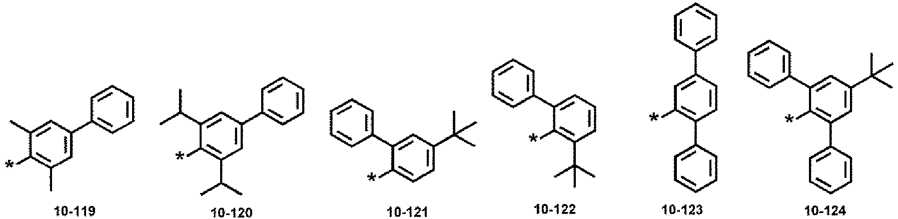

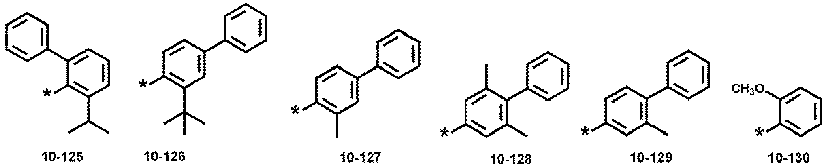

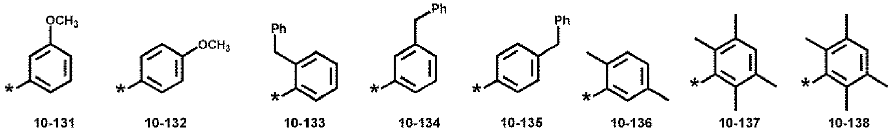

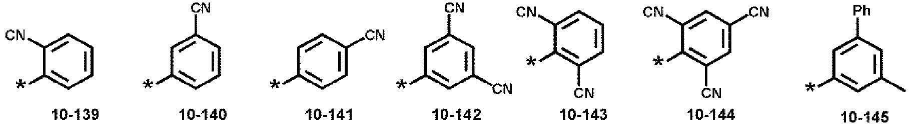

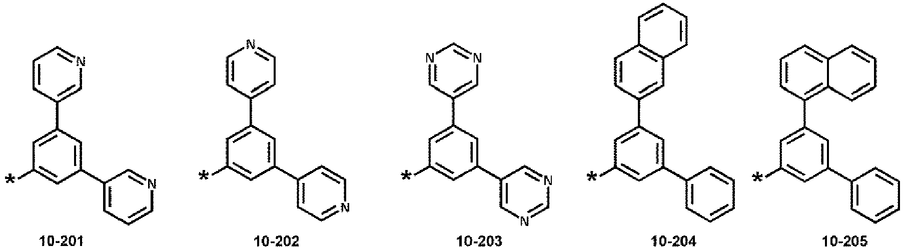

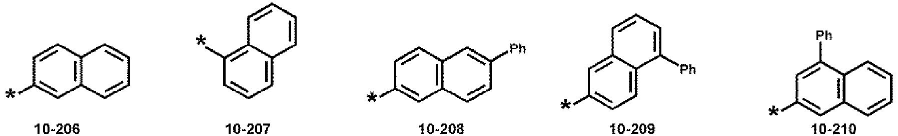

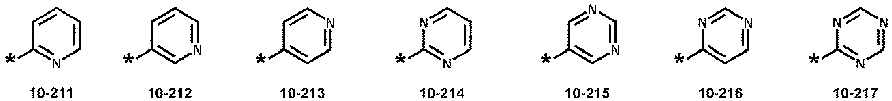

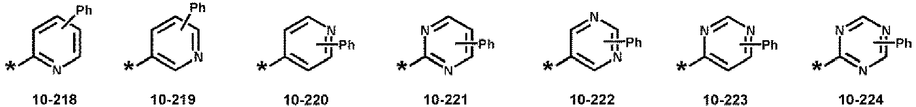

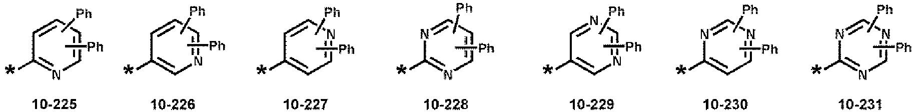

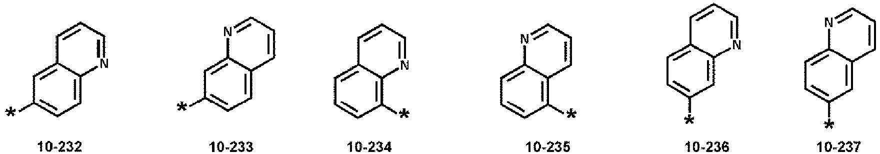

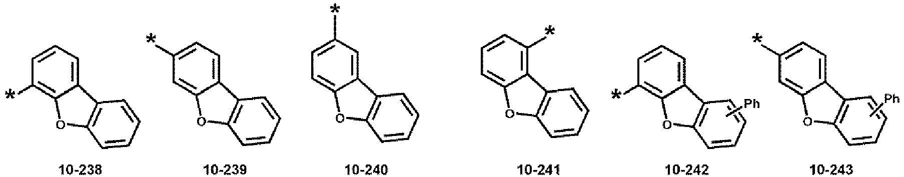

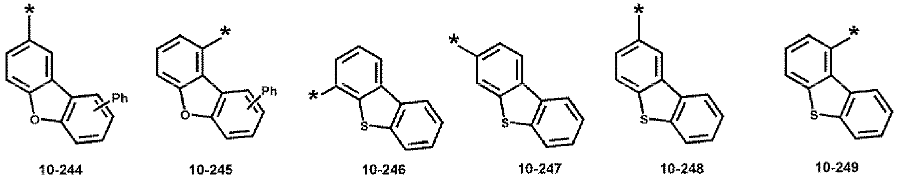

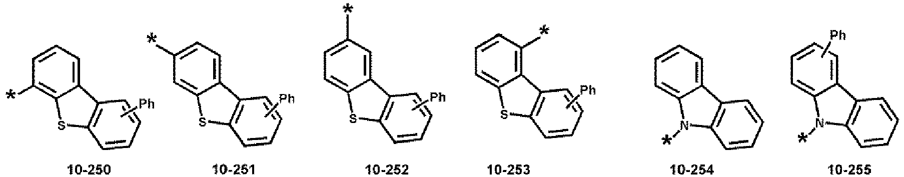

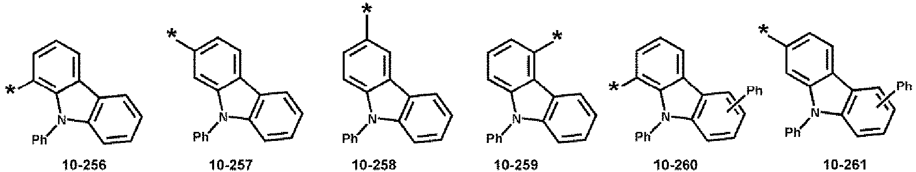

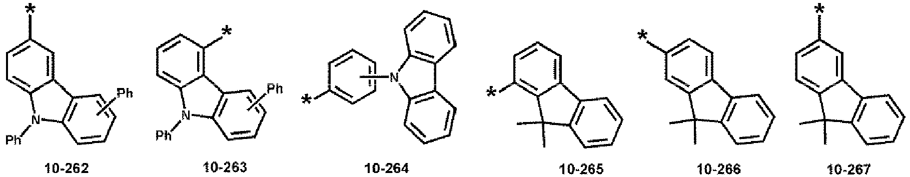

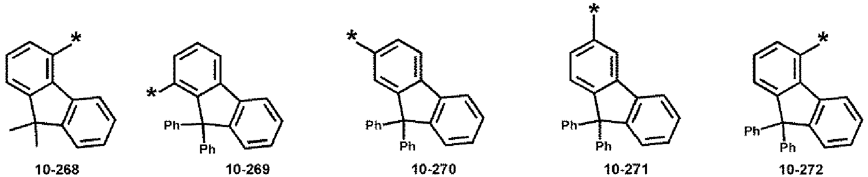

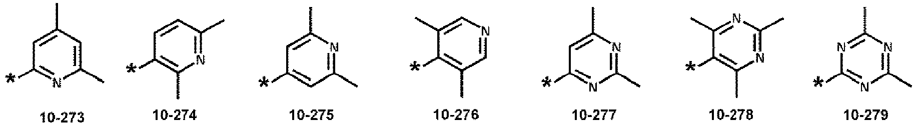

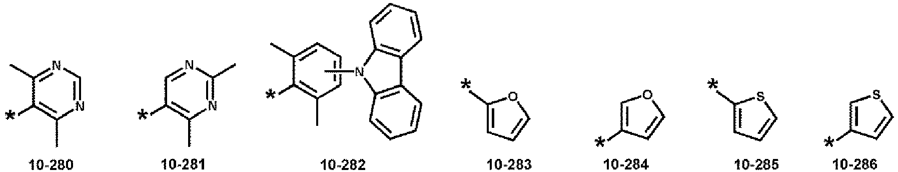

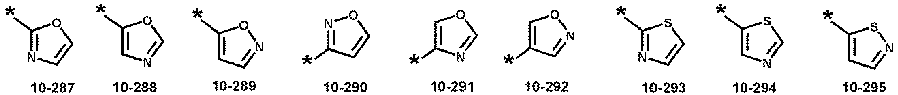

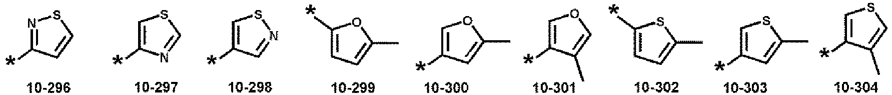

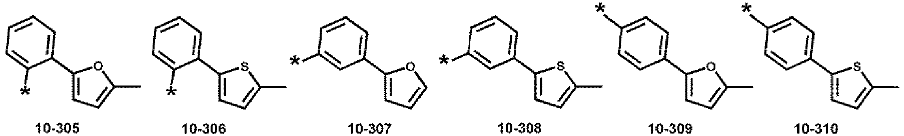

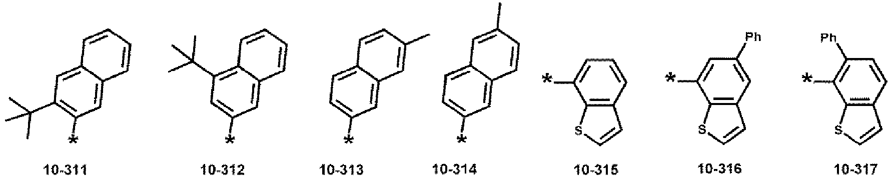

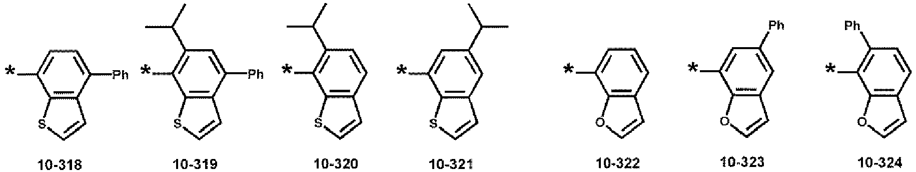

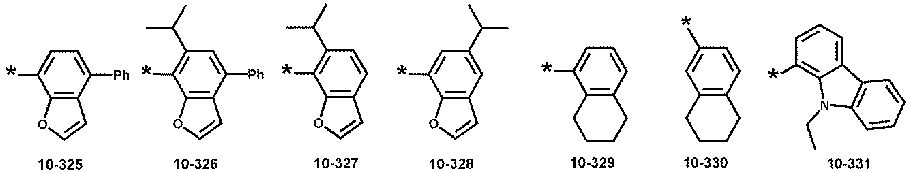

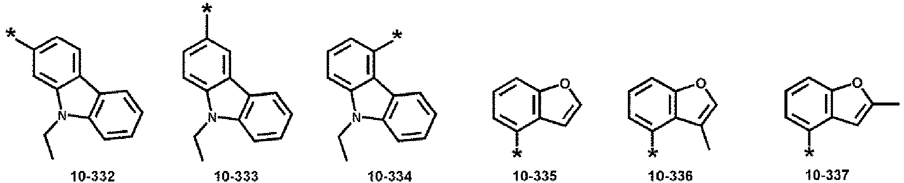

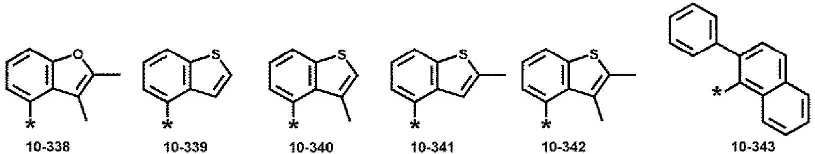

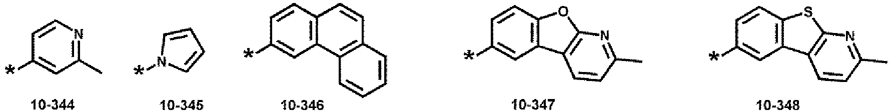

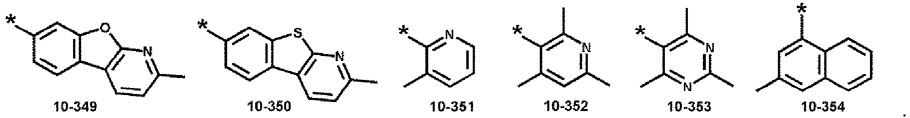

In Formulae 9-1 to 9-39, 9-201 to 9-230, 10-1 to 10-145, and 10-201 to 10-354, * indicates a binding site to a neighboring atom, "Ph" is a phenyl group, "TMS" is a trimethylsilyl group, and "TMG" is a trimethylgermyl group.

The "group represented by one of Formulae 9-1 to 9-39 in which at least one hydrogen is substituted with deuterium" and the "group represented by one of Formulae 9-201 to 9-230 in which at least one hydrogen is substituted with deuterium" may be, for example, a group represented by one of Formulae 9-501 to 9-514 or 9-601 to 9-637: 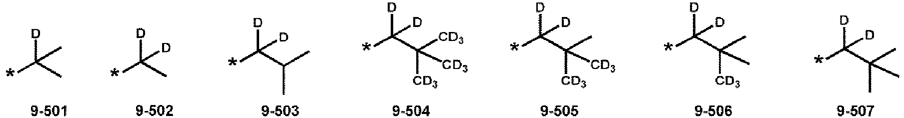 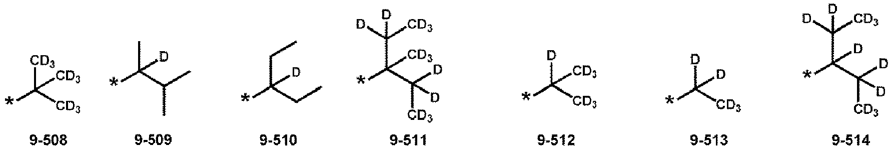 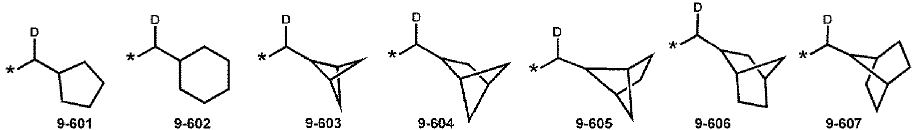 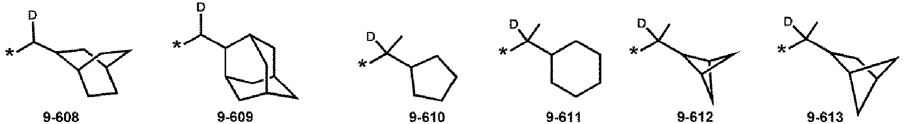 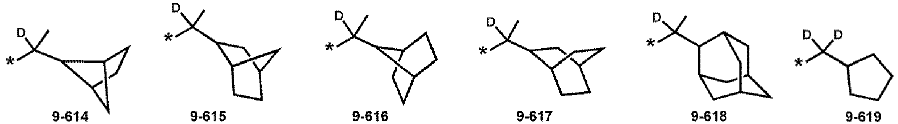 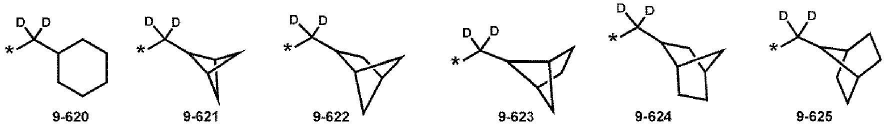 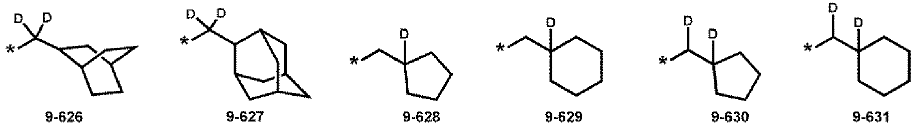 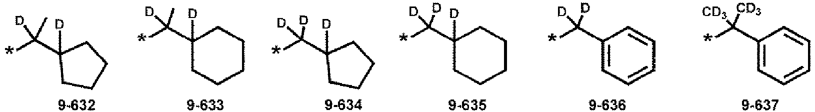 wherein, in Formulae 9-501 to 9-514 and 9-601 to 9-637, * indicates a binding site to a neighboring atom.

The "group represented by one of Formulae 9-1 to 9-39 in which at least one hydrogen is substituted with -F" and the "group represented by one of Formulae 9-201 to 9-230 in which at least one hydrogen is substituted with -F" may be, for example, a group represented by one of Formulae 9-701 to 9-710: 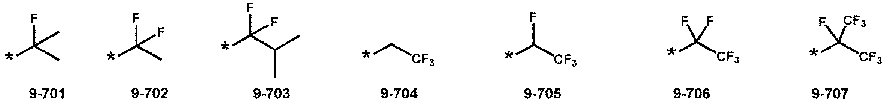 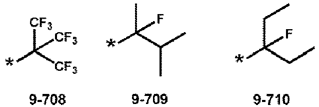 wherein, in Formulae 9-701 to 9-710, * indicates a binding site to a neighboring atom.

The "group represented by one of Formulae 10-1 to 10-145 in which at least one hydrogen is substituted with deuterium" and the "group represented by one of Formulae 10-201 to 10-354 in which at least one hydrogen is substituted with deuterium" may be, for example, a group represented by one of Formulae 10-501 to 10-553: 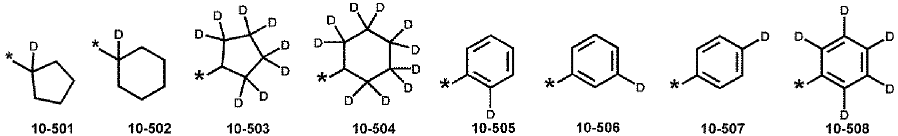 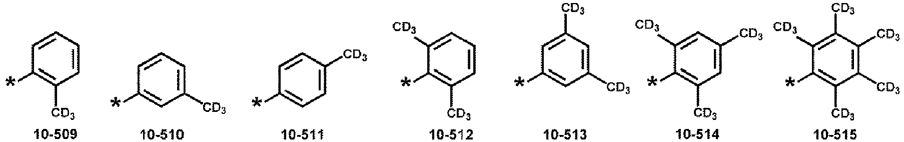 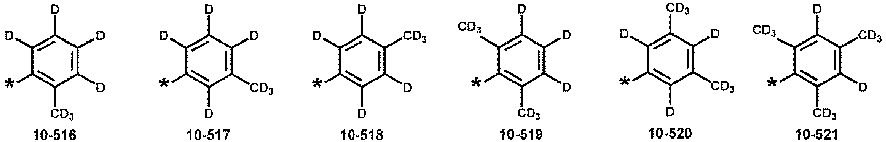 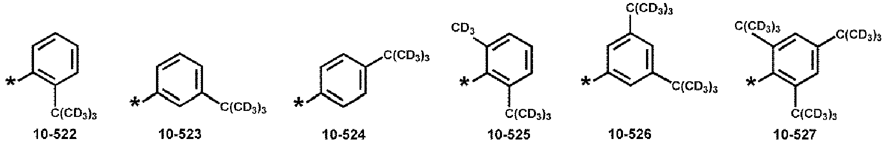 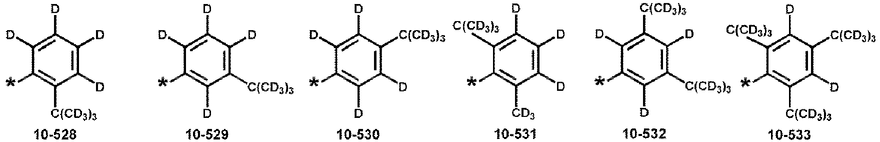 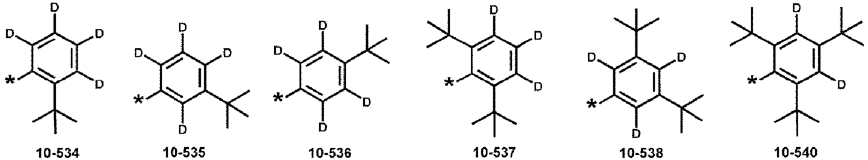 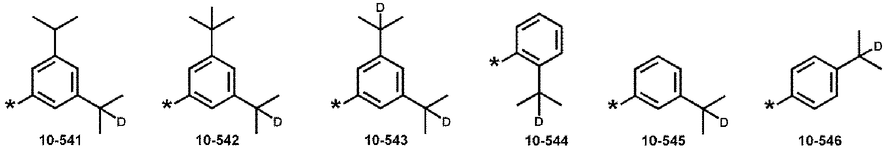 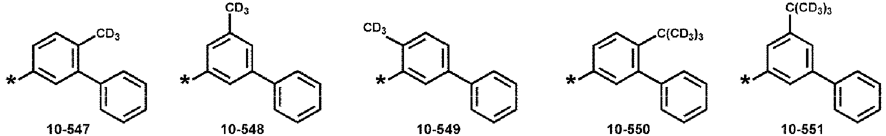 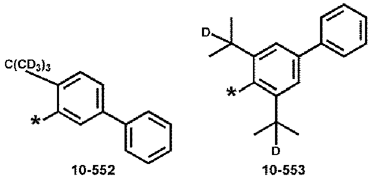 wherein, in Formulae 10-501 to 10-553, * indicates a binding site to a neighboring atom.

The "group represented by one of Formulae 10-1 to 10-145 in which at least one hydrogen is substituted with -F" and the "group represented by one of Formulae 10-201 to 10-354 in which at least one hydrogen is substituted with -F" may be, for example, a group represented by one of Formulae 10-601 to 10-636: 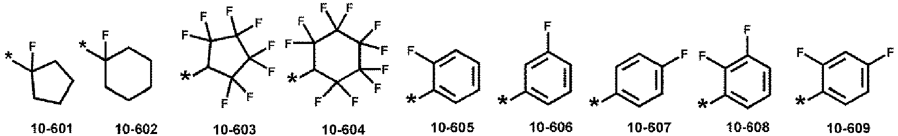 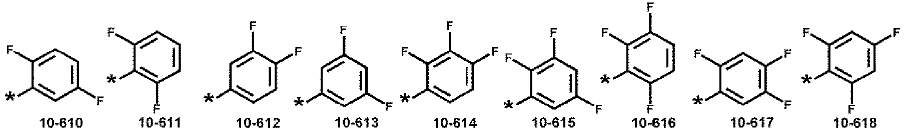 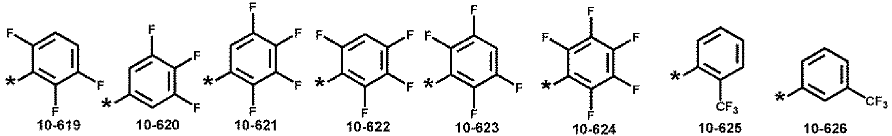 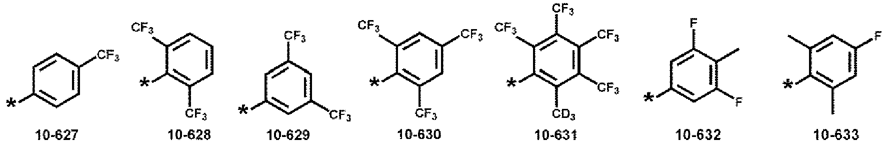 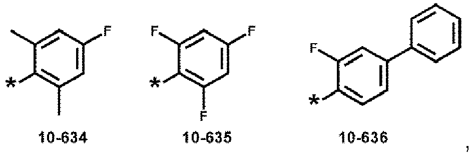 wherein, in Formulae 10-601 to 10-636, * indicates a binding site to a neighboring atom.
a1 to a4 in Formula 2-1 and 2-2 indicate numbers of R₁ to R₄, respectively, and a1 is an integer from 0 to 3, a2 is an integer from 0 to 6, a3 is an integer from 0 to 4, and a4 is an integer from 1 to 20 (for example, an integer from 0 to 10). When a1 is 2 or greater, two or more of R₁ may be identical to or different from each other, when a2 is 2 or greater, two or more of R₂ may be identical to or different from each other, when a3 is 2 or greater, two or more of R₃ may be identical to or different from each other, and when a4 is 2 or greater, two or more of R₄ may be identical to or different from each other. For example, a1 to a4 may each independently be 0, 1, 2, or 3.

In one or more embodiments, in Formula 2-1, R₂ may not be hydrogen.

In one or more embodiments, in Formula 2-2, R₃ may not be hydrogen.

In one or more embodiments, the organometallic compound may include at least one of deuterium, a fluoro group, or a combination thereof.

In one or more embodiments, the organometallic compound represented by Formula 1 may satisfy at least one of Condition 1 to Condition 8:
Condition 1
   a1 in Formula 2-1 is not 0, and at least one of R₁ in the number of a1 contains deuterium (for example, a1 in Formula 2-1 is not 0, and at least one of R₁ in the number of a1 is deuterium or a deuterated C₁-C₂₀ alkyl group);
Condition 2
   a2 in Formula 2-1 is not 0, and at least one of R₂ in the number of a2 contains deuterium (for example, a2 in Formula 2-1 is not 0, and at least one of R₂ in the number of a2 is deuterium or a deuterated C₁-C₂₀ alkyl group);
Condition 3
   a3 in Formula 2-2 is not 0, and at least one of R₃ in the number of a3 contains deuterium (for example, a3 in Formula 2-2 is not 0, and at least one of R₃ in the number of a3 is deuterium or a deuterated C₁-C₂₀ alkyl group);
Condition 4
   a4 in Formula 2-2 is not 0, and at least one of R₄ in the number of a4 contains deuterium (for example, a4 in Formula 2-2 is not 0, and at least one of R₄ in the number of a4 is deuterium or a deuterated C₁-C₂₀ alkyl group);
Condition 5
   a1 in Formula 2-1 is not 0, and at least one of R₁ in the number of a1 contains a fluoro group (for example, a1 in Formula 2-1 is not 0, and at least one of R₁ in the number of a1 is a fluoro group or a fluorinated C₁-C₂₀ alkyl group);
Condition 6
   a2 in Formula 2-1 is not 0, and at least one of R₂ in the number of a2 contains a fluoro group (for example, a2 in Formula 2-1 is not 0, and at least one of R₂ in the number of a2 is a fluoro group or a fluorinated C₁-C₂₀ alkyl group);
Condition 7
   a3 in Formula 2-2 is not 0, and at least one of R₃ in the number of a3 contains a fluoro group (for example, a3 in Formula 2-2 is not 0, and at least one of R₃ in the number of a3 is a fluoro group or a fluorinated C₁-C₂₀ alkyl group);
Condition 8
   a4 in Formula 2-2 is not 0, and at least one of R₄ in the number of a4 contains a fluoro group (for example, a4 in Formula 2-2 is not 0, and at least one of R₄ in the number of a4 is a fluoro group or a fluorinated C₁-C₂₀ alkyl group).

In Formulae 2-1 and 2-2, in each of i) two or more of a plurality of R₁, ii) two or more of a plurality of R₂, iii) two or more of a plurality of R₃, iv) two or more of a plurality of R₄, and v) two or more of R₁ to R₄, the two or more may be optionally linked to each other to form a C₅-C₃₀ carbocyclic group that is unsubstituted or substituted with at least one R₁₀ₐ or a C₁-C₃₀ heterocyclic group that is unsubstituted or substituted with at least one R₁₀ₐ. That is, i) two or more of a plurality of R₁ are optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ, ii) two or more of a plurality of R₂ are optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ, iii) two or more of a plurality of R₃ are optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ, iv) two or more of a plurality of R₄ are optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ, and v) two or more of R₁ to R₄ are optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ.

R₁₀ₐ is as described in connection with R₂. For example, R₁₀ₐ may be as described in connection with R₂, except that R₁₀ₐ may not be hydrogen.
* and *' in Formulae 2-1 and 2-2 each indicate a binding site to M in Formula 1.

In one or more embodiments, a group represented by: 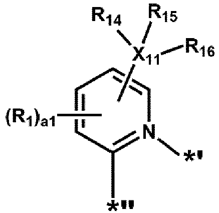 in Formula 2-1 may be a group represented by one of Formulae CY1-1 to CY1-6: 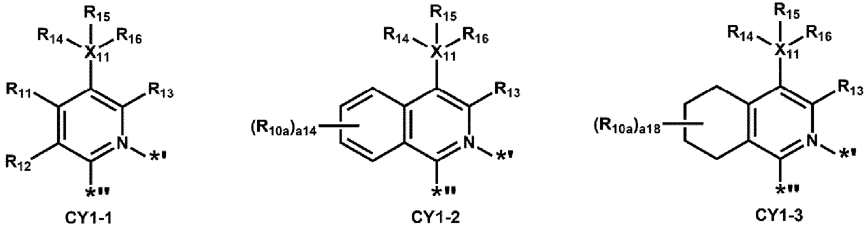 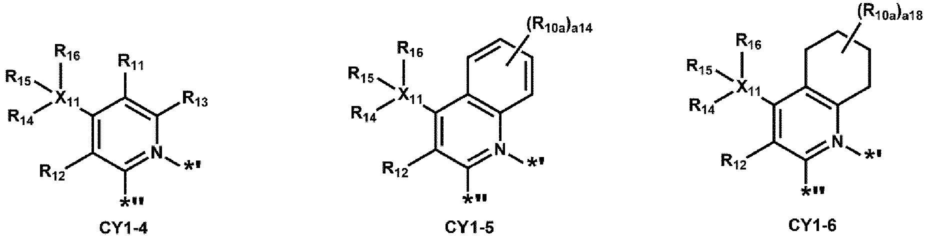 wherein, in Formulae CY1-1 to CY1-6,
X₁₁, R₁₄ to R₁₆, and R₁₀ₐ are each as described herein,
R₁₁ to R₁₃ are each independently as described in connection with R₁,
a14 may be an integer from 0 to 4,
a18 may be an integer from 0 to 8,
*' indicates a binding site to M in Formula 1, and
*" indicates a binding site to one of A₁ to A₄ in Formula 2-1.

For example, in one or more embodiments, R₁₁ in Formulae CY1-1 and/or CY1-4 may not be hydrogen.

In one or more embodiments, R₁₁ in Formulae CY1-1 and/or CY1-4 may not be hydrogen or a methyl group.

In one or more embodiments, R₁₁ in Formulae CY1-1 and/or CY1-4 may not be hydrogen, a methyl group, or a cyano group.

In one or more embodiments, R₁₁ in Formulae CY1-1 and/or CY1-4 may not be hydrogen, and R₁₂ and R₁₃ may each be hydrogen.

In one or more embodiments, R₁₁ in Formulae CY1-1 and/or CY1-4 may include two or more carbon atoms, three or more carbon atoms, or four or more carbon atoms.

In one or more embodiments, R₁₁ in Formulae CY1-1 and/or CY1-4 may be:
a methyl group that is substituted with at least one of deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or a combination thereof; or
a C₁-C₂₀ alkyl group, a C₃-C₁₀ cycloalkyl group, a phenyl group, a naphthyl group, a pyridinyl group, a furanyl group, a thiophenyl group, a benzofuranyl group, a benzothiophenyl group, a dibenzofuranyl group, or a dibenzothiophenyl group, each unsubstituted or substituted with at least one of deuterium, -F, cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, -Si(Q₃₃)(Q₃₄)(Q₃₅), - Ge(Q₃₃)(Q₃₄)(Q₃₅), or a combination thereof. Q₃₃ to Q₃₅ are each as defined herein. In one or more embodiments, a group represented by 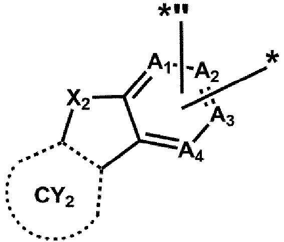 in Formula 2-1 may be a group represented by one of Formulae CY2-1 to CY2-14: 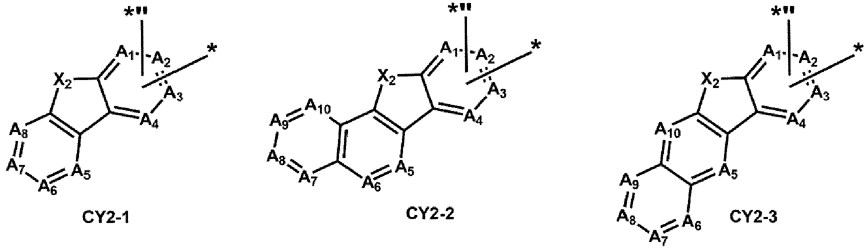 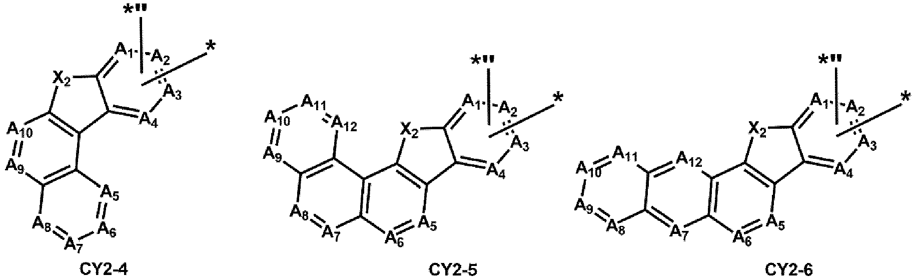 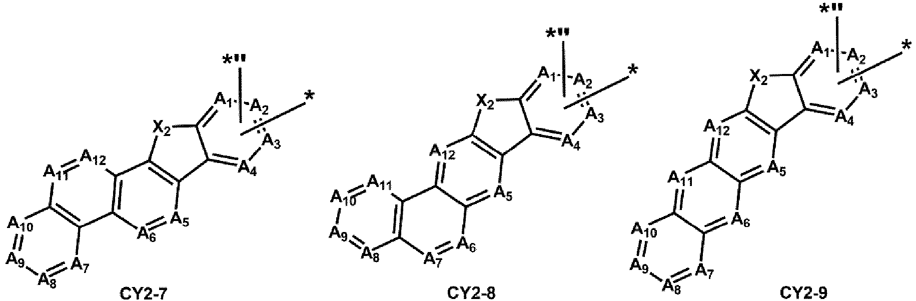 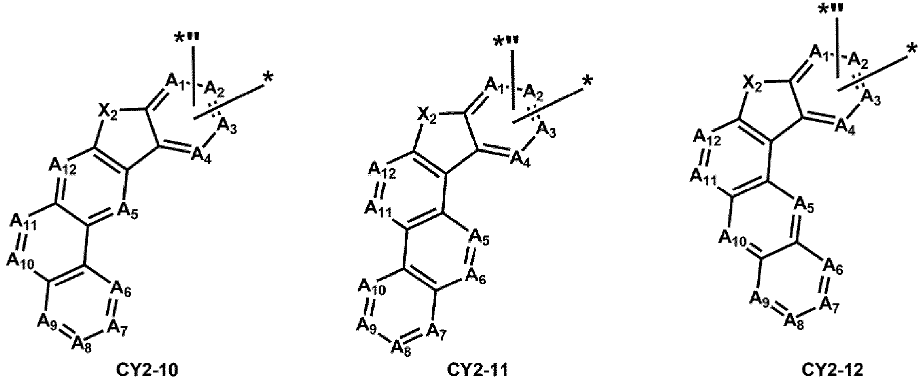 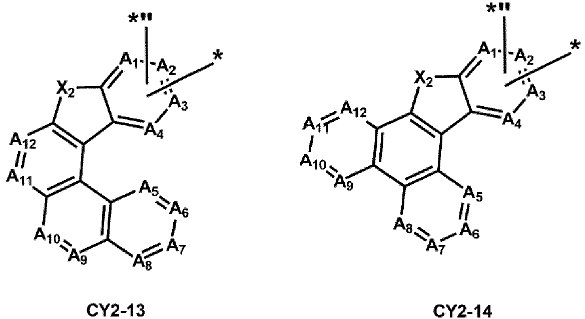 wherein, in Formulae CY2-1 to CY2-14,
   X₂ is as described herein,
   A₁ to A₁₂ may each independently be C or N, and at least one of A₁ to A₈ of Formula CY2-1 may be N, at least one of A₁ to A₁₀ of Formulae CY2-2 to CY2-4 may be N, and at least one of A₁ to A₁₂ of Formulae CY2-5 to CY2-14 may be N,
   *" indicates a binding site to a neighboring pyridine group in Formula 2-1, and
   * is a binding site to M in Formula 1.

For example, in one or more embodiments,
at least one of A₄ to A₈ in Formula CY2-1 may be N,
at least one of A₄ to A₁₀ in Formulae CY2-2 to CY2-4 may be N, and
at least one of A₄ to A₁₂ in Formulae CY2-5 to CY2-14 may be N.

In one or more embodiments, a group represented by 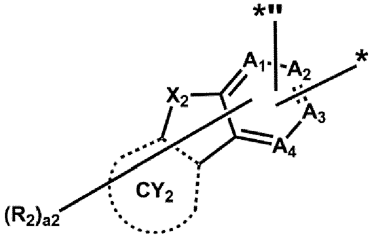 in Formula 2-1 may be a group represented by one of Formulae CY2(1) to CY2(60): 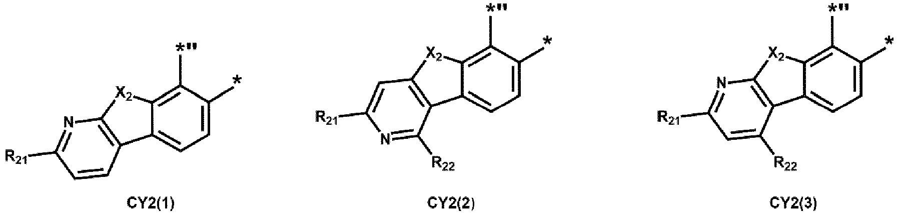 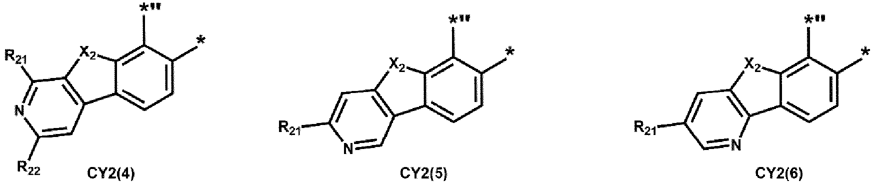 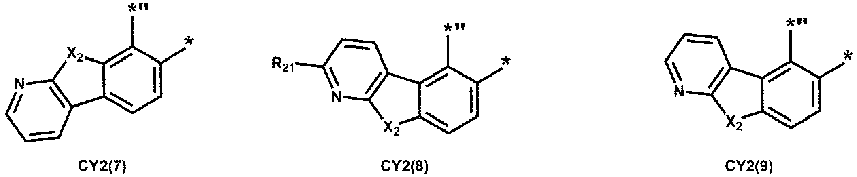 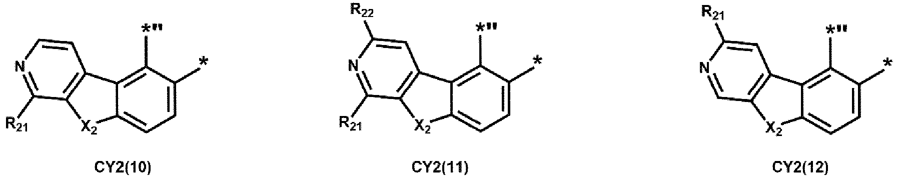 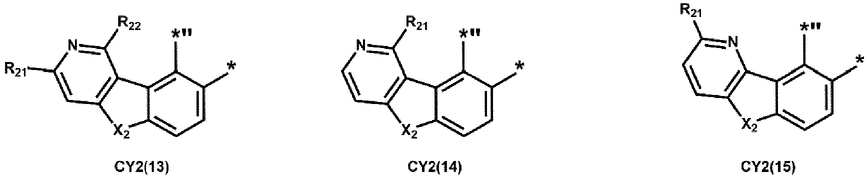 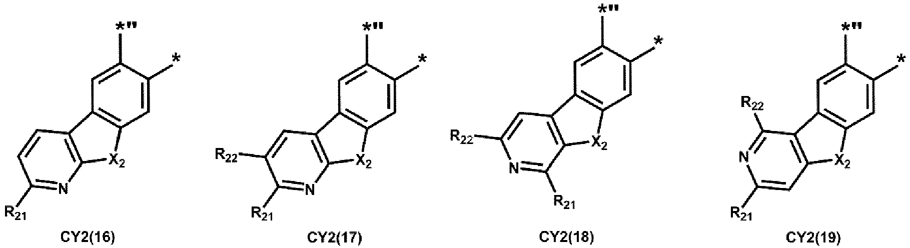 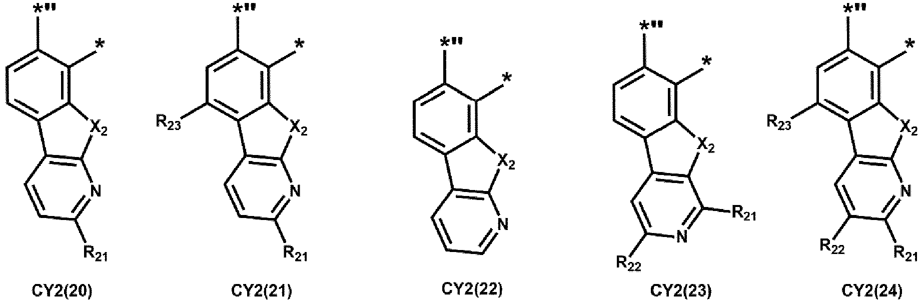 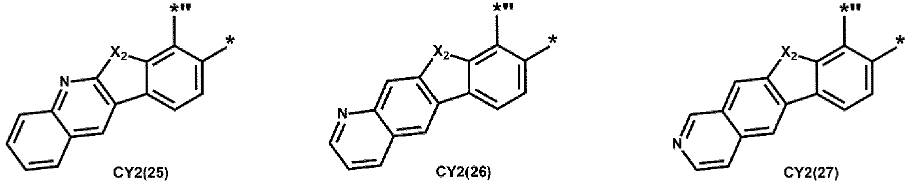 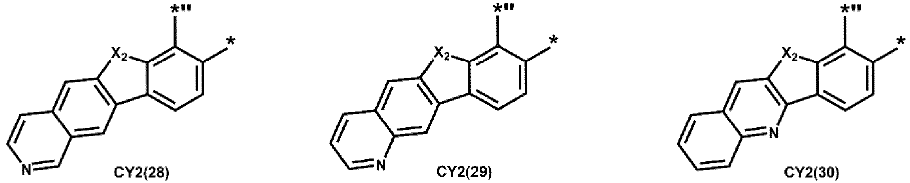 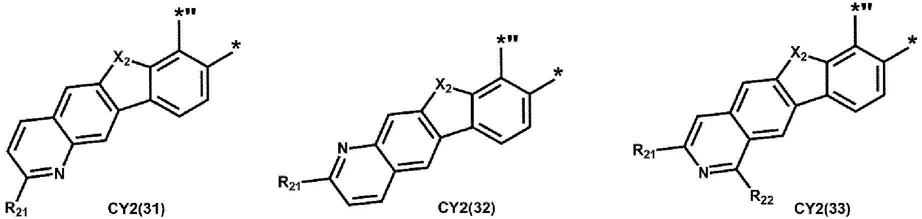 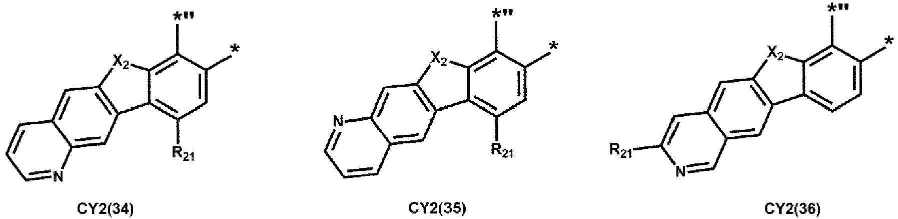 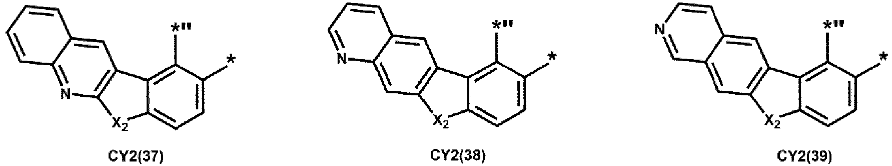 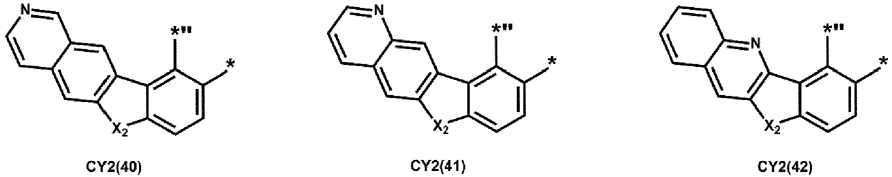 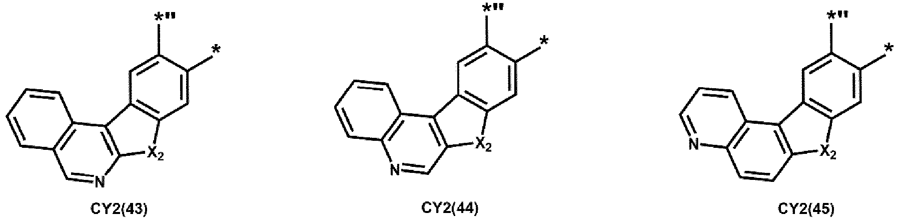 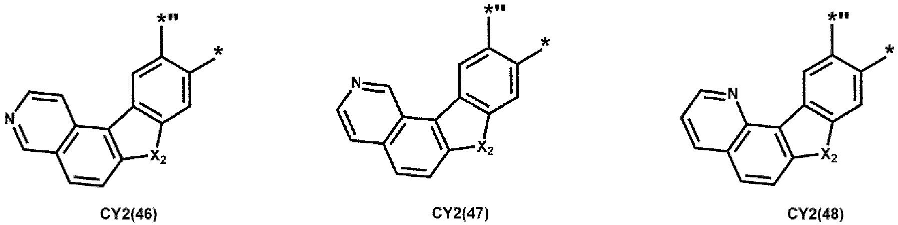 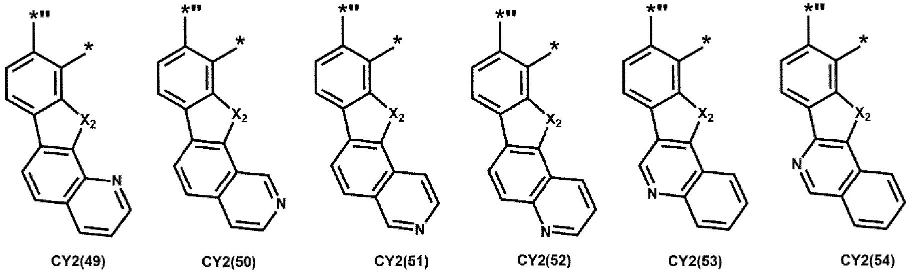 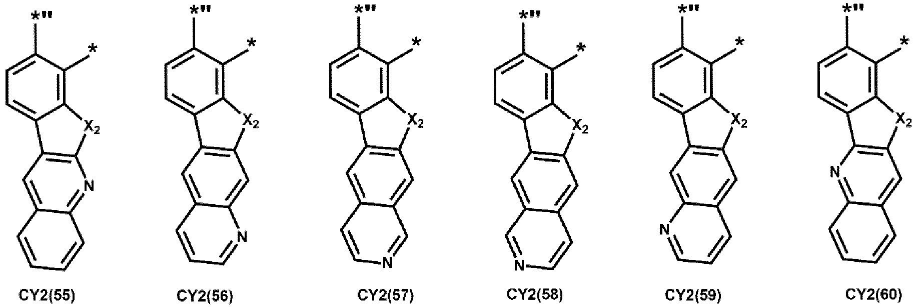 wherein, in Formulae CY2(1) to CY2(60),
X₂ is as described herein,
R₂₁ to R₂₃ are each independently as described in connection with R₂, wherein R₂₁ to R₂₃ are each not hydrogen,
*" indicates a binding site to a neighboring pyridine group in Formula 2-1, and
* is a binding site to M in Formula 1.

In one or more embodiments, a group represented by 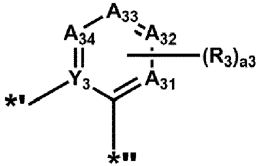 in Formula 2-2 may be a group represented by one of Formulae CY3(1) to CY3(16): 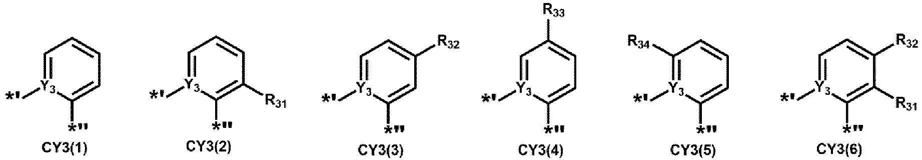 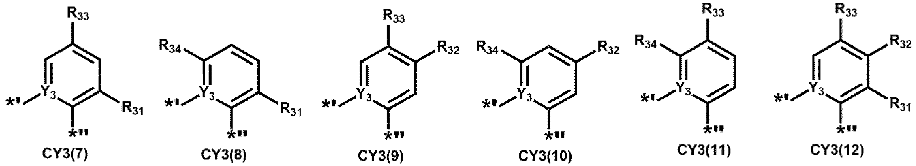 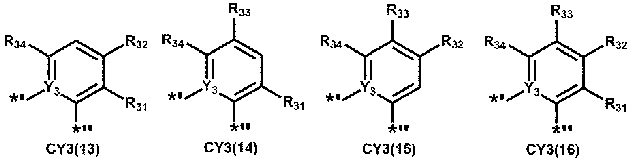 wherein, in Formulae CY3(1) to CY3(16),
Y₃ is as described herein,
R₃₁ to R₃₄ are each independently as described in connection with R₃, provided that each of R₃₁ to R₃₄ is not hydrogen,
*' indicates a binding site to M in Formula 1, and
*" indicates a binding site to a neighboring atom in Formula 2-2.

In one or more embodiments, a group represented by: 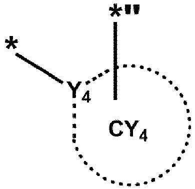 in Formula 2-2 may be a group represented by one of Formulae CY4-1 to CY4-21: 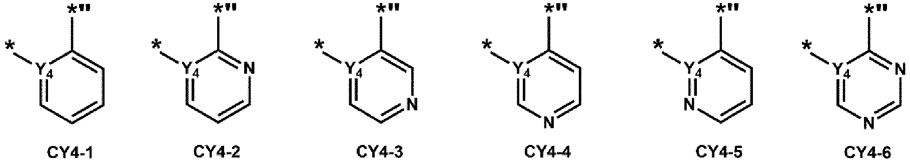 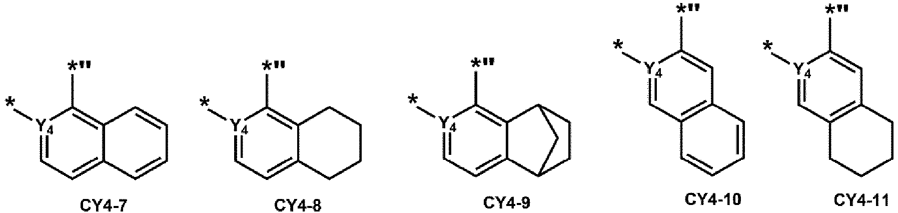 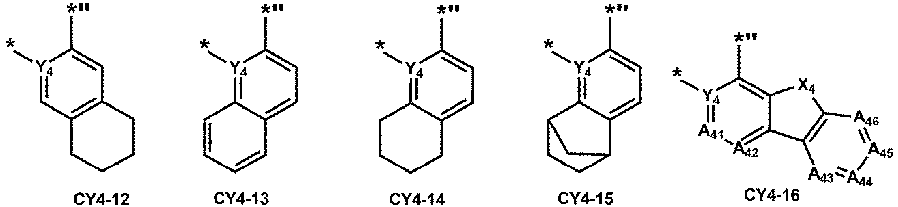 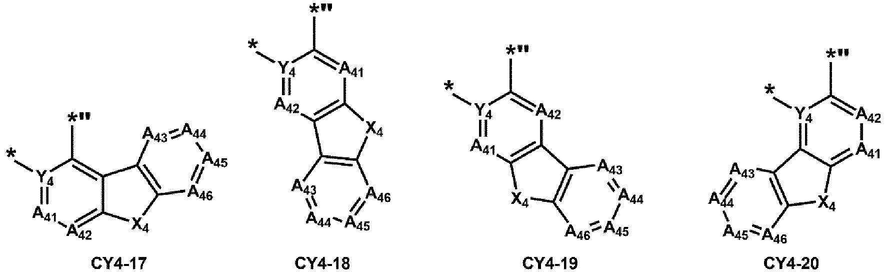 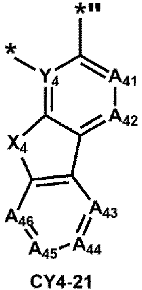 wherein, in Formulae CY4-1 to CY4-21,
Y₄ may be C,
A₄₁ to A₄₆ may each independently be C or N,
X₄ may be O, S, Se, N(R₄₉), C(R₄₉ₐ)(R_{49b}), or Si(R₄₉ₐ)(R_{49b}),
R₄₉, R₄₉ₐ, and R_{49b} are each independently as described in connection with R₄,
* indicates a binding site to M in Formula 1, and
*" indicates a binding site to a neighboring atom in Formula 2-2.

For example, A₄₁ to A₄₆ in Formulae CY4-16 to CY4-21 may each be C. In one or more embodiments, A₄₆ in Formulae CY4-16 to CY4-21 may be N. In one or more embodiments, a group represented by: 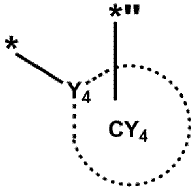 in Formula 2-2 may be a group represented by one of Formulae CY4-1 to CY4-16.

In one or more embodiments, a group represented by: 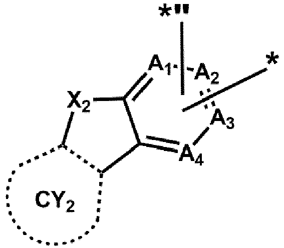 in Formula 2-1 may be substituted with at least one R₂, and a group represented by: 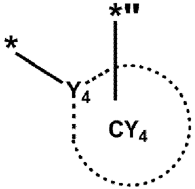 may be unsubstituted or substituted with at least one R₄, as defined herein.

In one or more embodiments, L₁ in Formula 1 may be a ligand represented by one of Formulae B1 to B331:

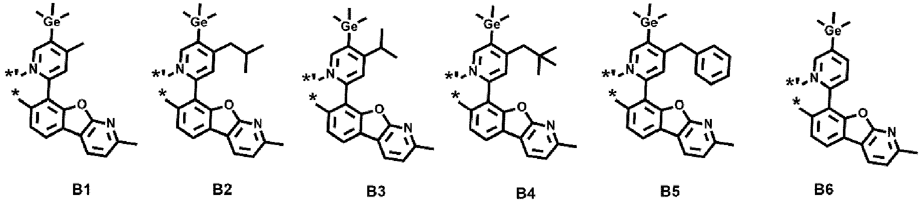

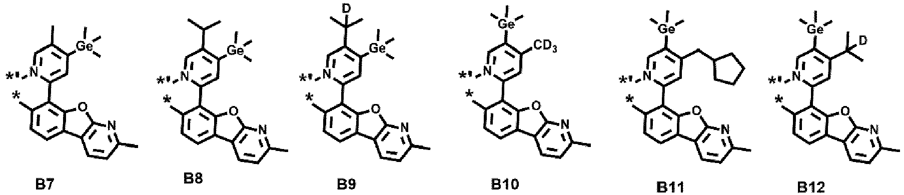

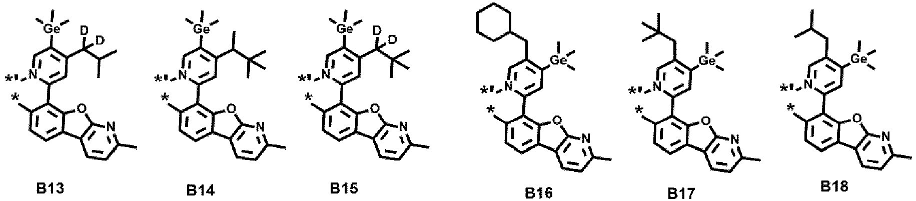

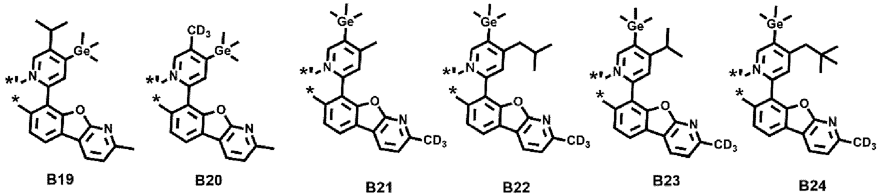

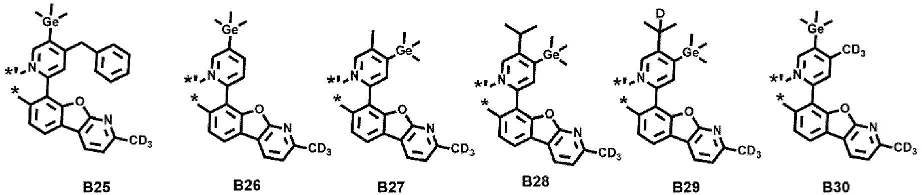

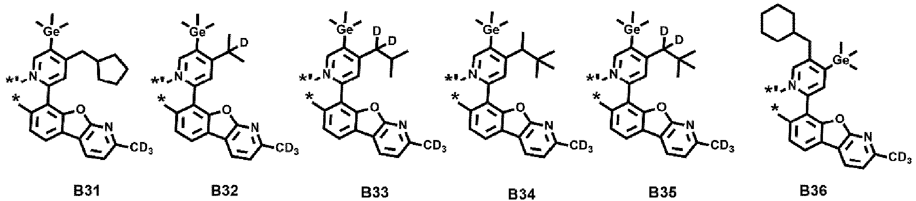

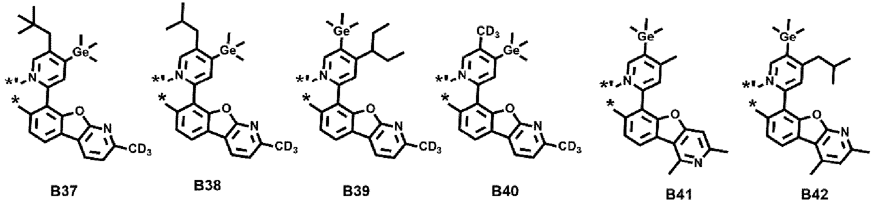

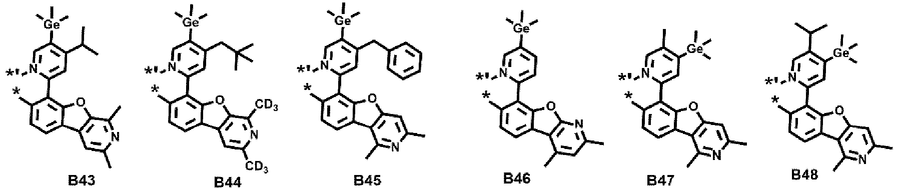

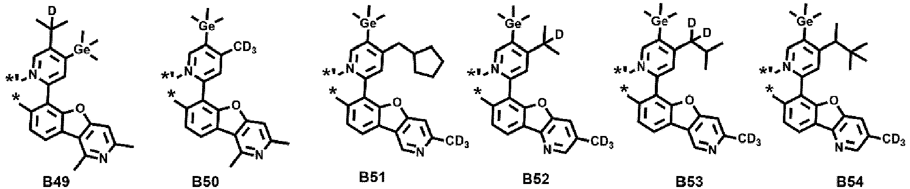

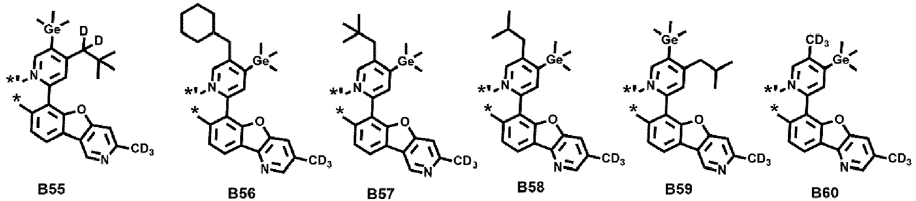

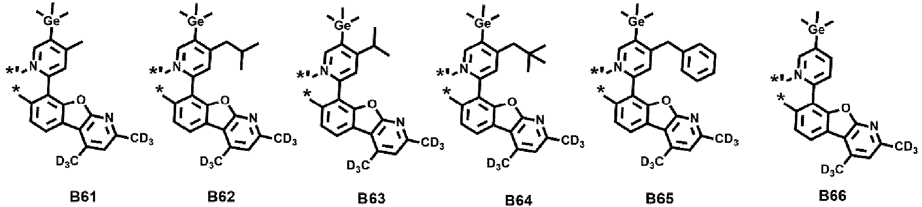

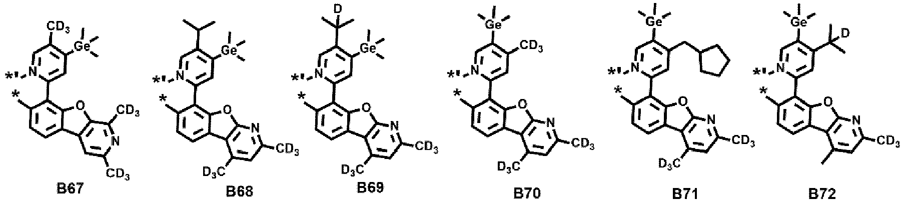

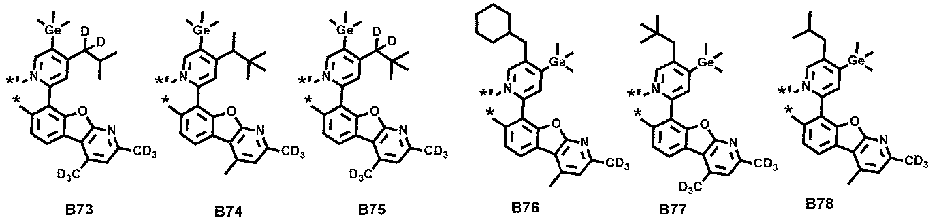

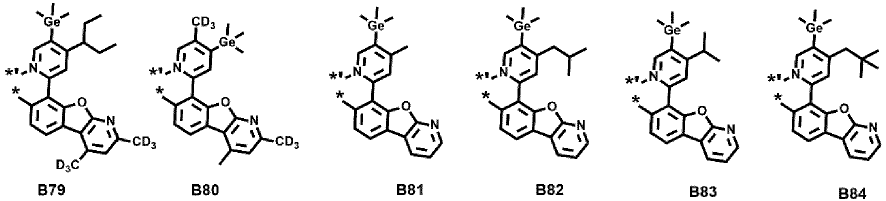

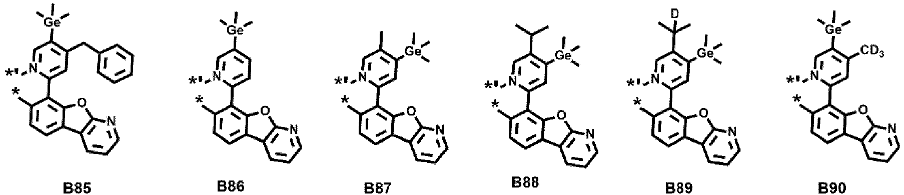

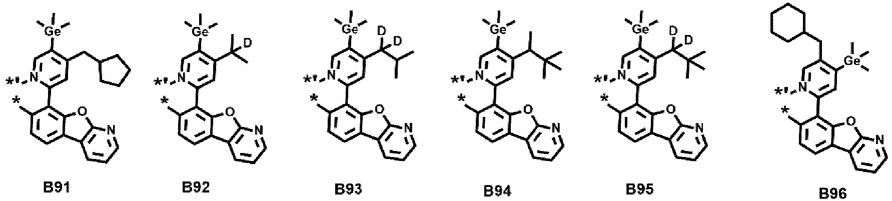

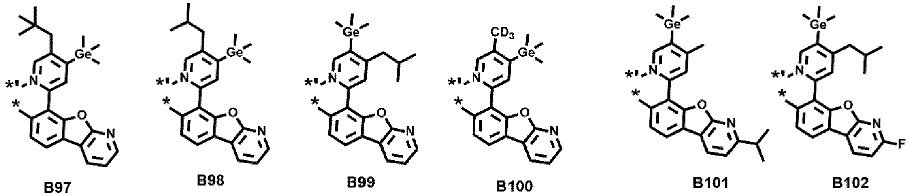

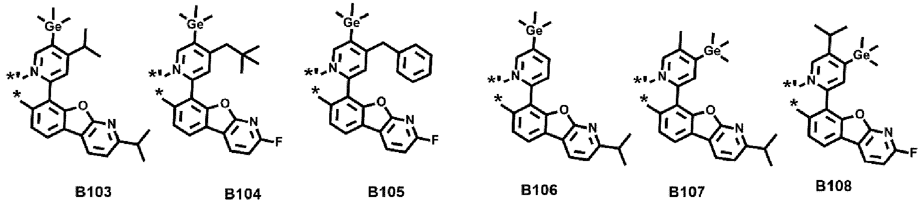

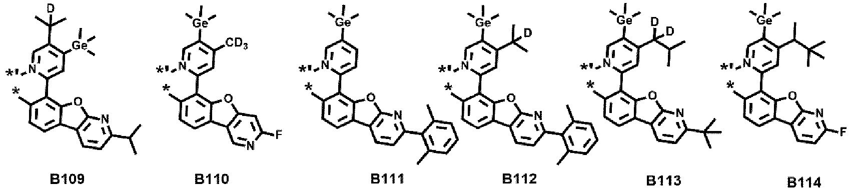

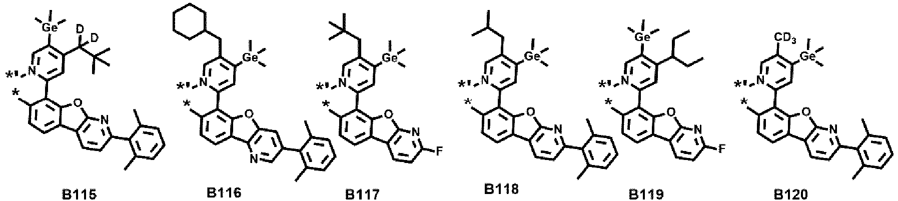

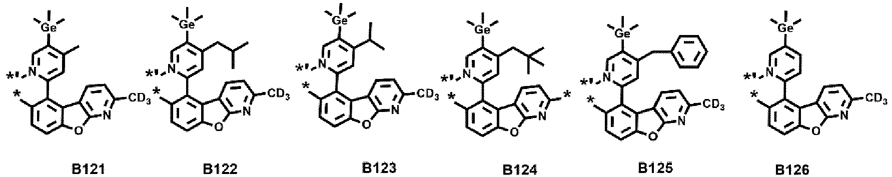

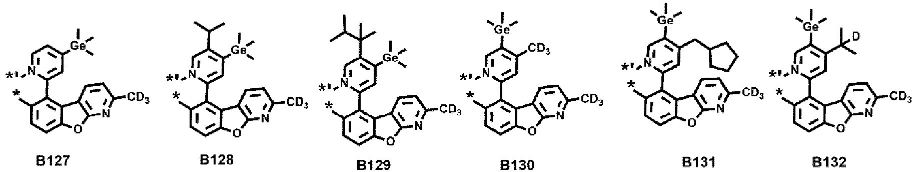

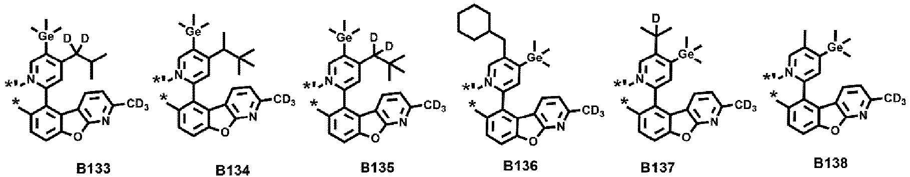

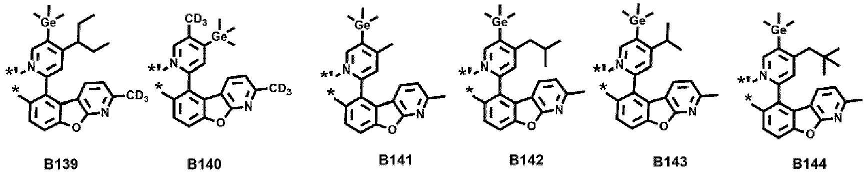

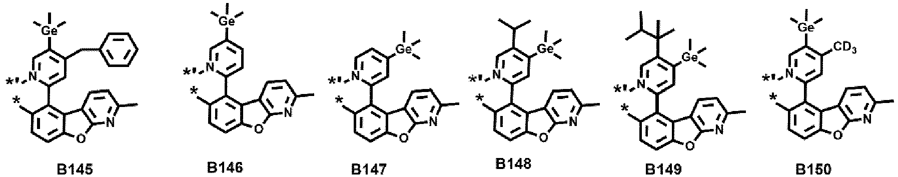

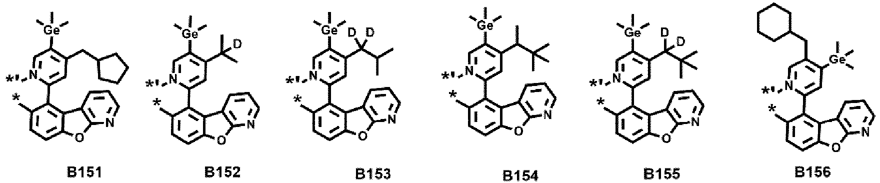

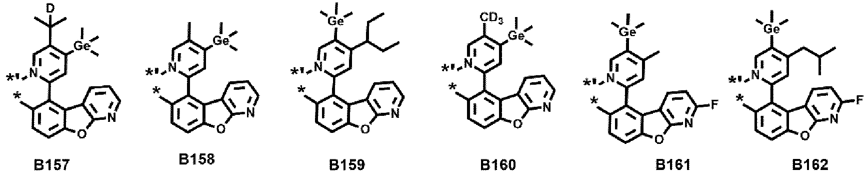

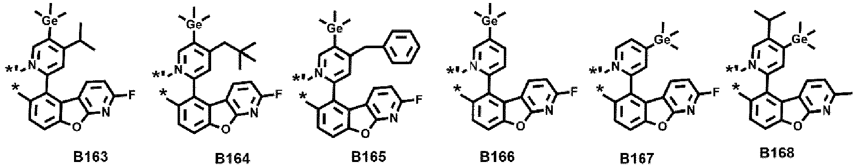

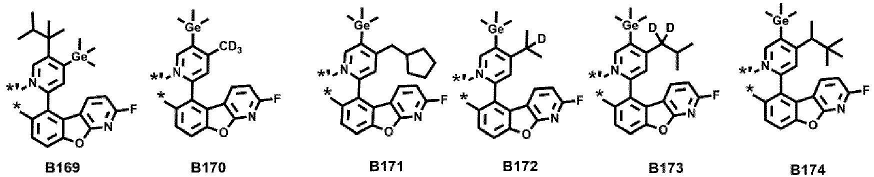

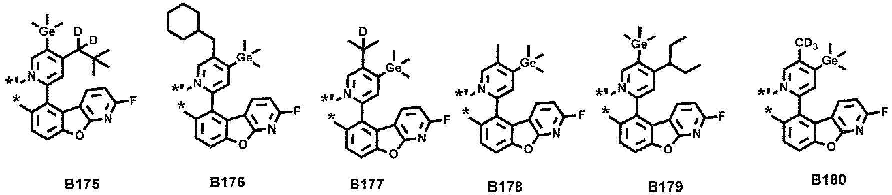

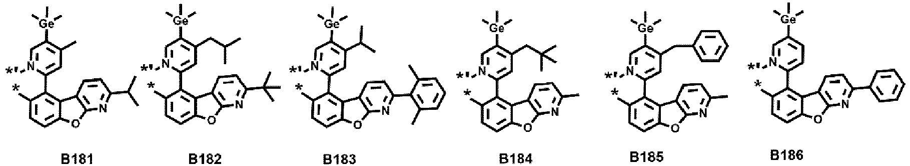

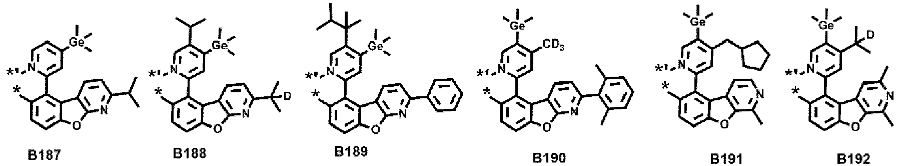

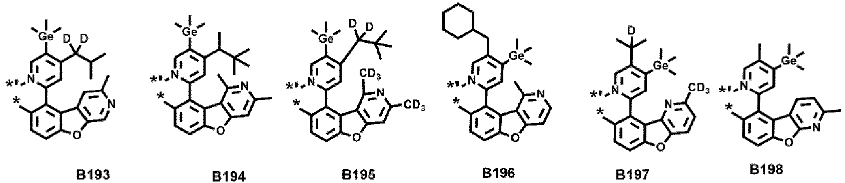

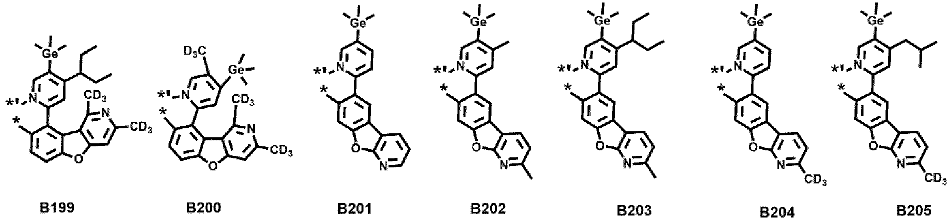

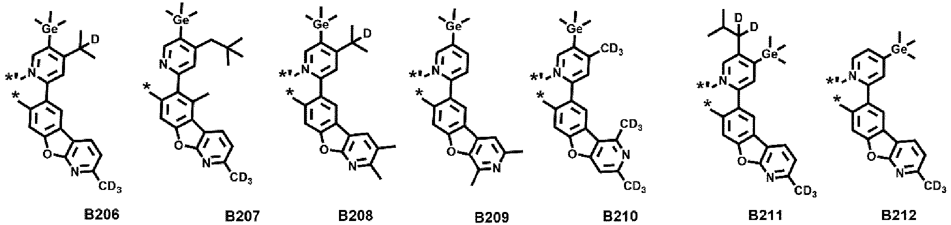

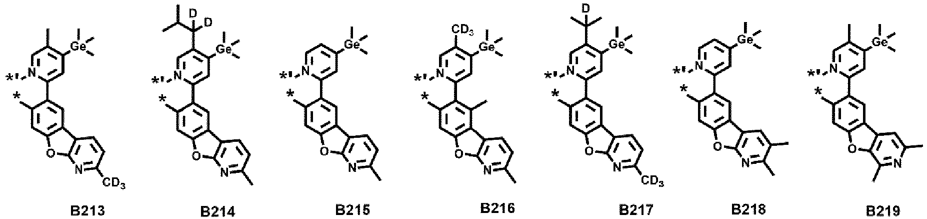

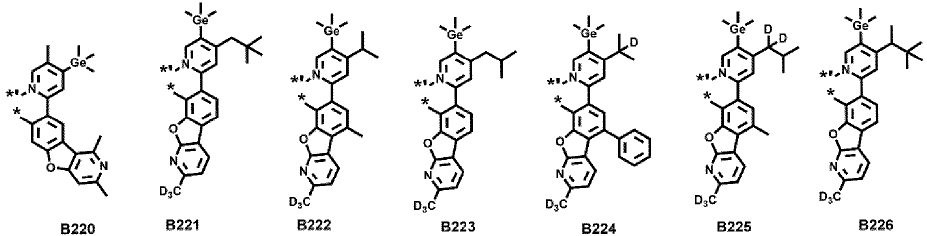

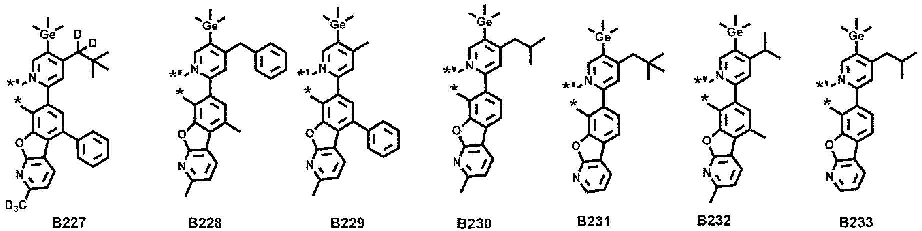

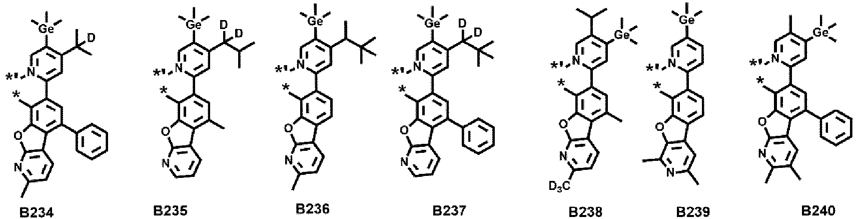

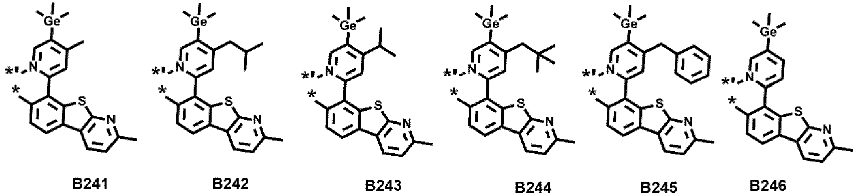

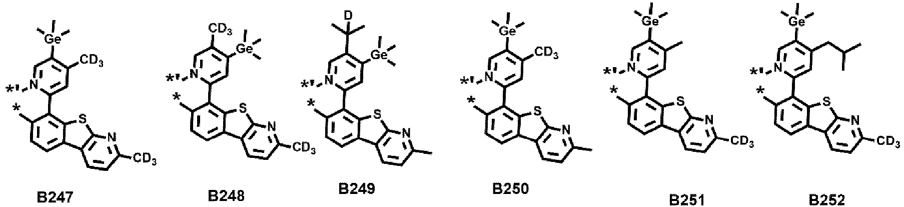

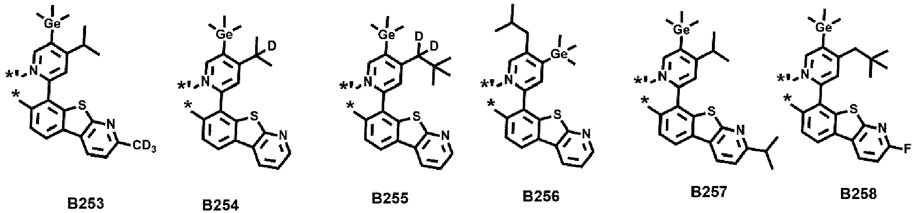

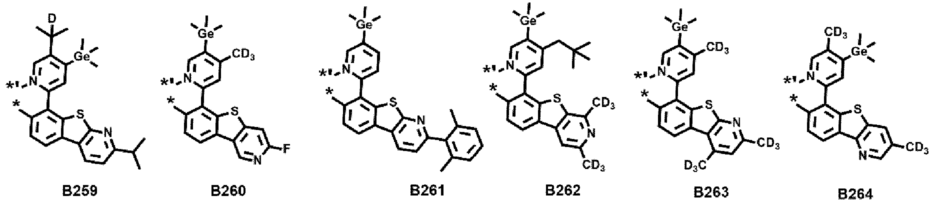

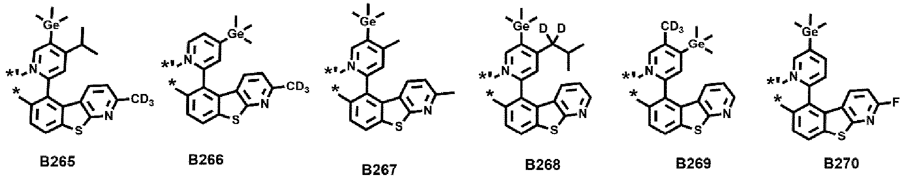

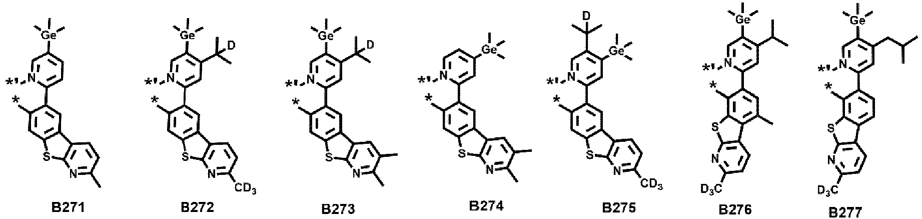

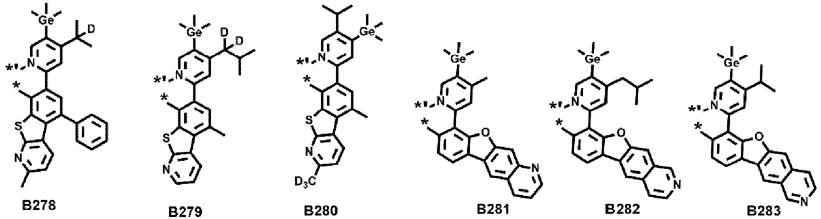

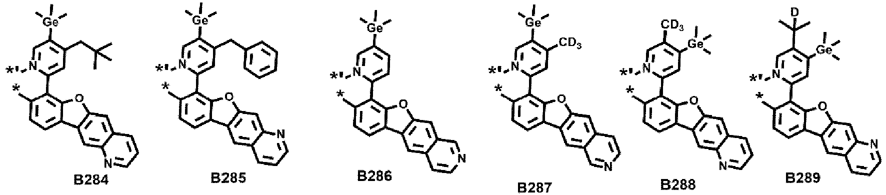

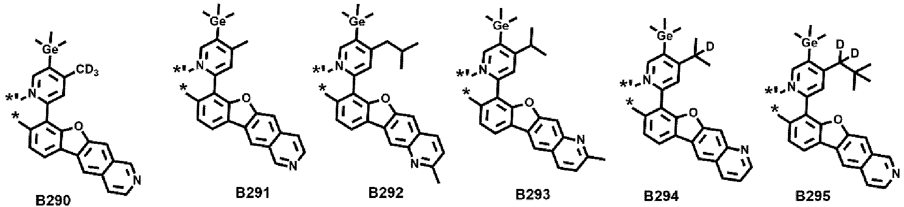

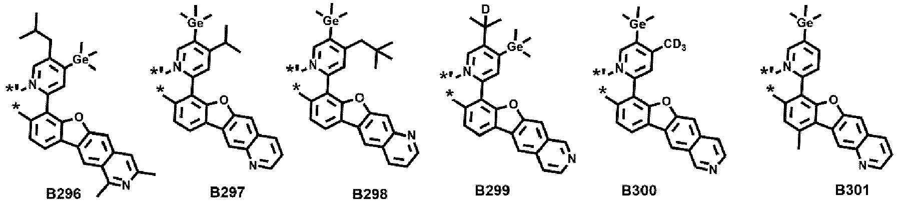

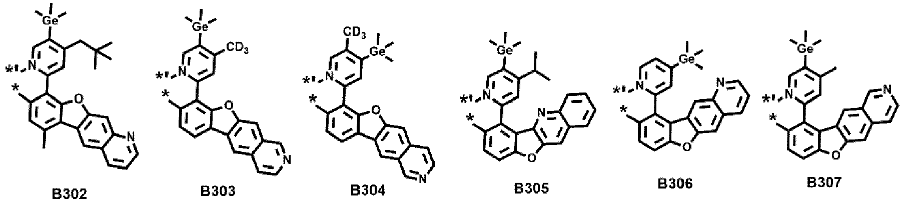

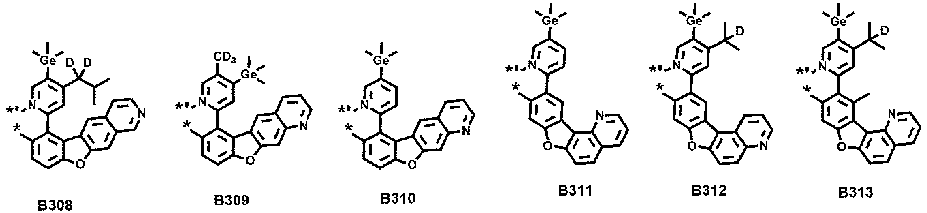

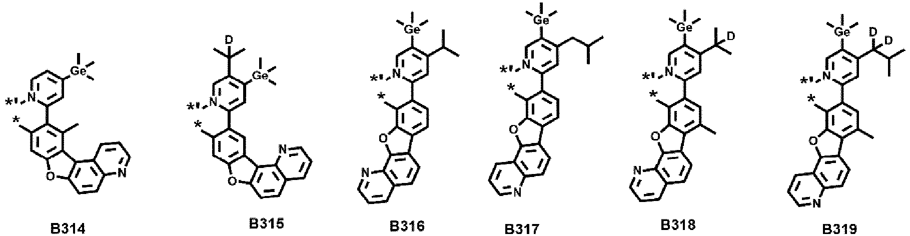

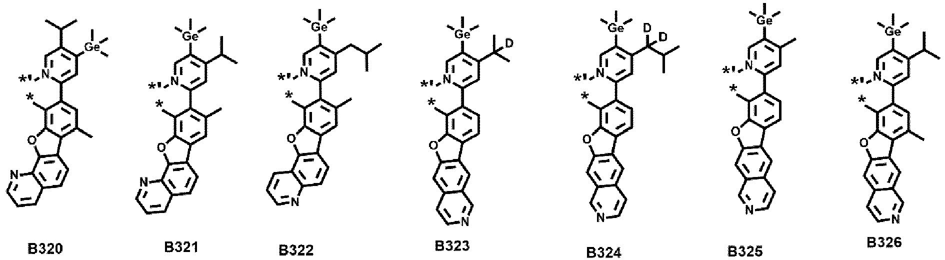

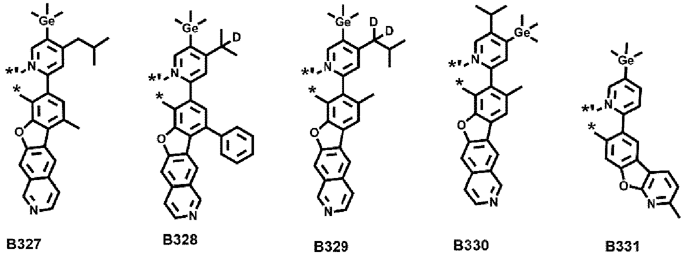

Each of * and *' in Formulae B1 to B331 indicates a binding site to M in Formula 1.

In one or more embodiments, L₂ in Formula 1 may be a ligand represented by one of Formula A1 to A250:

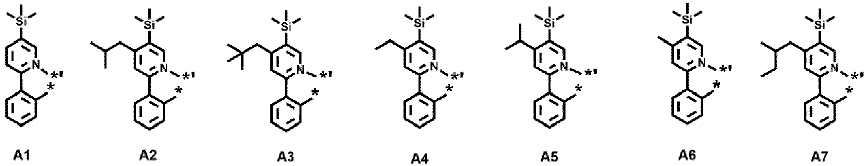

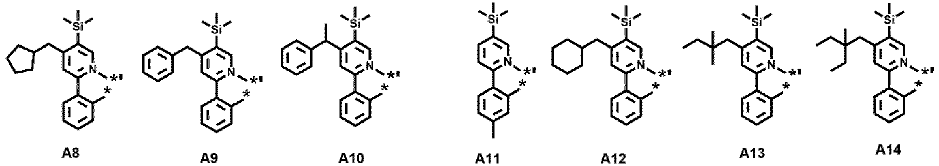

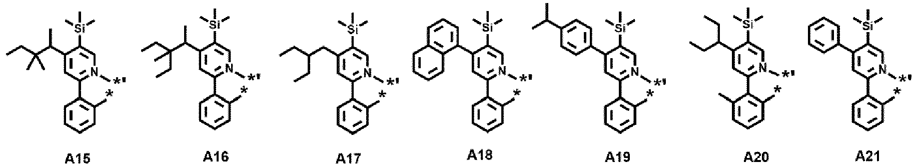

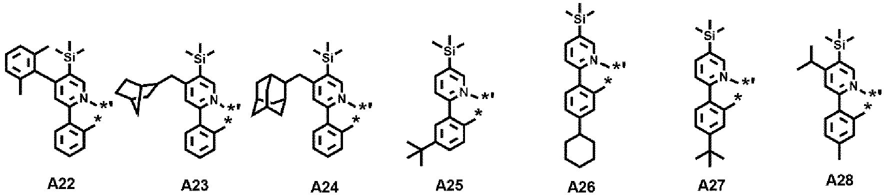

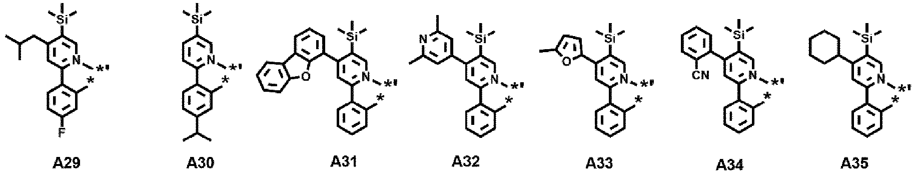

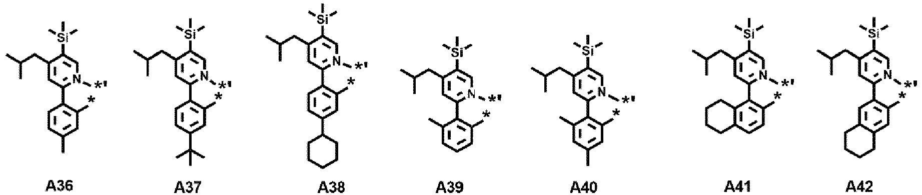

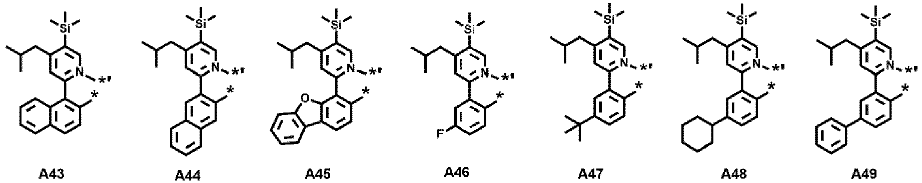

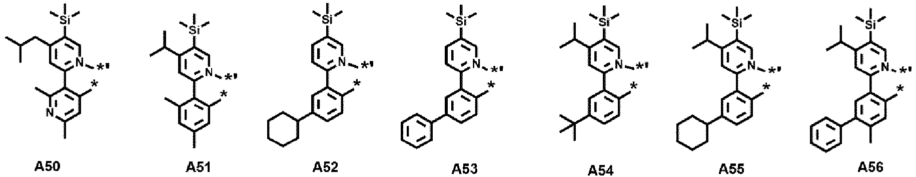

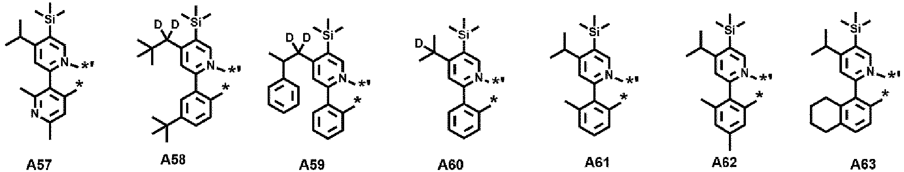

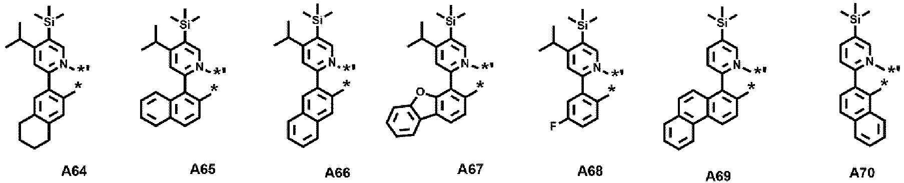

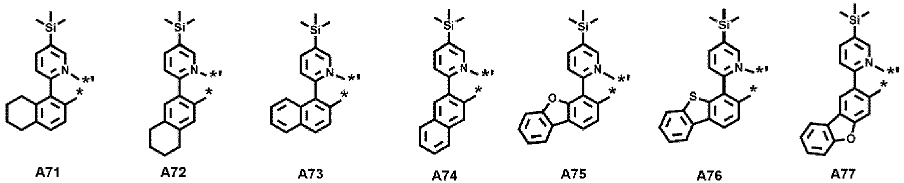

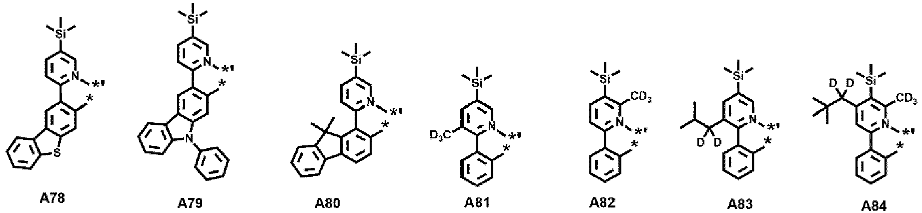

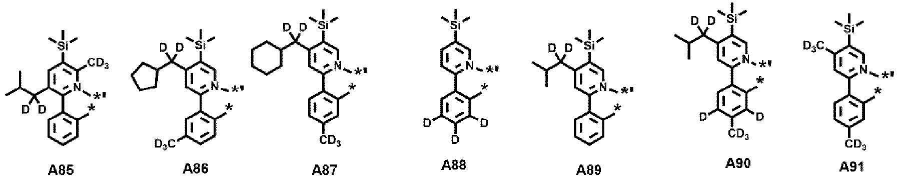

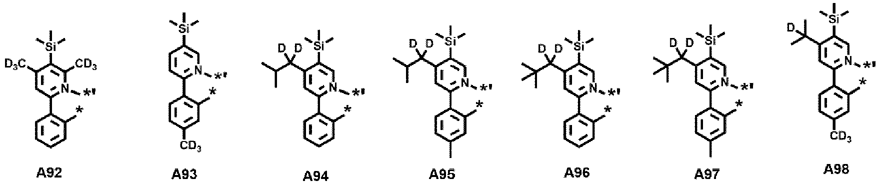

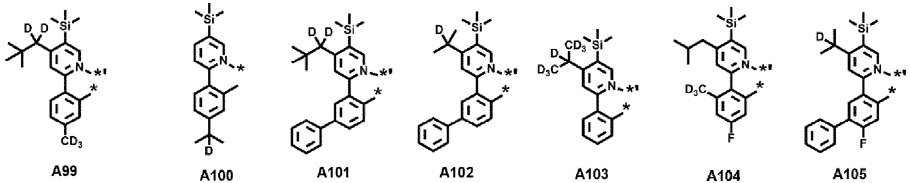

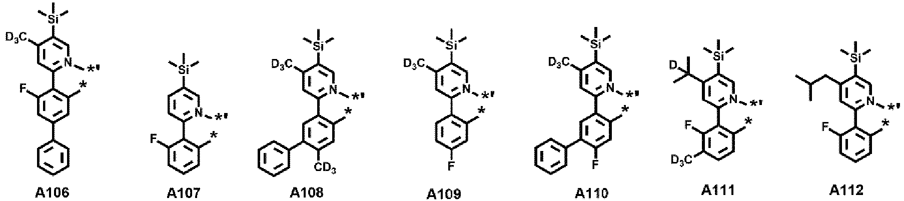

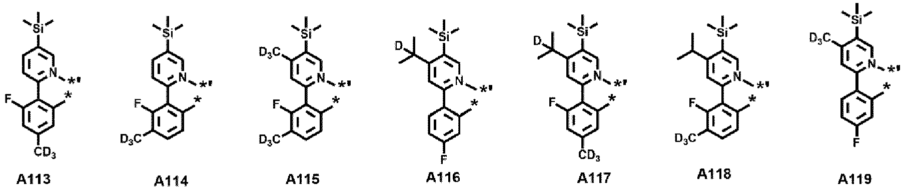

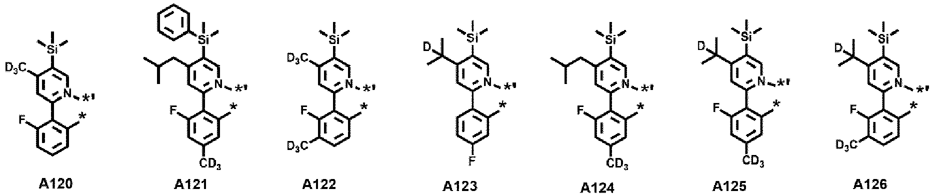

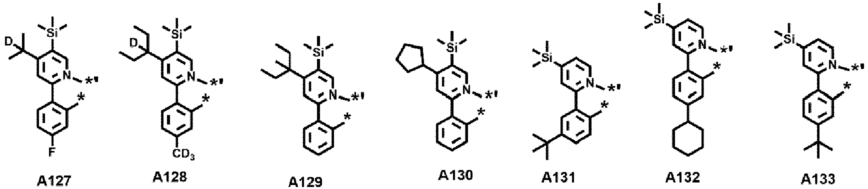

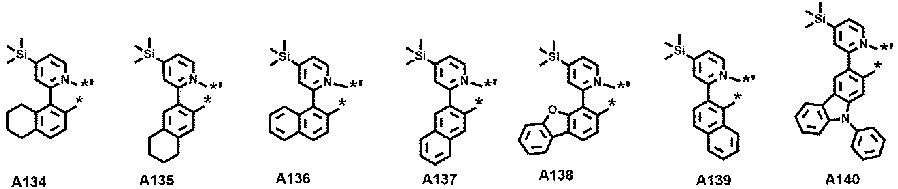

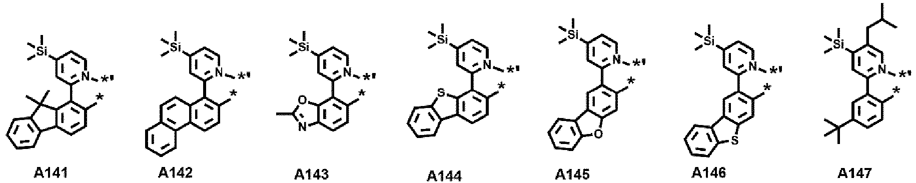

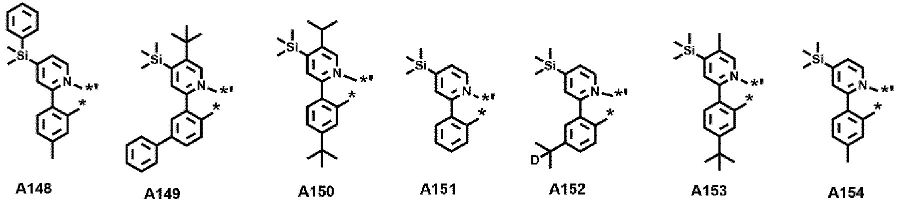

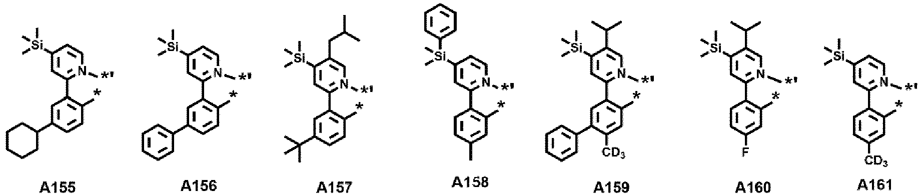

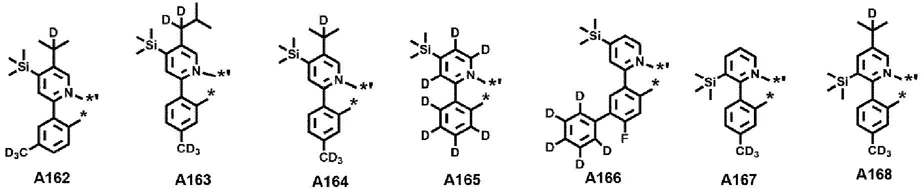

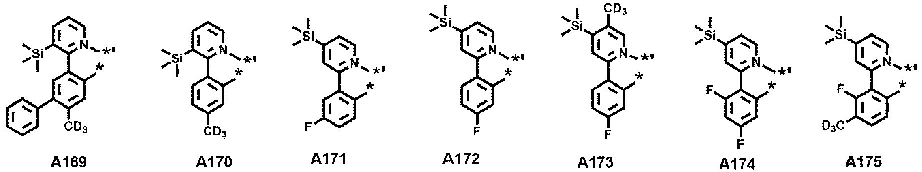

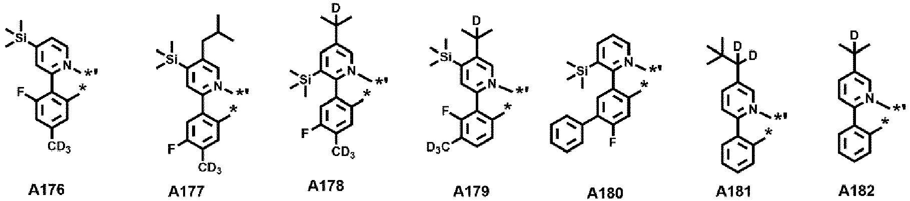

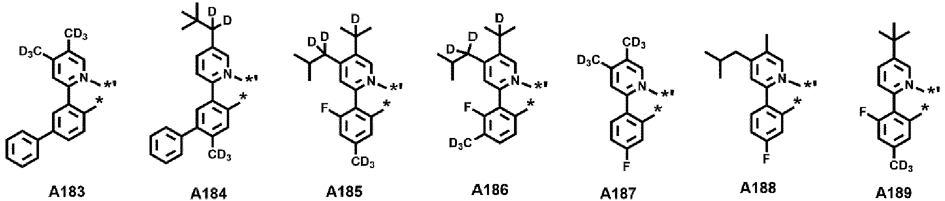

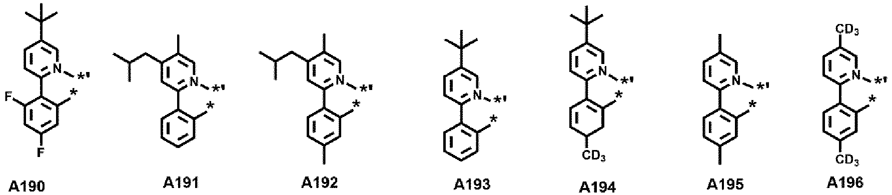

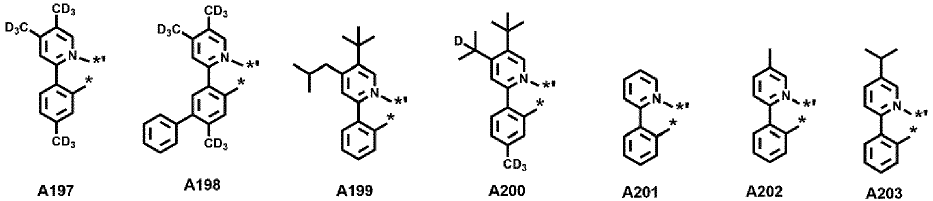

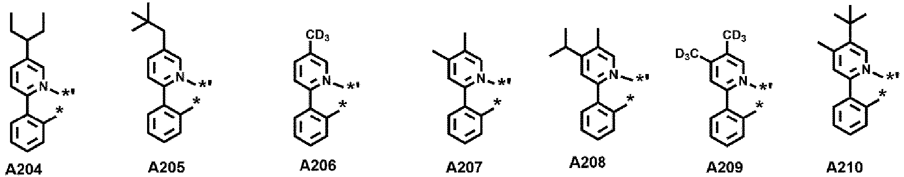

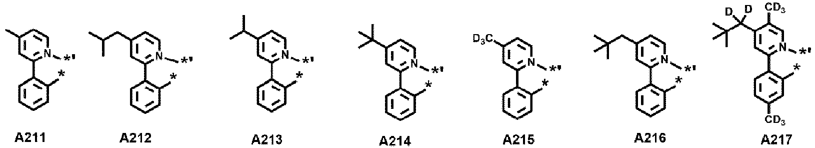

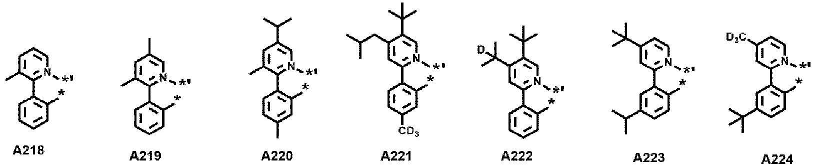

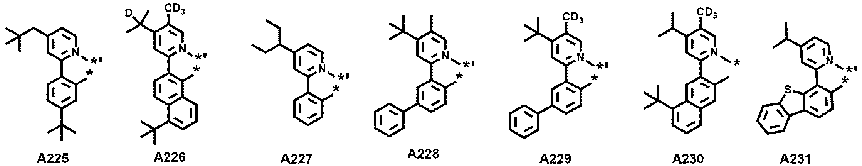

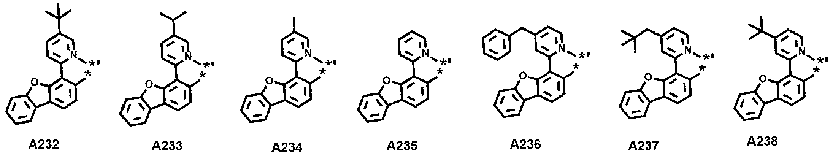

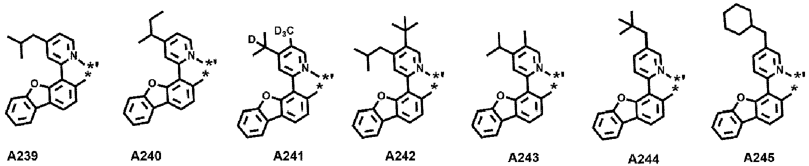

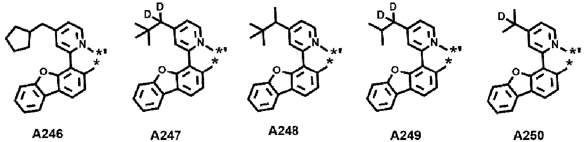

Each of * and *' in Formulae A1 to A250 indicates a binding site to M in Formula 1.

In one or more embodiments, the organometallic compound is represented by Formula 1, wherein M in Formula 1 may be iridium, and L₁, L₂, n1, and n2 may each be as defined for the compounds shown in Tables 1 to 56:

**Table 1**

| Compound No. | L₁ | L₂ | n1 | n2 | Compound No. | L₁ | L₂ | n1 | n2 |
|---|---|---|---|---|---|---|---|---|---|
| 2-1 | B2 | A1 | 1 | 2 | 2-208 | B2 | A208 | 1 | 2 |
| 2-2 | B2 | A2 | 1 | 2 | 2-209 | B2 | A209 | 1 | 2 |
| 2-3 | B2 | A3 | 1 | 2 | 2-212 | B2 | A212 | 1 | 2 |
| 2-5 | B2 | A5 | 1 | 2 | 2-213 | B2 | A213 | 1 | 2 |
| 2-8 | B2 | A8 | 1 | 2 | 2-214 | B2 | A214 | 1 | 2 |
| 2-35 | B2 | A35 | 1 | 2 | 2-215 | B2 | A215 | 1 | 2 |
| 2-36 | B2 | A36 | 1 | 2 | 2-216 | B2 | A216 | 1 | 2 |
| 2-45 | B2 | A45 | 1 | 2 | 2-217 | B2 | A217 | 1 | 2 |
| 2-47 | B2 | A47 | 1 | 2 | 2-221 | B2 | A221 | 1 | 2 |
| 2-49 | B2 | A49 | 1 | 2 | 2-222 | B2 | A222 | 1 | 2 |
| 2-60 | B2 | A60 | 1 | 2 | 2-224 | B2 | A224 | 1 | 2 |
| 2-86 | B2 | A86 | 1 | 2 | 2-225 | B2 | A225 | 1 | 2 |
| 2-94 | B2 | A94 | 1 | 2 | 2-226 | B2 | A226 | 1 | 2 |
| 2-99 | B2 | A99 | 1 | 2 | 2-228 | B2 | A228 | 1 | 2 |
| 2-101 | B2 | A101 | 1 | 2 | 2-229 | B2 | A229 | 1 | 2 |
| 2-139 | B2 | A139 | 1 | 2 | 2-231 | B2 | A231 | 1 | 2 |
| 2-161 | B2 | A161 | 1 | 2 | 2-232 | B2 | A232 | 1 | 2 |
| 2-162 | B2 | A162 | 1 | 2 | 2-233 | B2 | A233 | 1 | 2 |
| 2-181 | B2 | A181 | 1 | 2 | 2-235 | B2 | A235 | 1 | 2 |
| 2-182 | B2 | A182 | 1 | 2 | 2-236 | B2 | A236 | 1 | 2 |
| 2-191 | B2 | A191 | 1 | 2 | 2-237 | B2 | A237 | 1 | 2 |
| 2-192 | B2 | A192 | 1 | 2 | 2-238 | B2 | A238 | 1 | 2 |
| 2-193 | B2 | A193 | 1 | 2 | 2-239 | B2 | A239 | 1 | 2 |
| 2-194 | B2 | A194 | 1 | 2 | 2-241 | B2 | A241 | 1 | 2 |
| 2-196 | B2 | A196 | 1 | 2 | 2-242 | B2 | A242 | 1 | 2 |
| 2-197 | B2 | A197 | 1 | 2 | 2-243 | B2 | A243 | 1 | 2 |
| 2-199 | B2 | A199 | 1 | 2 | 2-246 | B2 | A246 | 1 | 2 |
| 2-200 | B2 | A200 | 1 | 2 | 2-247 | B2 | A247 | 1 | 2 |
| 2-201 | B2 | A201 | 1 | 2 | 2-248 | B2 | A248 | 1 | 2 |
| 2-203 | B2 | A203 | 1 | 2 | 2-249 | B2 | A249 | 1 | 2 |
| 2-206 | B2 | A206 | 1 | 2 | 2-250 | B2 | A250 | 1 | 2 |

**Table 2**

| Compound No. | L₁ | L₂ | n1 | n2 | Compound No. | L₁ | L₂ | n1 | n2 |
|---|---|---|---|---|---|---|---|---|---|
| 3-1 | B3 | A1 | 1 | 2 | 3-208 | B3 | A208 | 1 | 2 |
| 3-2 | B3 | A2 | 1 | 2 | 3-209 | B3 | A209 | 1 | 2 |
| 3-3 | B3 | A3 | 1 | 2 | 3-212 | B3 | A212 | 1 | 2 |
| 3-5 | B3 | A5 | 1 | 2 | 3-213 | B3 | A213 | 1 | 2 |
| 3-8 | B3 | A8 | 1 | 2 | 3-214 | B3 | A214 | 1 | 2 |
| 3-35 | B3 | A35 | 1 | 2 | 3-215 | B3 | A215 | 1 | 2 |
| 3-36 | B3 | A36 | 1 | 2 | 3-216 | B3 | A216 | 1 | 2 |
| 3-45 | B3 | A45 | 1 | 2 | 3-217 | B3 | A217 | 1 | 2 |
| 3-47 | B3 | A47 | 1 | 2 | 3-221 | B3 | A221 | 1 | 2 |
| 3-49 | B3 | A49 | 1 | 2 | 3-222 | B3 | A222 | 1 | 2 |
| 3-60 | B3 | A60 | 1 | 2 | 3-224 | B3 | A224 | 1 | 2 |
| 3-86 | B3 | A86 | 1 | 2 | 3-225 | B3 | A225 | 1 | 2 |
| 3-94 | B3 | A94 | 1 | 2 | 3-226 | B3 | A226 | 1 | 2 |
| 3-99 | B3 | A99 | 1 | 2 | 3-228 | B3 | A228 | 1 | 2 |
| 3-101 | B3 | A101 | 1 | 2 | 3-229 | B3 | A229 | 1 | 2 |
| 3-139 | B3 | A139 | 1 | 2 | 3-231 | B3 | A231 | 1 | 2 |
| 3-161 | B3 | A161 | 1 | 2 | 3-232 | B3 | A232 | 1 | 2 |
| 3-162 | B3 | A162 | 1 | 2 | 3-233 | B3 | A233 | 1 | 2 |
| 3-181 | B3 | A181 | 1 | 2 | 3-235 | B3 | A235 | 1 | 2 |
| 3-182 | B3 | A182 | 1 | 2 | 3-236 | B3 | A236 | 1 | 2 |
| 3-191 | B3 | A191 | 1 | 2 | 3-237 | B3 | A237 | 1 | 2 |
| 3-192 | B3 | A192 | 1 | 2 | 3-238 | B3 | A238 | 1 | 2 |
| 3-193 | B3 | A193 | 1 | 2 | 3-239 | B3 | A239 | 1 | 2 |
| 3-194 | B3 | A194 | 1 | 2 | 3-241 | B3 | A241 | 1 | 2 |
| 3-196 | B3 | A196 | 1 | 2 | 3-242 | B3 | A242 | 1 | 2 |
| 3-197 | B3 | A197 | 1 | 2 | 3-243 | B3 | A243 | 1 | 2 |
| 3-199 | B3 | A199 | 1 | 2 | 3-246 | B3 | A246 | 1 | 2 |
| 3-200 | B3 | A200 | 1 | 2 | 3-247 | B3 | A247 | 1 | 2 |
| 3-201 | B3 | A201 | 1 | 2 | 3-248 | B3 | A248 | 1 | 2 |
| 3-203 | B3 | A203 | 1 | 2 | 3-249 | B3 | A249 | 1 | 2 |
| 3-206 | B3 | A206 | 1 | 2 | 3-250 | B3 | A250 | 1 | 2 |

**Table 3**

| Compound No. | L₁ | L₂ | n1 | n2 | Compound No. | L₁ | L₂ | n1 | n2 |
|---|---|---|---|---|---|---|---|---|---|
| 4-1 | B4 | A1 | 1 | 2 | 4-208 | B4 | A208 | 1 | 2 |
| 4-2 | B4 | A2 | 1 | 2 | 4-209 | B4 | A209 | 1 | 2 |
| 4-3 | B4 | A3 | 1 | 2 | 4-212 | B4 | A212 | 1 | 2 |
| 4-5 | B4 | A5 | 1 | 2 | 4-213 | B4 | A213 | 1 | 2 |
| 4-8 | B4 | A8 | 1 | 2 | 4-214 | B4 | A214 | 1 | 2 |
| 4-35 | B4 | A35 | 1 | 2 | 4-215 | B4 | A215 | 1 | 2 |
| 4-36 | B4 | A36 | 1 | 2 | 4-216 | B4 | A216 | 1 | 2 |
| 4-45 | B4 | A45 | 1 | 2 | 4-217 | B4 | A217 | 1 | 2 |
| 4-47 | B4 | A47 | 1 | 2 | 4-221 | B4 | A221 | 1 | 2 |
| 4-49 | B4 | A49 | 1 | 2 | 4-222 | B4 | A222 | 1 | 2 |
| 4-60 | B4 | A60 | 1 | 2 | 4-224 | B4 | A224 | 1 | 2 |
| 4-86 | B4 | A86 | 1 | 2 | 4-225 | B4 | A225 | 1 | 2 |
| 4-94 | B4 | A94 | 1 | 2 | 4-226 | B4 | A226 | 1 | 2 |
| 4-99 | B4 | A99 | 1 | 2 | 4-228 | B4 | A228 | 1 | 2 |
| 4-101 | B4 | A101 | 1 | 2 | 4-229 | B4 | A229 | 1 | 2 |
| 4-139 | B4 | A139 | 1 | 2 | 4-231 | B4 | A231 | 1 | 2 |
| 4-161 | B4 | A161 | 1 | 2 | 4-232 | B4 | A232 | 1 | 2 |
| 4-162 | B4 | A162 | 1 | 2 | 4-233 | B4 | A233 | 1 | 2 |
| 4-181 | B4 | A181 | 1 | 2 | 4-235 | B4 | A235 | 1 | 2 |
| 4-182 | B4 | A182 | 1 | 2 | 4-236 | B4 | A236 | 1 | 2 |
| 4-191 | B4 | A191 | 1 | 2 | 4-237 | B4 | A237 | 1 | 2 |
| 4-192 | B4 | A192 | 1 | 2 | 4-238 | B4 | A238 | 1 | 2 |
| 4-193 | B4 | A193 | 1 | 2 | 4-239 | B4 | A239 | 1 | 2 |
| 4-194 | B4 | A194 | 1 | 2 | 4-241 | B4 | A241 | 1 | 2 |
| 4-196 | B4 | A196 | 1 | 2 | 4-242 | B4 | A242 | 1 | 2 |
| 4-197 | B4 | A197 | 1 | 2 | 4-243 | B4 | A243 | 1 | 2 |
| 4-199 | B4 | A199 | 1 | 2 | 4-246 | B4 | A246 | 1 | 2 |
| 4-200 | B4 | A200 | 1 | 2 | 4-247 | B4 | A247 | 1 | 2 |
| 4-201 | B4 | A201 | 1 | 2 | 4-248 | B4 | A248 | 1 | 2 |
| 4-203 | B4 | A203 | 1 | 2 | 4-249 | B4 | A249 | 1 | 2 |
| 4-206 | B4 | A206 | 1 | 2 | 4-250 | B4 | A250 | 1 | 2 |

**Table 4**

| Compound No. | L₁ | L₂ | n1 | n2 | Compound No. | L₁ | L₂ | n1 | n2 |
|---|---|---|---|---|---|---|---|---|---|
| 6-1 | B6 | A1 | 1 | 2 | 6-208 | B6 | A208 | 1 | 2 |
| 6-2 | B6 | A2 | 1 | 2 | 6-209 | B6 | A209 | 1 | 2 |
| 6-3 | B6 | A3 | 1 | 2 | 6-212 | B6 | A212 | 1 | 2 |
| 6-5 | B6 | A5 | 1 | 2 | 6-213 | B6 | A213 | 1 | 2 |
| 6-8 | B6 | A8 | 1 | 2 | 6-214 | B6 | A214 | 1 | 2 |
| 6-35 | B6 | A35 | 1 | 2 | 6-215 | B6 | A215 | 1 | 2 |
| 6-36 | B6 | A36 | 1 | 2 | 6-216 | B6 | A216 | 1 | 2 |
| 6-45 | B6 | A45 | 1 | 2 | 6-217 | B6 | A217 | 1 | 2 |
| 6-47 | B6 | A47 | 1 | 2 | 6-221 | B6 | A221 | 1 | 2 |
| 6-49 | B6 | A49 | 1 | 2 | 6-222 | B6 | A222 | 1 | 2 |
| 6-60 | B6 | A60 | 1 | 2 | 6-224 | B6 | A224 | 1 | 2 |
| 6-86 | B6 | A86 | 1 | 2 | 6-225 | B6 | A225 | 1 | 2 |
| 6-94 | B6 | A94 | 1 | 2 | 6-226 | B6 | A226 | 1 | 2 |
| 6-99 | B6 | A99 | 1 | 2 | 6-228 | B6 | A228 | 1 | 2 |
| 6-101 | B6 | A101 | 1 | 2 | 6-229 | B6 | A229 | 1 | 2 |
| 6-139 | B6 | A139 | 1 | 2 | 6-231 | B6 | A231 | 1 | 2 |
| 6-161 | B6 | A161 | 1 | 2 | 6-232 | B6 | A232 | 1 | 2 |
| 6-162 | B6 | A162 | 1 | 2 | 6-233 | B6 | A233 | 1 | 2 |
| 6-181 | B6 | A181 | 1 | 2 | 6-235 | B6 | A235 | 1 | 2 |
| 6-182 | B6 | A182 | 1 | 2 | 6-236 | B6 | A236 | 1 | 2 |
| 6-191 | B6 | A191 | 1 | 2 | 6-237 | B6 | A237 | 1 | 2 |
| 6-192 | B6 | A192 | 1 | 2 | 6-238 | B6 | A238 | 1 | 2 |
| 6-193 | B6 | A193 | 1 | 2 | 6-239 | B6 | A239 | 1 | 2 |
| 6-194 | B6 | A194 | 1 | 2 | 6-241 | B6 | A241 | 1 | 2 |
| 6-196 | B6 | A196 | 1 | 2 | 6-242 | B6 | A242 | 1 | 2 |
| 6-197 | B6 | A197 | 1 | 2 | 6-243 | B6 | A243 | 1 | 2 |
| 6-199 | B6 | A199 | 1 | 2 | 6-246 | B6 | A246 | 1 | 2 |
| 6-200 | B6 | A200 | 1 | 2 | 6-247 | B6 | A247 | 1 | 2 |
| 6-201 | B6 | A201 | 1 | 2 | 6-248 | B6 | A248 | 1 | 2 |
| 6-203 | B6 | A203 | 1 | 2 | 6-249 | B6 | A249 | 1 | 2 |
| 6-206 | B6 | A206 | 1 | 2 | 6-250 | B6 | A250 | 1 | 2 |

**Table 5**

| Compound No. | L₁ | L₂ | n1 | n2 | Compound No. | L₁ | L₂ | n1 | n2 |
|---|---|---|---|---|---|---|---|---|---|
| 10-1 | B10 | A1 | 1 | 2 | 10-208 | B10 | A208 | 1 | 2 |
| 10-2 | B10 | A2 | 1 | 2 | 10-209 | B10 | A209 | 1 | 2 |
| 10-3 | B10 | A3 | 1 | 2 | 10-212 | B10 | A212 | 1 | 2 |
| 10-5 | B10 | A5 | 1 | 2 | 10-213 | B10 | A213 | 1 | 2 |
| 10-8 | B10 | A8 | 1 | 2 | 10-214 | B10 | A214 | 1 | 2 |
| 10-35 | B10 | A35 | 1 | 2 | 10-215 | B10 | A215 | 1 | 2 |
| 10-36 | B10 | A36 | 1 | 2 | 10-216 | B10 | A216 | 1 | 2 |
| 10-45 | B10 | A45 | 1 | 2 | 10-217 | B10 | A217 | 1 | 2 |
| 10-47 | B10 | A47 | 1 | 2 | 10-221 | B10 | A221 | 1 | 2 |
| 10-49 | B10 | A49 | 1 | 2 | 10-222 | B10 | A222 | 1 | 2 |
| 10-60 | B10 | A60 | 1 | 2 | 10-224 | B10 | A224 | 1 | 2 |
| 10-86 | B10 | A86 | 1 | 2 | 10-225 | B10 | A225 | 1 | 2 |
| 10-94 | B10 | A94 | 1 | 2 | 10-226 | B10 | A226 | 1 | 2 |
| 10-99 | B10 | A99 | 1 | 2 | 10-228 | B10 | A228 | 1 | 2 |
| 10-101 | B10 | A101 | 1 | 2 | 10-229 | B10 | A229 | 1 | 2 |
| 10-139 | B10 | A139 | 1 | 2 | 10-231 | B10 | A231 | 1 | 2 |
| 10-161 | B10 | A161 | 1 | 2 | 10-232 | B10 | A232 | 1 | 2 |
| 10-162 | B10 | A162 | 1 | 2 | 10-233 | B10 | A233 | 1 | 2 |
| 10-181 | B10 | A181 | 1 | 2 | 10-235 | B10 | A235 | 1 | 2 |
| 10-182 | B10 | A182 | 1 | 2 | 10-236 | B10 | A236 | 1 | 2 |
| 10-191 | B10 | A191 | 1 | 2 | 10-237 | B10 | A237 | 1 | 2 |
| 10-192 | B10 | A192 | 1 | 2 | 10-238 | B10 | A238 | 1 | 2 |
| 10-193 | B10 | A193 | 1 | 2 | 10-239 | B10 | A239 | 1 | 2 |
| 10-194 | B10 | A194 | 1 | 2 | 10-241 | B10 | A241 | 1 | 2 |
| 10-196 | B10 | A196 | 1 | 2 | 10-242 | B10 | A242 | 1 | 2 |
| 10-197 | B10 | A197 | 1 | 2 | 10-243 | B10 | A243 | 1 | 2 |
| 10-199 | B10 | A199 | 1 | 2 | 10-246 | B10 | A246 | 1 | 2 |
| 10-200 | B10 | A200 | 1 | 2 | 10-247 | B10 | A247 | 1 | 2 |
| 10-201 | B10 | A201 | 1 | 2 | 10-248 | B10 | A248 | 1 | 2 |
| 10-203 | B10 | A203 | 1 | 2 | 10-249 | B10 | A249 | 1 | 2 |
| 10-206 | B10 | A206 | 1 | 2 | 10-250 | B10 | A250 | 1 | 2 |

**Table 6**

| Compound No. | L₁ | L₂ | n1 | n2 | Compound No. | L₁ | L₂ | n1 | n2 |
|---|---|---|---|---|---|---|---|---|---|
| 12-1 | B12 | A1 | 1 | 2 | 12-208 | B12 | A208 | 1 | 2 |
| 12-2 | B12 | A2 | 1 | 2 | 12-209 | B12 | A209 | 1 | 2 |
| 12-3 | B12 | A3 | 1 | 2 | 12-212 | B12 | A212 | 1 | 2 |
| 12-5 | B12 | A5 | 1 | 2 | 12-213 | B12 | A213 | 1 | 2 |
| 12-8 | B12 | A8 | 1 | 2 | 12-214 | B12 | A214 | 1 | 2 |
| 12-35 | B12 | A35 | 1 | 2 | 12-215 | B12 | A215 | 1 | 2 |
| 12-36 | B12 | A36 | 1 | 2 | 12-216 | B12 | A216 | 1 | 2 |
| 12-45 | B12 | A45 | 1 | 2 | 12-217 | B12 | A217 | 1 | 2 |
| 12-47 | B12 | A47 | 1 | 2 | 12-221 | B12 | A221 | 1 | 2 |
| 12-49 | B12 | A49 | 1 | 2 | 12-222 | B12 | A222 | 1 | 2 |
| 12-60 | B12 | A60 | 1 | 2 | 12-224 | B12 | A224 | 1 | 2 |
| 12-86 | B12 | A86 | 1 | 2 | 12-225 | B12 | A225 | 1 | 2 |
| 12-94 | B12 | A94 | 1 | 2 | 12-226 | B12 | A226 | 1 | 2 |
| 12-99 | B12 | A99 | 1 | 2 | 12-228 | B12 | A228 | 1 | 2 |
| 12-101 | B12 | A101 | 1 | 2 | 12-229 | B12 | A229 | 1 | 2 |
| 12-139 | B12 | A139 | 1 | 2 | 12-231 | B12 | A231 | 1 | 2 |
| 12-161 | B12 | A161 | 1 | 2 | 12-232 | B12 | A232 | 1 | 2 |
| 12-162 | B12 | A162 | 1 | 2 | 12-233 | B12 | A233 | 1 | 2 |
| 12-181 | B12 | A181 | 1 | 2 | 12-235 | B12 | A235 | 1 | 2 |
| 12-182 | B12 | A182 | 1 | 2 | 12-236 | B12 | A236 | 1 | 2 |
| 12-191 | B12 | A191 | 1 | 2 | 12-237 | B12 | A237 | 1 | 2 |
| 12-192 | B12 | A192 | 1 | 2 | 12-238 | B12 | A238 | 1 | 2 |
| 12-193 | B12 | A193 | 1 | 2 | 12-239 | B12 | A239 | 1 | 2 |
| 12-194 | B12 | A194 | 1 | 2 | 12-241 | B12 | A241 | 1 | 2 |
| 12-196 | B12 | A196 | 1 | 2 | 12-242 | B12 | A242 | 1 | 2 |
| 12-197 | B12 | A197 | 1 | 2 | 12-243 | B12 | A243 | 1 | 2 |
| 12-199 | B12 | A199 | 1 | 2 | 12-246 | B12 | A246 | 1 | 2 |
| 12-200 | B12 | A200 | 1 | 2 | 12-247 | B12 | A247 | 1 | 2 |
| 12-201 | B12 | A201 | 1 | 2 | 12-248 | B12 | A248 | 1 | 2 |
| 12-203 | B12 | A203 | 1 | 2 | 12-249 | B12 | A249 | 1 | 2 |
| 12-206 | B12 | A206 | 1 | 2 | 12-250 | B12 | A250 | 1 | 2 |

**Table 7**

| Compound No. | L₁ | L₂ | n1 | n2 | Compound No. | L₁ | L₂ | n1 | n2 |
|---|---|---|---|---|---|---|---|---|---|
| 15-1 | B15 | A1 | 1 | 2 | 15-208 | B15 | A208 | 1 | 2 |
| 15-2 | B15 | A2 | 1 | 2 | 15-209 | B15 | A209 | 1 | 2 |
| 15-3 | B15 | A3 | 1 | 2 | 15-212 | B15 | A212 | 1 | 2 |
| 15-5 | B15 | A5 | 1 | 2 | 15-213 | B15 | A213 | 1 | 2 |
| 15-8 | B15 | A8 | 1 | 2 | 15-214 | B15 | A214 | 1 | 2 |
| 15-35 | B15 | A35 | 1 | 2 | 15-215 | B15 | A215 | 1 | 2 |
| 15-36 | B15 | A36 | 1 | 2 | 15-216 | B15 | A216 | 1 | 2 |
| 15-45 | B15 | A45 | 1 | 2 | 15-217 | B15 | A217 | 1 | 2 |
| 15-47 | B15 | A47 | 1 | 2 | 15-221 | B15 | A221 | 1 | 2 |
| 15-49 | B15 | A49 | 1 | 2 | 15-222 | B15 | A222 | 1 | 2 |
| 15-60 | B15 | A60 | 1 | 2 | 15-224 | B15 | A224 | 1 | 2 |
| 15-86 | B15 | A86 | 1 | 2 | 15-225 | B15 | A225 | 1 | 2 |
| 15-94 | B15 | A94 | 1 | 2 | 15-226 | B15 | A226 | 1 | 2 |
| 15-99 | B15 | A99 | 1 | 2 | 15-228 | B15 | A228 | 1 | 2 |
| 15-101 | B15 | A101 | 1 | 2 | 15-229 | B15 | A229 | 1 | 2 |
| 15-139 | B15 | A139 | 1 | 2 | 15-231 | B15 | A231 | 1 | 2 |
| 15-161 | B15 | A161 | 1 | 2 | 15-232 | B15 | A232 | 1 | 2 |
| 15-162 | B15 | A162 | 1 | 2 | 15-233 | B15 | A233 | 1 | 2 |
| 15-181 | B15 | A181 | 1 | 2 | 15-235 | B15 | A235 | 1 | 2 |
| 15-182 | B15 | A182 | 1 | 2 | 15-236 | B15 | A236 | 1 | 2 |
| 15-191 | B15 | A191 | 1 | 2 | 15-237 | B15 | A237 | 1 | 2 |
| 15-192 | B15 | A192 | 1 | 2 | 15-238 | B15 | A238 | 1 | 2 |
| 15-193 | B15 | A193 | 1 | 2 | 15-239 | B15 | A239 | 1 | 2 |
| 15-194 | B15 | A194 | 1 | 2 | 15-241 | B15 | A241 | 1 | 2 |
| 15-196 | B15 | A196 | 1 | 2 | 15-242 | B15 | A242 | 1 | 2 |
| 15-197 | B15 | A197 | 1 | 2 | 15-243 | B15 | A243 | 1 | 2 |
| 15-199 | B15 | A199 | 1 | 2 | 15-246 | B15 | A246 | 1 | 2 |
| 15-200 | B15 | A200 | 1 | 2 | 15-247 | B15 | A247 | 1 | 2 |
| 15-201 | B15 | A201 | 1 | 2 | 15-248 | B15 | A248 | 1 | 2 |
| 15-203 | B15 | A203 | 1 | 2 | 15-249 | B15 | A249 | 1 | 2 |
| 15-206 | B15 | A206 | 1 | 2 | 15-250 | B15 | A250 | 1 | 2 |

**Table 8**

| Compound No. | L₁ | L₂ | n1 | n2 | Compound No. | L₁ | L₂ | n1 | n2 |
|---|---|---|---|---|---|---|---|---|---|
| 22-1 | B22 | A1 | 1 | 2 | 22-208 | B22 | A208 | 1 | 2 |
| 22-2 | B22 | A2 | 1 | 2 | 22-209 | B22 | A209 | 1 | 2 |
| 22-3 | B22 | A3 | 1 | 2 | 22-212 | B22 | A212 | 1 | 2 |
| 22-5 | B22 | A5 | 1 | 2 | 22-213 | B22 | A213 | 1 | 2 |
| 22-8 | B22 | A8 | 1 | 2 | 22-214 | B22 | A214 | 1 | 2 |
| 22-35 | B22 | A35 | 1 | 2 | 22-215 | B22 | A215 | 1 | 2 |
| 22-36 | B22 | A36 | 1 | 2 | 22-216 | B22 | A216 | 1 | 2 |
| 22-45 | B22 | A45 | 1 | 2 | 22-217 | B22 | A217 | 1 | 2 |
| 22-47 | B22 | A47 | 1 | 2 | 22-221 | B22 | A221 | 1 | 2 |
| 22-49 | B22 | A49 | 1 | 2 | 22-222 | B22 | A222 | 1 | 2 |
| 22-60 | B22 | A60 | 1 | 2 | 22-224 | B22 | A224 | 1 | 2 |
| 22-86 | B22 | A86 | 1 | 2 | 22-225 | B22 | A225 | 1 | 2 |
| 22-94 | B22 | A94 | 1 | 2 | 22-226 | B22 | A226 | 1 | 2 |
| 22-99 | B22 | A99 | 1 | 2 | 22-228 | B22 | A228 | 1 | 2 |
| 22-101 | B22 | A101 | 1 | 2 | 22-229 | B22 | A229 | 1 | 2 |
| 22-139 | B22 | A139 | 1 | 2 | 22-231 | B22 | A231 | 1 | 2 |
| 22-161 | B22 | A161 | 1 | 2 | 22-232 | B22 | A232 | 1 | 2 |
| 22-162 | B22 | A162 | 1 | 2 | 22-233 | B22 | A233 | 1 | 2 |
| 22-181 | B22 | A181 | 1 | 2 | 22-235 | B22 | A235 | 1 | 2 |
| 22-182 | B22 | A182 | 1 | 2 | 22-236 | B22 | A236 | 1 | 2 |
| 22-191 | B22 | A191 | 1 | 2 | 22-237 | B22 | A237 | 1 | 2 |
| 22-192 | B22 | A192 | 1 | 2 | 22-238 | B22 | A238 | 1 | 2 |
| 22-193 | B22 | A193 | 1 | 2 | 22-239 | B22 | A239 | 1 | 2 |
| 22-194 | B22 | A194 | 1 | 2 | 22-241 | B22 | A241 | 1 | 2 |
| 22-196 | B22 | A196 | 1 | 2 | 22-242 | B22 | A242 | 1 | 2 |
| 22-197 | B22 | A197 | 1 | 2 | 22-243 | B22 | A243 | 1 | 2 |
| 22-199 | B22 | A199 | 1 | 2 | 22-246 | B22 | A246 | 1 | 2 |
| 22-200 | B22 | A200 | 1 | 2 | 22-247 | B22 | A247 | 1 | 2 |
| 22-201 | B22 | A201 | 1 | 2 | 22-248 | B22 | A248 | 1 | 2 |
| 22-203 | B22 | A203 | 1 | 2 | 22-249 | B22 | A249 | 1 | 2 |
| 22-206 | B22 | A206 | 1 | 2 | 22-250 | B22 | A250 | 1 | 2 |

**Table 9**

| Compound No. | L₁ | L₂ | n1 | n2 | Compound No. | L₁ | L₂ | n1 | n2 |
|---|---|---|---|---|---|---|---|---|---|
| 24-1 | B24 | A1 | 1 | 2 | 24-208 | B24 | A208 | 1 | 2 |
| 24-2 | B24 | A2 | 1 | 2 | 24-209 | B24 | A209 | 1 | 2 |
| 24-3 | B24 | A3 | 1 | 2 | 24-212 | B24 | A212 | 1 | 2 |
| 24-5 | B24 | A5 | 1 | 2 | 24-213 | B24 | A213 | 1 | 2 |
| 24-8 | B24 | A8 | 1 | 2 | 24-214 | B24 | A214 | 1 | 2 |
| 24-35 | B24 | A35 | 1 | 2 | 24-215 | B24 | A215 | 1 | 2 |
| 24-36 | B24 | A36 | 1 | 2 | 24-216 | B24 | A216 | 1 | 2 |
| 24-45 | B24 | A45 | 1 | 2 | 24-217 | B24 | A217 | 1 | 2 |
| 24-47 | B24 | A47 | 1 | 2 | 24-221 | B24 | A221 | 1 | 2 |
| 24-49 | B24 | A49 | 1 | 2 | 24-222 | B24 | A222 | 1 | 2 |
| 24-60 | B24 | A60 | 1 | 2 | 24-224 | B24 | A224 | 1 | 2 |
| 24-86 | B24 | A86 | 1 | 2 | 24-225 | B24 | A225 | 1 | 2 |
| 24-94 | B24 | A94 | 1 | 2 | 24-226 | B24 | A226 | 1 | 2 |
| 24-99 | B24 | A99 | 1 | 2 | 24-228 | B24 | A228 | 1 | 2 |
| 24-101 | B24 | A101 | 1 | 2 | 24-229 | B24 | A229 | 1 | 2 |
| 24-139 | B24 | A139 | 1 | 2 | 24-231 | B24 | A231 | 1 | 2 |
| 24-161 | B24 | A161 | 1 | 2 | 24-232 | B24 | A232 | 1 | 2 |
| 24-162 | B24 | A162 | 1 | 2 | 24-233 | B24 | A233 | 1 | 2 |
| 24-181 | B24 | A181 | 1 | 2 | 24-235 | B24 | A235 | 1 | 2 |
| 24-182 | B24 | A182 | 1 | 2 | 24-236 | B24 | A236 | 1 | 2 |
| 24-191 | B24 | A191 | 1 | 2 | 24-237 | B24 | A237 | 1 | 2 |
| 24-192 | B24 | A192 | 1 | 2 | 24-238 | B24 | A238 | 1 | 2 |
| 24-193 | B24 | A193 | 1 | 2 | 24-239 | B24 | A239 | 1 | 2 |
| 24-194 | B24 | A194 | 1 | 2 | 24-241 | B24 | A241 | 1 | 2 |
| 24-196 | B24 | A196 | 1 | 2 | 24-242 | B24 | A242 | 1 | 2 |
| 24-197 | B24 | A197 | 1 | 2 | 24-243 | B24 | A243 | 1 | 2 |
| 24-199 | B24 | A199 | 1 | 2 | 24-246 | B24 | A246 | 1 | 2 |
| 24-200 | B24 | A200 | 1 | 2 | 24-247 | B24 | A247 | 1 | 2 |
| 24-201 | B24 | A201 | 1 | 2 | 24-248 | B24 | A248 | 1 | 2 |
| 24-203 | B24 | A203 | 1 | 2 | 24-249 | B24 | A249 | 1 | 2 |
| 24-206 | B24 | A206 | 1 | 2 | 24-250 | B24 | A250 | 1 | 2 |

**Table 10**

| Compound No. | L₁ | L₂ | n1 | n2 | Compound No. | L₁ | L₂ | n1 | n2 |
|---|---|---|---|---|---|---|---|---|---|
| 26-1 | B26 | A1 | 1 | 2 | 26-208 | B26 | A208 | 1 | 2 |
| 26-2 | B26 | A2 | 1 | 2 | 26-209 | B26 | A209 | 1 | 2 |
| 26-3 | B26 | A3 | 1 | 2 | 26-212 | B26 | A212 | 1 | 2 |
| 26-5 | B26 | A5 | 1 | 2 | 26-213 | B26 | A213 | 1 | 2 |
| 26-8 | B26 | A8 | 1 | 2 | 26-214 | B26 | A214 | 1 | 2 |
| 26-35 | B26 | A35 | 1 | 2 | 26-215 | B26 | A215 | 1 | 2 |
| 26-36 | B26 | A36 | 1 | 2 | 26-216 | B26 | A216 | 1 | 2 |
| 26-45 | B26 | A45 | 1 | 2 | 26-217 | B26 | A217 | 1 | 2 |
| 26-47 | B26 | A47 | 1 | 2 | 26-221 | B26 | A221 | 1 | 2 |
| 26-49 | B26 | A49 | 1 | 2 | 26-222 | B26 | A222 | 1 | 2 |
| 26-60 | B26 | A60 | 1 | 2 | 26-224 | B26 | A224 | 1 | 2 |
| 26-86 | B26 | A86 | 1 | 2 | 26-225 | B26 | A225 | 1 | 2 |
| 26-94 | B26 | A94 | 1 | 2 | 26-226 | B26 | A226 | 1 | 2 |
| 26-99 | B26 | A99 | 1 | 2 | 26-228 | B26 | A228 | 1 | 2 |
| 26-101 | B26 | A101 | 1 | 2 | 26-229 | B26 | A229 | 1 | 2 |
| 26-139 | B26 | A139 | 1 | 2 | 26-231 | B26 | A231 | 1 | 2 |
| 26-161 | B26 | A161 | 1 | 2 | 26-232 | B26 | A232 | 1 | 2 |
| 26-162 | B26 | A162 | 1 | 2 | 26-233 | B26 | A233 | 1 | 2 |
| 26-181 | B26 | A181 | 1 | 2 | 26-235 | B26 | A235 | 1 | 2 |
| 26-182 | B26 | A182 | 1 | 2 | 26-236 | B26 | A236 | 1 | 2 |
| 26-191 | B26 | A191 | 1 | 2 | 26-237 | B26 | A237 | 1 | 2 |
| 26-192 | B26 | A192 | 1 | 2 | 26-238 | B26 | A238 | 1 | 2 |
| 26-193 | B26 | A193 | 1 | 2 | 26-239 | B26 | A239 | 1 | 2 |
| 26-194 | B26 | A194 | 1 | 2 | 26-241 | B26 | A241 | 1 | 2 |
| 26-196 | B26 | A196 | 1 | 2 | 26-242 | B26 | A242 | 1 | 2 |
| 26-197 | B26 | A197 | 1 | 2 | 26-243 | B26 | A243 | 1 | 2 |
| 26-199 | B26 | A199 | 1 | 2 | 26-246 | B26 | A246 | 1 | 2 |
| 26-200 | B26 | A200 | 1 | 2 | 26-247 | B26 | A247 | 1 | 2 |
| 26-201 | B26 | A201 | 1 | 2 | 26-248 | B26 | A248 | 1 | 2 |
| 26-203 | B26 | A203 | 1 | 2 | 26-249 | B26 | A249 | 1 | 2 |
| 26-206 | B26 | A206 | 1 | 2 | 26-250 | B26 | A250 | 1 | 2 |

**Table 11**

| Compound No. | L₁ | L₂ | n1 | n2 | Compound No. | L₁ | L₂ | n1 | n2 |
|---|---|---|---|---|---|---|---|---|---|
| 29-1 | B29 | A1 | 1 | 2 | 29-208 | B29 | A208 | 1 | 2 |
| 29-2 | B29 | A2 | 1 | 2 | 29-209 | B29 | A209 | 1 | 2 |
| 29-3 | B29 | A3 | 1 | 2 | 29-212 | B29 | A212 | 1 | 2 |
| 29-5 | B29 | A5 | 1 | 2 | 29-213 | B29 | A213 | 1 | 2 |
| 29-8 | B29 | A8 | 1 | 2 | 29-214 | B29 | A214 | 1 | 2 |
| 29-35 | B29 | A35 | 1 | 2 | 29-215 | B29 | A215 | 1 | 2 |
| 29-36 | B29 | A36 | 1 | 2 | 29-216 | B29 | A216 | 1 | 2 |
| 29-45 | B29 | A45 | 1 | 2 | 29-217 | B29 | A217 | 1 | 2 |
| 29-47 | B29 | A47 | 1 | 2 | 29-221 | B29 | A221 | 1 | 2 |
| 29-49 | B29 | A49 | 1 | 2 | 29-222 | B29 | A222 | 1 | 2 |
| 29-60 | B29 | A60 | 1 | 2 | 29-224 | B29 | A224 | 1 | 2 |
| 29-86 | B29 | A86 | 1 | 2 | 29-225 | B29 | A225 | 1 | 2 |
| 29-94 | B29 | A94 | 1 | 2 | 29-226 | B29 | A226 | 1 | 2 |
| 29-99 | B29 | A99 | 1 | 2 | 29-228 | B29 | A228 | 1 | 2 |
| 29-101 | B29 | A101 | 1 | 2 | 29-229 | B29 | A229 | 1 | 2 |
| 29-139 | B29 | A139 | 1 | 2 | 29-231 | B29 | A231 | 1 | 2 |
| 29-161 | B29 | A161 | 1 | 2 | 29-232 | B29 | A232 | 1 | 2 |
| 29-162 | B29 | A162 | 1 | 2 | 29-233 | B29 | A233 | 1 | 2 |
| 29-181 | B29 | A181 | 1 | 2 | 29-235 | B29 | A235 | 1 | 2 |
| 29-182 | B29 | A182 | 1 | 2 | 29-236 | B29 | A236 | 1 | 2 |
| 29-191 | B29 | A191 | 1 | 2 | 29-237 | B29 | A237 | 1 | 2 |
| 29-192 | B29 | A192 | 1 | 2 | 29-238 | B29 | A238 | 1 | 2 |
| 29-193 | B29 | A193 | 1 | 2 | 29-239 | B29 | A239 | 1 | 2 |
| 29-194 | B29 | A194 | 1 | 2 | 29-241 | B29 | A241 | 1 | 2 |
| 29-196 | B29 | A196 | 1 | 2 | 29-242 | B29 | A242 | 1 | 2 |
| 29-197 | B29 | A197 | 1 | 2 | 29-243 | B29 | A243 | 1 | 2 |
| 29-199 | B29 | A199 | 1 | 2 | 29-246 | B29 | A246 | 1 | 2 |
| 29-200 | B29 | A200 | 1 | 2 | 29-247 | B29 | A247 | 1 | 2 |
| 29-201 | B29 | A201 | 1 | 2 | 29-248 | B29 | A248 | 1 | 2 |
| 29-203 | B29 | A203 | 1 | 2 | 29-249 | B29 | A249 | 1 | 2 |
| 29-206 | B29 | A206 | 1 | 2 | 29-250 | B29 | A250 | 1 | 2 |

**Table 12**

| Compound No. | L₁ | L₂ | n1 | n2 | Compound No. | L₁ | L₂ | n1 | n2 |
|---|---|---|---|---|---|---|---|---|---|
| 32-1 | B32 | A1 | 1 | 2 | 32-208 | B32 | A208 | 1 | 2 |
| 32-2 | B32 | A2 | 1 | 2 | 32-209 | B32 | A209 | 1 | 2 |
| 32-3 | B32 | A3 | 1 | 2 | 32-212 | B32 | A212 | 1 | 2 |
| 32-5 | B32 | A5 | 1 | 2 | 32-213 | B32 | A213 | 1 | 2 |
| 32-8 | B32 | A8 | 1 | 2 | 32-214 | B32 | A214 | 1 | 2 |
| 32-35 | B32 | A35 | 1 | 2 | 32-215 | B32 | A215 | 1 | 2 |
| 32-36 | B32 | A36 | 1 | 2 | 32-216 | B32 | A216 | 1 | 2 |
| 32-45 | B32 | A45 | 1 | 2 | 32-217 | B32 | A217 | 1 | 2 |
| 32-47 | B32 | A47 | 1 | 2 | 32-221 | B32 | A221 | 1 | 2 |
| 32-49 | B32 | A49 | 1 | 2 | 32-222 | B32 | A222 | 1 | 2 |
| 32-60 | B32 | A60 | 1 | 2 | 32-224 | B32 | A224 | 1 | 2 |
| 32-86 | B32 | A86 | 1 | 2 | 32-225 | B32 | A225 | 1 | 2 |
| 32-94 | B32 | A94 | 1 | 2 | 32-226 | B32 | A226 | 1 | 2 |
| 32-99 | B32 | A99 | 1 | 2 | 32-228 | B32 | A228 | 1 | 2 |
| 32-101 | B32 | A101 | 1 | 2 | 32-229 | B32 | A229 | 1 | 2 |
| 32-139 | B32 | A139 | 1 | 2 | 32-231 | B32 | A231 | 1 | 2 |
| 32-161 | B32 | A161 | 1 | 2 | 32-232 | B32 | A232 | 1 | 2 |
| 32-162 | B32 | A162 | 1 | 2 | 32-233 | B32 | A233 | 1 | 2 |
| 32-181 | B32 | A181 | 1 | 2 | 32-235 | B32 | A235 | 1 | 2 |
| 32-182 | B32 | A182 | 1 | 2 | 32-236 | B32 | A236 | 1 | 2 |
| 32-191 | B32 | A191 | 1 | 2 | 32-237 | B32 | A237 | 1 | 2 |
| 32-192 | B32 | A192 | 1 | 2 | 32-238 | B32 | A238 | 1 | 2 |
| 32-193 | B32 | A193 | 1 | 2 | 32-239 | B32 | A239 | 1 | 2 |
| 32-194 | B32 | A194 | 1 | 2 | 32-241 | B32 | A241 | 1 | 2 |
| 32-196 | B32 | A196 | 1 | 2 | 32-242 | B32 | A242 | 1 | 2 |
| 32-197 | B32 | A197 | 1 | 2 | 32-243 | B32 | A243 | 1 | 2 |
| 32-199 | B32 | A199 | 1 | 2 | 32-246 | B32 | A246 | 1 | 2 |
| 32-200 | B32 | A200 | 1 | 2 | 32-247 | B32 | A247 | 1 | 2 |
| 32-201 | B32 | A201 | 1 | 2 | 32-248 | B32 | A248 | 1 | 2 |
| 32-203 | B32 | A203 | 1 | 2 | 32-249 | B32 | A249 | 1 | 2 |
| 32-206 | B32 | A206 | 1 | 2 | 32-250 | B32 | A250 | 1 | 2 |

**Table 13**

| Compound No. | L₁ | L₂ | n1 | n2 | Compound No. | L₁ | L₂ | n1 | n2 |
|---|---|---|---|---|---|---|---|---|---|
| 33-1 | B33 | A1 | 1 | 2 | 33-208 | B33 | A208 | 1 | 2 |
| 33-2 | B33 | A2 | 1 | 2 | 33-209 | B33 | A209 | 1 | 2 |
| 33-3 | B33 | A3 | 1 | 2 | 33-212 | B33 | A212 | 1 | 2 |
| 33-5 | B33 | A5 | 1 | 2 | 33-213 | B33 | A213 | 1 | 2 |
| 33-8 | B33 | A8 | 1 | 2 | 33-214 | B33 | A214 | 1 | 2 |
| 33-35 | B33 | A35 | 1 | 2 | 33-215 | B33 | A215 | 1 | 2 |
| 33-36 | B33 | A36 | 1 | 2 | 33-216 | B33 | A216 | 1 | 2 |
| 33-45 | B33 | A45 | 1 | 2 | 33-217 | B33 | A217 | 1 | 2 |
| 33-47 | B33 | A47 | 1 | 2 | 33-221 | B33 | A221 | 1 | 2 |
| 33-49 | B33 | A49 | 1 | 2 | 33-222 | B33 | A222 | 1 | 2 |
| 33-60 | B33 | A60 | 1 | 2 | 33-224 | B33 | A224 | 1 | 2 |
| 33-86 | B33 | A86 | 1 | 2 | 33-225 | B33 | A225 | 1 | 2 |
| 33-94 | B33 | A94 | 1 | 2 | 33-226 | B33 | A226 | 1 | 2 |
| 33-99 | B33 | A99 | 1 | 2 | 33-228 | B33 | A228 | 1 | 2 |
| 33-101 | B33 | A101 | 1 | 2 | 33-229 | B33 | A229 | 1 | 2 |
| 33-139 | B33 | A139 | 1 | 2 | 33-231 | B33 | A231 | 1 | 2 |
| 33-161 | B33 | A161 | 1 | 2 | 33-232 | B33 | A232 | 1 | 2 |
| 33-162 | B33 | A162 | 1 | 2 | 33-233 | B33 | A233 | 1 | 2 |
| 33-181 | B33 | A181 | 1 | 2 | 33-235 | B33 | A235 | 1 | 2 |
| 33-182 | B33 | A182 | 1 | 2 | 33-236 | B33 | A236 | 1 | 2 |
| 33-191 | B33 | A191 | 1 | 2 | 33-237 | B33 | A237 | 1 | 2 |
| 33-192 | B33 | A192 | 1 | 2 | 33-238 | B33 | A238 | 1 | 2 |
| 33-193 | B33 | A193 | 1 | 2 | 33-239 | B33 | A239 | 1 | 2 |
| 33-194 | B33 | A194 | 1 | 2 | 33-241 | B33 | A241 | 1 | 2 |
| 33-196 | B33 | A196 | 1 | 2 | 33-242 | B33 | A242 | 1 | 2 |
| 33-197 | B33 | A197 | 1 | 2 | 33-243 | B33 | A243 | 1 | 2 |
| 33-199 | B33 | A199 | 1 | 2 | 33-246 | B33 | A246 | 1 | 2 |
| 33-200 | B33 | A200 | 1 | 2 | 33-247 | B33 | A247 | 1 | 2 |
| 33-201 | B33 | A201 | 1 | 2 | 33-248 | B33 | A248 | 1 | 2 |
| 33-203 | B33 | A203 | 1 | 2 | 33-249 | B33 | A249 | 1 | 2 |
| 33-206 | B33 | A206 | 1 | 2 | 33-250 | B33 | A250 | 1 | 2 |

**Table 14**

| Compound No. | L₁ | L₂ | n1 | n2 | Compound No. | L₁ | L₂ | n1 | n2 |
|---|---|---|---|---|---|---|---|---|---|
| 53-1 | B53 | A1 | 1 | 2 | 53-208 | B53 | A208 | 1 | 2 |
| 53-2 | B53 | A2 | 1 | 2 | 53-209 | B53 | A209 | 1 | 2 |
| 53-3 | B53 | A3 | 1 | 2 | 53-212 | B53 | A212 | 1 | 2 |
| 53-5 | B53 | A5 | 1 | 2 | 53-213 | B53 | A213 | 1 | 2 |
| 53-8 | B53 | A8 | 1 | 2 | 53-214 | B53 | A214 | 1 | 2 |
| 53-35 | B53 | A35 | 1 | 2 | 53-215 | B53 | A215 | 1 | 2 |
| 53-36 | B53 | A36 | 1 | 2 | 53-216 | B53 | A216 | 1 | 2 |
| 53-45 | B53 | A45 | 1 | 2 | 53-217 | B53 | A217 | 1 | 2 |
| 53-47 | B53 | A47 | 1 | 2 | 53-221 | B53 | A221 | 1 | 2 |
| 53-49 | B53 | A49 | 1 | 2 | 53-222 | B53 | A222 | 1 | 2 |
| 53-60 | B53 | A60 | 1 | 2 | 53-224 | B53 | A224 | 1 | 2 |
| 53-86 | B53 | A86 | 1 | 2 | 53-225 | B53 | A225 | 1 | 2 |
| 53-94 | B53 | A94 | 1 | 2 | 53-226 | B53 | A226 | 1 | 2 |
| 53-99 | B53 | A99 | 1 | 2 | 53-228 | B53 | A228 | 1 | 2 |
| 53-101 | B53 | A101 | 1 | 2 | 53-229 | B53 | A229 | 1 | 2 |
| 53-139 | B53 | A139 | 1 | 2 | 53-231 | B53 | A231 | 1 | 2 |
| 53-161 | B53 | A161 | 1 | 2 | 53-232 | B53 | A232 | 1 | 2 |
| 53-162 | B53 | A162 | 1 | 2 | 53-233 | B53 | A233 | 1 | 2 |
| 53-181 | B53 | A181 | 1 | 2 | 53-235 | B53 | A235 | 1 | 2 |
| 53-182 | B53 | A182 | 1 | 2 | 53-236 | B53 | A236 | 1 | 2 |
| 53-191 | B53 | A191 | 1 | 2 | 53-237 | B53 | A237 | 1 | 2 |
| 53-192 | B53 | A192 | 1 | 2 | 53-238 | B53 | A238 | 1 | 2 |
| 53-193 | B53 | A193 | 1 | 2 | 53-239 | B53 | A239 | 1 | 2 |
| 53-194 | B53 | A194 | 1 | 2 | 53-241 | B53 | A241 | 1 | 2 |
| 53-196 | B53 | A196 | 1 | 2 | 53-242 | B53 | A242 | 1 | 2 |
| 53-197 | B53 | A197 | 1 | 2 | 53-243 | B53 | A243 | 1 | 2 |
| 53-199 | B53 | A199 | 1 | 2 | 53-246 | B53 | A246 | 1 | 2 |
| 53-200 | B53 | A200 | 1 | 2 | 53-247 | B53 | A247 | 1 | 2 |
| 53-201 | B53 | A201 | 1 | 2 | 53-248 | B53 | A248 | 1 | 2 |
| 53-203 | B53 | A203 | 1 | 2 | 53-249 | B53 | A249 | 1 | 2 |
| 53-206 | B53 | A206 | 1 | 2 | 53-250 | B53 | A250 | 1 | 2 |

**Table 15**

| Compound No. | L₁ | L₂ | n1 | n2 | Compound No. | L₁ | L₂ | n1 | n2 |
|---|---|---|---|---|---|---|---|---|---|
| 54-1 | B54 | A1 | 1 | 2 | 54-208 | B54 | A208 | 1 | 2 |
| 54-2 | B54 | A2 | 1 | 2 | 54-209 | B54 | A209 | 1 | 2 |
| 54-3 | B54 | A3 | 1 | 2 | 54-212 | B54 | A212 | 1 | 2 |
| 54-5 | B54 | A5 | 1 | 2 | 54-213 | B54 | A213 | 1 | 2 |
| 54-8 | B54 | A8 | 1 | 2 | 54-214 | B54 | A214 | 1 | 2 |
| 54-35 | B54 | A35 | 1 | 2 | 54-215 | B54 | A215 | 1 | 2 |
| 54-36 | B54 | A36 | 1 | 2 | 54-216 | B54 | A216 | 1 | 2 |
| 54-45 | B54 | A45 | 1 | 2 | 54-217 | B54 | A217 | 1 | 2 |
| 54-47 | B54 | A47 | 1 | 2 | 54-221 | B54 | A221 | 1 | 2 |
| 54-49 | B54 | A49 | 1 | 2 | 54-222 | B54 | A222 | 1 | 2 |
| 54-60 | B54 | A60 | 1 | 2 | 54-224 | B54 | A224 | 1 | 2 |
| 54-86 | B54 | A86 | 1 | 2 | 54-225 | B54 | A225 | 1 | 2 |
| 54-94 | B54 | A94 | 1 | 2 | 54-226 | B54 | A226 | 1 | 2 |
| 54-99 | B54 | A99 | 1 | 2 | 54-228 | B54 | A228 | 1 | 2 |
| 54-101 | B54 | A101 | 1 | 2 | 54-229 | B54 | A229 | 1 | 2 |
| 54-139 | B54 | A139 | 1 | 2 | 54-231 | B54 | A231 | 1 | 2 |
| 54-161 | B54 | A161 | 1 | 2 | 54-232 | B54 | A232 | 1 | 2 |
| 54-162 | B54 | A162 | 1 | 2 | 54-233 | B54 | A233 | 1 | 2 |
| 54-181 | B54 | A181 | 1 | 2 | 54-235 | B54 | A235 | 1 | 2 |
| 54-182 | B54 | A182 | 1 | 2 | 54-236 | B54 | A236 | 1 | 2 |
| 54-191 | B54 | A191 | 1 | 2 | 54-237 | B54 | A237 | 1 | 2 |
| 54-192 | B54 | A192 | 1 | 2 | 54-238 | B54 | A238 | 1 | 2 |
| 54-193 | B54 | A193 | 1 | 2 | 54-239 | B54 | A239 | 1 | 2 |
| 54-194 | B54 | A194 | 1 | 2 | 54-241 | B54 | A241 | 1 | 2 |
| 54-196 | B54 | A196 | 1 | 2 | 54-242 | B54 | A242 | 1 | 2 |
| 54-197 | B54 | A197 | 1 | 2 | 54-243 | B54 | A243 | 1 | 2 |
| 54-199 | B54 | A199 | 1 | 2 | 54-246 | B54 | A246 | 1 | 2 |
| 54-200 | B54 | A200 | 1 | 2 | 54-247 | B54 | A247 | 1 | 2 |
| 54-201 | B54 | A201 | 1 | 2 | 54-248 | B54 | A248 | 1 | 2 |
| 54-203 | B54 | A203 | 1 | 2 | 54-249 | B54 | A249 | 1 | 2 |
| 54-206 | B54 | A206 | 1 | 2 | 54-250 | B54 | A250 | 1 | 2 |

**Table 16**

| Compound No. | L₁ | L₂ | n1 | n2 | Compound No. | L₁ | L₂ | n1 | n2 |
|---|---|---|---|---|---|---|---|---|---|
| 62-1 | B62 | A1 | 1 | 2 | 62-208 | B62 | A208 | 1 | 2 |
| 62-2 | B62 | A2 | 1 | 2 | 62-209 | B62 | A209 | 1 | 2 |
| 62-3 | B62 | A3 | 1 | 2 | 62-212 | B62 | A212 | 1 | 2 |
| 62-5 | B62 | A5 | 1 | 2 | 62-213 | B62 | A213 | 1 | 2 |
| 62-8 | B62 | A8 | 1 | 2 | 62-214 | B62 | A214 | 1 | 2 |
| 62-35 | B62 | A35 | 1 | 2 | 62-215 | B62 | A215 | 1 | 2 |
| 62-36 | B62 | A36 | 1 | 2 | 62-216 | B62 | A216 | 1 | 2 |
| 62-45 | B62 | A45 | 1 | 2 | 62-217 | B62 | A217 | 1 | 2 |
| 62-47 | B62 | A47 | 1 | 2 | 62-221 | B62 | A221 | 1 | 2 |
| 62-49 | B62 | A49 | 1 | 2 | 62-222 | B62 | A222 | 1 | 2 |
| 62-60 | B62 | A60 | 1 | 2 | 62-224 | B62 | A224 | 1 | 2 |
| 62-86 | B62 | A86 | 1 | 2 | 62-225 | B62 | A225 | 1 | 2 |
| 62-94 | B62 | A94 | 1 | 2 | 62-226 | B62 | A226 | 1 | 2 |
| 62-99 | B62 | A99 | 1 | 2 | 62-228 | B62 | A228 | 1 | 2 |
| 62-101 | B62 | A101 | 1 | 2 | 62-229 | B62 | A229 | 1 | 2 |
| 62-139 | B62 | A139 | 1 | 2 | 62-231 | B62 | A231 | 1 | 2 |
| 62-161 | B62 | A161 | 1 | 2 | 62-232 | B62 | A232 | 1 | 2 |
| 62-162 | B62 | A162 | 1 | 2 | 62-233 | B62 | A233 | 1 | 2 |
| 62-181 | B62 | A181 | 1 | 2 | 62-235 | B62 | A235 | 1 | 2 |
| 62-182 | B62 | A182 | 1 | 2 | 62-236 | B62 | A236 | 1 | 2 |
| 62-191 | B62 | A191 | 1 | 2 | 62-237 | B62 | A237 | 1 | 2 |
| 62-192 | B62 | A192 | 1 | 2 | 62-238 | B62 | A238 | 1 | 2 |
| 62-193 | B62 | A193 | 1 | 2 | 62-239 | B62 | A239 | 1 | 2 |
| 62-194 | B62 | A194 | 1 | 2 | 62-241 | B62 | A241 | 1 | 2 |
| 62-196 | B62 | A196 | 1 | 2 | 62-242 | B62 | A242 | 1 | 2 |
| 62-197 | B62 | A197 | 1 | 2 | 62-243 | B62 | A243 | 1 | 2 |
| 62-199 | B62 | A199 | 1 | 2 | 62-246 | B62 | A246 | 1 | 2 |
| 62-200 | B62 | A200 | 1 | 2 | 62-247 | B62 | A247 | 1 | 2 |
| 62-201 | B62 | A201 | 1 | 2 | 62-248 | B62 | A248 | 1 | 2 |
| 62-203 | B62 | A203 | 1 | 2 | 62-249 | B62 | A249 | 1 | 2 |
| 62-206 | B62 | A206 | 1 | 2 | 62-250 | B62 | A250 | 1 | 2 |

**Table 17**

| Compound No. | L₁ | L₂ | n1 | n2 | Compound No. | L₁ | L₂ | n1 | n2 |
|---|---|---|---|---|---|---|---|---|---|
| 66-1 | B66 | A1 | 1 | 2 | 66-208 | B66 | A208 | 1 | 2 |
| 66-2 | B66 | A2 | 1 | 2 | 66-209 | B66 | A209 | 1 | 2 |
| 66-3 | B66 | A3 | 1 | 2 | 66-212 | B66 | A212 | 1 | 2 |
| 66-5 | B66 | A5 | 1 | 2 | 66-213 | B66 | A213 | 1 | 2 |
| 66-8 | B66 | A8 | 1 | 2 | 66-214 | B66 | A214 | 1 | 2 |
| 66-35 | B66 | A35 | 1 | 2 | 66-215 | B66 | A215 | 1 | 2 |
| 66-36 | B66 | A36 | 1 | 2 | 66-216 | B66 | A216 | 1 | 2 |
| 66-45 | B66 | A45 | 1 | 2 | 66-217 | B66 | A217 | 1 | 2 |
| 66-47 | B66 | A47 | 1 | 2 | 66-221 | B66 | A221 | 1 | 2 |
| 66-49 | B66 | A49 | 1 | 2 | 66-222 | B66 | A222 | 1 | 2 |
| 66-60 | B66 | A60 | 1 | 2 | 66-224 | B66 | A224 | 1 | 2 |
| 66-86 | B66 | A86 | 1 | 2 | 66-225 | B66 | A225 | 1 | 2 |
| 66-94 | B66 | A94 | 1 | 2 | 66-226 | B66 | A226 | 1 | 2 |
| 66-99 | B66 | A99 | 1 | 2 | 66-228 | B66 | A228 | 1 | 2 |
| 66-101 | B66 | A101 | 1 | 2 | 66-229 | B66 | A229 | 1 | 2 |
| 66-139 | B66 | A139 | 1 | 2 | 66-231 | B66 | A231 | 1 | 2 |
| 66-161 | B66 | A161 | 1 | 2 | 66-232 | B66 | A232 | 1 | 2 |
| 66-162 | B66 | A162 | 1 | 2 | 66-233 | B66 | A233 | 1 | 2 |
| 66-181 | B66 | A181 | 1 | 2 | 66-235 | B66 | A235 | 1 | 2 |
| 66-182 | B66 | A182 | 1 | 2 | 66-236 | B66 | A236 | 1 | 2 |
| 66-191 | B66 | A191 | 1 | 2 | 66-237 | B66 | A237 | 1 | 2 |
| 66-192 | B66 | A192 | 1 | 2 | 66-238 | B66 | A238 | 1 | 2 |
| 66-193 | B66 | A193 | 1 | 2 | 66-239 | B66 | A239 | 1 | 2 |
| 66-194 | B66 | A194 | 1 | 2 | 66-241 | B66 | A241 | 1 | 2 |
| 66-196 | B66 | A196 | 1 | 2 | 66-242 | B66 | A242 | 1 | 2 |
| 66-197 | B66 | A197 | 1 | 2 | 66-243 | B66 | A243 | 1 | 2 |
| 66-199 | B66 | A199 | 1 | 2 | 66-246 | B66 | A246 | 1 | 2 |
| 66-200 | B66 | A200 | 1 | 2 | 66-247 | B66 | A247 | 1 | 2 |
| 66-201 | B66 | A201 | 1 | 2 | 66-248 | B66 | A248 | 1 | 2 |
| 66-203 | B66 | A203 | 1 | 2 | 66-249 | B66 | A249 | 1 | 2 |
| 66-206 | B66 | A206 | 1 | 2 | 66-250 | B66 | A250 | 1 | 2 |

**Table 18**

| Compound No. | L₁ | L₂ | n1 | n2 | Compound No. | L₁ | L₂ | n1 | n2 |
|---|---|---|---|---|---|---|---|---|---|
| 67-1 | B67 | A1 | 1 | 2 | 67-208 | B67 | A208 | 1 | 2 |
| 67-2 | B67 | A2 | 1 | 2 | 67-209 | B67 | A209 | 1 | 2 |
| 67-3 | B67 | A3 | 1 | 2 | 67-212 | B67 | A212 | 1 | 2 |
| 67-5 | B67 | A5 | 1 | 2 | 67-213 | B67 | A213 | 1 | 2 |
| 67-8 | B67 | A8 | 1 | 2 | 67-214 | B67 | A214 | 1 | 2 |
| 67-35 | B67 | A35 | 1 | 2 | 67-215 | B67 | A215 | 1 | 2 |
| 67-36 | B67 | A36 | 1 | 2 | 67-216 | B67 | A216 | 1 | 2 |
| 67-45 | B67 | A45 | 1 | 2 | 67-217 | B67 | A217 | 1 | 2 |
| 67-47 | B67 | A47 | 1 | 2 | 67-221 | B67 | A221 | 1 | 2 |
| 67-49 | B67 | A49 | 1 | 2 | 67-222 | B67 | A222 | 1 | 2 |
| 67-60 | B67 | A60 | 1 | 2 | 67-224 | B67 | A224 | 1 | 2 |
| 67-86 | B67 | A86 | 1 | 2 | 67-225 | B67 | A225 | 1 | 2 |
| 67-94 | B67 | A94 | 1 | 2 | 67-226 | B67 | A226 | 1 | 2 |
| 67-99 | B67 | A99 | 1 | 2 | 67-228 | B67 | A228 | 1 | 2 |
| 67-101 | B67 | A101 | 1 | 2 | 67-229 | B67 | A229 | 1 | 2 |
| 67-139 | B67 | A139 | 1 | 2 | 67-231 | B67 | A231 | 1 | 2 |
| 67-161 | B67 | A161 | 1 | 2 | 67-232 | B67 | A232 | 1 | 2 |
| 67-162 | B67 | A162 | 1 | 2 | 67-233 | B67 | A233 | 1 | 2 |
| 67-181 | B67 | A181 | 1 | 2 | 67-235 | B67 | A235 | 1 | 2 |
| 67-182 | B67 | A182 | 1 | 2 | 67-236 | B67 | A236 | 1 | 2 |
| 67-191 | B67 | A191 | 1 | 2 | 67-237 | B67 | A237 | 1 | 2 |
| 67-192 | B67 | A192 | 1 | 2 | 67-238 | B67 | A238 | 1 | 2 |
| 67-193 | B67 | A193 | 1 | 2 | 67-239 | B67 | A239 | 1 | 2 |
| 67-194 | B67 | A194 | 1 | 2 | 67-241 | B67 | A241 | 1 | 2 |
| 67-196 | B67 | A196 | 1 | 2 | 67-242 | B67 | A242 | 1 | 2 |
| 67-197 | B67 | A197 | 1 | 2 | 67-243 | B67 | A243 | 1 | 2 |
| 67-199 | B67 | A199 | 1 | 2 | 67-246 | B67 | A246 | 1 | 2 |
| 67-200 | B67 | A200 | 1 | 2 | 67-247 | B67 | A247 | 1 | 2 |
| 67-201 | B67 | A201 | 1 | 2 | 67-248 | B67 | A248 | 1 | 2 |
| 67-203 | B67 | A203 | 1 | 2 | 67-249 | B67 | A249 | 1 | 2 |
| 67-206 | B67 | A206 | 1 | 2 | 67-250 | B67 | A250 | 1 | 2 |

**Table 19**

| Compound No. | L₁ | L₂ | n1 | n2 | Compound No. | L₁ | L₂ | n1 | n2 |
|---|---|---|---|---|---|---|---|---|---|
| 70-1 | B70 | A1 | 1 | 2 | 70-208 | B70 | A208 | 1 | 2 |
| 70-2 | B70 | A2 | 1 | 2 | 70-209 | B70 | A209 | 1 | 2 |
| 70-3 | B70 | A3 | 1 | 2 | 70-212 | B70 | A212 | 1 | 2 |
| 70-5 | B70 | A5 | 1 | 2 | 70-213 | B70 | A213 | 1 | 2 |
| 70-8 | B70 | A8 | 1 | 2 | 70-214 | B70 | A214 | 1 | 2 |
| 70-35 | B70 | A35 | 1 | 2 | 70-215 | B70 | A215 | 1 | 2 |
| 70-36 | B70 | A36 | 1 | 2 | 70-216 | B70 | A216 | 1 | 2 |
| 70-45 | B70 | A45 | 1 | 2 | 70-217 | B70 | A217 | 1 | 2 |
| 70-47 | B70 | A47 | 1 | 2 | 70-221 | B70 | A221 | 1 | 2 |
| 70-49 | B70 | A49 | 1 | 2 | 70-222 | B70 | A222 | 1 | 2 |
| 70-60 | B70 | A60 | 1 | 2 | 70-224 | B70 | A224 | 1 | 2 |
| 70-86 | B70 | A86 | 1 | 2 | 70-225 | B70 | A225 | 1 | 2 |
| 70-94 | B70 | A94 | 1 | 2 | 70-226 | B70 | A226 | 1 | 2 |
| 70-99 | B70 | A99 | 1 | 2 | 70-228 | B70 | A228 | 1 | 2 |
| 70-101 | B70 | A101 | 1 | 2 | 70-229 | B70 | A229 | 1 | 2 |
| 70-139 | B70 | A139 | 1 | 2 | 70-231 | B70 | A231 | 1 | 2 |
| 70-161 | B70 | A161 | 1 | 2 | 70-232 | B70 | A232 | 1 | 2 |
| 70-162 | B70 | A162 | 1 | 2 | 70-233 | B70 | A233 | 1 | 2 |
| 70-181 | B70 | A181 | 1 | 2 | 70-235 | B70 | A235 | 1 | 2 |
| 70-182 | B70 | A182 | 1 | 2 | 70-236 | B70 | A236 | 1 | 2 |
| 70-191 | B70 | A191 | 1 | 2 | 70-237 | B70 | A237 | 1 | 2 |
| 70-192 | B70 | A192 | 1 | 2 | 70-238 | B70 | A238 | 1 | 2 |
| 70-193 | B70 | A193 | 1 | 2 | 70-239 | B70 | A239 | 1 | 2 |
| 70-194 | B70 | A194 | 1 | 2 | 70-241 | B70 | A241 | 1 | 2 |
| 70-196 | B70 | A196 | 1 | 2 | 70-242 | B70 | A242 | 1 | 2 |
| 70-197 | B70 | A197 | 1 | 2 | 70-243 | B70 | A243 | 1 | 2 |
| 70-199 | B70 | A199 | 1 | 2 | 70-246 | B70 | A246 | 1 | 2 |
| 70-200 | B70 | A200 | 1 | 2 | 70-247 | B70 | A247 | 1 | 2 |
| 70-201 | B70 | A201 | 1 | 2 | 70-248 | B70 | A248 | 1 | 2 |
| 70-203 | B70 | A203 | 1 | 2 | 70-249 | B70 | A249 | 1 | 2 |
| 70-206 | B70 | A206 | 1 | 2 | 70-250 | B70 | A250 | 1 | 2 |

**Table 20**

| Compound No. | L₁ | L₂ | n1 | n2 | Compound No. | L₁ | L₂ | n1 | n2 |
|---|---|---|---|---|---|---|---|---|---|
| 75-1 | B75 | A1 | 1 | 2 | 75-208 | B75 | A208 | 1 | 2 |
| 75-2 | B75 | A2 | 1 | 2 | 75-209 | B75 | A209 | 1 | 2 |
| 75-3 | B75 | A3 | 1 | 2 | 75-212 | B75 | A212 | 1 | 2 |
| 75-5 | B75 | A5 | 1 | 2 | 75-213 | B75 | A213 | 1 | 2 |
| 75-8 | B75 | A8 | 1 | 2 | 75-214 | B75 | A214 | 1 | 2 |
| 75-35 | B75 | A35 | 1 | 2 | 75-215 | B75 | A215 | 1 | 2 |
| 75-36 | B75 | A36 | 1 | 2 | 75-216 | B75 | A216 | 1 | 2 |
| 75-45 | B75 | A45 | 1 | 2 | 75-217 | B75 | A217 | 1 | 2 |
| 75-47 | B75 | A47 | 1 | 2 | 75-221 | B75 | A221 | 1 | 2 |
| 75-49 | B75 | A49 | 1 | 2 | 75-222 | B75 | A222 | 1 | 2 |
| 75-60 | B75 | A60 | 1 | 2 | 75-224 | B75 | A224 | 1 | 2 |
| 75-86 | B75 | A86 | 1 | 2 | 75-225 | B75 | A225 | 1 | 2 |
| 75-94 | B75 | A94 | 1 | 2 | 75-226 | B75 | A226 | 1 | 2 |
| 75-99 | B75 | A99 | 1 | 2 | 75-228 | B75 | A228 | 1 | 2 |
| 75-101 | B75 | A101 | 1 | 2 | 75-229 | B75 | A229 | 1 | 2 |
| 75-139 | B75 | A139 | 1 | 2 | 75-231 | B75 | A231 | 1 | 2 |
| 75-161 | B75 | A161 | 1 | 2 | 75-232 | B75 | A232 | 1 | 2 |
| 75-162 | B75 | A162 | 1 | 2 | 75-233 | B75 | A233 | 1 | 2 |
| 75-181 | B75 | A181 | 1 | 2 | 75-235 | B75 | A235 | 1 | 2 |
| 75-182 | B75 | A182 | 1 | 2 | 75-236 | B75 | A236 | 1 | 2 |
| 75-191 | B75 | A191 | 1 | 2 | 75-237 | B75 | A237 | 1 | 2 |
| 75-192 | B75 | A192 | 1 | 2 | 75-238 | B75 | A238 | 1 | 2 |
| 75-193 | B75 | A193 | 1 | 2 | 75-239 | B75 | A239 | 1 | 2 |
| 75-194 | B75 | A194 | 1 | 2 | 75-241 | B75 | A241 | 1 | 2 |
| 75-196 | B75 | A196 | 1 | 2 | 75-242 | B75 | A242 | 1 | 2 |
| 75-197 | B75 | A197 | 1 | 2 | 75-243 | B75 | A243 | 1 | 2 |
| 75-199 | B75 | A199 | 1 | 2 | 75-246 | B75 | A246 | 1 | 2 |
| 75-200 | B75 | A200 | 1 | 2 | 75-247 | B75 | A247 | 1 | 2 |
| 75-201 | B75 | A201 | 1 | 2 | 75-248 | B75 | A248 | 1 | 2 |
| 75-203 | B75 | A203 | 1 | 2 | 75-249 | B75 | A249 | 1 | 2 |
| 75-206 | B75 | A206 | 1 | 2 | 75-250 | B75 | A250 | 1 | 2 |

**Table 21**

| Compound No. | L₁ | L₂ | n1 | n2 | Compound No. | L₁ | L₂ | n1 | n2 |
|---|---|---|---|---|---|---|---|---|---|
| 82-1 | B82 | A1 | 1 | 2 | 82-208 | B82 | A208 | 1 | 2 |
| 82-2 | B82 | A2 | 1 | 2 | 82-209 | B82 | A209 | 1 | 2 |
| 82-3 | B82 | A3 | 1 | 2 | 82-212 | B82 | A212 | 1 | 2 |
| 82-5 | B82 | A5 | 1 | 2 | 82-213 | B82 | A213 | 1 | 2 |
| 82-8 | B82 | A8 | 1 | 2 | 82-214 | B82 | A214 | 1 | 2 |
| 82-35 | B82 | A35 | 1 | 2 | 82-215 | B82 | A215 | 1 | 2 |
| 82-36 | B82 | A36 | 1 | 2 | 82-216 | B82 | A216 | 1 | 2 |
| 82-45 | B82 | A45 | 1 | 2 | 82-217 | B82 | A217 | 1 | 2 |
| 82-47 | B82 | A47 | 1 | 2 | 82-221 | B82 | A221 | 1 | 2 |
| 82-49 | B82 | A49 | 1 | 2 | 82-222 | B82 | A222 | 1 | 2 |
| 82-60 | B82 | A60 | 1 | 2 | 82-224 | B82 | A224 | 1 | 2 |
| 82-86 | B82 | A86 | 1 | 2 | 82-225 | B82 | A225 | 1 | 2 |
| 82-94 | B82 | A94 | 1 | 2 | 82-226 | B82 | A226 | 1 | 2 |
| 82-99 | B82 | A99 | 1 | 2 | 82-228 | B82 | A228 | 1 | 2 |
| 82-101 | B82 | A101 | 1 | 2 | 82-229 | B82 | A229 | 1 | 2 |
| 82-139 | B82 | A139 | 1 | 2 | 82-231 | B82 | A231 | 1 | 2 |
| 82-161 | B82 | A161 | 1 | 2 | 82-232 | B82 | A232 | 1 | 2 |
| 82-162 | B82 | A162 | 1 | 2 | 82-233 | B82 | A233 | 1 | 2 |
| 82-181 | B82 | A181 | 1 | 2 | 82-235 | B82 | A235 | 1 | 2 |
| 82-182 | B82 | A182 | 1 | 2 | 82-236 | B82 | A236 | 1 | 2 |
| 82-191 | B82 | A191 | 1 | 2 | 82-237 | B82 | A237 | 1 | 2 |
| 82-192 | B82 | A192 | 1 | 2 | 82-238 | B82 | A238 | 1 | 2 |
| 82-193 | B82 | A193 | 1 | 2 | 82-239 | B82 | A239 | 1 | 2 |
| 82-194 | B82 | A194 | 1 | 2 | 82-241 | B82 | A241 | 1 | 2 |
| 82-196 | B82 | A196 | 1 | 2 | 82-242 | B82 | A242 | 1 | 2 |
| 82-197 | B82 | A197 | 1 | 2 | 82-243 | B82 | A243 | 1 | 2 |
| 82-199 | B82 | A199 | 1 | 2 | 82-246 | B82 | A246 | 1 | 2 |
| 82-200 | B82 | A200 | 1 | 2 | 82-247 | B82 | A247 | 1 | 2 |
| 82-201 | B82 | A201 | 1 | 2 | 82-248 | B82 | A248 | 1 | 2 |
| 82-203 | B82 | A203 | 1 | 2 | 82-249 | B82 | A249 | 1 | 2 |
| 82-206 | B82 | A206 | 1 | 2 | 82-250 | B82 | A250 | 1 | 2 |

**Table 22**

| Compound No. | L₁ | L₂ | n1 | n2 | Compound No. | L₁ | L₂ | n1 | n2 |
|---|---|---|---|---|---|---|---|---|---|
| 89-1 | B89 | A1 | 1 | 2 | 89-208 | B89 | A208 | 1 | 2 |
| 89-2 | B89 | A2 | 1 | 2 | 89-209 | B89 | A209 | 1 | 2 |
| 89-3 | B89 | A3 | 1 | 2 | 89-212 | B89 | A212 | 1 | 2 |
| 89-5 | B89 | A5 | 1 | 2 | 89-213 | B89 | A213 | 1 | 2 |
| 89-8 | B89 | A8 | 1 | 2 | 89-214 | B89 | A214 | 1 | 2 |
| 89-35 | B89 | A35 | 1 | 2 | 89-215 | B89 | A215 | 1 | 2 |
| 89-36 | B89 | A36 | 1 | 2 | 89-216 | B89 | A216 | 1 | 2 |
| 89-45 | B89 | A45 | 1 | 2 | 89-217 | B89 | A217 | 1 | 2 |
| 89-47 | B89 | A47 | 1 | 2 | 89-221 | B89 | A221 | 1 | 2 |
| 89-49 | B89 | A49 | 1 | 2 | 89-222 | B89 | A222 | 1 | 2 |
| 89-60 | B89 | A60 | 1 | 2 | 89-224 | B89 | A224 | 1 | 2 |
| 89-86 | B89 | A86 | 1 | 2 | 89-225 | B89 | A225 | 1 | 2 |
| 89-94 | B89 | A94 | 1 | 2 | 89-226 | B89 | A226 | 1 | 2 |
| 89-99 | B89 | A99 | 1 | 2 | 89-228 | B89 | A228 | 1 | 2 |
| 89-101 | B89 | A101 | 1 | 2 | 89-229 | B89 | A229 | 1 | 2 |
| 89-139 | B89 | A139 | 1 | 2 | 89-231 | B89 | A231 | 1 | 2 |
| 89-161 | B89 | A161 | 1 | 2 | 89-232 | B89 | A232 | 1 | 2 |
| 89-162 | B89 | A162 | 1 | 2 | 89-233 | B89 | A233 | 1 | 2 |
| 89-181 | B89 | A181 | 1 | 2 | 89-235 | B89 | A235 | 1 | 2 |
| 89-182 | B89 | A182 | 1 | 2 | 89-236 | B89 | A236 | 1 | 2 |
| 89-191 | B89 | A191 | 1 | 2 | 89-237 | B89 | A237 | 1 | 2 |
| 89-192 | B89 | A192 | 1 | 2 | 89-238 | B89 | A238 | 1 | 2 |
| 89-193 | B89 | A193 | 1 | 2 | 89-239 | B89 | A239 | 1 | 2 |
| 89-194 | B89 | A194 | 1 | 2 | 89-241 | B89 | A241 | 1 | 2 |
| 89-196 | B89 | A196 | 1 | 2 | 89-242 | B89 | A242 | 1 | 2 |
| 89-197 | B89 | A197 | 1 | 2 | 89-243 | B89 | A243 | 1 | 2 |
| 89-199 | B89 | A199 | 1 | 2 | 89-246 | B89 | A246 | 1 | 2 |
| 89-200 | B89 | A200 | 1 | 2 | 89-247 | B89 | A247 | 1 | 2 |
| 89-201 | B89 | A201 | 1 | 2 | 89-248 | B89 | A248 | 1 | 2 |
| 89-203 | B89 | A203 | 1 | 2 | 89-249 | B89 | A249 | 1 | 2 |
| 89-206 | B89 | A206 | 1 | 2 | 89-250 | B89 | A250 | 1 | 2 |

**Table 23**

| Compound No. | L₁ | L₂ | n1 | n2 | Compound No. | L₁ | L₂ | n1 | n2 |
|---|---|---|---|---|---|---|---|---|---|
| 91-1 | B91 | A1 | 1 | 2 | 91-208 | B91 | A208 | 1 | 2 |
| 91-2 | B91 | A2 | 1 | 2 | 91-209 | B91 | A209 | 1 | 2 |
| 91-3 | B91 | A3 | 1 | 2 | 91-212 | B91 | A212 | 1 | 2 |
| 91-5 | B91 | A5 | 1 | 2 | 91-213 | B91 | A213 | 1 | 2 |
| 91-8 | B91 | A8 | 1 | 2 | 91-214 | B91 | A214 | 1 | 2 |
| 91-35 | B91 | A35 | 1 | 2 | 91-215 | B91 | A215 | 1 | 2 |
| 91-36 | B91 | A36 | 1 | 2 | 91-216 | B91 | A216 | 1 | 2 |
| 91-45 | B91 | A45 | 1 | 2 | 91-217 | B91 | A217 | 1 | 2 |
| 91-47 | B91 | A47 | 1 | 2 | 91-221 | B91 | A221 | 1 | 2 |
| 91-49 | B91 | A49 | 1 | 2 | 91-222 | B91 | A222 | 1 | 2 |
| 91-60 | B91 | A60 | 1 | 2 | 91-224 | B91 | A224 | 1 | 2 |
| 91-86 | B91 | A86 | 1 | 2 | 91-225 | B91 | A225 | 1 | 2 |
| 91-94 | B91 | A94 | 1 | 2 | 91-226 | B91 | A226 | 1 | 2 |
| 91-99 | B91 | A99 | 1 | 2 | 91-228 | B91 | A228 | 1 | 2 |
| 91-101 | B91 | A101 | 1 | 2 | 91-229 | B91 | A229 | 1 | 2 |
| 91-139 | B91 | A139 | 1 | 2 | 91-231 | B91 | A231 | 1 | 2 |
| 91-161 | B91 | A161 | 1 | 2 | 91-232 | B91 | A232 | 1 | 2 |
| 91-162 | B91 | A162 | 1 | 2 | 91-233 | B91 | A233 | 1 | 2 |
| 91-181 | B91 | A181 | 1 | 2 | 91-235 | B91 | A235 | 1 | 2 |
| 91-182 | B91 | A182 | 1 | 2 | 91-236 | B91 | A236 | 1 | 2 |
| 91-191 | B91 | A191 | 1 | 2 | 91-237 | B91 | A237 | 1 | 2 |
| 91-192 | B91 | A192 | 1 | 2 | 91-238 | B91 | A238 | 1 | 2 |
| 91-193 | B91 | A193 | 1 | 2 | 91-239 | B91 | A239 | 1 | 2 |
| 91-194 | B91 | A194 | 1 | 2 | 91-241 | B91 | A241 | 1 | 2 |
| 91-196 | B91 | A196 | 1 | 2 | 91-242 | B91 | A242 | 1 | 2 |
| 91-197 | B91 | A197 | 1 | 2 | 91-243 | B91 | A243 | 1 | 2 |
| 91-199 | B91 | A199 | 1 | 2 | 91-246 | B91 | A246 | 1 | 2 |
| 91-200 | B91 | A200 | 1 | 2 | 91-247 | B91 | A247 | 1 | 2 |
| 91-201 | B91 | A201 | 1 | 2 | 91-248 | B91 | A248 | 1 | 2 |
| 91-203 | B91 | A203 | 1 | 2 | 91-249 | B91 | A249 | 1 | 2 |
| 91-206 | B91 | A206 | 1 | 2 | 91-250 | B91 | A250 | 1 | 2 |

**Table 24**

| Compound No. | L₁ | L₂ | n1 | n2 | Compound No. | L₁ | L₂ | n1 | n2 |
|---|---|---|---|---|---|---|---|---|---|
| 99-1 | B99 | A1 | 1 | 2 | 99-208 | B99 | A208 | 1 | 2 |
| 99-2 | B99 | A2 | 1 | 2 | 99-209 | B99 | A209 | 1 | 2 |
| 99-3 | B99 | A3 | 1 | 2 | 99-212 | B99 | A212 | 1 | 2 |
| 99-5 | B99 | A5 | 1 | 2 | 99-213 | B99 | A213 | 1 | 2 |
| 99-8 | B99 | A8 | 1 | 2 | 99-214 | B99 | A214 | 1 | 2 |
| 99-35 | B99 | A35 | 1 | 2 | 99-215 | B99 | A215 | 1 | 2 |
| 99-36 | B99 | A36 | 1 | 2 | 99-216 | B99 | A216 | 1 | 2 |
| 99-45 | B99 | A45 | 1 | 2 | 99-217 | B99 | A217 | 1 | 2 |
| 99-47 | B99 | A47 | 1 | 2 | 99-221 | B99 | A221 | 1 | 2 |
| 99-49 | B99 | A49 | 1 | 2 | 99-222 | B99 | A222 | 1 | 2 |
| 99-60 | B99 | A60 | 1 | 2 | 99-224 | B99 | A224 | 1 | 2 |
| 99-86 | B99 | A86 | 1 | 2 | 99-225 | B99 | A225 | 1 | 2 |
| 99-94 | B99 | A94 | 1 | 2 | 99-226 | B99 | A226 | 1 | 2 |
| 99-99 | B99 | A99 | 1 | 2 | 99-228 | B99 | A228 | 1 | 2 |
| 99-101 | B99 | A101 | 1 | 2 | 99-229 | B99 | A229 | 1 | 2 |
| 99-139 | B99 | A139 | 1 | 2 | 99-231 | B99 | A231 | 1 | 2 |
| 99-161 | B99 | A161 | 1 | 2 | 99-232 | B99 | A232 | 1 | 2 |
| 99-162 | B99 | A162 | 1 | 2 | 99-233 | B99 | A233 | 1 | 2 |
| 99-181 | B99 | A181 | 1 | 2 | 99-235 | B99 | A235 | 1 | 2 |
| 99-182 | B99 | A182 | 1 | 2 | 99-236 | B99 | A236 | 1 | 2 |
| 99-191 | B99 | A191 | 1 | 2 | 99-237 | B99 | A237 | 1 | 2 |
| 99-192 | B99 | A192 | 1 | 2 | 99-238 | B99 | A238 | 1 | 2 |
| 99-193 | B99 | A193 | 1 | 2 | 99-239 | B99 | A239 | 1 | 2 |
| 99-194 | B99 | A194 | 1 | 2 | 99-241 | B99 | A241 | 1 | 2 |
| 99-196 | B99 | A196 | 1 | 2 | 99-242 | B99 | A242 | 1 | 2 |
| 99-197 | B99 | A197 | 1 | 2 | 99-243 | B99 | A243 | 1 | 2 |
| 99-199 | B99 | A199 | 1 | 2 | 99-246 | B99 | A246 | 1 | 2 |
| 99-200 | B99 | A200 | 1 | 2 | 99-247 | B99 | A247 | 1 | 2 |
| 99-201 | B99 | A201 | 1 | 2 | 99-248 | B99 | A248 | 1 | 2 |
| 99-203 | B99 | A203 | 1 | 2 | 99-249 | B99 | A249 | 1 | 2 |
| 99-206 | B99 | A206 | 1 | 2 | 99-250 | B99 | A250 | 1 | 2 |

**Table 25**

| Compound No. | L₁ | L₂ | n1 | n2 | Compound No. | L₁ | L₂ | n1 | n2 |
|---|---|---|---|---|---|---|---|---|---|
| 106-1 | B106 | A1 | 1 | 2 | 106-208 | B106 | A208 | 1 | 2 |
| 106-2 | B106 | A2 | 1 | 2 | 106-209 | B106 | A209 | 1 | 2 |
| 106-3 | B106 | A3 | 1 | 2 | 106-212 | B106 | A212 | 1 | 2 |
| 106-5 | B106 | A5 | 1 | 2 | 106-213 | B106 | A213 | 1 | 2 |
| 106-8 | B106 | A8 | 1 | 2 | 106-214 | B106 | A214 | 1 | 2 |
| 106-35 | B106 | A35 | 1 | 2 | 106-215 | B106 | A215 | 1 | 2 |
| 106-36 | B106 | A36 | 1 | 2 | 106-216 | B106 | A216 | 1 | 2 |
| 106-45 | B106 | A45 | 1 | 2 | 106-217 | B106 | A217 | 1 | 2 |
| 106-47 | B106 | A47 | 1 | 2 | 106-221 | B106 | A221 | 1 | 2 |
| 106-49 | B106 | A49 | 1 | 2 | 106-222 | B106 | A222 | 1 | 2 |
| 106-60 | B106 | A60 | 1 | 2 | 106-224 | B106 | A224 | 1 | 2 |
| 106-86 | B106 | A86 | 1 | 2 | 106-225 | B106 | A225 | 1 | 2 |
| 106-94 | B106 | A94 | 1 | 2 | 106-226 | B106 | A226 | 1 | 2 |
| 106-99 | B106 | A99 | 1 | 2 | 106-228 | B106 | A228 | 1 | 2 |
| 106-101 | B106 | A101 | 1 | 2 | 106-229 | B106 | A229 | 1 | 2 |
| 106-139 | B106 | A139 | 1 | 2 | 106-231 | B106 | A231 | 1 | 2 |
| 106-161 | B106 | A161 | 1 | 2 | 106-232 | B106 | A232 | 1 | 2 |
| 106-162 | B106 | A162 | 1 | 2 | 106-233 | B106 | A233 | 1 | 2 |
| 106-181 | B106 | A181 | 1 | 2 | 106-235 | B106 | A235 | 1 | 2 |
| 106-182 | B106 | A182 | 1 | 2 | 106-236 | B106 | A236 | 1 | 2 |
| 106-191 | B106 | A191 | 1 | 2 | 106-237 | B106 | A237 | 1 | 2 |
| 106-192 | B106 | A192 | 1 | 2 | 106-238 | B106 | A238 | 1 | 2 |
| 106-193 | B106 | A193 | 1 | 2 | 106-239 | B106 | A239 | 1 | 2 |
| 106-194 | B106 | A194 | 1 | 2 | 106-241 | B106 | A241 | 1 | 2 |
| 106-196 | B106 | A196 | 1 | 2 | 106-242 | B106 | A242 | 1 | 2 |
| 106-197 | B106 | A197 | 1 | 2 | 106-243 | B106 | A243 | 1 | 2 |
| 106-199 | B106 | A199 | 1 | 2 | 106-246 | B106 | A246 | 1 | 2 |
| 106-200 | B106 | A200 | 1 | 2 | 106-247 | B106 | A247 | 1 | 2 |
| 106-201 | B106 | A201 | 1 | 2 | 106-248 | B106 | A248 | 1 | 2 |
| 106-203 | B106 | A203 | 1 | 2 | 106-249 | B106 | A249 | 1 | 2 |
| 106-206 | B106 | A206 | 1 | 2 | 106-250 | B106 | A250 | 1 | 2 |

**Table 26**

| Compound No. | L₁ | L₂ | n1 | n2 | Compound No. | L₁ | L₂ | n1 | n2 |
|---|---|---|---|---|---|---|---|---|---|
| 111-1 | B111 | A1 | 1 | 2 | 111-208 | B111 | A208 | 1 | 2 |
| 111-2 | B111 | A2 | 1 | 2 | 111-209 | B111 | A209 | 1 | 2 |
| 111-3 | B111 | A3 | 1 | 2 | 111-212 | B111 | A212 | 1 | 2 |
| 111-5 | B111 | A5 | 1 | 2 | 111-213 | B111 | A213 | 1 | 2 |
| 111-8 | B111 | A8 | 1 | 2 | 111-214 | B111 | A214 | 1 | 2 |
| 111-35 | B111 | A35 | 1 | 2 | 111-215 | B111 | A215 | 1 | 2 |
| 111-36 | B111 | A36 | 1 | 2 | 111-216 | B111 | A216 | 1 | 2 |
| 111-45 | B111 | A45 | 1 | 2 | 111-217 | B111 | A217 | 1 | 2 |
| 111-47 | B111 | A47 | 1 | 2 | 111-221 | B111 | A221 | 1 | 2 |
| 111-49 | B111 | A49 | 1 | 2 | 111-222 | B111 | A222 | 1 | 2 |
| 111-60 | B111 | A60 | 1 | 2 | 111-224 | B111 | A224 | 1 | 2 |
| 111-86 | B111 | A86 | 1 | 2 | 111-225 | B111 | A225 | 1 | 2 |
| 111-94 | B111 | A94 | 1 | 2 | 111-226 | B111 | A226 | 1 | 2 |
| 111-99 | B111 | A99 | 1 | 2 | 111-228 | B111 | A228 | 1 | 2 |
| 111-101 | B111 | A101 | 1 | 2 | 111-229 | B111 | A229 | 1 | 2 |
| 111-139 | B111 | A139 | 1 | 2 | 111-231 | B111 | A231 | 1 | 2 |
| 111-161 | B111 | A161 | 1 | 2 | 111-232 | B111 | A232 | 1 | 2 |
| 111-162 | B111 | A162 | 1 | 2 | 111-233 | B111 | A233 | 1 | 2 |
| 111-181 | B111 | A181 | 1 | 2 | 111-235 | B111 | A235 | 1 | 2 |
| 111-182 | B111 | A182 | 1 | 2 | 111-236 | B111 | A236 | 1 | 2 |
| 111-191 | B111 | A191 | 1 | 2 | 111-237 | B111 | A237 | 1 | 2 |
| 111-192 | B111 | A192 | 1 | 2 | 111-238 | B111 | A238 | 1 | 2 |
| 111-193 | B111 | A193 | 1 | 2 | 111-239 | B111 | A239 | 1 | 2 |
| 111-194 | B111 | A194 | 1 | 2 | 111-241 | B111 | A241 | 1 | 2 |
| 111-196 | B111 | A196 | 1 | 2 | 111-242 | B111 | A242 | 1 | 2 |
| 111-197 | B111 | A197 | 1 | 2 | 111-243 | B111 | A243 | 1 | 2 |
| 111-199 | B111 | A199 | 1 | 2 | 111-246 | B111 | A246 | 1 | 2 |
| 111-200 | B111 | A200 | 1 | 2 | 111-247 | B111 | A247 | 1 | 2 |
| 111-201 | B111 | A201 | 1 | 2 | 111-248 | B111 | A248 | 1 | 2 |
| 111-203 | B111 | A203 | 1 | 2 | 111-249 | B111 | A249 | 1 | 2 |
| 111-206 | B111 | A206 | 1 | 2 | 111-250 | B111 | A250 | 1 | 2 |

**Table 27**

| Compound No. | L₁ | L₂ | n1 | n2 | Compound No. | L₁ | L₂ | n1 | n2 |
|---|---|---|---|---|---|---|---|---|---|
| 115-1 | B115 | A1 | 1 | 2 | 115-208 | B115 | A208 | 1 | 2 |
| 115-2 | B115 | A2 | 1 | 2 | 115-209 | B115 | A209 | 1 | 2 |
| 115-3 | B115 | A3 | 1 | 2 | 115-212 | B115 | A212 | 1 | 2 |
| 115-5 | B115 | A5 | 1 | 2 | 115-213 | B115 | A213 | 1 | 2 |
| 111-8 | B115 | A8 | 1 | 2 | 115-214 | B115 | A214 | 1 | 2 |
| 115-35 | B115 | A35 | 1 | 2 | 115-215 | B115 | A215 | 1 | 2 |
| 115-36 | B115 | A36 | 1 | 2 | 115-216 | B115 | A216 | 1 | 2 |
| 115-45 | B115 | A45 | 1 | 2 | 115-217 | B115 | A217 | 1 | 2 |
| 115-47 | B115 | A47 | 1 | 2 | 115-221 | B115 | A221 | 1 | 2 |
| 115-49 | B115 | A49 | 1 | 2 | 115-222 | B115 | A222 | 1 | 2 |
| 115-60 | B115 | A60 | 1 | 2 | 115-224 | B115 | A224 | 1 | 2 |
| 115-86 | B115 | A86 | 1 | 2 | 115-225 | B115 | A225 | 1 | 2 |
| 115-94 | B115 | A94 | 1 | 2 | 115-226 | B115 | A226 | 1 | 2 |
| 115-99 | B115 | A99 | 1 | 2 | 115-228 | B115 | A228 | 1 | 2 |
| 115-101 | B115 | A101 | 1 | 2 | 115-229 | B115 | A229 | 1 | 2 |
| 115-139 | B115 | A139 | 1 | 2 | 115-231 | B115 | A231 | 1 | 2 |
| 115-161 | B115 | A161 | 1 | 2 | 115-232 | B115 | A232 | 1 | 2 |
| 115-162 | B115 | A162 | 1 | 2 | 115-233 | B115 | A233 | 1 | 2 |
| 115-181 | B115 | A181 | 1 | 2 | 115-235 | B115 | A235 | 1 | 2 |
| 115-182 | B115 | A182 | 1 | 2 | 115-236 | B115 | A236 | 1 | 2 |
| 115-191 | B115 | A191 | 1 | 2 | 115-237 | B115 | A237 | 1 | 2 |
| 115-192 | B115 | A192 | 1 | 2 | 115-238 | B115 | A238 | 1 | 2 |
| 115-193 | B115 | A193 | 1 | 2 | 115-239 | B115 | A239 | 1 | 2 |
| 115-194 | B115 | A194 | 1 | 2 | 115-241 | B115 | A241 | 1 | 2 |
| 115-196 | B115 | A196 | 1 | 2 | 115-242 | B115 | A242 | 1 | 2 |
| 115-197 | B115 | A197 | 1 | 2 | 115-243 | B115 | A243 | 1 | 2 |
| 115-199 | B115 | A199 | 1 | 2 | 115-246 | B115 | A246 | 1 | 2 |
| 115-200 | B115 | A200 | 1 | 2 | 115-247 | B115 | A247 | 1 | 2 |
| 115-201 | B115 | A201 | 1 | 2 | 115-248 | B115 | A248 | 1 | 2 |
| 115-203 | B115 | A203 | 1 | 2 | 115-249 | B115 | A249 | 1 | 2 |
| 115-206 | B115 | A206 | 1 | 2 | 115-250 | B115 | A250 | 1 | 2 |

**Table 28**

| Compound No. | L₁ | L₂ | n1 | n2 | Compound No. | L₁ | L₂ | n1 | n2 |
|---|---|---|---|---|---|---|---|---|---|
| 122-1 | B122 | A1 | 1 | 2 | 122-208 | B122 | A208 | 1 | 2 |
| 122-2 | B122 | A2 | 1 | 2 | 122-209 | B122 | A209 | 1 | 2 |
| 122-3 | B122 | A3 | 1 | 2 | 122-212 | B122 | A212 | 1 | 2 |
| 122-5 | B122 | A5 | 1 | 2 | 122-213 | B122 | A213 | 1 | 2 |
| 122-8 | B122 | A8 | 1 | 2 | 122-214 | B122 | A214 | 1 | 2 |
| 122-35 | B122 | A35 | 1 | 2 | 122-215 | B122 | A215 | 1 | 2 |
| 122-36 | B122 | A36 | 1 | 2 | 122-216 | B122 | A216 | 1 | 2 |
| 122-45 | B122 | A45 | 1 | 2 | 122-217 | B122 | A217 | 1 | 2 |
| 122-47 | B122 | A47 | 1 | 2 | 122-221 | B122 | A221 | 1 | 2 |
| 122-49 | B122 | A49 | 1 | 2 | 122-222 | B122 | A222 | 1 | 2 |
| 122-60 | B122 | A60 | 1 | 2 | 122-224 | B122 | A224 | 1 | 2 |
| 122-86 | B122 | A86 | 1 | 2 | 122-225 | B122 | A225 | 1 | 2 |
| 122-94 | B122 | A94 | 1 | 2 | 122-226 | B122 | A226 | 1 | 2 |
| 122-99 | B122 | A99 | 1 | 2 | 122-228 | B122 | A228 | 1 | 2 |
| 122-101 | B122 | A101 | 1 | 2 | 122-229 | B122 | A229 | 1 | 2 |
| 122-139 | B122 | A139 | 1 | 2 | 122-231 | B122 | A231 | 1 | 2 |
| 122-161 | B122 | A161 | 1 | 2 | 122-232 | B122 | A232 | 1 | 2 |
| 122-162 | B122 | A162 | 1 | 2 | 122-233 | B122 | A233 | 1 | 2 |
| 122-181 | B122 | A181 | 1 | 2 | 122-235 | B122 | A235 | 1 | 2 |
| 122-182 | B122 | A182 | 1 | 2 | 122-236 | B122 | A236 | 1 | 2 |
| 122-191 | B122 | A191 | 1 | 2 | 122-237 | B122 | A237 | 1 | 2 |
| 122-192 | B122 | A192 | 1 | 2 | 122-238 | B122 | A238 | 1 | 2 |
| 122-193 | B122 | A193 | 1 | 2 | 122-239 | B122 | A239 | 1 | 2 |
| 122-194 | B122 | A194 | 1 | 2 | 122-241 | B122 | A241 | 1 | 2 |
| 122-196 | B122 | A196 | 1 | 2 | 122-242 | B122 | A242 | 1 | 2 |
| 122-197 | B122 | A197 | 1 | 2 | 122-243 | B122 | A243 | 1 | 2 |
| 122-199 | B122 | A199 | 1 | 2 | 122-246 | B122 | A246 | 1 | 2 |
| 122-200 | B122 | A200 | 1 | 2 | 122-247 | B122 | A247 | 1 | 2 |
| 122-201 | B122 | A201 | 1 | 2 | 122-248 | B122 | A248 | 1 | 2 |
| 122-203 | B122 | A203 | 1 | 2 | 122-249 | B122 | A249 | 1 | 2 |
| 122-206 | B122 | A206 | 1 | 2 | 122-250 | B122 | A250 | 1 | 2 |

**Table 29**

| Compound No. | L₁ | L₂ | n1 | n2 | Compound No. | L₁ | L₂ | n1 | n2 |
|---|---|---|---|---|---|---|---|---|---|
| 146-1 | B146 | A1 | 1 | 2 | 146-208 | B146 | A208 | 1 | 2 |
| 146-2 | B146 | A2 | 1 | 2 | 146-209 | B146 | A209 | 1 | 2 |
| 146-3 | B146 | A3 | 1 | 2 | 146-212 | B146 | A212 | 1 | 2 |
| 146-5 | B146 | A5 | 1 | 2 | 146-213 | B146 | A213 | 1 | 2 |
| 146-8 | B146 | A8 | 1 | 2 | 146-214 | B146 | A214 | 1 | 2 |
| 146-35 | B146 | A35 | 1 | 2 | 146-215 | B146 | A215 | 1 | 2 |
| 146-36 | B146 | A36 | 1 | 2 | 146-216 | B146 | A216 | 1 | 2 |
| 146-45 | B146 | A45 | 1 | 2 | 146-217 | B146 | A217 | 1 | 2 |
| 146-47 | B146 | A47 | 1 | 2 | 146-221 | B146 | A221 | 1 | 2 |
| 146-49 | B146 | A49 | 1 | 2 | 146-222 | B146 | A222 | 1 | 2 |
| 146-60 | B146 | A60 | 1 | 2 | 146-224 | B146 | A224 | 1 | 2 |
| 146-86 | B146 | A86 | 1 | 2 | 146-225 | B146 | A225 | 1 | 2 |
| 146-94 | B146 | A94 | 1 | 2 | 146-226 | B146 | A226 | 1 | 2 |
| 146-99 | B146 | A99 | 1 | 2 | 146-228 | B146 | A228 | 1 | 2 |
| 146-101 | B146 | A101 | 1 | 2 | 146-229 | B146 | A229 | 1 | 2 |
| 146-139 | B146 | A139 | 1 | 2 | 146-231 | B146 | A231 | 1 | 2 |
| 146-161 | B146 | A161 | 1 | 2 | 146-232 | B146 | A232 | 1 | 2 |
| 146-162 | B146 | A162 | 1 | 2 | 146-233 | B146 | A233 | 1 | 2 |
| 146-181 | B146 | A181 | 1 | 2 | 146-235 | B146 | A235 | 1 | 2 |
| 146-182 | B146 | A182 | 1 | 2 | 146-236 | B146 | A236 | 1 | 2 |
| 146-191 | B146 | A191 | 1 | 2 | 146-237 | B146 | A237 | 1 | 2 |
| 146-192 | B146 | A192 | 1 | 2 | 146-238 | B146 | A238 | 1 | 2 |
| 146-193 | B146 | A193 | 1 | 2 | 146-239 | B146 | A239 | 1 | 2 |
| 146-194 | B146 | A194 | 1 | 2 | 146-241 | B146 | A241 | 1 | 2 |
| 146-196 | B146 | A196 | 1 | 2 | 146-242 | B146 | A242 | 1 | 2 |
| 146-197 | B146 | A197 | 1 | 2 | 146-243 | B146 | A243 | 1 | 2 |
| 146-199 | B146 | A199 | 1 | 2 | 146-246 | B146 | A246 | 1 | 2 |
| 146-200 | B146 | A200 | 1 | 2 | 146-247 | B146 | A247 | 1 | 2 |
| 146-201 | B146 | A201 | 1 | 2 | 146-248 | B146 | A248 | 1 | 2 |
| 146-203 | B146 | A203 | 1 | 2 | 146-249 | B146 | A249 | 1 | 2 |
| 146-206 | B146 | A206 | 1 | 2 | 146-250 | B146 | A250 | 1 | 2 |

**Table 30**

| Compound No. | L₁ | L₂ | n1 | n2 | Compound No. | L₁ | L₂ | n1 | n2 |
|---|---|---|---|---|---|---|---|---|---|
| 183-1 | B183 | A1 | 1 | 2 | 183-208 | B183 | A208 | 1 | 2 |
| 183-2 | B183 | A2 | 1 | 2 | 183-209 | B183 | A209 | 1 | 2 |
| 183-3 | B183 | A3 | 1 | 2 | 183-212 | B183 | A212 | 1 | 2 |
| 183-5 | B183 | A5 | 1 | 2 | 183-213 | B183 | A213 | 1 | 2 |
| 183-8 | B183 | A8 | 1 | 2 | 183-214 | B183 | A214 | 1 | 2 |
| 183-35 | B183 | A35 | 1 | 2 | 183-215 | B183 | A215 | 1 | 2 |
| 183-36 | B183 | A36 | 1 | 2 | 183-216 | B183 | A216 | 1 | 2 |
| 183-45 | B183 | A45 | 1 | 2 | 183-217 | B183 | A217 | 1 | 2 |
| 183-47 | B183 | A47 | 1 | 2 | 183-221 | B183 | A221 | 1 | 2 |
| 183-49 | B183 | A49 | 1 | 2 | 183-222 | B183 | A222 | 1 | 2 |
| 183-60 | B183 | A60 | 1 | 2 | 183-224 | B183 | A224 | 1 | 2 |
| 183-86 | B183 | A86 | 1 | 2 | 183-225 | B183 | A225 | 1 | 2 |
| 183-94 | B183 | A94 | 1 | 2 | 183-226 | B183 | A226 | 1 | 2 |
| 183-99 | B183 | A99 | 1 | 2 | 183-228 | B183 | A228 | 1 | 2 |
| 183-101 | B183 | A101 | 1 | 2 | 183-229 | B183 | A229 | 1 | 2 |
| 183-139 | B183 | A139 | 1 | 2 | 183-231 | B183 | A231 | 1 | 2 |
| 183-161 | B183 | A161 | 1 | 2 | 183-232 | B183 | A232 | 1 | 2 |
| 183-162 | B183 | A162 | 1 | 2 | 183-233 | B183 | A233 | 1 | 2 |
| 183-181 | B183 | A181 | 1 | 2 | 183-235 | B183 | A235 | 1 | 2 |
| 183-182 | B183 | A182 | 1 | 2 | 183-236 | B183 | A236 | 1 | 2 |
| 183-191 | B183 | A191 | 1 | 2 | 183-237 | B183 | A237 | 1 | 2 |
| 183-192 | B183 | A192 | 1 | 2 | 183-238 | B183 | A238 | 1 | 2 |
| 183-193 | B183 | A193 | 1 | 2 | 183-239 | B183 | A239 | 1 | 2 |
| 183-194 | B183 | A194 | 1 | 2 | 183-241 | B183 | A241 | 1 | 2 |
| 183-196 | B183 | A196 | 1 | 2 | 183-242 | B183 | A242 | 1 | 2 |
| 183-197 | B183 | A197 | 1 | 2 | 183-243 | B183 | A243 | 1 | 2 |
| 183-199 | B183 | A199 | 1 | 2 | 183-246 | B183 | A246 | 1 | 2 |
| 183-200 | B183 | A200 | 1 | 2 | 183-247 | B183 | A247 | 1 | 2 |
| 183-201 | B183 | A201 | 1 | 2 | 183-248 | B183 | A248 | 1 | 2 |
| 183-203 | B183 | A203 | 1 | 2 | 183-249 | B183 | A249 | 1 | 2 |
| 183-206 | B183 | A206 | 1 | 2 | 183-250 | B183 | A250 | 1 | 2 |

**Table 31**

| Compound No. | L₁ | L₂ | n1 | n2 | Compound No. | L₁ | L₂ | n1 | n2 |
|---|---|---|---|---|---|---|---|---|---|
| 201-1 | B201 | A1 | 1 | 2 | 201-208 | B201 | A208 | 1 | 2 |
| 201-2 | B201 | A2 | 1 | 2 | 201-209 | B201 | A209 | 1 | 2 |
| 201-3 | B201 | A3 | 1 | 2 | 201-212 | B201 | A212 | 1 | 2 |
| 201-5 | B201 | A5 | 1 | 2 | 201-213 | B201 | A213 | 1 | 2 |
| 201-8 | B201 | A8 | 1 | 2 | 201-214 | B201 | A214 | 1 | 2 |
| 201-35 | B201 | A35 | 1 | 2 | 201-215 | B201 | A215 | 1 | 2 |
| 201-36 | B201 | A36 | 1 | 2 | 201-216 | B201 | A216 | 1 | 2 |
| 201-45 | B201 | A45 | 1 | 2 | 201-217 | B201 | A217 | 1 | 2 |
| 201-47 | B201 | A47 | 1 | 2 | 201-221 | B201 | A221 | 1 | 2 |
| 201-49 | B201 | A49 | 1 | 2 | 201-222 | B201 | A222 | 1 | 2 |
| 201-60 | B201 | A60 | 1 | 2 | 201-224 | B201 | A224 | 1 | 2 |
| 201-86 | B201 | A86 | 1 | 2 | 201-225 | B201 | A225 | 1 | 2 |
| 201-94 | B201 | A94 | 1 | 2 | 201-226 | B201 | A226 | 1 | 2 |
| 201-99 | B201 | A99 | 1 | 2 | 201-228 | B201 | A228 | 1 | 2 |
| 201-101 | B201 | A101 | 1 | 2 | 201-229 | B201 | A229 | 1 | 2 |
| 201-139 | B201 | A139 | 1 | 2 | 201-231 | B201 | A231 | 1 | 2 |
| 201-161 | B201 | A161 | 1 | 2 | 201-232 | B201 | A232 | 1 | 2 |
| 201-162 | B201 | A162 | 1 | 2 | 201-233 | B201 | A233 | 1 | 2 |
| 201-181 | B201 | A181 | 1 | 2 | 201-235 | B201 | A235 | 1 | 2 |
| 201-182 | B201 | A182 | 1 | 2 | 201-236 | B201 | A236 | 1 | 2 |
| 201-191 | B201 | A191 | 1 | 2 | 201-237 | B201 | A237 | 1 | 2 |
| 201-192 | B201 | A192 | 1 | 2 | 201-238 | B201 | A238 | 1 | 2 |
| 201-193 | B201 | A193 | 1 | 2 | 201-239 | B201 | A239 | 1 | 2 |
| 201-194 | B201 | A194 | 1 | 2 | 201-241 | B201 | A241 | 1 | 2 |
| 201-196 | B201 | A196 | 1 | 2 | 201-242 | B201 | A242 | 1 | 2 |
| 201-197 | B201 | A197 | 1 | 2 | 201-243 | B201 | A243 | 1 | 2 |
| 201-199 | B201 | A199 | 1 | 2 | 201-246 | B201 | A246 | 1 | 2 |
| 201-200 | B201 | A200 | 1 | 2 | 201-247 | B201 | A247 | 1 | 2 |
| 201-201 | B201 | A201 | 1 | 2 | 201-248 | B201 | A248 | 1 | 2 |
| 201-203 | B201 | A203 | 1 | 2 | 201-249 | B201 | A249 | 1 | 2 |
| 201-206 | B201 | A206 | 1 | 2 | 201-250 | B201 | A250 | 1 | 2 |

**Table 32**

| Compound No. | L₁ | L₂ | n1 | n2 | Compound No. | L₁ | L₂ | n1 | n2 |
|---|---|---|---|---|---|---|---|---|---|
| 214-1 | B214 | A1 | 1 | 2 | 214-208 | B214 | A208 | 1 | 2 |
| 214-2 | B214 | A2 | 1 | 2 | 214-209 | B214 | A209 | 1 | 2 |
| 214-3 | B214 | A3 | 1 | 2 | 214-212 | B214 | A212 | 1 | 2 |
| 214-5 | B214 | A5 | 1 | 2 | 214-213 | B214 | A213 | 1 | 2 |
| 214-8 | B214 | A8 | 1 | 2 | 214-214 | B214 | A214 | 1 | 2 |
| 214-35 | B214 | A35 | 1 | 2 | 214-215 | B214 | A215 | 1 | 2 |
| 214-36 | B214 | A36 | 1 | 2 | 214-216 | B214 | A216 | 1 | 2 |
| 214-45 | B214 | A45 | 1 | 2 | 214-217 | B214 | A217 | 1 | 2 |
| 214-47 | B214 | A47 | 1 | 2 | 214-221 | B214 | A221 | 1 | 2 |
| 214-49 | B214 | A49 | 1 | 2 | 214-222 | B214 | A222 | 1 | 2 |
| 214-60 | B214 | A60 | 1 | 2 | 214-224 | B214 | A224 | 1 | 2 |
| 214-86 | B214 | A86 | 1 | 2 | 214-225 | B214 | A225 | 1 | 2 |
| 214-94 | B214 | A94 | 1 | 2 | 214-226 | B214 | A226 | 1 | 2 |
| 214-99 | B214 | A99 | 1 | 2 | 214-228 | B214 | A228 | 1 | 2 |
| 214-101 | B214 | A101 | 1 | 2 | 214-229 | B214 | A229 | 1 | 2 |
| 214-139 | B214 | A139 | 1 | 2 | 214-231 | B214 | A231 | 1 | 2 |
| 214-161 | B214 | A161 | 1 | 2 | 214-232 | B214 | A232 | 1 | 2 |
| 214-162 | B214 | A162 | 1 | 2 | 214-233 | B214 | A233 | 1 | 2 |
| 214-181 | B214 | A181 | 1 | 2 | 214-235 | B214 | A235 | 1 | 2 |
| 214-182 | B214 | A182 | 1 | 2 | 214-236 | B214 | A236 | 1 | 2 |
| 214-191 | B214 | A191 | 1 | 2 | 214-237 | B214 | A237 | 1 | 2 |
| 214-192 | B214 | A192 | 1 | 2 | 214-238 | B214 | A238 | 1 | 2 |
| 214-193 | B214 | A193 | 1 | 2 | 214-239 | B214 | A239 | 1 | 2 |
| 214-194 | B214 | A194 | 1 | 2 | 214-241 | B214 | A241 | 1 | 2 |
| 214-196 | B214 | A196 | 1 | 2 | 214-242 | B214 | A242 | 1 | 2 |
| 214-197 | B214 | A197 | 1 | 2 | 214-243 | B214 | A243 | 1 | 2 |
| 214-199 | B214 | A199 | 1 | 2 | 214-246 | B214 | A246 | 1 | 2 |
| 214-200 | B214 | A200 | 1 | 2 | 214-247 | B214 | A247 | 1 | 2 |
| 214-201 | B214 | A201 | 1 | 2 | 214-248 | B214 | A248 | 1 | 2 |
| 214-203 | B214 | A203 | 1 | 2 | 214-249 | B214 | A249 | 1 | 2 |
| 214-206 | B214 | A206 | 1 | 2 | 214-250 | B214 | A250 | 1 | 2 |

**Table 33**

| Compound No. | L₁ | L₂ | n1 | n2 | Compound No. | L₁ | L₂ | n1 | n2 |
|---|---|---|---|---|---|---|---|---|---|
| 223-1 | B223 | A1 | 1 | 2 | 223-208 | B223 | A208 | 1 | 2 |
| 223-2 | B223 | A2 | 1 | 2 | 223-209 | B223 | A209 | 1 | 2 |
| 223-3 | B223 | A3 | 1 | 2 | 223-212 | B223 | A212 | 1 | 2 |
| 223-5 | B223 | A5 | 1 | 2 | 223-213 | B223 | A213 | 1 | 2 |
| 223-8 | B223 | A8 | 1 | 2 | 223-214 | B223 | A214 | 1 | 2 |
| 223-35 | B223 | A35 | 1 | 2 | 223-215 | B223 | A215 | 1 | 2 |
| 223-36 | B223 | A36 | 1 | 2 | 223-216 | B223 | A216 | 1 | 2 |
| 223-45 | B223 | A45 | 1 | 2 | 223-217 | B223 | A217 | 1 | 2 |
| 223-47 | B223 | A47 | 1 | 2 | 223-221 | B223 | A221 | 1 | 2 |
| 223-49 | B223 | A49 | 1 | 2 | 223-222 | B223 | A222 | 1 | 2 |
| 223-60 | B223 | A60 | 1 | 2 | 223-224 | B223 | A224 | 1 | 2 |
| 223-86 | B223 | A86 | 1 | 2 | 223-225 | B223 | A225 | 1 | 2 |
| 223-94 | B223 | A94 | 1 | 2 | 223-226 | B223 | A226 | 1 | 2 |
| 223-99 | B223 | A99 | 1 | 2 | 223-228 | B223 | A228 | 1 | 2 |
| 223-101 | B223 | A101 | 1 | 2 | 223-229 | B223 | A229 | 1 | 2 |
| 223-139 | B223 | A139 | 1 | 2 | 223-231 | B223 | A231 | 1 | 2 |
| 223-161 | B223 | A161 | 1 | 2 | 223-232 | B223 | A232 | 1 | 2 |
| 223-162 | B223 | A162 | 1 | 2 | 223-233 | B223 | A233 | 1 | 2 |
| 223-181 | B223 | A181 | 1 | 2 | 223-235 | B223 | A235 | 1 | 2 |
| 223-182 | B223 | A182 | 1 | 2 | 223-236 | B223 | A236 | 1 | 2 |
| 223-191 | B223 | A191 | 1 | 2 | 223-237 | B223 | A237 | 1 | 2 |
| 223-192 | B223 | A192 | 1 | 2 | 223-238 | B223 | A238 | 1 | 2 |
| 223-193 | B223 | A193 | 1 | 2 | 223-239 | B223 | A239 | 1 | 2 |
| 223-194 | B223 | A194 | 1 | 2 | 223-241 | B223 | A241 | 1 | 2 |
| 223-196 | B223 | A196 | 1 | 2 | 223-242 | B223 | A242 | 1 | 2 |
| 223-197 | B223 | A197 | 1 | 2 | 223-243 | B223 | A243 | 1 | 2 |
| 223-199 | B223 | A199 | 1 | 2 | 223-246 | B223 | A246 | 1 | 2 |
| 223-200 | B223 | A200 | 1 | 2 | 223-247 | B223 | A247 | 1 | 2 |
| 223-201 | B223 | A201 | 1 | 2 | 223-248 | B223 | A248 | 1 | 2 |
| 223-203 | B223 | A203 | 1 | 2 | 223-249 | B223 | A249 | 1 | 2 |
| 223-206 | B223 | A206 | 1 | 2 | 223-250 | B223 | A250 | 1 | 2 |

**Table 34**

| Compound No. | L₁ | L₂ | n1 | n2 | Compound No. | L₁ | L₂ | n1 | n2 |
|---|---|---|---|---|---|---|---|---|---|
| 242-1 | B242 | A1 | 1 | 2 | 242-208 | B242 | A208 | 1 | 2 |
| 242-2 | B242 | A2 | 1 | 2 | 242-209 | B242 | A209 | 1 | 2 |
| 242-3 | B242 | A3 | 1 | 2 | 242-212 | B242 | A212 | 1 | 2 |
| 242-5 | B242 | A5 | 1 | 2 | 242-213 | B242 | A213 | 1 | 2 |
| 242-8 | B242 | A8 | 1 | 2 | 242-214 | B242 | A214 | 1 | 2 |
| 242-35 | B242 | A35 | 1 | 2 | 242-215 | B242 | A215 | 1 | 2 |
| 242-36 | B242 | A36 | 1 | 2 | 242-216 | B242 | A216 | 1 | 2 |
| 242-45 | B242 | A45 | 1 | 2 | 242-217 | B242 | A217 | 1 | 2 |
| 242-47 | B242 | A47 | 1 | 2 | 242-221 | B242 | A221 | 1 | 2 |
| 242-49 | B242 | A49 | 1 | 2 | 242-222 | B242 | A222 | 1 | 2 |
| 242-60 | B242 | A60 | 1 | 2 | 242-224 | B242 | A224 | 1 | 2 |
| 242-86 | B242 | A86 | 1 | 2 | 242-225 | B242 | A225 | 1 | 2 |
| 242-94 | B242 | A94 | 1 | 2 | 242-226 | B242 | A226 | 1 | 2 |
| 242-99 | B242 | A99 | 1 | 2 | 242-228 | B242 | A228 | 1 | 2 |
| 242-101 | B242 | A101 | 1 | 2 | 242-229 | B242 | A229 | 1 | 2 |
| 242-139 | B242 | A139 | 1 | 2 | 242-231 | B242 | A231 | 1 | 2 |
| 242-161 | B242 | A161 | 1 | 2 | 242-232 | B242 | A232 | 1 | 2 |
| 242-162 | B242 | A162 | 1 | 2 | 242-233 | B242 | A233 | 1 | 2 |
| 242-181 | B242 | A181 | 1 | 2 | 242-235 | B242 | A235 | 1 | 2 |
| 242-182 | B242 | A182 | 1 | 2 | 242-236 | B242 | A236 | 1 | 2 |
| 242-191 | B242 | A191 | 1 | 2 | 242-237 | B242 | A237 | 1 | 2 |
| 242-192 | B242 | A192 | 1 | 2 | 242-238 | B242 | A238 | 1 | 2 |
| 242-193 | B242 | A193 | 1 | 2 | 242-239 | B242 | A239 | 1 | 2 |
| 242-194 | B242 | A194 | 1 | 2 | 242-241 | B242 | A241 | 1 | 2 |
| 242-196 | B242 | A196 | 1 | 2 | 242-242 | B242 | A242 | 1 | 2 |
| 242-197 | B242 | A197 | 1 | 2 | 242-243 | B242 | A243 | 1 | 2 |
| 242-199 | B242 | A199 | 1 | 2 | 242-246 | B242 | A246 | 1 | 2 |
| 242-200 | B242 | A200 | 1 | 2 | 242-247 | B242 | A247 | 1 | 2 |
| 242-201 | B242 | A201 | 1 | 2 | 242-248 | B242 | A248 | 1 | 2 |
| 242-203 | B242 | A203 | 1 | 2 | 242-249 | B242 | A249 | 1 | 2 |
| 242-206 | B242 | A206 | 1 | 2 | 242-250 | B242 | A250 | 1 | 2 |

**Table 35**

| Compound No. | L₁ | L₂ | n1 | n2 | Compound No. | L₁ | L₂ | n1 | n2 |
|---|---|---|---|---|---|---|---|---|---|
| 253-1 | B253 | A1 | 1 | 2 | 253-208 | B253 | A208 | 1 | 2 |
| 253-2 | B253 | A2 | 1 | 2 | 253-209 | B253 | A209 | 1 | 2 |
| 253-3 | B253 | A3 | 1 | 2 | 253-212 | B253 | A212 | 1 | 2 |
| 253-5 | B253 | A5 | 1 | 2 | 253-213 | B253 | A213 | 1 | 2 |
| 253-8 | B253 | A8 | 1 | 2 | 253-214 | B253 | A214 | 1 | 2 |
| 253-35 | B253 | A35 | 1 | 2 | 253-215 | B253 | A215 | 1 | 2 |
| 253-36 | B253 | A36 | 1 | 2 | 253-216 | B253 | A216 | 1 | 2 |
| 253-45 | B253 | A45 | 1 | 2 | 253-217 | B253 | A217 | 1 | 2 |
| 253-47 | B253 | A47 | 1 | 2 | 253-221 | B253 | A221 | 1 | 2 |
| 253-49 | B253 | A49 | 1 | 2 | 253-222 | B253 | A222 | 1 | 2 |
| 253-60 | B253 | A60 | 1 | 2 | 253-224 | B253 | A224 | 1 | 2 |
| 253-86 | B253 | A86 | 1 | 2 | 253-225 | B253 | A225 | 1 | 2 |
| 253-94 | B253 | A94 | 1 | 2 | 253-226 | B253 | A226 | 1 | 2 |
| 253-99 | B253 | A99 | 1 | 2 | 253-228 | B253 | A228 | 1 | 2 |
| 253-101 | B253 | A101 | 1 | 2 | 253-229 | B253 | A229 | 1 | 2 |
| 253-139 | B253 | A139 | 1 | 2 | 253-231 | B253 | A231 | 1 | 2 |
| 253-161 | B253 | A161 | 1 | 2 | 253-232 | B253 | A232 | 1 | 2 |
| 253-162 | B253 | A162 | 1 | 2 | 253-233 | B253 | A233 | 1 | 2 |
| 253-181 | B253 | A181 | 1 | 2 | 253-235 | B253 | A235 | 1 | 2 |
| 253-182 | B253 | A182 | 1 | 2 | 253-236 | B253 | A236 | 1 | 2 |
| 253-191 | B253 | A191 | 1 | 2 | 253-237 | B253 | A237 | 1 | 2 |
| 253-192 | B253 | A192 | 1 | 2 | 253-238 | B253 | A238 | 1 | 2 |
| 253-193 | B253 | A193 | 1 | 2 | 253-239 | B253 | A239 | 1 | 2 |
| 253-194 | B253 | A194 | 1 | 2 | 253-241 | B253 | A241 | 1 | 2 |
| 253-196 | B253 | A196 | 1 | 2 | 253-242 | B253 | A242 | 1 | 2 |
| 253-197 | B253 | A197 | 1 | 2 | 253-243 | B253 | A243 | 1 | 2 |
| 253-199 | B253 | A199 | 1 | 2 | 253-246 | B253 | A246 | 1 | 2 |
| 253-200 | B253 | A200 | 1 | 2 | 253-247 | B253 | A247 | 1 | 2 |
| 253-201 | B253 | A201 | 1 | 2 | 253-248 | B253 | A248 | 1 | 2 |
| 253-203 | B253 | A203 | 1 | 2 | 253-249 | B253 | A249 | 1 | 2 |
| 253-206 | B253 | A206 | 1 | 2 | 253-250 | B253 | A250 | 1 | 2 |

**Table 36**

| Compound No. | L₁ | L₂ | n1 | n2 | Compound No. | L₁ | L₂ | n1 | n2 |
|---|---|---|---|---|---|---|---|---|---|
| 265-1 | B265 | A1 | 1 | 2 | 265-208 | B265 | A208 | 1 | 2 |
| 265-2 | B265 | A2 | 1 | 2 | 265-209 | B265 | A209 | 1 | 2 |
| 265-3 | B265 | A3 | 1 | 2 | 265-212 | B265 | A212 | 1 | 2 |
| 265-5 | B265 | A5 | 1 | 2 | 265-213 | B265 | A213 | 1 | 2 |
| 265-8 | B265 | A8 | 1 | 2 | 265-214 | B265 | A214 | 1 | 2 |
| 265-35 | B265 | A35 | 1 | 2 | 265-215 | B265 | A215 | 1 | 2 |
| 265-36 | B265 | A36 | 1 | 2 | 265-216 | B265 | A216 | 1 | 2 |
| 265-45 | B265 | A45 | 1 | 2 | 265-217 | B265 | A217 | 1 | 2 |
| 265-47 | B265 | A47 | 1 | 2 | 265-221 | B265 | A221 | 1 | 2 |
| 265-49 | B265 | A49 | 1 | 2 | 265-222 | B265 | A222 | 1 | 2 |
| 265-60 | B265 | A60 | 1 | 2 | 265-224 | B265 | A224 | 1 | 2 |
| 265-86 | B265 | A86 | 1 | 2 | 265-225 | B265 | A225 | 1 | 2 |
| 265-94 | B265 | A94 | 1 | 2 | 265-226 | B265 | A226 | 1 | 2 |
| 265-99 | B265 | A99 | 1 | 2 | 265-228 | B265 | A228 | 1 | 2 |
| 265-101 | B265 | A101 | 1 | 2 | 265-229 | B265 | A229 | 1 | 2 |
| 265-139 | B265 | A139 | 1 | 2 | 265-231 | B265 | A231 | 1 | 2 |
| 265-161 | B265 | A161 | 1 | 2 | 265-232 | B265 | A232 | 1 | 2 |
| 265-162 | B265 | A162 | 1 | 2 | 265-233 | B265 | A233 | 1 | 2 |
| 265-181 | B265 | A181 | 1 | 2 | 265-235 | B265 | A235 | 1 | 2 |
| 265-182 | B265 | A182 | 1 | 2 | 265-236 | B265 | A236 | 1 | 2 |
| 265-191 | B265 | A191 | 1 | 2 | 265-237 | B265 | A237 | 1 | 2 |
| 265-192 | B265 | A192 | 1 | 2 | 265-238 | B265 | A238 | 1 | 2 |
| 265-193 | B265 | A193 | 1 | 2 | 265-239 | B265 | A239 | 1 | 2 |
| 265-194 | B265 | A194 | 1 | 2 | 265-241 | B265 | A241 | 1 | 2 |
| 265-196 | B265 | A196 | 1 | 2 | 265-242 | B265 | A242 | 1 | 2 |
| 265-197 | B265 | A197 | 1 | 2 | 265-243 | B265 | A243 | 1 | 2 |
| 265-199 | B265 | A199 | 1 | 2 | 265-246 | B265 | A246 | 1 | 2 |
| 265-200 | B265 | A200 | 1 | 2 | 265-247 | B265 | A247 | 1 | 2 |
| 265-201 | B265 | A201 | 1 | 2 | 265-248 | B265 | A248 | 1 | 2 |
| 265-203 | B265 | A203 | 1 | 2 | 265-249 | B265 | A249 | 1 | 2 |
| 265-206 | B265 | A206 | 1 | 2 | 265-250 | B265 | A250 | 1 | 2 |

**Table 37**

| Compound No. | L₁ | L₂ | n1 | n2 | Compound No. | L₁ | L₂ | n1 | n2 |
|---|---|---|---|---|---|---|---|---|---|
| 282-1 | B282 | A1 | 1 | 2 | 282-208 | B282 | A208 | 1 | 2 |
| 282-2 | B282 | A2 | 1 | 2 | 282-209 | B282 | A209 | 1 | 2 |
| 282-3 | B282 | A3 | 1 | 2 | 282-212 | B282 | A212 | 1 | 2 |
| 282-5 | B282 | A5 | 1 | 2 | 282-213 | B282 | A213 | 1 | 2 |
| 282-8 | B282 | A8 | 1 | 2 | 282-214 | B282 | A214 | 1 | 2 |
| 282-35 | B282 | A35 | 1 | 2 | 282-215 | B282 | A215 | 1 | 2 |
| 282-36 | B282 | A36 | 1 | 2 | 282-216 | B282 | A216 | 1 | 2 |
| 282-45 | B282 | A45 | 1 | 2 | 282-217 | B282 | A217 | 1 | 2 |
| 282-47 | B282 | A47 | 1 | 2 | 282-221 | B282 | A221 | 1 | 2 |
| 282-49 | B282 | A49 | 1 | 2 | 282-222 | B282 | A222 | 1 | 2 |
| 282-60 | B282 | A60 | 1 | 2 | 282-224 | B282 | A224 | 1 | 2 |
| 282-86 | B282 | A86 | 1 | 2 | 282-225 | B282 | A225 | 1 | 2 |
| 282-94 | B282 | A94 | 1 | 2 | 282-226 | B282 | A226 | 1 | 2 |
| 282-99 | B282 | A99 | 1 | 2 | 282-228 | B282 | A228 | 1 | 2 |
| 282-101 | B282 | A101 | 1 | 2 | 282-229 | B282 | A229 | 1 | 2 |
| 282-139 | B282 | A139 | 1 | 2 | 282-231 | B282 | A231 | 1 | 2 |
| 282-161 | B282 | A161 | 1 | 2 | 282-232 | B282 | A232 | 1 | 2 |
| 282-162 | B282 | A162 | 1 | 2 | 282-233 | B282 | A233 | 1 | 2 |
| 282-181 | B282 | A181 | 1 | 2 | 282-235 | B282 | A235 | 1 | 2 |
| 282-182 | B282 | A182 | 1 | 2 | 282-236 | B282 | A236 | 1 | 2 |
| 282-191 | B282 | A191 | 1 | 2 | 282-237 | B282 | A237 | 1 | 2 |
| 282-192 | B282 | A192 | 1 | 2 | 282-238 | B282 | A238 | 1 | 2 |
| 282-193 | B282 | A193 | 1 | 2 | 282-239 | B282 | A239 | 1 | 2 |
| 282-194 | B282 | A194 | 1 | 2 | 282-241 | B282 | A241 | 1 | 2 |
| 282-196 | B282 | A196 | 1 | 2 | 282-242 | B282 | A242 | 1 | 2 |
| 282-197 | B282 | A197 | 1 | 2 | 282-243 | B282 | A243 | 1 | 2 |
| 282-199 | B282 | A199 | 1 | 2 | 282-246 | B282 | A246 | 1 | 2 |
| 282-200 | B282 | A200 | 1 | 2 | 282-247 | B282 | A247 | 1 | 2 |
| 282-201 | B282 | A201 | 1 | 2 | 282-248 | B282 | A248 | 1 | 2 |
| 282-203 | B282 | A203 | 1 | 2 | 282-249 | B282 | A249 | 1 | 2 |
| 282-206 | B282 | A206 | 1 | 2 | 282-250 | B282 | A250 | 1 | 2 |

**Table 38**

| Compound No. | L₁ | L₂ | n1 | n2 | Compound No. | L₁ | L₂ | n1 | n2 |
|---|---|---|---|---|---|---|---|---|---|
| 287-1 | B287 | A1 | 1 | 2 | 287-208 | B287 | A208 | 1 | 2 |
| 287-2 | B287 | A2 | 1 | 2 | 287-209 | B287 | A209 | 1 | 2 |
| 287-3 | B287 | A3 | 1 | 2 | 287-212 | B287 | A212 | 1 | 2 |
| 287-5 | B287 | A5 | 1 | 2 | 287-213 | B287 | A213 | 1 | 2 |
| 287-8 | B287 | A8 | 1 | 2 | 287-214 | B287 | A214 | 1 | 2 |
| 287-35 | B287 | A35 | 1 | 2 | 287-215 | B287 | A215 | 1 | 2 |
| 287-36 | B287 | A36 | 1 | 2 | 287-216 | B287 | A216 | 1 | 2 |
| 287-45 | B287 | A45 | 1 | 2 | 287-217 | B287 | A217 | 1 | 2 |
| 287-47 | B287 | A47 | 1 | 2 | 287-221 | B287 | A221 | 1 | 2 |
| 287-49 | B287 | A49 | 1 | 2 | 287-222 | B287 | A222 | 1 | 2 |
| 287-60 | B287 | A60 | 1 | 2 | 287-224 | B287 | A224 | 1 | 2 |
| 287-86 | B287 | A86 | 1 | 2 | 287-225 | B287 | A225 | 1 | 2 |
| 287-94 | B287 | A94 | 1 | 2 | 287-226 | B287 | A226 | 1 | 2 |
| 287-99 | B287 | A99 | 1 | 2 | 287-228 | B287 | A228 | 1 | 2 |
| 287-101 | B287 | A101 | 1 | 2 | 287-229 | B287 | A229 | 1 | 2 |
| 287-139 | B287 | A139 | 1 | 2 | 287-231 | B287 | A231 | 1 | 2 |
| 287-161 | B287 | A161 | 1 | 2 | 287-232 | B287 | A232 | 1 | 2 |
| 287-162 | B287 | A162 | 1 | 2 | 287-233 | B287 | A233 | 1 | 2 |
| 287-181 | B287 | A181 | 1 | 2 | 287-235 | B287 | A235 | 1 | 2 |
| 287-182 | B287 | A182 | 1 | 2 | 287-236 | B287 | A236 | 1 | 2 |
| 287-191 | B287 | A191 | 1 | 2 | 287-237 | B287 | A237 | 1 | 2 |
| 287-192 | B287 | A192 | 1 | 2 | 287-238 | B287 | A238 | 1 | 2 |
| 287-193 | B287 | A193 | 1 | 2 | 287-239 | B287 | A239 | 1 | 2 |
| 287-194 | B287 | A194 | 1 | 2 | 287-241 | B287 | A241 | 1 | 2 |
| 287-196 | B287 | A196 | 1 | 2 | 287-242 | B287 | A242 | 1 | 2 |
| 287-197 | B287 | A197 | 1 | 2 | 287-243 | B287 | A243 | 1 | 2 |
| 287-199 | B287 | A199 | 1 | 2 | 287-246 | B287 | A246 | 1 | 2 |
| 287-200 | B287 | A200 | 1 | 2 | 287-247 | B287 | A247 | 1 | 2 |
| 287-201 | B287 | A201 | 1 | 2 | 287-248 | B287 | A248 | 1 | 2 |
| 287-203 | B287 | A203 | 1 | 2 | 287-249 | B287 | A249 | 1 | 2 |
| 287-206 | B287 | A206 | 1 | 2 | 287-250 | B287 | A250 | 1 | 2 |

**Table 39**

| Compound No. | L₁ | L₂ | n1 | n2 | Compound No. | L₁ | L₂ | n1 | n2 |
|---|---|---|---|---|---|---|---|---|---|
| 293-1 | B293 | A1 | 1 | 2 | 293-208 | B293 | A208 | 1 | 2 |
| 293-2 | B293 | A2 | 1 | 2 | 293-209 | B293 | A209 | 1 | 2 |
| 293-3 | B293 | A3 | 1 | 2 | 293-212 | B293 | A212 | 1 | 2 |
| 293-5 | B293 | A5 | 1 | 2 | 293-213 | B293 | A213 | 1 | 2 |
| 293-8 | B293 | A8 | 1 | 2 | 293-214 | B293 | A214 | 1 | 2 |
| 293-35 | B293 | A35 | 1 | 2 | 293-215 | B293 | A215 | 1 | 2 |
| 293-36 | B293 | A36 | 1 | 2 | 293-216 | B293 | A216 | 1 | 2 |
| 293-45 | B293 | A45 | 1 | 2 | 293-217 | B293 | A217 | 1 | 2 |
| 293-47 | B293 | A47 | 1 | 2 | 293-221 | B293 | A221 | 1 | 2 |
| 293-49 | B293 | A49 | 1 | 2 | 293-222 | B293 | A222 | 1 | 2 |
| 293-60 | B293 | A60 | 1 | 2 | 293-224 | B293 | A224 | 1 | 2 |
| 293-86 | B293 | A86 | 1 | 2 | 293-225 | B293 | A225 | 1 | 2 |
| 293-94 | B293 | A94 | 1 | 2 | 293-226 | B293 | A226 | 1 | 2 |
| 293-99 | B293 | A99 | 1 | 2 | 293-228 | B293 | A228 | 1 | 2 |
| 293-101 | B293 | A101 | 1 | 2 | 293-229 | B293 | A229 | 1 | 2 |
| 293-139 | B293 | A139 | 1 | 2 | 293-231 | B293 | A231 | 1 | 2 |
| 293-161 | B293 | A161 | 1 | 2 | 293-232 | B293 | A232 | 1 | 2 |
| 293-162 | B293 | A162 | 1 | 2 | 293-233 | B293 | A233 | 1 | 2 |
| 293-181 | B293 | A181 | 1 | 2 | 293-235 | B293 | A235 | 1 | 2 |
| 293-182 | B293 | A182 | 1 | 2 | 293-236 | B293 | A236 | 1 | 2 |
| 293-191 | B293 | A191 | 1 | 2 | 293-237 | B293 | A237 | 1 | 2 |
| 293-192 | B293 | A192 | 1 | 2 | 293-238 | B293 | A238 | 1 | 2 |
| 293-193 | B293 | A193 | 1 | 2 | 293-239 | B293 | A239 | 1 | 2 |
| 293-194 | B293 | A194 | 1 | 2 | 293-241 | B293 | A241 | 1 | 2 |
| 293-196 | B293 | A196 | 1 | 2 | 293-242 | B293 | A242 | 1 | 2 |
| 293-197 | B293 | A197 | 1 | 2 | 293-243 | B293 | A243 | 1 | 2 |
| 293-199 | B293 | A199 | 1 | 2 | 293-246 | B293 | A246 | 1 | 2 |
| 293-200 | B293 | A200 | 1 | 2 | 293-247 | B293 | A247 | 1 | 2 |
| 293-201 | B293 | A201 | 1 | 2 | 293-248 | B293 | A248 | 1 | 2 |
| 293-203 | B293 | A203 | 1 | 2 | 293-249 | B293 | A249 | 1 | 2 |
| 293-206 | B293 | A206 | 1 | 2 | 293-250 | B293 | A250 | 1 | 2 |

**Table 40**

| Compound No. | L₁ | L₂ | n1 | n2 | Compound No. | L₁ | L₂ | n1 | n2 |
|---|---|---|---|---|---|---|---|---|---|
| 295-1 | B295 | A1 | 1 | 2 | 295-208 | B295 | A208 | 1 | 2 |
| 295-2 | B295 | A2 | 1 | 2 | 295-209 | B295 | A209 | 1 | 2 |
| 295-3 | B295 | A3 | 1 | 2 | 295-212 | B295 | A212 | 1 | 2 |
| 295-5 | B295 | A5 | 1 | 2 | 295-213 | B295 | A213 | 1 | 2 |
| 295-8 | B295 | A8 | 1 | 2 | 295-214 | B295 | A214 | 1 | 2 |
| 295-35 | B295 | A35 | 1 | 2 | 295-215 | B295 | A215 | 1 | 2 |
| 295-36 | B295 | A36 | 1 | 2 | 295-216 | B295 | A216 | 1 | 2 |
| 295-45 | B295 | A45 | 1 | 2 | 295-217 | B295 | A217 | 1 | 2 |
| 295-47 | B295 | A47 | 1 | 2 | 295-221 | B295 | A221 | 1 | 2 |
| 295-49 | B295 | A49 | 1 | 2 | 295-222 | B295 | A222 | 1 | 2 |
| 295-60 | B295 | A60 | 1 | 2 | 295-224 | B295 | A224 | 1 | 2 |
| 295-86 | B295 | A86 | 1 | 2 | 295-225 | B295 | A225 | 1 | 2 |
| 295-94 | B295 | A94 | 1 | 2 | 295-226 | B295 | A226 | 1 | 2 |
| 295-99 | B295 | A99 | 1 | 2 | 295-228 | B295 | A228 | 1 | 2 |
| 295-101 | B295 | A101 | 1 | 2 | 295-229 | B295 | A229 | 1 | 2 |
| 295-139 | B295 | A139 | 1 | 2 | 295-231 | B295 | A231 | 1 | 2 |
| 295-161 | B295 | A161 | 1 | 2 | 295-232 | B295 | A232 | 1 | 2 |
| 295-162 | B295 | A162 | 1 | 2 | 295-233 | B295 | A233 | 1 | 2 |
| 295-181 | B295 | A181 | 1 | 2 | 295-235 | B295 | A235 | 1 | 2 |
| 295-182 | B295 | A182 | 1 | 2 | 295-236 | B295 | A236 | 1 | 2 |
| 295-191 | B295 | A191 | 1 | 2 | 295-237 | B295 | A237 | 1 | 2 |
| 295-192 | B295 | A192 | 1 | 2 | 295-238 | B295 | A238 | 1 | 2 |
| 295-193 | B295 | A193 | 1 | 2 | 295-239 | B295 | A239 | 1 | 2 |
| 295-194 | B295 | A194 | 1 | 2 | 295-241 | B295 | A241 | 1 | 2 |
| 295-196 | B295 | A196 | 1 | 2 | 295-242 | B295 | A242 | 1 | 2 |
| 295-197 | B295 | A197 | 1 | 2 | 295-243 | B295 | A243 | 1 | 2 |
| 295-199 | B295 | A199 | 1 | 2 | 295-246 | B295 | A246 | 1 | 2 |
| 295-200 | B295 | A200 | 1 | 2 | 295-247 | B295 | A247 | 1 | 2 |
| 295-201 | B295 | A201 | 1 | 2 | 295-248 | B295 | A248 | 1 | 2 |
| 295-203 | B295 | A203 | 1 | 2 | 295-249 | B295 | A249 | 1 | 2 |
| 295-206 | B295 | A206 | 1 | 2 | 295-250 | B295 | A250 | 1 | 2 |

**Table 41**

| Compound No. | L₁ | L₂ | n1 | n2 | Compound No. | L₁ | L₂ | n1 | n2 |
|---|---|---|---|---|---|---|---|---|---|
| 312-1 | B312 | A1 | 1 | 2 | 312-208 | B312 | A208 | 1 | 2 |
| 312-2 | B312 | A2 | 1 | 2 | 312-209 | B312 | A209 | 1 | 2 |
| 312-3 | B312 | A3 | 1 | 2 | 312-212 | B312 | A212 | 1 | 2 |
| 312-5 | B312 | A5 | 1 | 2 | 312-213 | B312 | A213 | 1 | 2 |
| 312-8 | B312 | A8 | 1 | 2 | 312-214 | B312 | A214 | 1 | 2 |
| 312-35 | B312 | A35 | 1 | 2 | 312-215 | B312 | A215 | 1 | 2 |
| 312-36 | B312 | A36 | 1 | 2 | 312-216 | B312 | A216 | 1 | 2 |
| 312-45 | B312 | A45 | 1 | 2 | 312-217 | B312 | A217 | 1 | 2 |
| 312-47 | B312 | A47 | 1 | 2 | 312-221 | B312 | A221 | 1 | 2 |
| 312-49 | B312 | A49 | 1 | 2 | 312-222 | B312 | A222 | 1 | 2 |
| 312-60 | B312 | A60 | 1 | 2 | 312-224 | B312 | A224 | 1 | 2 |
| 312-86 | B312 | A86 | 1 | 2 | 312-225 | B312 | A225 | 1 | 2 |
| 312-94 | B312 | A94 | 1 | 2 | 312-226 | B312 | A226 | 1 | 2 |
| 312-99 | B312 | A99 | 1 | 2 | 312-228 | B312 | A228 | 1 | 2 |
| 312-101 | B312 | A101 | 1 | 2 | 312-229 | B312 | A229 | 1 | 2 |
| 312-139 | B312 | A139 | 1 | 2 | 312-231 | B312 | A231 | 1 | 2 |
| 312-161 | B312 | A161 | 1 | 2 | 312-232 | B312 | A232 | 1 | 2 |
| 312-162 | B312 | A162 | 1 | 2 | 312-233 | B312 | A233 | 1 | 2 |
| 312-181 | B312 | A181 | 1 | 2 | 312-235 | B312 | A235 | 1 | 2 |
| 312-182 | B312 | A182 | 1 | 2 | 312-236 | B312 | A236 | 1 | 2 |
| 312-191 | B312 | A191 | 1 | 2 | 312-237 | B312 | A237 | 1 | 2 |
| 312-192 | B312 | A192 | 1 | 2 | 312-238 | B312 | A238 | 1 | 2 |
| 312-193 | B312 | A193 | 1 | 2 | 312-239 | B312 | A239 | 1 | 2 |
| 312-194 | B312 | A194 | 1 | 2 | 312-241 | B312 | A241 | 1 | 2 |
| 312-196 | B312 | A196 | 1 | 2 | 312-242 | B312 | A242 | 1 | 2 |
| 312-197 | B312 | A197 | 1 | 2 | 312-243 | B312 | A243 | 1 | 2 |
| 312-199 | B312 | A199 | 1 | 2 | 312-246 | B312 | A246 | 1 | 2 |
| 312-200 | B312 | A200 | 1 | 2 | 312-247 | B312 | A247 | 1 | 2 |
| 312-201 | B312 | A201 | 1 | 2 | 312-248 | B312 | A248 | 1 | 2 |
| 312-203 | B312 | A203 | 1 | 2 | 312-249 | B312 | A249 | 1 | 2 |
| 312-206 | B312 | A206 | 1 | 2 | 312-250 | B312 | A250 | 1 | 2 |

**Table 42**

| Compound No. | L₁ | L₂ | n1 | n2 | Compound No. | L₁ | L₂ | n1 | n2 |
|---|---|---|---|---|---|---|---|---|---|
| 327-1 | B327 | A1 | 1 | 2 | 327-208 | B327 | A208 | 1 | 2 |
| 327-2 | B327 | A2 | 1 | 2 | 327-209 | B327 | A209 | 1 | 2 |
| 327-3 | B327 | A3 | 1 | 2 | 327-212 | B327 | A212 | 1 | 2 |
| 327-5 | B327 | A5 | 1 | 2 | 327-213 | B327 | A213 | 1 | 2 |
| 327-8 | B327 | A8 | 1 | 2 | 327-214 | B327 | A214 | 1 | 2 |
| 327-35 | B327 | A35 | 1 | 2 | 327-215 | B327 | A215 | 1 | 2 |
| 327-36 | B327 | A36 | 1 | 2 | 327-216 | B327 | A216 | 1 | 2 |
| 327-45 | B327 | A45 | 1 | 2 | 327-217 | B327 | A217 | 1 | 2 |
| 327-47 | B327 | A47 | 1 | 2 | 327-221 | B327 | A221 | 1 | 2 |
| 327-49 | B327 | A49 | 1 | 2 | 327-222 | B327 | A222 | 1 | 2 |
| 327-60 | B327 | A60 | 1 | 2 | 327-224 | B327 | A224 | 1 | 2 |
| 327-86 | B327 | A86 | 1 | 2 | 327-225 | B327 | A225 | 1 | 2 |
| 327-94 | B327 | A94 | 1 | 2 | 327-226 | B327 | A226 | 1 | 2 |
| 327-99 | B327 | A99 | 1 | 2 | 327-228 | B327 | A228 | 1 | 2 |
| 327-101 | B327 | A101 | 1 | 2 | 327-229 | B327 | A229 | 1 | 2 |
| 327-139 | B327 | A139 | 1 | 2 | 327-231 | B327 | A231 | 1 | 2 |
| 327-161 | B327 | A161 | 1 | 2 | 327-232 | B327 | A232 | 1 | 2 |
| 327-162 | B327 | A162 | 1 | 2 | 327-233 | B327 | A233 | 1 | 2 |
| 327-181 | B327 | A181 | 1 | 2 | 327-235 | B327 | A235 | 1 | 2 |
| 327-182 | B327 | A182 | 1 | 2 | 327-236 | B327 | A236 | 1 | 2 |
| 327-191 | B327 | A191 | 1 | 2 | 327-237 | B327 | A237 | 1 | 2 |
| 327-192 | B327 | A192 | 1 | 2 | 327-238 | B327 | A238 | 1 | 2 |
| 327-193 | B327 | A193 | 1 | 2 | 327-239 | B327 | A239 | 1 | 2 |
| 327-194 | B327 | A194 | 1 | 2 | 327-241 | B327 | A241 | 1 | 2 |
| 327-196 | B327 | A196 | 1 | 2 | 327-242 | B327 | A242 | 1 | 2 |
| 327-197 | B327 | A197 | 1 | 2 | 327-243 | B327 | A243 | 1 | 2 |
| 327-199 | B327 | A199 | 1 | 2 | 327-246 | B327 | A246 | 1 | 2 |
| 327-200 | B327 | A200 | 1 | 2 | 327-247 | B327 | A247 | 1 | 2 |
| 327-201 | B327 | A201 | 1 | 2 | 327-248 | B327 | A248 | 1 | 2 |
| 327-203 | B327 | A203 | 1 | 2 | 327-249 | B327 | A249 | 1 | 2 |
| 327-206 | B327 | A206 | 1 | 2 | 327-250 | B327 | A250 | 1 | 2 |

**Table 43**

| Compound No. | L₁ | L₂ | n1 | n2 | Compound No. | L₁ | L₂ | n1 | n2 |
|---|---|---|---|---|---|---|---|---|---|
| 2-1R | B2 | A1 | 2 | 1 | 2-208R | B2 | A208 | 2 | 1 |
| 2-2R | B2 | A2 | 2 | 1 | 2-209R | B2 | A209 | 2 | 1 |
| 2-3R | B2 | A3 | 2 | 1 | 2-212R | B2 | A212 | 2 | 1 |
| 2-5R | B2 | A5 | 2 | 1 | 2-213R | B2 | A213 | 2 | 1 |
| 2-8R | B2 | A8 | 2 | 1 | 2-214R | B2 | A214 | 2 | 1 |
| 2-35R | B2 | A35 | 2 | 1 | 2-215R | B2 | A215 | 2 | 1 |
| 2-36R | B2 | A36 | 2 | 1 | 2-216R | B2 | A216 | 2 | 1 |
| 2-45R | B2 | A45 | 2 | 1 | 2-217R | B2 | A217 | 2 | 1 |
| 2-47R | B2 | A47 | 2 | 1 | 2-221R | B2 | A221 | 2 | 1 |
| 2-49R | B2 | A49 | 2 | 1 | 2-222R | B2 | A222 | 2 | 1 |
| 2-60R | B2 | A60 | 2 | 1 | 2-224R | B2 | A224 | 2 | 1 |
| 2-86R | B2 | A86 | 2 | 1 | 2-225R | B2 | A225 | 2 | 1 |
| 2-94R | B2 | A94 | 2 | 1 | 2-226R | B2 | A226 | 2 | 1 |
| 2-99R | B2 | A99 | 2 | 1 | 2-228R | B2 | A228 | 2 | 1 |
| 2-101R | B2 | A101 | 2 | 1 | 2-229R | B2 | A229 | 2 | 1 |
| 2-139R | B2 | A139 | 2 | 1 | 2-231R | B2 | A231 | 2 | 1 |
| 2-161R | B2 | A161 | 2 | 1 | 2-232R | B2 | A232 | 2 | 1 |
| 2-162R | B2 | A162 | 2 | 1 | 2-233R | B2 | A233 | 2 | 1 |
| 2-181R | B2 | A181 | 2 | 1 | 2-235R | B2 | A235 | 2 | 1 |
| 2-182R | B2 | A182 | 2 | 1 | 2-236R | B2 | A236 | 2 | 1 |
| 2-191R | B2 | A191 | 2 | 1 | 2-237R | B2 | A237 | 2 | 1 |
| 2-192R | B2 | A192 | 2 | 1 | 2-238R | B2 | A238 | 2 | 1 |
| 2-193R | B2 | A193 | 2 | 1 | 2-239R | B2 | A239 | 2 | 1 |
| 2-194R | B2 | A194 | 2 | 1 | 2-241R | B2 | A241 | 2 | 1 |
| 2-196R | B2 | A196 | 2 | 1 | 2-242R | B2 | A242 | 2 | 1 |
| 2-197R | B2 | A197 | 2 | 1 | 2-243R | B2 | A243 | 2 | 1 |
| 2-199R | B2 | A199 | 2 | 1 | 2-246R | B2 | A246 | 2 | 1 |
| 2-200R | B2 | A200 | 2 | 1 | 2-247R | B2 | A247 | 2 | 1 |
| 2-201R | B2 | A201 | 2 | 1 | 2-248R | B2 | A248 | 2 | 1 |
| 2-203R | B2 | A203 | 2 | 1 | 2-249R | B2 | A249 | 2 | 1 |
| 2-206R | B2 | A206 | 2 | 1 | 2-250R | B2 | A250 | 2 | 1 |

**Table 44**

| Compound No. | L₁ | L₂ | n1 | n2 | Compound No. | L₁ | L₂ | n1 | n2 |
|---|---|---|---|---|---|---|---|---|---|
| 4-1R | B4 | A1 | 2 | 1 | 4-208R | B4 | A208 | 2 | 1 |
| 4-2R | B4 | A2 | 2 | 1 | 4-209R | B4 | A209 | 2 | 1 |
| 4-3R | B4 | A3 | 2 | 1 | 4-212R | B4 | A212 | 2 | 1 |
| 4-5R | B4 | A5 | 2 | 1 | 4-213R | B4 | A213 | 2 | 1 |
| 4-8R | B4 | A8 | 2 | 1 | 4-214R | B4 | A214 | 2 | 1 |
| 4-35R | B4 | A35 | 2 | 1 | 4-215R | B4 | A215 | 2 | 1 |
| 4-36R | B4 | A36 | 2 | 1 | 4-216R | B4 | A216 | 2 | 1 |
| 4-45R | B4 | A45 | 2 | 1 | 4-217R | B4 | A217 | 2 | 1 |
| 4-47R | B4 | A47 | 2 | 1 | 4-221R | B4 | A221 | 2 | 1 |
| 4-49R | B4 | A49 | 2 | 1 | 4-222R | B4 | A222 | 2 | 1 |
| 4-60R | B4 | A60 | 2 | 1 | 4-224R | B4 | A224 | 2 | 1 |
| 4-86R | B4 | A86 | 2 | 1 | 4-225R | B4 | A225 | 2 | 1 |
| 4-94R | B4 | A94 | 2 | 1 | 4-226R | B4 | A226 | 2 | 1 |
| 4-99R | B4 | A99 | 2 | 1 | 4-228R | B4 | A228 | 2 | 1 |
| 4-101R | B4 | A101 | 2 | 1 | 4-229R | B4 | A229 | 2 | 1 |
| 4-139R | B4 | A139 | 2 | 1 | 4-231R | B4 | A231 | 2 | 1 |
| 4-161R | B4 | A161 | 2 | 1 | 4-232R | B4 | A232 | 2 | 1 |
| 4-162R | B4 | A162 | 2 | 1 | 4-233R | B4 | A233 | 2 | 1 |
| 4-181R | B4 | A181 | 2 | 1 | 4-235R | B4 | A235 | 2 | 1 |
| 4-182R | B4 | A182 | 2 | 1 | 4-236R | B4 | A236 | 2 | 1 |
| 4-191R | B4 | A191 | 2 | 1 | 4-237R | B4 | A237 | 2 | 1 |
| 4-192R | B4 | A192 | 2 | 1 | 4-238R | B4 | A238 | 2 | 1 |
| 4-193R | B4 | A193 | 2 | 1 | 4-239R | B4 | A239 | 2 | 1 |
| 4-194R | B4 | A194 | 2 | 1 | 4-241R | B4 | A241 | 2 | 1 |
| 4-196R | B4 | A196 | 2 | 1 | 4-242R | B4 | A242 | 2 | 1 |
| 4-197R | B4 | A197 | 2 | 1 | 4-243R | B4 | A243 | 2 | 1 |
| 4-199R | B4 | A199 | 2 | 1 | 4-246R | B4 | A246 | 2 | 1 |
| 4-200R | B4 | A200 | 2 | 1 | 4-247R | B4 | A247 | 2 | 1 |
| 4-201R | B4 | A201 | 2 | 1 | 4-248R | B4 | A248 | 2 | 1 |
| 4-203R | B4 | A203 | 2 | 1 | 4-249R | B4 | A249 | 2 | 1 |
| 4-206R | B4 | A206 | 2 | 1 | 4-250R | B4 | A250 | 2 | 1 |

**Table 45**

| Compound No. | L₁ | L₂ | n1 | n2 | Compound No. | L₁ | L₂ | n1 | n2 |
|---|---|---|---|---|---|---|---|---|---|
| 6-1R | B6 | A1 | 2 | 1 | 6-208R | B6 | A208 | 2 | 1 |
| 6-2R | B6 | A2 | 2 | 1 | 6-209R | B6 | A209 | 2 | 1 |
| 6-3R | B6 | A3 | 2 | 1 | 6-212R | B6 | A212 | 2 | 1 |
| 6-5R | B6 | A5 | 2 | 1 | 6-213R | B6 | A213 | 2 | 1 |
| 6-8R | B6 | A8 | 2 | 1 | 6-214R | B6 | A214 | 2 | 1 |
| 6-35R | B6 | A35 | 2 | 1 | 6-215R | B6 | A215 | 2 | 1 |
| 6-36R | B6 | A36 | 2 | 1 | 6-216R | B6 | A216 | 2 | 1 |
| 6-45R | B6 | A45 | 2 | 1 | 6-217R | B6 | A217 | 2 | 1 |
| 6-47R | B6 | A47 | 2 | 1 | 6-221R | B6 | A221 | 2 | 1 |
| 6-49R | B6 | A49 | 2 | 1 | 6-222R | B6 | A222 | 2 | 1 |
| 6-60R | B6 | A60 | 2 | 1 | 6-224R | B6 | A224 | 2 | 1 |
| 6-86R | B6 | A86 | 2 | 1 | 6-225R | B6 | A225 | 2 | 1 |
| 6-94R | B6 | A94 | 2 | 1 | 6-226R | B6 | A226 | 2 | 1 |
| 6-99R | B6 | A99 | 2 | 1 | 6-228R | B6 | A228 | 2 | 1 |
| 6-101R | B6 | A101 | 2 | 1 | 6-229R | B6 | A229 | 2 | 1 |
| 6-139R | B6 | A139 | 2 | 1 | 6-231R | B6 | A231 | 2 | 1 |
| 6-161R | B6 | A161 | 2 | 1 | 6-232R | B6 | A232 | 2 | 1 |
| 6-162R | B6 | A162 | 2 | 1 | 6-233R | B6 | A233 | 2 | 1 |
| 6-181R | B6 | A181 | 2 | 1 | 6-235R | B6 | A235 | 2 | 1 |
| 6-182R | B6 | A182 | 2 | 1 | 6-236R | B6 | A236 | 2 | 1 |
| 6-191R | B6 | A191 | 2 | 1 | 6-237R | B6 | A237 | 2 | 1 |
| 6-192R | B6 | A192 | 2 | 1 | 6-238R | B6 | A238 | 2 | 1 |
| 6-193R | B6 | A193 | 2 | 1 | 6-239R | B6 | A239 | 2 | 1 |
| 6-194R | B6 | A194 | 2 | 1 | 6-241R | B6 | A241 | 2 | 1 |
| 6-196R | B6 | A196 | 2 | 1 | 6-242R | B6 | A242 | 2 | 1 |
| 6-197R | B6 | A197 | 2 | 1 | 6-243R | B6 | A243 | 2 | 1 |
| 6-199R | B6 | A199 | 2 | 1 | 6-246R | B6 | A246 | 2 | 1 |
| 6-200R | B6 | A200 | 2 | 1 | 6-247R | B6 | A247 | 2 | 1 |
| 6-201R | B6 | A201 | 2 | 1 | 6-248R | B6 | A248 | 2 | 1 |
| 6-203R | B6 | A203 | 2 | 1 | 6-249R | B6 | A249 | 2 | 1 |
| 6-206R | B6 | A206 | 2 | 1 | 6-250R | B6 | A250 | 2 | 1 |

**Table 46**

| Compound No. | L₁ | L₂ | n1 | n2 | Compound No. | L₁ | L₂ | n1 | n2 |
|---|---|---|---|---|---|---|---|---|---|
| 22-1R | B22 | A1 | 2 | 1 | 22-208R | B22 | A208 | 2 | 1 |
| 22-2R | B22 | A2 | 2 | 1 | 22-209R | B22 | A209 | 2 | 1 |
| 22-3R | B22 | A3 | 2 | 1 | 22-212R | B22 | A212 | 2 | 1 |
| 22-5R | B22 | A5 | 2 | 1 | 22-213R | B22 | A213 | 2 | 1 |
| 22-8R | B22 | A8 | 2 | 1 | 22-214R | B22 | A214 | 2 | 1 |
| 22-35R | B22 | A35 | 2 | 1 | 22-215R | B22 | A215 | 2 | 1 |
| 22-36R | B22 | A36 | 2 | 1 | 22-216R | B22 | A216 | 2 | 1 |
| 22-45R | B22 | A45 | 2 | 1 | 22-217R | B22 | A217 | 2 | 1 |
| 22-47R | B22 | A47 | 2 | 1 | 22-221R | B22 | A221 | 2 | 1 |
| 22-49R | B22 | A49 | 2 | 1 | 22-222R | B22 | A222 | 2 | 1 |
| 22-60R | B22 | A60 | 2 | 1 | 22-224R | B22 | A224 | 2 | 1 |
| 22-86R | B22 | A86 | 2 | 1 | 22-225R | B22 | A225 | 2 | 1 |
| 22-94R | B22 | A94 | 2 | 1 | 22-226R | B22 | A226 | 2 | 1 |
| 22-99R | B22 | A99 | 2 | 1 | 22-228R | B22 | A228 | 2 | 1 |
| 22-101R | B22 | A101 | 2 | 1 | 22-229R | B22 | A229 | 2 | 1 |
| 22-139R | B22 | A139 | 2 | 1 | 22-231R | B22 | A231 | 2 | 1 |
| 22-161R | B22 | A161 | 2 | 1 | 22-232R | B22 | A232 | 2 | 1 |
| 22-162R | B22 | A162 | 2 | 1 | 22-233R | B22 | A233 | 2 | 1 |
| 22-181R | B22 | A181 | 2 | 1 | 22-235R | B22 | A235 | 2 | 1 |
| 22-182R | B22 | A182 | 2 | 1 | 22-236R | B22 | A236 | 2 | 1 |
| 22-191R | B22 | A191 | 2 | 1 | 22-237R | B22 | A237 | 2 | 1 |
| 22-192R | B22 | A192 | 2 | 1 | 22-238R | B22 | A238 | 2 | 1 |
| 22-193R | B22 | A193 | 2 | 1 | 22-239R | B22 | A239 | 2 | 1 |
| 22-194R | B22 | A194 | 2 | 1 | 22-241R | B22 | A241 | 2 | 1 |
| 22-196R | B22 | A196 | 2 | 1 | 22-242R | B22 | A242 | 2 | 1 |
| 22-197R | B22 | A197 | 2 | 1 | 22-243R | B22 | A243 | 2 | 1 |
| 22-199R | B22 | A199 | 2 | 1 | 22-246R | B22 | A246 | 2 | 1 |
| 22-200R | B22 | A200 | 2 | 1 | 22-247R | B22 | A247 | 2 | 1 |
| 22-201R | B22 | A201 | 2 | 1 | 22-248R | B22 | A248 | 2 | 1 |
| 22-203R | B22 | A203 | 2 | 1 | 22-249R | B22 | A249 | 2 | 1 |
| 22-206R | B22 | A206 | 2 | 1 | 22-250R | B22 | A250 | 2 | 1 |

**Table 47**

| Compound No. | L₁ | L₂ | n1 | n2 | Compound No. | L₁ | L₂ | n1 | n2 |
|---|---|---|---|---|---|---|---|---|---|
| 24-1R | B24 | A1 | 2 | 1 | 24-208R | B24 | A208 | 2 | 1 |
| 24-2R | B24 | A2 | 2 | 1 | 24-209R | B24 | A209 | 2 | 1 |
| 24-3R | B24 | A3 | 2 | 1 | 24-212R | B24 | A212 | 2 | 1 |
| 24-5R | B24 | A5 | 2 | 1 | 24-213R | B24 | A213 | 2 | 1 |
| 24-8R | B24 | A8 | 2 | 1 | 24-214R | B24 | A214 | 2 | 1 |
| 24-35R | B24 | A35 | 2 | 1 | 24-215R | B24 | A215 | 2 | 1 |
| 24-36R | B24 | A36 | 2 | 1 | 24-216R | B24 | A216 | 2 | 1 |
| 24-45R | B24 | A45 | 2 | 1 | 24-217R | B24 | A217 | 2 | 1 |
| 24-47R | B24 | A47 | 2 | 1 | 24-221R | B24 | A221 | 2 | 1 |
| 24-49R | B24 | A49 | 2 | 1 | 24-222R | B24 | A222 | 2 | 1 |
| 24-60R | B24 | A60 | 2 | 1 | 24-224R | B24 | A224 | 2 | 1 |
| 24-86R | B24 | A86 | 2 | 1 | 24-225R | B24 | A225 | 2 | 1 |
| 24-94R | B24 | A94 | 2 | 1 | 24-226R | B24 | A226 | 2 | 1 |
| 24-99R | B24 | A99 | 2 | 1 | 24-228R | B24 | A228 | 2 | 1 |
| 24-101R | B24 | A101 | 2 | 1 | 24-229R | B24 | A229 | 2 | 1 |
| 24-139R | B24 | A139 | 2 | 1 | 24-231R | B24 | A231 | 2 | 1 |
| 24-161R | B24 | A161 | 2 | 1 | 24-232R | B24 | A232 | 2 | 1 |
| 24-162R | B24 | A162 | 2 | 1 | 24-233R | B24 | A233 | 2 | 1 |
| 24-181R | B24 | A181 | 2 | 1 | 24-235R | B24 | A235 | 2 | 1 |
| 24-182R | B24 | A182 | 2 | 1 | 24-236R | B24 | A236 | 2 | 1 |
| 24-191R | B24 | A191 | 2 | 1 | 24-237R | B24 | A237 | 2 | 1 |
| 24-192R | B24 | A192 | 2 | 1 | 24-238R | B24 | A238 | 2 | 1 |
| 24-193R | B24 | A193 | 2 | 1 | 24-239R | B24 | A239 | 2 | 1 |
| 24-194R | B24 | A194 | 2 | 1 | 24-241R | B24 | A241 | 2 | 1 |
| 24-196R | B24 | A196 | 2 | 1 | 24-242R | B24 | A242 | 2 | 1 |
| 24-197R | B24 | A197 | 2 | 1 | 24-243R | B24 | A243 | 2 | 1 |
| 24-199R | B24 | A199 | 2 | 1 | 24-246R | B24 | A246 | 2 | 1 |
| 24-200R | B24 | A200 | 2 | 1 | 24-247R | B24 | A247 | 2 | 1 |
| 24-201R | B24 | A201 | 2 | 1 | 24-248R | B24 | A248 | 2 | 1 |
| 24-203R | B24 | A203 | 2 | 1 | 24-249R | B24 | A249 | 2 | 1 |
| 24-206R | B24 | A206 | 2 | 1 | 24-250R | B24 | A250 | 2 | 1 |

**Table 48**

| Compound No. | L₁ | L₂ | n1 | n2 | Compound No. | L₁ | L₂ | n1 | n2 |
|---|---|---|---|---|---|---|---|---|---|
| 26-1R | B26 | A1 | 2 | 1 | 26-208R | B26 | A208 | 2 | 1 |
| 26-2R | B26 | A2 | 2 | 1 | 26-209R | B26 | A209 | 2 | 1 |
| 26-3R | B26 | A3 | 2 | 1 | 26-212R | B26 | A212 | 2 | 1 |
| 26-5R | B26 | A5 | 2 | 1 | 26-213R | B26 | A213 | 2 | 1 |
| 26-8R | B26 | A8 | 2 | 1 | 26-214R | B26 | A214 | 2 | 1 |
| 26-35R | B26 | A35 | 2 | 1 | 26-215R | B26 | A215 | 2 | 1 |
| 26-36R | B26 | A36 | 2 | 1 | 26-216R | B26 | A216 | 2 | 1 |
| 26-45R | B26 | A45 | 2 | 1 | 26-217R | B26 | A217 | 2 | 1 |
| 26-47R | B26 | A47 | 2 | 1 | 26-221R | B26 | A221 | 2 | 1 |
| 26-49R | B26 | A49 | 2 | 1 | 26-222R | B26 | A222 | 2 | 1 |
| 26-60R | B26 | A60 | 2 | 1 | 26-224R | B26 | A224 | 2 | 1 |
| 26-86R | B26 | A86 | 2 | 1 | 26-225R | B26 | A225 | 2 | 1 |
| 26-94R | B26 | A94 | 2 | 1 | 26-226R | B26 | A226 | 2 | 1 |
| 26-99R | B26 | A99 | 2 | 1 | 26-228R | B26 | A228 | 2 | 1 |
| 26-101R | B26 | A101 | 2 | 1 | 26-229R | B26 | A229 | 2 | 1 |
| 26-139R | B26 | A139 | 2 | 1 | 26-231R | B26 | A231 | 2 | 1 |
| 26-161R | B26 | A161 | 2 | 1 | 26-232R | B26 | A232 | 2 | 1 |
| 26-162R | B26 | A162 | 2 | 1 | 26-233R | B26 | A233 | 2 | 1 |
| 26-181R | B26 | A181 | 2 | 1 | 26-235R | B26 | A235 | 2 | 1 |
| 26-182R | B26 | A182 | 2 | 1 | 26-236R | B26 | A236 | 2 | 1 |
| 26-191R | B26 | A191 | 2 | 1 | 26-237R | B26 | A237 | 2 | 1 |
| 26-192R | B26 | A192 | 2 | 1 | 26-238R | B26 | A238 | 2 | 1 |
| 26-193R | B26 | A193 | 2 | 1 | 26-239R | B26 | A239 | 2 | 1 |
| 26-194R | B26 | A194 | 2 | 1 | 26-241R | B26 | A241 | 2 | 1 |
| 26-196R | B26 | A196 | 2 | 1 | 26-242R | B26 | A242 | 2 | 1 |
| 26-197R | B26 | A197 | 2 | 1 | 26-243R | B26 | A243 | 2 | 1 |
| 26-199R | B26 | A199 | 2 | 1 | 26-246R | B26 | A246 | 2 | 1 |
| 26-200R | B26 | A200 | 2 | 1 | 26-247R | B26 | A247 | 2 | 1 |
| 26-201R | B26 | A201 | 2 | 1 | 26-248R | B26 | A248 | 2 | 1 |
| 26-203R | B26 | A203 | 2 | 1 | 26-249R | B26 | A249 | 2 | 1 |
| 26-206R | B26 | A206 | 2 | 1 | 26-250R | B26 | A250 | 2 | 1 |

**Table 49**

| Compound No. | L₁ | L₂ | n1 | n2 | Compound No. | L₁ | L₂ | n1 | n2 |
|---|---|---|---|---|---|---|---|---|---|
| 67-1R | B67 | A1 | 2 | 1 | 67-208R | B67 | A208 | 2 | 1 |
| 67-2R | B67 | A2 | 2 | 1 | 67-209R | B67 | A209 | 2 | 1 |
| 67-3R | B67 | A3 | 2 | 1 | 67-212R | B67 | A212 | 2 | 1 |
| 67-5R | B67 | A5 | 2 | 1 | 67-213R | B67 | A213 | 2 | 1 |
| 67-8R | B67 | A8 | 2 | 1 | 67-214R | B67 | A214 | 2 | 1 |
| 67-35R | B67 | A35 | 2 | 1 | 67-215R | B67 | A215 | 2 | 1 |
| 67-36 R | B67 | A36 | 2 | 1 | 67-216R | B67 | A216 | 2 | 1 |
| 67-45R | B67 | A45 | 2 | 1 | 67-217R | B67 | A217 | 2 | 1 |
| 67-47R | B67 | A47 | 2 | 1 | 67-221R | B67 | A221 | 2 | 1 |
| 67-49R | B67 | A49 | 2 | 1 | 67-222R | B67 | A222 | 2 | 1 |
| 67-60R | B67 | A60 | 2 | 1 | 67-224R | B67 | A224 | 2 | 1 |
| 67-86R | B67 | A86 | 2 | 1 | 67-225R | B67 | A225 | 2 | 1 |
| 67-94R | B67 | A94 | 2 | 1 | 67-226 R | B67 | A226 | 2 | 1 |
| 67-99R | B67 | A99 | 2 | 1 | 67-228R | B67 | A228 | 2 | 1 |
| 67-101R | B67 | A101 | 2 | 1 | 67-229R | B67 | A229 | 2 | 1 |
| 67-139R | B67 | A139 | 2 | 1 | 67-231R | B67 | A231 | 2 | 1 |
| 67-161R | B67 | A161 | 2 | 1 | 67-232R | B67 | A232 | 2 | 1 |
| 67-162R | B67 | A162 | 2 | 1 | 67-233R | B67 | A233 | 2 | 1 |
| 67-181R | B67 | A181 | 2 | 1 | 67-235R | B67 | A235 | 2 | 1 |
| 67-182R | B67 | A182 | 2 | 1 | 67-236R | B67 | A236 | 2 | 1 |
| 67-191R | B67 | A191 | 2 | 1 | 67-237R | B67 | A237 | 2 | 1 |
| 67-192R | B67 | A192 | 2 | 1 | 67-238R | B67 | A238 | 2 | 1 |
| 67-193R | B67 | A193 | 2 | 1 | 67-239R | B67 | A239 | 2 | 1 |
| 67-194R | B67 | A194 | 2 | 1 | 67-241 R | B67 | A241 | 2 | 1 |
| 67-196R | B67 | A196 | 2 | 1 | 67-242R | B67 | A242 | 2 | 1 |
| 67-197R | B67 | A197 | 2 | 1 | 67-243R | B67 | A243 | 2 | 1 |
| 67-199R | B67 | A199 | 2 | 1 | 67-246R | B67 | A246 | 2 | 1 |
| 67-200R | B67 | A200 | 2 | 1 | 67-247R | B67 | A247 | 2 | 1 |
| 67-201R | B67 | A201 | 2 | 1 | 67-248R | B67 | A248 | 2 | 1 |
| 67-203R | B67 | A203 | 2 | 1 | 67-249R | B67 | A249 | 2 | 1 |
| 67-206R | B67 | A206 | 2 | 1 | 67-250R | B67 | A250 | 2 | 1 |

**Table 50**

| Compound No. | L₁ | L₂ | n1 | n2 | Compound No. | L₁ | L₂ | n1 | n2 |
|---|---|---|---|---|---|---|---|---|---|
| 70-1R | B70 | A1 | 2 | 1 | 70-208R | B70 | A208 | 2 | 1 |
| 70-2R | B70 | A2 | 2 | 1 | 70-209R | B70 | A209 | 2 | 1 |
| 70-3R | B70 | A3 | 2 | 1 | 70-212R | B70 | A212 | 2 | 1 |
| 70-5R | B70 | A5 | 2 | 1 | 70-213R | B70 | A213 | 2 | 1 |
| 70-8R | B70 | A8 | 2 | 1 | 70-214R | B70 | A214 | 2 | 1 |
| 70-35R | B70 | A35 | 2 | 1 | 70-215R | B70 | A215 | 2 | 1 |
| 70-36 R | B70 | A36 | 2 | 1 | 70-216R | B70 | A216 | 2 | 1 |
| 70-45R | B70 | A45 | 2 | 1 | 70-217R | B70 | A217 | 2 | 1 |
| 70-47R | B70 | A47 | 2 | 1 | 70-221R | B70 | A221 | 2 | 1 |
| 70-49R | B70 | A49 | 2 | 1 | 70-222R | B70 | A222 | 2 | 1 |
| 70-60R | B70 | A60 | 2 | 1 | 70-224R | B70 | A224 | 2 | 1 |
| 70-86R | B70 | A86 | 2 | 1 | 70-225R | B70 | A225 | 2 | 1 |
| 70-94R | B70 | A94 | 2 | 1 | 70-226 R | B70 | A226 | 2 | 1 |
| 70-99R | B70 | A99 | 2 | 1 | 70-228R | B70 | A228 | 2 | 1 |
| 70-101R | B70 | A101 | 2 | 1 | 70-229R | B70 | A229 | 2 | 1 |
| 70-139R | B70 | A139 | 2 | 1 | 70-231R | B70 | A231 | 2 | 1 |
| 70-161R | B70 | A161 | 2 | 1 | 70-232R | B70 | A232 | 2 | 1 |
| 70-162R | B70 | A162 | 2 | 1 | 70-233R | B70 | A233 | 2 | 1 |
| 70-181R | B70 | A181 | 2 | 1 | 70-235R | B70 | A235 | 2 | 1 |
| 70-182R | B70 | A182 | 2 | 1 | 70-236R | B70 | A236 | 2 | 1 |
| 70-191R | B70 | A191 | 2 | 1 | 70-237R | B70 | A237 | 2 | 1 |
| 70-192R | B70 | A192 | 2 | 1 | 70-238R | B70 | A238 | 2 | 1 |
| 70-193R | B70 | A193 | 2 | 1 | 70-239R | B70 | A239 | 2 | 1 |
| 70-194R | B70 | A194 | 2 | 1 | 70-241 R | B70 | A241 | 2 | 1 |
| 70-196R | B70 | A196 | 2 | 1 | 70-242R | B70 | A242 | 2 | 1 |
| 70-197R | B70 | A197 | 2 | 1 | 70-243R | B70 | A243 | 2 | 1 |
| 70-199R | B70 | A199 | 2 | 1 | 70-246R | B70 | A246 | 2 | 1 |
| 70-200R | B70 | A200 | 2 | 1 | 70-247R | B70 | A247 | 2 | 1 |
| 70-201R | B70 | A201 | 2 | 1 | 70-248R | B70 | A248 | 2 | 1 |
| 70-203R | B70 | A203 | 2 | 1 | 70-249R | B70 | A249 | 2 | 1 |
| 70-206R | B70 | A206 | 2 | 1 | 70-250R | B70 | A250 | 2 | 1 |

**Table 51**

| Compound No. | L₁ | L₂ | n1 | n2 | Compound No. | L₁ | L₂ | n1 | n2 |
|---|---|---|---|---|---|---|---|---|---|
| 106-1R | B106 | A1 | 2 | 1 | 106-208R | B106 | A208 | 2 | 1 |
| 106-2R | B106 | A2 | 2 | 1 | 106-209R | B106 | A209 | 2 | 1 |
| 106-3R | B106 | A3 | 2 | 1 | 106-212R | B106 | A212 | 2 | 1 |
| 106-5R | B106 | A5 | 2 | 1 | 106-213R | B106 | A213 | 2 | 1 |
| 106-8R | B106 | A8 | 2 | 1 | 106-214R | B106 | A214 | 2 | 1 |
| 106-35R | B106 | A35 | 2 | 1 | 106-215R | B106 | A215 | 2 | 1 |
| 106-36R | B106 | A36 | 2 | 1 | 106-216R | B106 | A216 | 2 | 1 |
| 106-45R | B106 | A45 | 2 | 1 | 106-217R | B106 | A217 | 2 | 1 |
| 106-47R | B106 | A47 | 2 | 1 | 106-221R | B106 | A221 | 2 | 1 |
| 106-49R | B106 | A49 | 2 | 1 | 106-222R | B106 | A222 | 2 | 1 |
| 106-60R | B106 | A60 | 2 | 1 | 106-224R | B106 | A224 | 2 | 1 |
| 106-86R | B106 | A86 | 2 | 1 | 106-225R | B106 | A225 | 2 | 1 |
| 106-94R | B106 | A94 | 2 | 1 | 106-226R | B106 | A226 | 2 | 1 |
| 106-99R | B106 | A99 | 2 | 1 | 106-228R | B106 | A228 | 2 | 1 |
| 106-101R | B106 | A101 | 2 | 1 | 106-229R | B106 | A229 | 2 | 1 |
| 106-139R | B106 | A139 | 2 | 1 | 106-231R | B106 | A231 | 2 | 1 |
| 106-161R | B106 | A161 | 2 | 1 | 106-232R | B106 | A232 | 2 | 1 |
| 106-162R | B106 | A162 | 2 | 1 | 106-233R | B106 | A233 | 2 | 1 |
| 106-181R | B106 | A181 | 2 | 1 | 106-235R | B106 | A235 | 2 | 1 |
| 106-182R | B106 | A182 | 2 | 1 | 106-236R | B106 | A236 | 2 | 1 |
| 106-191R | B106 | A191 | 2 | 1 | 106-237R | B106 | A237 | 2 | 1 |
| 106-192R | B106 | A192 | 2 | 1 | 106-238R | B106 | A238 | 2 | 1 |
| 106-193R | B106 | A193 | 2 | 1 | 106-239R | B106 | A239 | 2 | 1 |
| 106-194R | B106 | A194 | 2 | 1 | 106-241R | B106 | A241 | 2 | 1 |
| 106-196R | B106 | A196 | 2 | 1 | 106-242R | B106 | A242 | 2 | 1 |
| 106-197R | B106 | A197 | 2 | 1 | 106-243R | B106 | A243 | 2 | 1 |
| 106-199R | B106 | A199 | 2 | 1 | 106-246R | B106 | A246 | 2 | 1 |
| 106-200R | B106 | A200 | 2 | 1 | 106-247R | B106 | A247 | 2 | 1 |
| 106-201R | B106 | A201 | 2 | 1 | 106-248R | B106 | A248 | 2 | 1 |
| 106-203R | B106 | A203 | 2 | 1 | 106-249R | B106 | A249 | 2 | 1 |
| 106-206R | B106 | A206 | 2 | 1 | 106-250R | B106 | A250 | 2 | 1 |

**Table 52**

| Compound No. | L₁ | L₂ | n1 | n2 | Compound No. | L₁ | L₂ | n1 | n2 |
|---|---|---|---|---|---|---|---|---|---|
| 111-1R | B111 | A1 | 2 | 1 | 111-208R | B111 | A208 | 2 | 1 |
| 111-2R | B111 | A2 | 2 | 1 | 111-209R | B111 | A209 | 2 | 1 |
| 111-3R | B111 | A3 | 2 | 1 | 111-212R | B111 | A212 | 2 | 1 |
| 111-5R | B111 | A5 | 2 | 1 | 111-213R | B111 | A213 | 2 | 1 |
| 111-8R | B111 | A8 | 2 | 1 | 111-214R | B111 | A214 | 2 | 1 |
| 111-35R | B111 | A35 | 2 | 1 | 111-215R | B111 | A215 | 2 | 1 |
| 111-36R | B111 | A36 | 2 | 1 | 111-216R | B111 | A216 | 2 | 1 |
| 111-45R | B111 | A45 | 2 | 1 | 111-217R | B111 | A217 | 2 | 1 |
| 111-47R | B111 | A47 | 2 | 1 | 111-221R | B111 | A221 | 2 | 1 |
| 111-49R | B111 | A49 | 2 | 1 | 111-222R | B111 | A222 | 2 | 1 |
| 111-60R | B111 | A60 | 2 | 1 | 111-224R | B111 | A224 | 2 | 1 |
| 111-86R | B111 | A86 | 2 | 1 | 111-225R | B111 | A225 | 2 | 1 |
| 111-94R | B111 | A94 | 2 | 1 | 111-226R | B111 | A226 | 2 | 1 |
| 111-99R | B111 | A99 | 2 | 1 | 111-228R | B111 | A228 | 2 | 1 |
| 111-101R | B111 | A101 | 2 | 1 | 111-229R | B111 | A229 | 2 | 1 |
| 111-139R | B111 | A139 | 2 | 1 | 111-231R | B111 | A231 | 2 | 1 |
| 111-161R | B111 | A161 | 2 | 1 | 111-232R | B111 | A232 | 2 | 1 |
| 111-162R | B111 | A162 | 2 | 1 | 111-233R | B111 | A233 | 2 | 1 |
| 111-181R | B111 | A181 | 2 | 1 | 111-235R | B111 | A235 | 2 | 1 |
| 111-182R | B111 | A182 | 2 | 1 | 111-236R | B111 | A236 | 2 | 1 |
| 111-191R | B111 | A191 | 2 | 1 | 111-237R | B111 | A237 | 2 | 1 |
| 111-192R | B111 | A192 | 2 | 1 | 111-238R | B111 | A238 | 2 | 1 |
| 111-193R | B111 | A193 | 2 | 1 | 111-239R | B111 | A239 | 2 | 1 |
| 111-194R | B111 | A194 | 2 | 1 | 111-241R | B111 | A241 | 2 | 1 |
| 111-196R | B111 | A196 | 2 | 1 | 111-242R | B111 | A242 | 2 | 1 |
| 111-197R | B111 | A197 | 2 | 1 | 111-243R | B111 | A243 | 2 | 1 |
| 111-199R | B111 | A199 | 2 | 1 | 111-246R | B111 | A246 | 2 | 1 |
| 111-200R | B111 | A200 | 2 | 1 | 111-247R | B111 | A247 | 2 | 1 |
| 111-201R | B111 | A201 | 2 | 1 | 111-248R | B111 | A248 | 2 | 1 |
| 111-203R | B111 | A203 | 2 | 1 | 111-249R | B111 | A249 | 2 | 1 |
| 111-206R | B111 | A206 | 2 | 1 | 111-250R | B111 | A250 | 2 | 1 |

**Table 53**

| Compound No. | L₁ | L₂ | n1 | n2 | Compound No. | L₁ | L₂ | n1 | n2 |
|---|---|---|---|---|---|---|---|---|---|
| 115-1R | B115 | A1 | 2 | 1 | 115-208R | B115 | A208 | 2 | 1 |
| 115-2R | B115 | A2 | 2 | 1 | 115-209R | B115 | A209 | 2 | 1 |
| 115-3R | B115 | A3 | 2 | 1 | 115-212R | B115 | A212 | 2 | 1 |
| 115-5R | B115 | A5 | 2 | 1 | 115-213R | B115 | A213 | 2 | 1 |
| 111-8R | B115 | A8 | 2 | 1 | 115-214R | B115 | A214 | 2 | 1 |
| 115-35R | B115 | A35 | 2 | 1 | 115-215R | B115 | A215 | 2 | 1 |
| 115-36R | B115 | A36 | 2 | 1 | 115-216R | B115 | A216 | 2 | 1 |
| 115-45R | B115 | A45 | 2 | 1 | 115-217R | B115 | A217 | 2 | 1 |
| 115-47R | B115 | A47 | 2 | 1 | 115-221R | B115 | A221 | 2 | 1 |
| 115-49R | B115 | A49 | 2 | 1 | 115-222R | B115 | A222 | 2 | 1 |
| 115-60R | B115 | A60 | 2 | 1 | 115-224R | B115 | A224 | 2 | 1 |
| 115-86R | B115 | A86 | 2 | 1 | 115-225R | B115 | A225 | 2 | 1 |
| 115-94R | B115 | A94 | 2 | 1 | 115-226R | B115 | A226 | 2 | 1 |
| 115-99R | B115 | A99 | 2 | 1 | 115-228R | B115 | A228 | 2 | 1 |
| 115-101R | B115 | A101 | 2 | 1 | 115-229R | B115 | A229 | 2 | 1 |
| 115-139R | B115 | A139 | 2 | 1 | 115-231R | B115 | A231 | 2 | 1 |
| 115-161R | B115 | A161 | 2 | 1 | 115-232R | B115 | A232 | 2 | 1 |
| 115-162R | B115 | A162 | 2 | 1 | 115-233R | B115 | A233 | 2 | 1 |
| 115-181R | B115 | A181 | 2 | 1 | 115-235R | B115 | A235 | 2 | 1 |
| 115-182R | B115 | A182 | 2 | 1 | 115-236R | B115 | A236 | 2 | 1 |
| 115-191R | B115 | A191 | 2 | 1 | 115-237R | B115 | A237 | 2 | 1 |
| 115-192R | B115 | A192 | 2 | 1 | 115-238R | B115 | A238 | 2 | 1 |
| 115-193R | B115 | A193 | 2 | 1 | 115-239R | B115 | A239 | 2 | 1 |
| 115-194R | B115 | A194 | 2 | 1 | 115-241R | B115 | A241 | 2 | 1 |
| 115-196R | B115 | A196 | 2 | 1 | 115-242R | B115 | A242 | 2 | 1 |
| 115-197R | B115 | A197 | 2 | 1 | 115-243R | B115 | A243 | 2 | 1 |
| 115-199R | B115 | A199 | 2 | 1 | 115-246R | B115 | A246 | 2 | 1 |
| 115-200R | B115 | A200 | 2 | 1 | 115-247R | B115 | A247 | 2 | 1 |
| 115-201R | B115 | A201 | 2 | 1 | 115-248R | B115 | A248 | 2 | 1 |
| 115-203R | B115 | A203 | 2 | 1 | 115-249R | B115 | A249 | 2 | 1 |
| 115-206R | B115 | A206 | 2 | 1 | 115-250R | B115 | A250 | 2 | 1 |

**Table 54**

| Compound No. | L₁ | L₂ | n1 | n2 | Compound No. | L₁ | L₂ | n1 | n2 |
|---|---|---|---|---|---|---|---|---|---|
| 201-1R | B201 | A1 | 2 | 1 | 201-208R | B201 | A208 | 2 | 1 |
| 201-2R | B201 | A2 | 2 | 1 | 201-209R | B201 | A209 | 2 | 1 |
| 201-3R | B201 | A3 | 2 | 1 | 201-212R | B201 | A212 | 2 | 1 |
| 201-5R | B201 | A5 | 2 | 1 | 201-213R | B201 | A213 | 2 | 1 |
| 201-8R | B201 | A8 | 2 | 1 | 201-214R | B201 | A214 | 2 | 1 |
| 201-35R | B201 | A35 | 2 | 1 | 201-215R | B201 | A215 | 2 | 1 |
| 201-36R | B201 | A36 | 2 | 1 | 201-216R | B201 | A216 | 2 | 1 |
| 201-45R | B201 | A45 | 2 | 1 | 201-217R | B201 | A217 | 2 | 1 |
| 201-47R | B201 | A47 | 2 | 1 | 201-221R | B201 | A221 | 2 | 1 |
| 201-49R | B201 | A49 | 2 | 1 | 201-222R | B201 | A222 | 2 | 1 |
| 201-60R | B201 | A60 | 2 | 1 | 201-224R | B201 | A224 | 2 | 1 |
| 201-86R | B201 | A86 | 2 | 1 | 201-225R | B201 | A225 | 2 | 1 |
| 201-94R | B201 | A94 | 2 | 1 | 201-226R | B201 | A226 | 2 | 1 |
| 201-99R | B201 | A99 | 2 | 1 | 201-228R | B201 | A228 | 2 | 1 |
| 201-101R | B201 | A101 | 2 | 1 | 201-229R | B201 | A229 | 2 | 1 |
| 201-139R | B201 | A139 | 2 | 1 | 201-231R | B201 | A231 | 2 | 1 |
| 201-161R | B201 | A161 | 2 | 1 | 201-232R | B201 | A232 | 2 | 1 |
| 201-162R | B201 | A162 | 2 | 1 | 201-233R | B201 | A233 | 2 | 1 |
| 201-181R | B201 | A181 | 2 | 1 | 201-235R | B201 | A235 | 2 | 1 |
| 201-182R | B201 | A182 | 2 | 1 | 201-236R | B201 | A236 | 2 | 1 |
| 201-191R | B201 | A191 | 2 | 1 | 201-237R | B201 | A237 | 2 | 1 |
| 201-192R | B201 | A192 | 2 | 1 | 201-238R | B201 | A238 | 2 | 1 |
| 201-193R | B201 | A193 | 2 | 1 | 201-239R | B201 | A239 | 2 | 1 |
| 201-194R | B201 | A194 | 2 | 1 | 201-241R | B201 | A241 | 2 | 1 |
| 201-196R | B201 | A196 | 2 | 1 | 201-242R | B201 | A242 | 2 | 1 |
| 201-197R | B201 | A197 | 2 | 1 | 201-243R | B201 | A243 | 2 | 1 |
| 201-199R | B201 | A199 | 2 | 1 | 201-246R | B201 | A246 | 2 | 1 |
| 201-200R | B201 | A200 | 2 | 1 | 201-247R | B201 | A247 | 2 | 1 |
| 201-201R | B201 | A201 | 2 | 1 | 201-248R | B201 | A248 | 2 | 1 |
| 201-203R | B201 | A203 | 2 | 1 | 201-249R | B201 | A249 | 2 | 1 |
| 201-206R | B201 | A206 | 2 | 1 | 201-250R | B201 | A250 | 2 | 1 |

**Table 55**

| Compound No. | L₁ | L₂ | n1 | n2 | Compound No. | L₁ | L₂ | n1 | n2 |
|---|---|---|---|---|---|---|---|---|---|
| 253-1R | B253 | A1 | 2 | 1 | 253-208R | B253 | A208 | 2 | 1 |
| 253-2R | B253 | A2 | 2 | 1 | 253-209R | B253 | A209 | 2 | 1 |
| 253-3R | B253 | A3 | 2 | 1 | 253-212R | B253 | A212 | 2 | 1 |
| 253-5R | B253 | A5 | 2 | 1 | 253-213R | B253 | A213 | 2 | 1 |
| 253-8R | B253 | A8 | 2 | 1 | 253-214R | B253 | A214 | 2 | 1 |
| 253-35R | B253 | A35 | 2 | 1 | 253-215R | B253 | A215 | 2 | 1 |
| 253-36R | B253 | A36 | 2 | 1 | 253-216R | B253 | A216 | 2 | 1 |
| 253-45R | B253 | A45 | 2 | 1 | 253-217R | B253 | A217 | 2 | 1 |
| 253-47R | B253 | A47 | 2 | 1 | 253-221R | B253 | A221 | 2 | 1 |
| 253-49R | B253 | A49 | 2 | 1 | 253-222R | B253 | A222 | 2 | 1 |
| 253-60R | B253 | A60 | 2 | 1 | 253-224R | B253 | A224 | 2 | 1 |
| 253-86R | B253 | A86 | 2 | 1 | 253-225R | B253 | A225 | 2 | 1 |
| 253-94R | B253 | A94 | 2 | 1 | 253-226R | B253 | A226 | 2 | 1 |
| 253-99R | B253 | A99 | 2 | 1 | 253-228R | B253 | A228 | 2 | 1 |
| 253-101R | B253 | A101 | 2 | 1 | 253-229R | B253 | A229 | 2 | 1 |
| 253-139R | B253 | A139 | 2 | 1 | 253-231R | B253 | A231 | 2 | 1 |
| 253-161R | B253 | A161 | 2 | 1 | 253-232R | B253 | A232 | 2 | 1 |
| 253-162R | B253 | A162 | 2 | 1 | 253-233R | B253 | A233 | 2 | 1 |
| 253-181R | B253 | A181 | 2 | 1 | 253-235R | B253 | A235 | 2 | 1 |
| 253-182R | B253 | A182 | 2 | 1 | 253-236R | B253 | A236 | 2 | 1 |
| 253-191R | B253 | A191 | 2 | 1 | 253-237R | B253 | A237 | 2 | 1 |
| 253-192R | B253 | A192 | 2 | 1 | 253-238R | B253 | A238 | 2 | 1 |
| 253-193R | B253 | A193 | 2 | 1 | 253-239R | B253 | A239 | 2 | 1 |
| 253-194R | B253 | A194 | 2 | 1 | 253-241R | B253 | A241 | 2 | 1 |
| 253-196R | B253 | A196 | 2 | 1 | 253-242R | B253 | A242 | 2 | 1 |
| 253-197R | B253 | A197 | 2 | 1 | 253-243R | B253 | A243 | 2 | 1 |
| 253-199R | B253 | A199 | 2 | 1 | 253-246R | B253 | A246 | 2 | 1 |
| 253-200R | B253 | A200 | 2 | 1 | 253-247R | B253 | A247 | 2 | 1 |
| 253-201R | B253 | A201 | 2 | 1 | 253-248R | B253 | A248 | 2 | 1 |
| 253-203R | B253 | A203 | 2 | 1 | 253-249R | B253 | A249 | 2 | 1 |
| 253-206R | B253 | A206 | 2 | 1 | 253-250R | B253 | A250 | 2 | 1 |

**Table 56**

| Compound No. | L₁ | L₂ | n1 | n2 | Compound No. | L₁ | L₂ | n1 | n2 |
|---|---|---|---|---|---|---|---|---|---|
| 293-1R | B293 | A1 | 2 | 1 | 293-208R | B293 | A208 | 2 | 1 |
| 293-2R | B293 | A2 | 2 | 1 | 293-209R | B293 | A209 | 2 | 1 |
| 293-3R | B293 | A3 | 2 | 1 | 293-212R | B293 | A212 | 2 | 1 |
| 293-5R | B293 | A5 | 2 | 1 | 293-213R | B293 | A213 | 2 | 1 |
| 293-8R | B293 | A8 | 2 | 1 | 293-214R | B293 | A214 | 2 | 1 |
| 293-35R | B293 | A35 | 2 | 1 | 293-215R | B293 | A215 | 2 | 1 |
| 293-36R | B293 | A36 | 2 | 1 | 293-216R | B293 | A216 | 2 | 1 |
| 293-45R | B293 | A45 | 2 | 1 | 293-217R | B293 | A217 | 2 | 1 |
| 293-47R | B293 | A47 | 2 | 1 | 293-221R | B293 | A221 | 2 | 1 |
| 293-49R | B293 | A49 | 2 | 1 | 293-222R | B293 | A222 | 2 | 1 |
| 293-60R | B293 | A60 | 2 | 1 | 293-224R | B293 | A224 | 2 | 1 |
| 293-86R | B293 | A86 | 2 | 1 | 293-225R | B293 | A225 | 2 | 1 |
| 293-94R | B293 | A94 | 2 | 1 | 293-226R | B293 | A226 | 2 | 1 |
| 293-99R | B293 | A99 | 2 | 1 | 293-228R | B293 | A228 | 2 | 1 |
| 293-101R | B293 | A101 | 2 | 1 | 293-229R | B293 | A229 | 2 | 1 |
| 293-139R | B293 | A139 | 2 | 1 | 293-231R | B293 | A231 | 2 | 1 |
| 293-161R | B293 | A161 | 2 | 1 | 293-232R | B293 | A232 | 2 | 1 |
| 293-162R | B293 | A162 | 2 | 1 | 293-233R | B293 | A233 | 2 | 1 |
| 293-181R | B293 | A181 | 2 | 1 | 293-235R | B293 | A235 | 2 | 1 |
| 293-182R | B293 | A182 | 2 | 1 | 293-236R | B293 | A236 | 2 | 1 |
| 293-191R | B293 | A191 | 2 | 1 | 293-237R | B293 | A237 | 2 | 1 |
| 293-192R | B293 | A192 | 2 | 1 | 293-238R | B293 | A238 | 2 | 1 |
| 293-193R | B293 | A193 | 2 | 1 | 293-239R | B293 | A239 | 2 | 1 |
| 293-194R | B293 | A194 | 2 | 1 | 293-241R | B293 | A241 | 2 | 1 |
| 293-196R | B293 | A196 | 2 | 1 | 293-242R | B293 | A242 | 2 | 1 |
| 293-197R | B293 | A197 | 2 | 1 | 293-243R | B293 | A243 | 2 | 1 |
| 293-199R | B293 | A199 | 2 | 1 | 293-246R | B293 | A246 | 2 | 1 |
| 293-200R | B293 | A200 | 2 | 1 | 293-247R | B293 | A247 | 2 | 1 |
| 293-201R | B293 | A201 | 2 | 1 | 293-248R | B293 | A248 | 2 | 1 |
| 293-203R | B293 | A203 | 2 | 1 | 293-249R | B293 | A249 | 2 | 1 |
| 293-206R | B293 | A206 | 2 | 1 | 293-250R | B293 | A250 | 2 | 1 |

The organometallic compound of the invention is not the following compound:

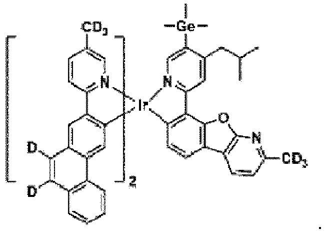

In one or more embodiments, the organometallic compound represented by Formula 1 may emit a red light or a green light, for example, a red light or a green light having a maximum luminescence wavelength of about 500 nanometers (nm) or greater, for example, a maximum luminescence wavelength of about 500 nm to about 750 nm. For example, the organometallic compound may emit a green light. In one or more embodiments, the organometallic compound may emit a light (for example, a green light) having a maximum emission wavelength of about 515 nm to about 550 nm, or about 520 nm to about 540 nm.

In relation to the organometallic compound represented by Formula 1, L₁ is a ligand represented by Formula 2-1, L₂ is a ligand represented by Formula 2-2, n1, which is the number of L₁, and n2, which is the number of L₂, may each independently be 1 or 2. Accordingly, the current efficiency and the lifespan of an electronic device, such as, an organic light-emitting device, including at least one organometallic compound represented by Formula 1, may be improved.

A highest occupied molecular orbital (HOMO) energy level, a lowest unoccupied molecular orbital (LUMO) energy level, and a triplet (T₁) energy level of some compounds of the organometallic compound represented by Formula 1 were calculated using a density functional theory (DFT) method of the Gaussian 09 program with the molecular structure optimization obtained at the B3LYP level, and results thereof are shown in Table 57. The energy levels are expressed in electron volts (eV).

**Table 57**

| Compound No. | HOMO (eV) | LUMO (eV) | T₁(eV) |
|---|---|---|---|
| 1 (Compound 2-201 of Table 1) | -4.850 | -1.254 | 2.536 |
| 2 (Compound 22-1 of Table 8) | -4.813 | -1.276 | 2.526 |
| 3 (Compound 2-1R of Table 43) | -4.833 | -1.289 | 2.536 |
| 4 (Compound 6-215R of Table 45) | -4.879 | -1.324 | 2.497 |
| 5 (Compound 2-212R of Table 43) | -4.816 | -1.229 | 2.533 |
| 6 (Compound 201-2 of Table 31) | -4.784 | -1.222 | 2.613 |
| 7 (Compound 6-2 of Table 4) | -4.779 | -1.229 | 2.486 |
| 8 (Compound 106-206 of Table 25) | -4.826 | -1.254 | 2.495 |
| 9 (Compound 26-208 of Table 10) | -4.748 | -1.183 | 2.484 |
| 10 (Compound 111-203 of Table 26) | -4.865 | -1.289 | 2.492 |
| 11 (Compound 26-238R of Table 48) | -4.905 | -1.359 | 2.509 |
| 12 (Compound 253-212 of Table 35) | -4.772 | -1.154 | 2.530 |
| 13 (Compound 67-217 of Table 18) | -4.751 | -1.205 | 2.495 |
| 14 (Compound 293-222 of Table 39) | -4.728 | -1.196 | 2.386 |

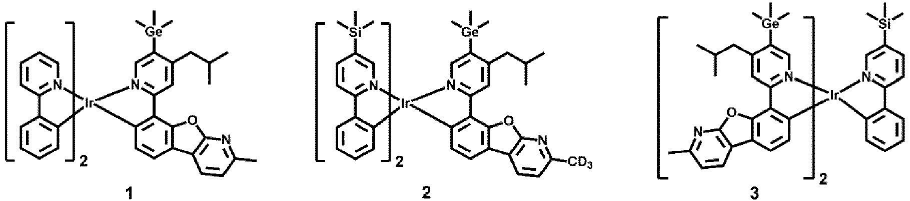

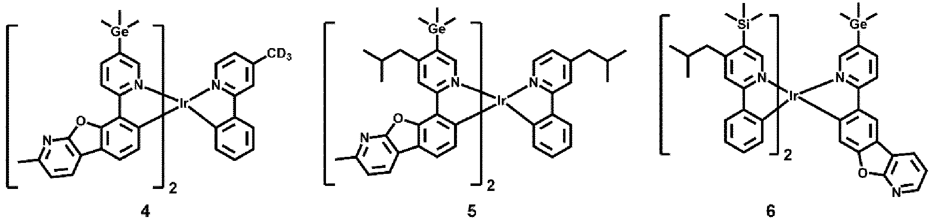

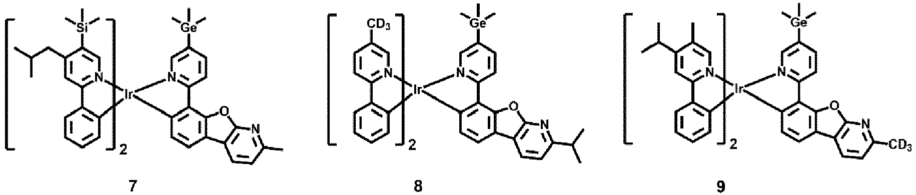

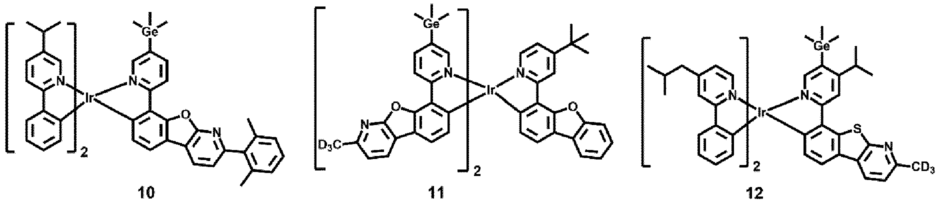

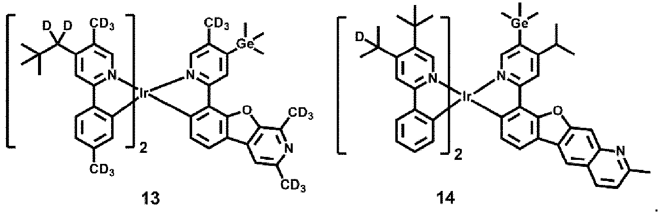

From Table 1, it was confirmed that the organometallic compound represented by Formula 1 has such electric characteristics that are suitable for use in an electronic device, for example, for use as a dopant for an organic light-emitting device.

Synthesis methods of the organometallic compound represented by Formula 1 may be recognizable by one of ordinary skill in the art by referring to Synthesis Examples provided below.

Accordingly, the organometallic compound represented by Formula 1 is suitable for use as a material for an organic layer of organic light-emitting device, for example, a dopant in an emission layer of the organic layer. Thus, another aspect provides an organic light-emitting device including: a first electrode; a second electrode; and an organic layer located between the first electrode and the second electrode, wherein the organic layer includes an emission layer, and the organic layer includes at least one organometallic compound represented by Formula 1.

The organic light-emitting device includes an organic layer containing at least one organometallic compound represented by Formula 1. Accordingly, the organic light-emitting device may have improved external quantum efficiency and improved lifespan characteristics.

The organometallic compound of Formula 1 may be used or located between a pair of electrodes of an organic light-emitting device. For example, at least one organometallic compound represented by Formula 1 may be included in the emission layer. In this regard, the organometallic compound may act as a dopant, and the emission layer may further include a host (that is, an amount of the at least one organometallic compound represented by Formula 1 in the emission layer is less than an amount of the host in the emission layer). In other words, in one or more embodiments, an amount of the host in the emission layer is greater than an amount of the at least one organometallic compound represented by Formula 1 in the emission layer, based on the total weight of the emission layer.

The emission layer may emit a red or a green light, for example, a red light or a green light having a maximum luminescence wavelength of about 500 nanometers (nm) or greater, for example, a maximum luminescence wavelength of about 500 nm to about 750 nm. For example, the organometallic compound may emit a green light. In one or more embodiments, the emission layer (or an organic light-emitting device) may emit a light (for example, a green light) having a maximum emission wavelength of about 515 nm to about 550 nm, or about 520 nm to about 540 nm.

The expression "(an organic layer) includes at least one organometallic compound represented by Formula 1" used herein may include a case in which "(an organic layer) includes identical organometallic compounds represented by Formula 1, and a case in which "(an organic layer) includes two or more different organometallic compounds each represented by Formula 1.

For example, the organic layer may include, as the at least one organometallic compound represented by Formula 1, only Compound 1. In this embodiment, Compound 1 may be included in the emission layer of the organic light-emitting device. In one or more embodiments, the organic layer may include, as the at least one organometallic compound represented by Formula 1, Compound 1 and Compound 2, wherein Compound 1 and Compound 2 are different. In this regard, Compound 1 and Compound 2 may exist in an identical layer (for example, Compound 1 and Compound 2 all may exist in an emission layer).

The first electrode may be an anode, which is a hole injection electrode, and the second electrode may be a cathode, which is an electron injection electrode; or the first electrode may be a cathode, which is an electron injection electrode, and the second electrode may be an anode, which is a hole injection electrode.

In one or more embodiments, in the organic light-emitting device, the first electrode may be an anode, and the second electrode may be a cathode, and the organic layer may further include a hole transport region located between the first electrode and the emission layer, and an electron transport region located between the emission layer and the second electrode, and the hole transport region may include a hole injection layer, a hole transport layer, an electron-blocking layer, a buffer layer, or a combination thereof, and the electron transport region may include a hole-blocking layer, an electron transport layer, an electron injection layer, or a combination thereof.

The term "organic layer" as used herein refers to a single layer and/or a plurality of layers located between the first electrode and the second electrode of the organic light-emitting device. The "organic layer" may include, in addition to an organic compound, an organometallic complex including a metal.

The FIGURE is a schematic cross-sectional view of an organic light-emitting device 10 according to one or more embodiments. Hereinafter, the structure and manufacturing method of the organic light-emitting device 10 according to one or more embodiments will be described in further detail in connection with the FIGURE, but embodiments are not limited thereto. The organic light-emitting device 10 includes a first electrode 11, an organic layer 15, and a second electrode 19, which are sequentially stacked.

A substrate may be additionally disposed under the first electrode 11 or on the second electrode 19. The substrate may be a conventional substrate used in organic light-emitting devices, e.g., a glass substrate or a transparent plastic substrate, each having excellent mechanical strength, thermal stability, transparency, surface smoothness, ease of handling, and/or water repellency.

The first electrode 11 may be produced by depositing or sputtering, onto the substrate, a material for forming the first electrode 11. The first electrode 11 may be an anode. The material for forming the first electrode 11 may include materials with a high work function to facilitate hole injection. The first electrode 11 may be a reflective electrode, a semi-transmissive electrode, or a transmissive electrode. The material for forming the first electrode 11 may be indium tin oxide (ITO), indium zinc oxide (IZO), tin oxide (SnO₂), or zinc oxide (ZnO). In one or more embodiments, the material for forming the first electrode 11 may be a metal, such as magnesium (Mg), aluminum (Al), silver (Ag), aluminum-lithium (Al-Li), calcium (Ca), magnesium-indium (Mg-In), or magnesium-silver (Mg-Ag).

The first electrode 11 may have a single-layered structure or the first electrode 11 may have a multi-layered structure including a plurality of layers. For example, in one or more embodiments, the first electrode 11 may have a three-layered structure of ITO/Ag/ITO.

The organic layer 15 may be located on the first electrode 11.

The organic layer 15 may include a hole transport region, an emission layer, and an electron transport region.

The hole transport region may be located between the first electrode 11 and the emission layer.

The hole transport region may include a hole injection layer, a hole transport layer, an electron-blocking layer, a buffer layer, or a combination thereof.

The hole transport region may include only either a hole injection layer or a hole transport layer. In one or more embodiments, the hole transport region may have a hole injection layer/hole transport layer structure or a hole injection layer/hole transport layer/electron-blocking layer structure, wherein, for each structure, respective layers are sequentially stacked in this stated order from the first electrode 11.

When the hole transport region includes a hole injection layer, the hole injection layer may be formed on the first electrode 11 by using one or more suitable methods, for example, vacuum deposition, spin coating, casting, and/or Langmuir-Blodgett (LB) deposition.

When a hole injection layer is formed by vacuum deposition, the deposition conditions may vary depending on a material that is used to form the hole injection layer, and the structure and thermal characteristics of the hole injection layer. For example, the deposition conditions may include a deposition temperature of about 100°C to about 500°C, a vacuum pressure of about 10⁻⁸ torr to about 10⁻³ torr, and a deposition rate of about 0.01 angstroms per second (Å/sec) to about 100 Å/sec.

When the hole injection layer is formed by spin coating, the coating conditions may vary depending on a material for forming the hole injection layer, and the structure and thermal characteristics of the hole injection layer. For example, the coating conditions may include a coating speed of about 2,000 revolutions per minute (rpm) to about 5,000 rpm and heat treatment at about 80°C to about 200°C to remove solvent(s) after coating.

The conditions for forming the hole transport layer and the electron-blocking layer may be similar to or the same as the conditions for forming the hole injection layer.

The hole transport region may include at least one of 4,4',4"-tris(3-methylphenylphenylamino)triphenylamine (m-MTDATA), 4,4',4"-tris(N,N-diphenylamino)triphenylamine (TDATA), 4,4',4"-tris{N-(2-naphthyl)-N-phenylamino}-triphenylamine (2-TNATA), N,N'-di(1-naphthyl)-N,N'-diphenylbenzidine (NPB), β-NPB, N,N'-bis(3-methylphenyl)-N,N'-diphenyl-[1,1-biphenyl]-4,4'-diamine (TPD), spiro-TPD, spiro-NPB, methylated NPB, 4,4'-cyclohexylidene bis[N,N-bis(4-methylphenyl)benzenamine] (TAPC), 4,4'-bis[N,N'-(3-tolyl)amino]-3,3'-dimethylbiphenyl (HMTPD), 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201, a compound represented by Formula 202, or a combination thereof, but embodiments are not limited thereto:

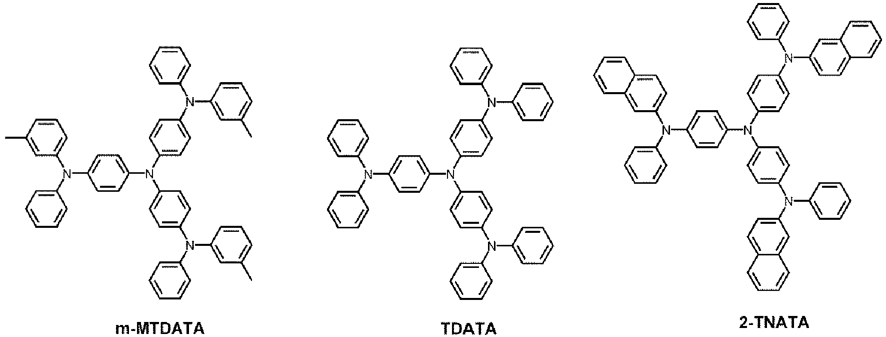

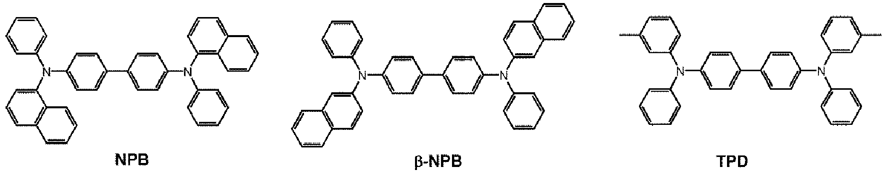

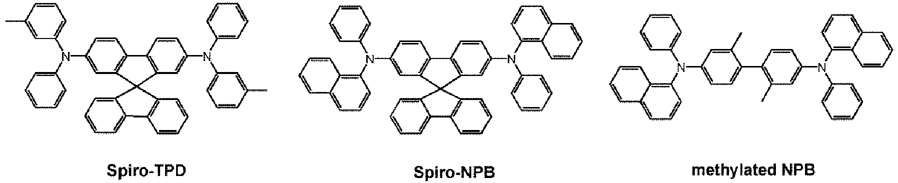

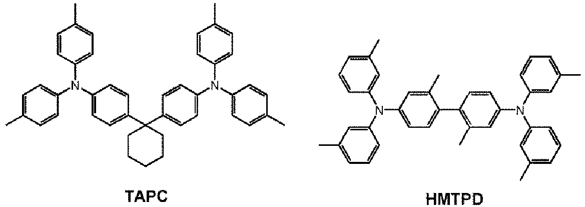

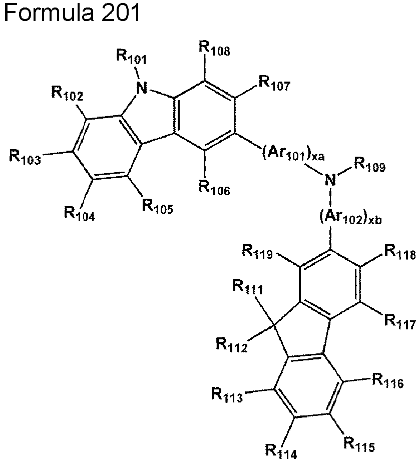

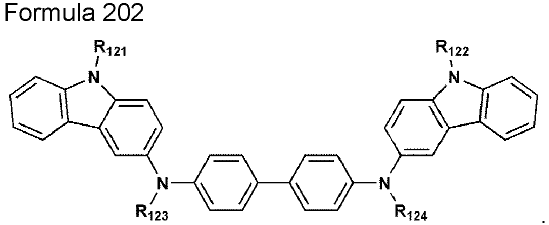

Ar₁₀₁ and Ar₁₀₂ in Formula 201 may each independently be a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with at least one of deuterium, -F, -Cl, -Br, -I, - SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₉ cycloalkyl group, a C₃-C₁₉ cycloalkenyl group, a C₁-C₁₀ heterocycloalkyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, or a combination thereof.

xa and xb in Formula 201 may each independently be an integer from 0 to 5, or 0, 1, or 2. For example, xa may be 1 and xb may be 0.

R₁₀₁ to R₁₀₈, R₁₁₁ to R₁₁₉, and R₁₂₁ to R₁₂₄ in Formulae 201 and 202 may each independently be:
hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group (for example, a methyl group, an ethyl group, a propyl group, a butyl group, a pentyl group, a hexyl group, or the like), a C₁-C₁₀ alkoxy group (for example, a methoxy group, an ethoxy group, a propoxy group, a butoxy group, a pentoxy group, or the like), or a C₁-C₁₀ alkylthio group;
a C₁-C₁₀ alkyl group, a C₁-C₁₀ alkoxy group, or a C₁-C₁₀ alkylthio group, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or a combination thereof; or
a phenyl group, a naphthyl group, an anthracenyl group, a fluorenyl group, or a pyrenyl group, each unsubstituted or substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a C₁-C₁₀ alkoxy group, a C₁-C₁₀ alkylthio group, or a combination thereof.

R₁₀₉ in Formula 201 may be a phenyl group, a naphthyl group, an anthracenyl group, or a pyridinyl group, each unsubstituted or substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a phenyl group, a naphthyl group, an anthracenyl group, a pyridinyl group, or a combination thereof.

In one or more embodiments, the compound represented by Formula 201 may be represented by Formula 201A:

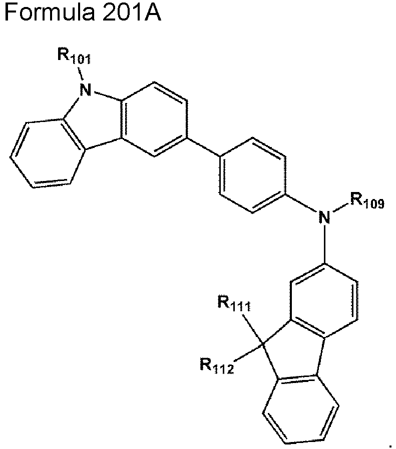

R₁₀₁, R₁₁₁, R₁₁₂, and R₁₀₉ in Formula 201A are each as described herein.

For example, the compound represented by Formula 201 and the compound represented by Formula 202 may include one of Compounds HT1 to HT20, but embodiments are not limited thereto:

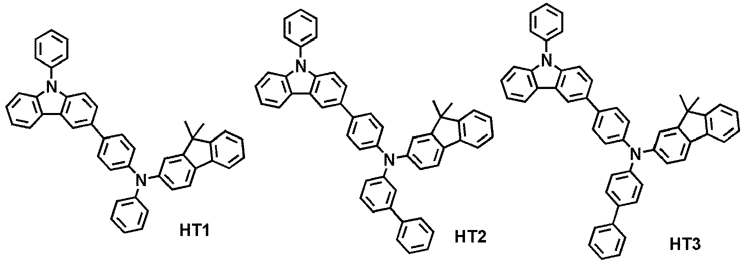

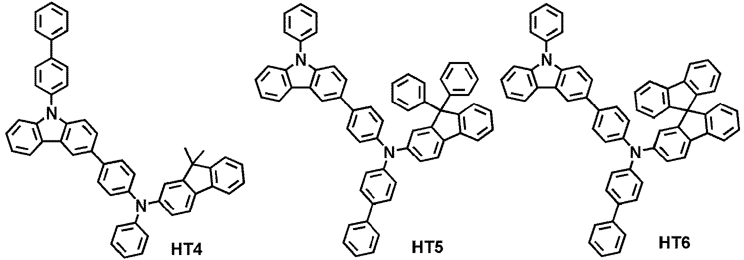

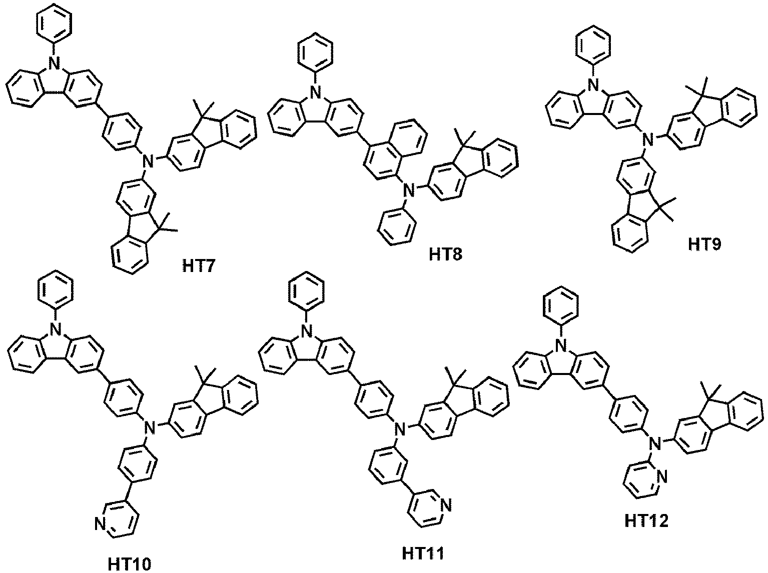

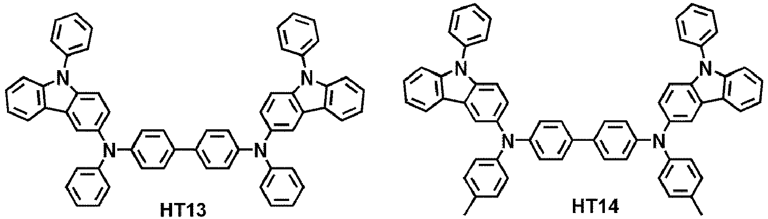

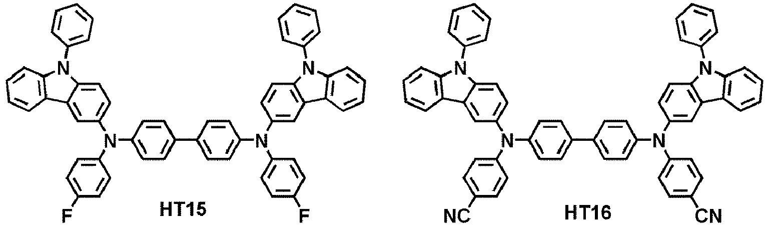

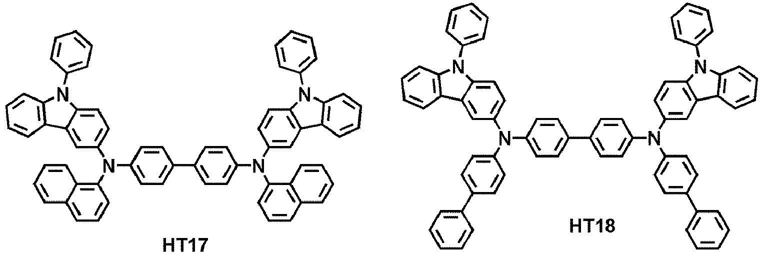

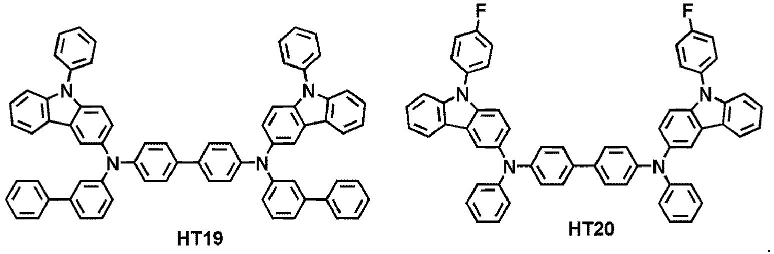

A thickness of the hole transport region may be about 100 angstroms (Å) to about 10,000 Å, for example, about 100 Å to about 1,000 Å. When the hole transport region includes at least one of a hole injection layer and a hole transport layer, a thickness of the hole injection layer may be about 100 Å to about 10,000 Å, for example, about 100 Å to about 1,000 Å, and a thickness of the hole transport layer may be about 50 Å to about 2,000 Å, for example, about 100 Å to about 1,500 Å. Without wishing to be bound to theory, when the thicknesses of the hole transport region, the hole injection layer, and the hole transport layer are within these ranges, satisfactory hole transporting characteristics may be obtained without a substantial increase in driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may be one of a quinone derivative, a metal oxide, or a cyano group-containing compound, but embodiments are not limited thereto. For example, non-limiting examples of the p-dopant include a quinone derivative, such as tetracyanoquinodimethane (TCNQ), 2,3,5,6-tetrafluoro-tetracyano-1,4-benzoquinonedimethane (F4-TCNQ), 1,3,4,5,7,8-hexafluorotetracyanonaphthoquinodimethane (F6-TCNNQ), or the like; a metal oxide, such as a tungsten oxide, a molybdenum oxide, or the like; or a cyano group-containing compound, such as Compound HT-D1, but embodiments are not limited thereto.

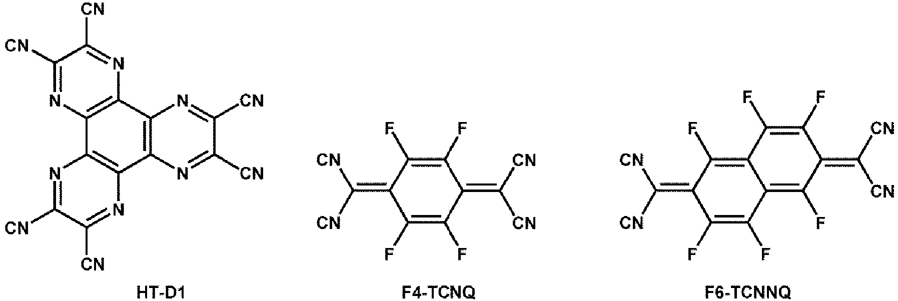

The hole transport region may include a buffer layer.

Also, the buffer layer may compensate for an optical resonance distance according to a wavelength of a light emitted from the emission layer, and thus, efficiency of a formed organic light-emitting device may be improved.

Meanwhile, when the hole transport region includes an electron-blocking layer, a material for forming the electron-blocking layer may include a material that is used in the hole transport region as described herein, a host material as described herein, or a combination thereof. For example, when the hole transport region includes an electron-blocking layer, mCP, Compound H-H1, or the like, which will be described herein, may be used as a material for the electron-blocking layer, but embodiments are not limited thereto.

An emission layer may be formed on the hole transport region, for example, by vacuum deposition, spin coating, casting, LB deposition, or the like. When the emission layer is formed by vacuum deposition or spin coating, the deposition or coating conditions may be similar to those applied in forming the hole injection layer, although the deposition or coating conditions may vary according to a material that is used to form the emission layer.

The emission layer may include a host and a dopant, and the dopant may include at least one organometallic compound represented by Formula 1.

The host may include at least one of 1,3,5-tri(1-phenyl-1H-benzo[d]imidazol-2-yl)benzene (TPBi), 3-tert-butyl-9,10-di(naphth-2-yl)anthracene (TBADN), 9,10-di(naphthalen-2-yl)anthracene (ADN) (also referred to as "DNA"), 4,4'-bis(N-carbazolyl)-1,1'-biphenyl (CBP), 4,4'-bis(9-carbazolyl)-2,2'-dimethyl-biphenyl (CDBP), 1,3,5-tris(carbazol-9-yl)benzene (TCP), 1,3-bis(N-carbazolyl)benzene (mCP), Compound H50, Compound H51, Compound H52, Compound H-H1, Compound H-E43, or a combination thereof, but embodiments are not limited thereto:

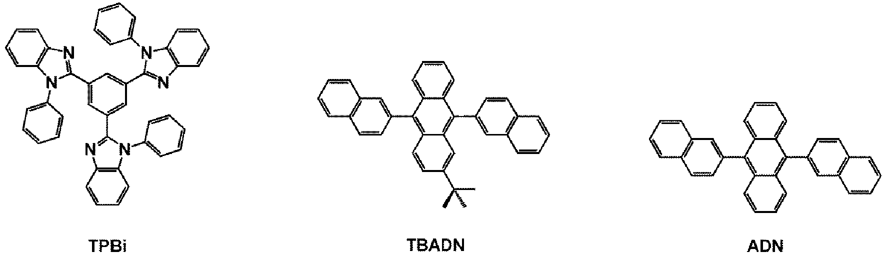

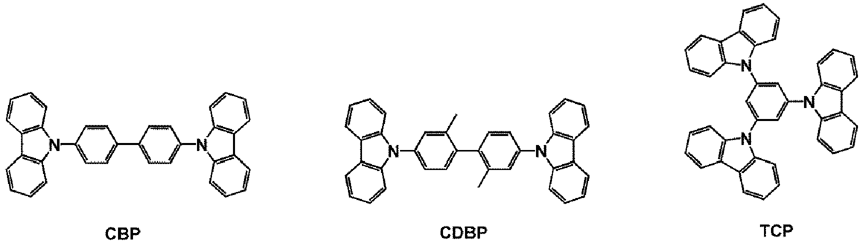

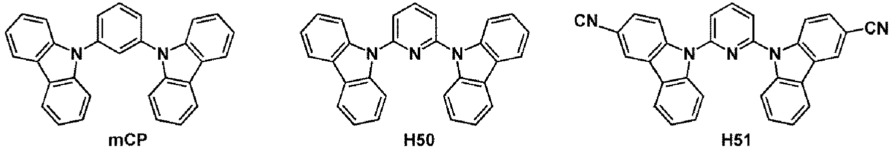

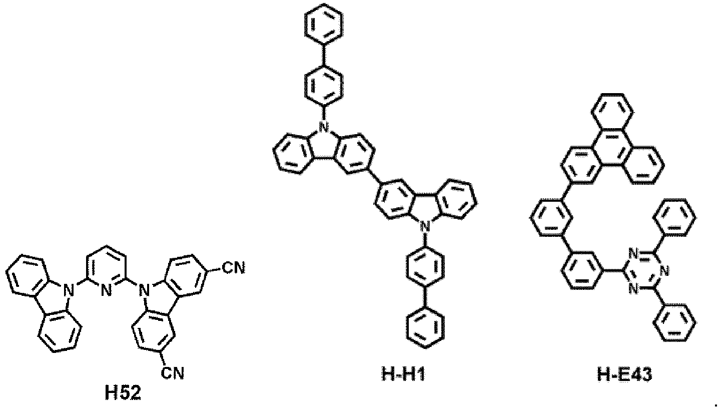

When the organic light-emitting device is a full-color organic light-emitting device, the emission layer may be patterned into a red emission layer, a green emission layer, and/or a blue emission layer. In one or more embodiments, due to a stacked structure including a red emission layer, a green emission layer, and/or a blue emission layer, the emission layer may emit a white light.

When the emission layer includes both a host and a dopant, an amount (for example, a weight) of the dopant in the emission layer may be about 0.01 parts by weight to about 15 parts by weight, based on 100 parts by weight of the emission layer.

A thickness of the emission layer may be about 100 Å to about 1,000 Å, for example, about 200 Å to about 600 Å. Without wishing to be bound to theory, when the thickness of the emission layer is within these ranges, excellent light-emission characteristics may be obtained without a substantial increase in driving voltage.

Next, an electron transport region may be located on the emission layer.

The electron transport region may include a hole-blocking layer, an electron transport layer, an electron injection layer, or a combination thereof.

For example, the electron transport region may have a hole-blocking layer/electron transport layer/electron injection layer structure or an electron transport layer/electron injection layer structure. The electron transport layer may have a single-layered structure or a multi-layered structure including two or more different materials.

Conditions for forming the hole-blocking layer, the electron transport layer, and the electron injection layer which constitute the electron transport region may be understood, for example, by referring to the conditions for forming the hole injection layer.

When the electron transport region includes a hole-blocking layer, the hole-blocking layer may include, for example, 2,9-dimethyl-4,7-diphenyl-1,10-phenanthroline (BCP), 4,7-diphenyl-1,10-phenanthroline (Bphen), bis(2-methyl-8-quinolinolato-N1,O8)-(1,1'-biphenyl-4-olato)aluminum (BAlq), or a combination thereof, but embodiments are not limited thereto:

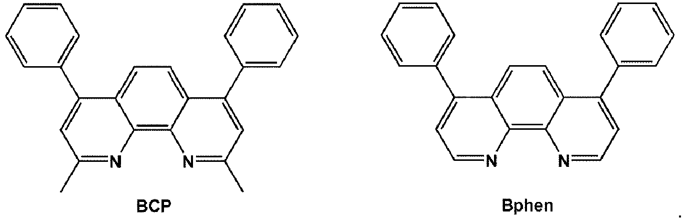

A thickness of the hole-blocking layer may be about 20 Å to about 1,000 Å, for example, about 30 Å to about 300 Å. Without wishing to be bound to theory, when the thickness of the hole-blocking layer is within these ranges, excellent hole-blocking characteristics may be obtained without a substantial increase in driving voltage.

In one or more embodiments, the electron transport layer may include, for example, at least one of 2,9-dimethyl-4,7-diphenyl-1,10-phenanthroline (BCP), 4,7-diphenyl-1,10-phenanthroline (Bphen), tris(8-hydroxy-quinolinato)aluminum (Alq₃), bis(2-methyl-8-quinolinolato-N1,O8)-(1,1'-biphenyl-4-olato)aluminum (BAlq), 3-(4-biphenylyl)-4-phenyl-5-tert-butylphenyl-1,2,4-triazole (TAZ), 4-(naphthalen-1-yl)-3,5-diphenyl-4H-1,2,4-triazole (NTAZ), or a combination thereof.

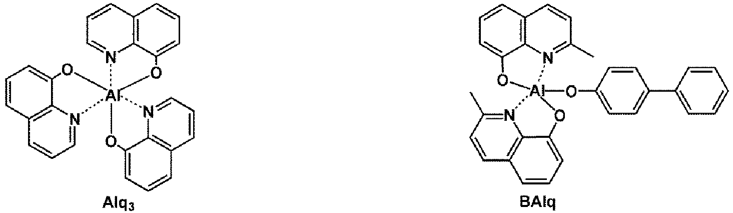

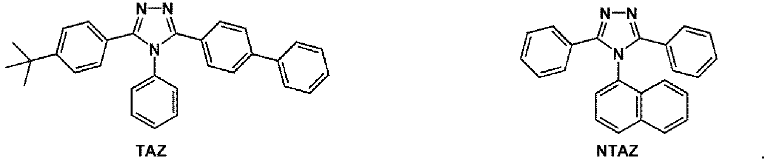

In one or more embodiments, the electron transport layer may include one of Compounds ET1 to ET25, or a combination thereof, but embodiments are not limited thereto:

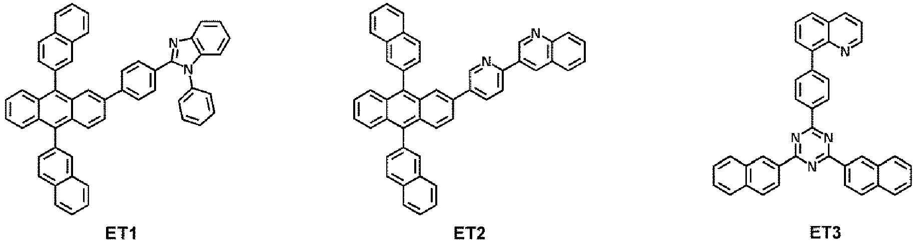

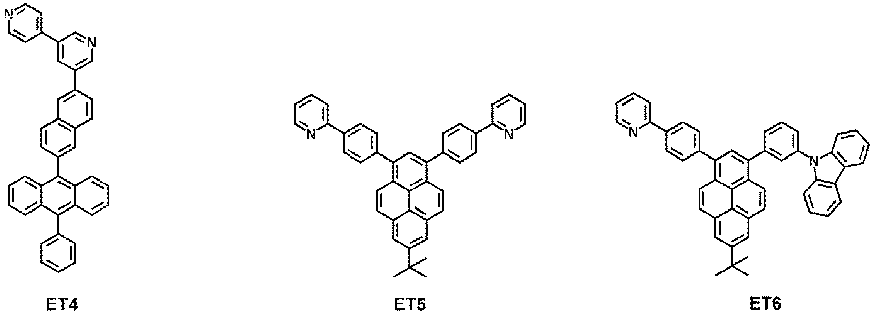

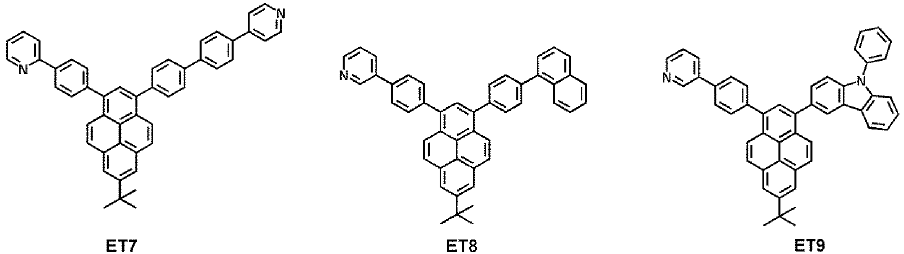

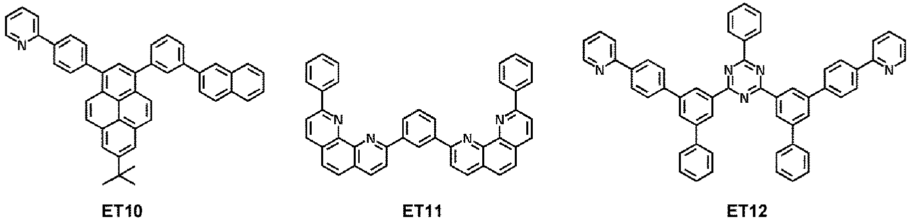

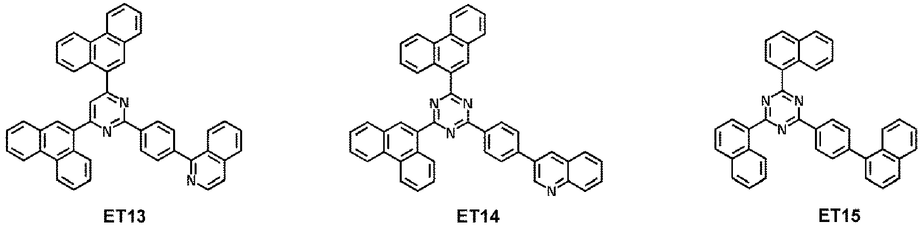

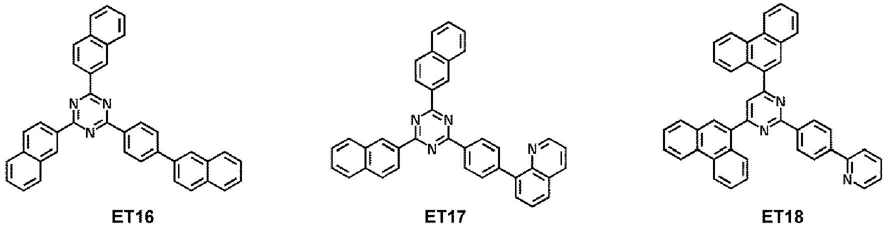

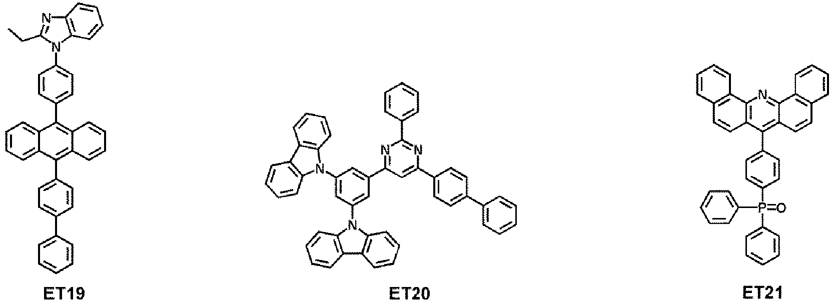

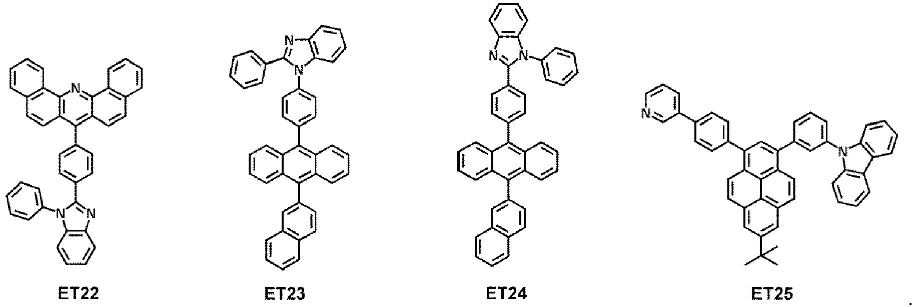

A thickness of the electron transport layer may be about 100 Å to about 1,000 Å, for example, about 150 Å to about 500 Å. Without wishing to be bound to theory, when the thickness of the electron transport layer is within the range described above, the electron transport layer may have satisfactory electron transporting characteristics without a substantial increase in driving voltage.

The electron transport layer may include a metal-containing material in addition to the materials as described herein.

The metal-containing material may include a Li complex. The Li complex may include, for example, Compound ET-D1 (LiQ) or ET-D2, but embodiments are not limited thereto:

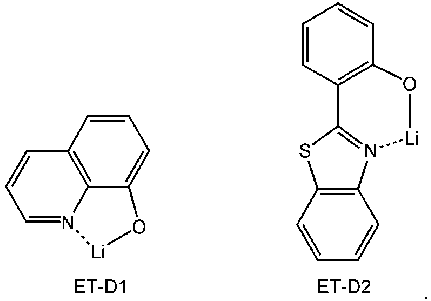

The electron transport region may include an electron injection layer that promotes the flow of electrons from the second electrode 19 into the electron transport region.

The electron injection layer may include, for example, LiF, NaCl, CsF, Li₂O, BaO, or a combination thereof, but embodiments are not limited thereto.

A thickness of the electron injection layer may be about 1 Å to about 100 Å, and, for example, about 3 Å to about 90 Å. Without wishing to be bound to theory, when the thickness of the electron injection layer is within the ranges described above, satisfactory electron injection characteristics may be obtained without a substantial increase in driving voltage.

The second electrode 19 may be located on the organic layer 15. The second electrode 19 may be a cathode. A material for forming the second electrode 19 may be a metal, an alloy, an electrically conductive compound, or a combination thereof, which have a relatively low work function. Examples of the material for forming the second electrode 19 may include lithium (Li), silver (Ag), magnesium (Mg), aluminum (Al), aluminum-lithium (Al-Li), calcium (Ca), magnesium-indium (Mg-In), or magnesium-silver (Mg-Ag). In one or more embodiments, to manufacture a top-emission type light-emitting device, a transmissive electrode formed using ITO or IZO may be used as the second electrode 19.

Hereinbefore, the organic light-emitting device has been described in detail and with reference to the FIGURE, but embodiments are not limited thereto.

According to another aspect, the organic light-emitting device may be included in an electronic apparatus. Thus, an electronic apparatus including the organic light-emitting device is also provided. The electronic apparatus may include, for example, a display, an illumination, a sensor, or the like, but embodiments are not limited thereto.

Another aspect provides a diagnostic composition including at least one organometallic compound represented by Formula 1.

The organometallic compound represented by Formula 1 provides a high luminescent efficiency. Accordingly, a diagnostic composition including the organometallic compound may have a high diagnostic efficiency.

The diagnostic composition may be used in various applications including a diagnosis kit, a diagnosis reagent, a biosensor, a biomarker, or the like, but embodiments are not limited thereto.

The term "C₁-C₆₀ alkyl group" as used herein refers to a linear or branched saturated aliphatic hydrocarbon monovalent group having 1 to 60 carbon atoms, and the term "C₁-C₆₀ alkylene group" as used herein refers to a divalent group having the same structure as the C₁-C₆₀ alkyl group.

Non-limiting examples of the C₁-C₆₀ alkyl group, the C₁-C₂₀ alkyl group, and/or the C₁-C₁₀ alkyl group include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or the like, each unsubstituted or substituted with at least one of a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or a combination thereof.

The term "C₁-C₆₀ alkoxy group" as used herein refers to a monovalent group represented by -OA₁₀₁ (wherein A₁₀₁ is the C₁-C₆₀ alkyl group), and non-limiting examples thereof include a methoxy group, an ethoxy group, a propoxy group, a butoxy group, a pentoxy group, or the like.

The term "C₁-C₆₀ alkylthio group" as used herein refers to a monovalent group represented by -SA₁₀₂ (wherein A₁₀₂ is the C₁-C₆₀ alkyl group).

The term "C₂-C₆₀ alkenyl group" as used herein refers to a hydrocarbon group formed by substituting at least one carbon-carbon double bond in the middle or at the terminus of the C₂-C₆₀ alkyl group, and non-limiting examples thereof include an ethenyl group, a propenyl group, a butenyl group, or the like. The term "C₂-C₆₀ alkenylene group" as used herein refers to a divalent group having the same structure as the C₂-C₆₀ alkenyl group.

The term "C₂-C₆₀ alkynyl group" as used herein refers to a hydrocarbon group formed by substituting at least one carbon-carbon triple bond in the middle or at the terminus of the C₂-C₆₀ alkyl group, and non-limiting examples thereof include an ethynyl group, a propynyl group, or the like. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent saturated hydrocarbon cyclic group having 3 to 10 carbon atoms. The term "C₃-C₁₀ cycloalkylene group" as used herein refers to a divalent group having the same structure as the C₃-C₁₀ cycloalkyl group.

Non-limiting examples of the C₃-C₁₀ cycloalkyl group include a cyclopropyl group, a cyclobutyl group, a cyclopentyl, cyclohexyl group, a cycloheptyl group, a cyclooctyl group, an adamantanyl group, a norbornanyl group (or a bicyclo[2.2.1]heptyl group), a bicyclo[1.1.1]pentyl group, a bicyclo[2.1.1]hexyl group, and a bicyclo[2.2.2]octyl group.

The term "C₁-C₁₀"heterocycloalkyl group" as used herein refers to a saturated cyclic group that includes at least one heteroatom selected from N, O, P, Si, S, Se, Ge, and B as a ring-forming atom and 1 to 10 carbon atoms. The term "C₁-C₁₀ heterocycloalkylene group" as used herein refers to a divalent group having the same structure as the C₁-C₁₀ heterocycloalkyl group.

Non-limiting examples of the C₁-C₁₀ heterocycloalkyl group include a silolanyl group, a silinanyl group, tetrahydrofuranyl group, a tetrahydro-2H-pyranyl group, a tetrahydrothiophenyl group, or the like.

The term "C₃-C₁₀ cycloalkenyl group" as used herein refers to a monovalent cyclic group that includes 3 to 10 carbon atoms and at least one carbon-carbon double bond in the ring thereof and has no aromaticity, and non-limiting examples thereof include a cyclopentenyl group, a cyclohexenyl group, a cycloheptenyl group, or the like. The term "C₃-C₁₉ cycloalkenylene group" as used herein refers to a divalent group having the same structure as the C₃-C₁₀ cycloalkenyl group.

The term "C₁-C₁₀ heterocycloalkenyl group" as used herein refers to a monovalent cyclic group that has at least one heteroatom selected from N, O, P, Si, S, Se, Ge, and B as a ring-forming atom, 1 to 10 carbon atoms, and at least one double bond in its ring. Non-limiting examples of the C₁-C₁₀ heterocycloalkenyl group include a 2,3-dihydrofuranyl group, a 2,3-dihydrothiophenyl group, or the like. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system having 6 to 60 carbon atoms. The term "C₆-C₆₀ arylene group" as used herein refers to a divalent group having a carbocyclic aromatic system having 6 to 60 carbon atoms. Non-limiting examples of the C₆-C₆₀ aryl group include a phenyl group, a naphthyl group, an anthracenyl group, a phenanthrenyl group, a pyrenyl group, a chrysenyl group, or the like. When the C₆-C₆₀ aryl group and the C₆-C₆₀ arylene group each include two or more rings, the rings may be fused to each other.

The term "C₇-C₆₀ alkyl aryl group" as used herein refers to a C₆-C₆₀ aryl group substituted with at least one C₁-C₆₀ alkyl group. The term "C₇-C₆₀ aryl alkyl group" as used herein refers to a C₁-C₆₀ alkyl group substituted with at least one C₆-C₆₀ aryl group.

The term "C₁-C₆₀ heteroaryl group" as used herein refers to a monovalent group that includes a cyclic aromatic system having at least one heteroatom selected from N, O, P, Si, S, Se, Ge, and B as a ring-forming atom, and 1 to 60 carbon atoms. The term "C₁-C₆₀ heteroarylene group" as used herein refers to a divalent group that includes a cyclic aromatic system having at least one heteroatom selected from N, O, P, Si, S, Se, Ge, and B as a ring-forming atom and 1 to 60 carbon atoms. Non-limiting examples of the C₁-C₆₀ heteroaryl group include a pyridinyl group, a pyrimidinyl group, a pyrazinyl group, a pyridazinyl group, a triazinyl group, a quinolinyl group, an isoquinolinyl group, or the like. When the C₁-C₆₀ heteroaryl group and the C₁-C₆₀ heteroarylene group each include two or more rings, the rings may be fused to each other.

The term "C₂-C₆₀ alkyl heteroaryl group" as used herein refers to a C₁-C₆₀ heteroaryl group substituted with at least one C₁-C₆₀ alkyl group. The term "C₂-C₆₀ heteroaryl alkyl group" as used herein refers to a C₁-C₆₀ alkyl group substituted with at least one C₁-C₆₀ heteroaryl group.

The term "C₆-C₆₀ aryloxy group" as used herein indicates -OA₁₀₃ (wherein A₁₀₃ indicates the C₆-C₆₀ aryl group). The term "C₆-C₆₀ arylthio group" as used herein indicates -SA₁₀₄ (wherein A₁₀₄ indicates the C₆-C₆₀ aryl group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Non-limiting examples of the monovalent non-aromatic condensed polycyclic group include a fluorenyl group or the like. The term "divalent non-aromatic condensed polycyclic group" as used herein refers to a divalent group having the same structure as the monovalent non-aromatic condensed polycyclic group described above.

The term "monovalent non-aromatic condensed heteropolycyclic group" as used herein refers to a monovalent group (for example, having 1 to 60 carbon atoms) having two or more rings condensed to each other, at least one heteroatom selected from N, O, P, Si, S, Se, Ge, and B, other than carbon atoms, as a ring-forming atom, and no aromaticity in its entire molecular structure. Non-limiting examples of the monovalent non-aromatic condensed heteropolycyclic group include a carbazolyl group or the like. The term "divalent non-aromatic condensed heteropolycyclic group" as used herein refers to a divalent group having the same structure as the monovalent non-aromatic condensed heteropolycyclic group described herein.

The term "C₅-C₃₀ carbocyclic group" as used herein refers to a saturated or unsaturated cyclic group having, as a ring-forming atom, 5 to 30 carbon atoms only. The C₅-C₃₀ carbocyclic group may be a monocyclic group or a polycyclic group. Non-limiting examples of the C₅-C₃₀ carbocyclic group (unsubstituted or substituted with at least one R₁₀ₐ) as used herein include an adamantane group, a norbornene group, a bicyclo[1.1.1]pentane group, a bicyclo[2.1.1]hexane group, a bicyclo[2.2.1]heptane(norbornane) group, a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, and a fluorene group (each unsubstituted or substituted with at least one R₁₀ₐ).

The term "C₁-C₃₀ heterocyclic group" as used herein refers to a saturated or unsaturated cyclic group having, as a ring-forming atom, at least one heteroatom selected from N, O, P, Si, S, Se, Ge, and B, other than 1 to 30 carbon atoms. The C₁-C₃₀ heterocyclic group may be a monocyclic group or a polycyclic group. Non-limiting examples of the C₁-C₃₀ heterocyclic group (unsubstituted or substituted with at least one R₁₀ₐ) may be, for example, a thiophene group, a furan group, a pyrrole group, a silole group, borole group, a phosphole group, a selenophene group, a germole group, a benzothiophene group, a benzofuran group, an indole group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluoren-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, or the like (each unsubstituted or substituted with at least one R₁₀ₐ).

Non-limiting examples of the "C₅-C₃₀ carbocyclic group" and the "C₁-C₃₀ heterocyclic group" as used herein include i) a first ring, ii) a second ring, iii) a condensed ring system in which two or more first rings are condensed with each other, iv) a condensed ring system in which two or more second rings are condensed with each other, or v) a condensed ring system in which at least one first ring is condensed with at least one second ring,
the first ring may be a cyclopentane group, a cyclopentene group, a furan group, a thiophene group, a pyrrole group, a silole group, a borole group, a phosphole group, a germole group, a selenophene group, an oxazole group, an isoxazole group, an oxadiazole group, an oxatriazole group, a thiazole group, an isothiazole group, a thiadiazole group, a thiatriazole group, a pyrazole group, an imidazole group, a triazole group, a tetrazole group, an azasilole group, a diazasilole group, or a triazasilole group, and
the second ring may be an adamantane group, a norbornane group, a norbornene group, a cyclohexane group, a cyclohexene group, a benzene group, a pyridine group, a pyrimidine group, a pyrazine group, a pyridazine group, or a triazine group.

The terms "fluorinated C₁-C₆₀ alkyl group" (or a fluorinated C₁-C₂₀ alkyl group or the like)," "fluorinated C₃-C₁₀ cycloalkyl group," "fluorinated C₁-C₁₀ heterocycloalkyl group," and "fluorinated phenyl group" respectively indicate a C₁-C₆₀ alkyl group (or a C₁-C₂₀ alkyl group or the like), a C₃-C₁₀ cycloalkyl group, a C₁-C₁₀ heterocycloalkyl group, and a phenyl group, each substituted with at least one fluoro group (-F). For example, the term "fluorinated C₁ alkyl group" (that is, a fluorinated methyl group) includes -CF₃, - CF₂H, and -CFH₂. The "fluorinated C₁-C₆₀ alkyl group" (or, a fluorinated C₁-C₂₀ alkyl group, or the like), the "fluorinated C₃-C₁₀ cycloalkyl group," the "fluorinated C₁-C₁₀ heterocycloalkyl group," and the "the fluorinated phenyl group" may respectively be i) a fully fluorinated C₁-C₆₀ alkyl group (or, a fully fluorinated C₁-C₂₀ alkyl group, or the like), a fully fluorinated C₃-C₁₀ cycloalkyl group, a fully fluorinated C₁-C₁₀ heterocycloalkyl group, or a fully fluorinated phenyl group, wherein, in each group, all hydrogen atoms included therein are substituted with a fluoro group, or ii) a partially fluorinated C₁-C₆₀ alkyl group (or, a partially fluorinated C₁-C₂₀ alkyl group, or the like), a partially fluorinated C₃-C₁₀ cycloalkyl group, a partially fluorinated C₁-C₁₀ heterocycloalkyl group, or partially fluorinated phenyl group, wherein, in each group, all hydrogen atoms included therein are not substituted with a fluoro group.

The terms "deuterated C₁-C₆₀ alkyl group" (or a deuterated C₁-C₂₀ alkyl group, or the like), "deuterated C₃-C₁₀ cycloalkyl group," "deuterated C₁-C₁₀ heterocycloalkyl group," and "deuterated phenyl group" respectively indicate a C₁-C₆₀ alkyl group (or a C₁-C₂₀ alkyl group or the like), a C₃-C₁₀ cycloalkyl group, a C₁-C₁₀ heterocycloalkyl group, and a phenyl group, each substituted with at least one deuterium. For example, the "deuterated C₁ alkyl group" (that is, the deuterated methyl group) may include -CD₃, - CD₂H, and -CDH₂, and examples of the "deuterated C₃-C₁₀ cycloalkyl group" include, for example, Formulae 10-501, 10-502, 10-503, 10-504, or the like. The "deuterated C₁-C₆₀ alkyl group" (or, the deuterated C₁-C₂₀ alkyl group, or the like), "the "deuterated C₃-C₁₀ cycloalkyl group," "the "deuterated C₁-C₁₀ heterocycloalkyl group," and "the deuterated phenyl group" may respectively be i) a fully deuterated C₁-C₆₀ alkyl group (or, a fully deuterated C₁-C₂₀ alkyl group, or the like), a fully deuterated C₃-C₁₀ cycloalkyl group, a fully deuterated C₁-C₁₀ heterocycloalkyl group, or a fully deuterated phenyl group, in which, in each group, all hydrogen atoms included therein are substituted with deuterium, or ii) a partially deuterated C₁-C₆₀ alkyl group (or, a partially deuterated C₁-C₂₀ alkyl group or the like), a partially deuterated C₃-C₁₀ cycloalkyl group, a partially deuterated C₁-C₁₀ heterocycloalkyl group, or a partially deuterated phenyl group, in which, in each group, all hydrogen atoms included therein are not substituted with deuterium.

The term "(C₁-C₂₀ alkyl)'X' group" as used herein refers to a 'X' group that is substituted with at least one C₁-C₂₀ alkyl group. For example, the term "(C₁-C₂₀ alkyl)C₃-C₁₀ cycloalkyl group" as used herein refers to a C₃-C₁₀ cycloalkyl group substituted with at least one C₁-C₂₀ alkyl group, and the term "(C₁-C₂₀ alkyl)phenyl group" as used herein refers to a phenyl group substituted with at least one C₁-C₂₀ alkyl group. An example of a (C₁ alkyl)phenyl group may include a toluyl group.

As used herein, the terms "an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, and an azadibenzothiophene 5,5-dioxide group" each refers to a hetero ring group respectively having an identical backbone as "an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluoren-9-one group, and a dibenzothiophene 5,5-dioxide group, in which, in each group, at least one ring-forming carbon atom is substituted with N."

As used herein, at least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group may be:
deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₁₁)(Q₁₂), - Si(Q₁₃)(Q₁₄)(Q₁₅, -Ge(Q₁₃)(Q₁₄)(Q₁₅), -B(Q₁₆)(Q₁₇), -P(=O)(Q₁₈)(Q₁₉), - P(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with at least one of deuterium, -F, -Cl, -Br, -I, -SF₅, - CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), - Ge(Q₂₃)(Q₂₄)(Q₂₅), -B(Q₂₆)(Q₂₇), -P(=O)(Q₂₈)(Q₂₉), -P(Q₂₈)(Q₂₉), or a combination thereof;
-N(Q₃₁)(Q₃₂), -Si(Q₃₃)(Q₃₄)(Q₃₅), -Ge(Q₃₃)(Q₃₄)(Q₃₅, -B(Q₃₆)(Q₃₇), - P(=O)(Q₃₈)(Q₃₉), or -P(Q₃₈)(Q₃₉); or
a combination thereof,
wherein Q₁ to Q₉, Q₁₁ to Q₁₉, Q₂₁ to Q₂₉ and Q₃₁ to Q₃₉ as used herein may each independently be hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group.

For example, Q₁ to Q₉, Q₁₁ to Q₁₉, Q₂₁ to Q₂₉ and Q₃₁ to Q₃₉ as described herein may each independently be:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or - CD₂CDH₂; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, a C₁-C₁₀ alkyl group, a phenyl group, or a combination thereof.

Hereinafter, a compound and an organic light-emitting device according to exemplary embodiments are described in further detail with reference to Synthesis Example and Examples. However, the organic light-emitting device is not limited thereto. The wording "B was used instead of A" used in describing Synthesis Examples means that an amount of A used was identical to an amount of B used, in terms of a molar equivalent.

### EXAMPLES

### Synthesis Example

### Synthesis Example 1 (Compound 1)

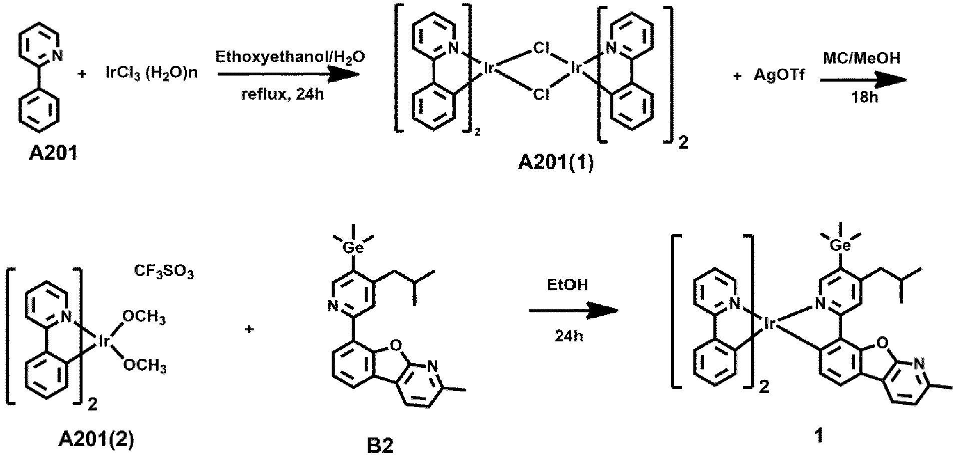

### Synthesis of Compound A201(1)

Compound A201 (2-phenylpyridine) (7.0 grams (g), 45.1 millimoles (mmol)) and iridium chloride trihydrate (IrCl₃(H₂Oₙ, n=3) (7.63 g, 21.6 mmol) were mixed with 120 milliliters (mL) of ethoxyethanol and 40 mL of deionized (DI) water, and then, the resultant mixture was stirred and heated under reflux for 24 hours. Then, the temperature was allowed to lower to room temperature. The resultant solid was separated from the reaction mixture by filtration, washed sufficiently with DI water, methanol, and hexane, in this stated order, and then dried in a vacuum oven to obtain 8.75 g (yield of 75%) of Compound A201(1).

### Synthesis of Compound A201(2)

Compound A201(1) (3.00 g, 2.80 mmol) and 60 mL of methylene chloride (MC) were mixed together, and then, a separate mixture including silver trifluoromethanesulfonate (AgOTf) (1.51 g, 5.88 mmol) and 20 mL of methanol (MeOH) was added thereto. Afterwards, the resultant mixture was stirred for 18 hours at room temperature while light was blocked with aluminum foil, and then the reaction mixture was filtered through a Celite plug to remove the resulting solid. The solvent was removed from the filtrate under a reduced pressure to obtain a solid (Compound A201(2)). Compound A201(2) was used in the next reaction step without an additional purification process.

### Synthesis of Compound 1

40 mL of ethanol was mixed with Compound A201(2) (3.24 g, 4.54 mmol) and Compound B2 (8-(4-isobutyl-5-(trimethylgermyl)pyridin-2-yl)-2-methylbenzofuro[2,3-b]pyridine) (1.966 g, 4.54 mmol), and then, the reaction mixture was stirred and heated at 90°C under reflux for 24 hours, and then, the temperature was allowed to lower to room temperature. The resulting solid product was separated by filtration, and purified by column chromatography using EA (ethyl acetate):hexane (1:1 by volume) as eluents to obtain 1.46 g (yield of 34%) of Compound 1. Compound 1 was characterized by high resolution mass spectrometry using matrix assisted laser desorption ionization (HRMS (MALDI)) and high-performance liquid chromatography (HPLC) analysis.

HRMS (MALDI) calculated for C₄₆H₄₃GeIN₄O: m/z 934.2278 grams per mole (g/mol), found: 934.2277 g/mol.

### Synthesis Example 2 (Compound 2)

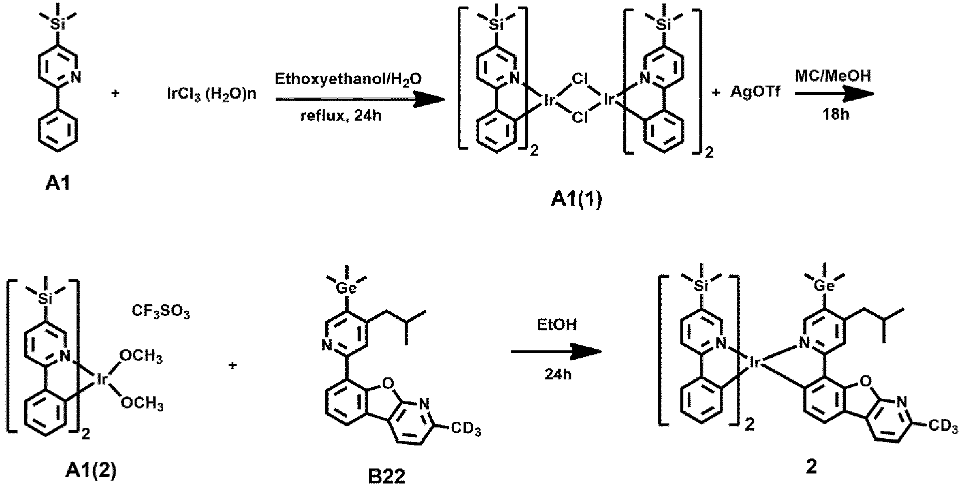

### Synthesis of Compound A1(1)

Compound A1 (2-phenyl-5-(trimethylsilyl)pyridine) (7.5 g, 33.1 mmol) and iridium chloride trihydrate (IrCl₃(H₂O)ₙ) (5.2 g, 14.7 mmol) were mixed with 120 mL of ethoxyethanol and 40 mL of DI water. The reaction mixture was stirred and heated under reflux for 24 hours, and then the temperature was allowed to lower to room temperature. The resultant solid was separated therefrom by filtration, washed sufficiently with DI water, methanol, and hexane, in this stated order, and then dried in a vacuum oven, to obtain 8.2 g (yield of 82%) of Compound A1(1).

### Synthesis of Compound A1(2)

Compound A1(1) (1.60 g, 1.18 mmol) and 45 mL of MC were mixed, and then, a separate mixture including AgOTf (0.61 g, 2.35 mmol) and 15 mL of methanol were added thereto. Afterwards, the reaction mixture was stirred for 18 hours at room temperature while light was blocked with aluminum foil, and then filtered through a plug of Celite to remove the resulting solid. The solvent was removed from the filtrate under a reduced pressure to obtain a solid (Compound A1(2)). Compound A1(2) was used in the next reaction step without an additional purification process.

### Synthesis of Compound 2

30 mL of ethanol was mixed with Compound A1(2) (1.610 g, 1.88 mmol) and Compound B22 (8-(4-isobutyl-5-(trimethylgermyl)pyridin-2-yl)-2-(methyl-d3)benzofuro[2,3-b]pyridine) (0.818 g, 1.88 mmol), and then, the reaction mixture was stirred and heated under reflux at a temperature of 90°C for 24 hours. Then, the temperature was allowed to lower to room temperature. The resulting solid was separated by filtration, and the product was purified by column chromatography using EA:hexane (1:1 v/v) as eluents to obtain 0.71 g (yield of 35%) of Compound 2.

HRMS (MALDI) calculated for C₅₂H₅₆D₃GeIrN₄OSi₂: m/z 1081.3257 g/mol, found: 1081.3256 g/mol.

### Synthesis Example 3 (Compound 3)

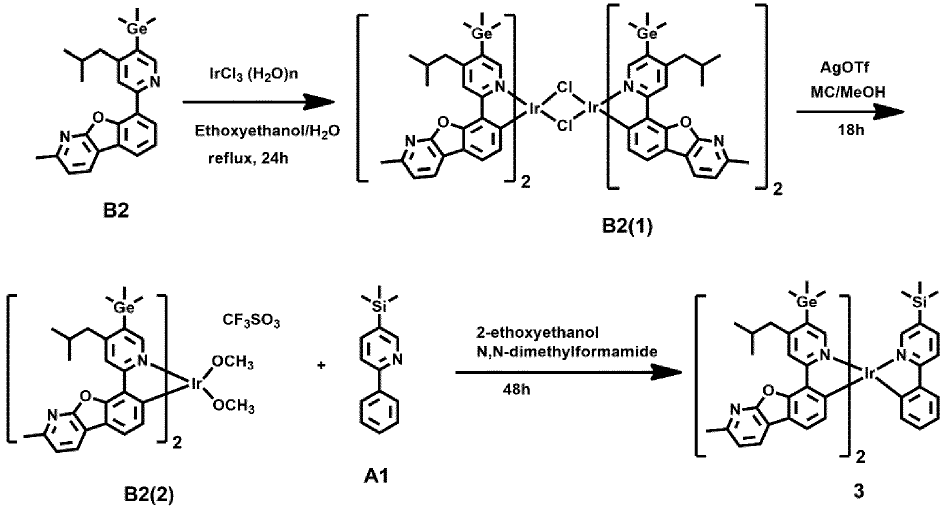

### Synthesis of Compound B2(1)

12.1 g (yield of 71%) of Compound B2(1) was obtained in a similar manner as was used to obtain Compound A1(1) in Synthesis Example 2, except that Compound B2 (8-(4-isobutyl-5-(trimethylgermyl)pyridin-2-yl)-2-methylbenzofuro[2,3-b]pyridine) was used instead of Compound A1 (2-phenyl-5-(trimethylsilyl)pyridine).

### Synthesis of Compound B2(2)

Compound B2(2) was obtained in a similar manner as used to obtain Compound A1(2) in Synthesis Example 2, except that Compound B2(1) was used instead of Compound A1(1). The obtained Compound B2(2) was used in the next reaction step without an additional purification process.

### Synthesis of Compound 3

Compound B2(2) (3.52 g, 2.78 mmol) and Compound A1 (2-phenyl-5-(trimethylsilyl)pyridine) (0.631 g, 2.78 mmol) were mixed with 25 mL of 2-ethoxyethanol and 25 mL of N,N-dimethylformamide, and then, the reaction mixture was stirred and heated under reflux at a temperature of 130°C for 48 hours. Then, the temperature was allowed to lower to room temperature. The solvent was removed from the resulting mixture under a reduced pressure to obtain a solid, and the solid was purified by column chromatography using EA:hexane (1:1 v/v) as eluents to obtain 1.18 g (yield of 33 %) of Compound 3.

HRMS (MALDI) calculated for C₆₂H₇₀Ge₂IrN₅O₂Si: m/z 1285.3352 g/mol, found: 1285.3351 g/mol.

### Synthesis Example 4 (Compound 4)

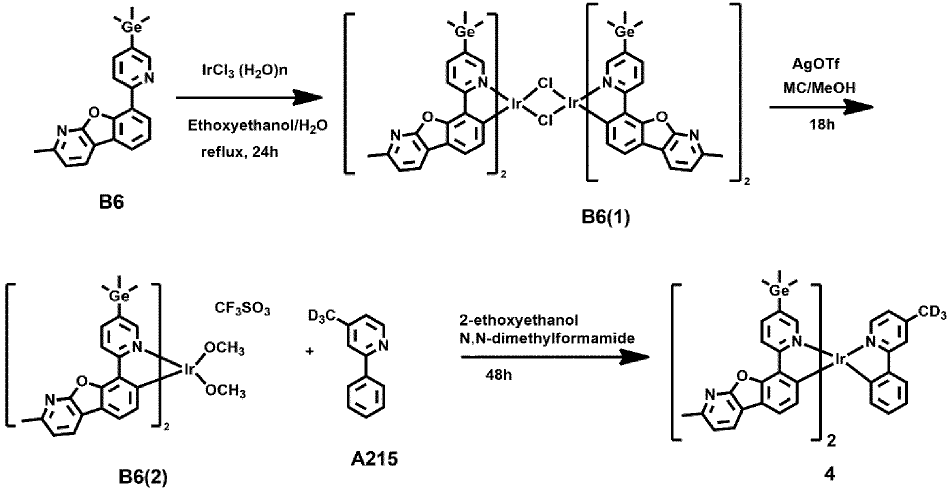

### Synthesis of Compound B6(1)

11.6 g (yield of 74%) of Compound B6(1) was obtained in a similar manner as was used to obtain Compound A1(1) in Synthesis Example 2, except that Compound B6 (2-methyl-8-(5-(trimethylgermyl)pyridin-2-yl)benzofuro[2,3-b]pyridine) (12.5 g, 33.15 mmol) was used instead of Compound A1 (2-phenyl-5-(trimethylsilyl)pyridine).

### Synthesis of Compound B6(2)

Compound B6(2) was obtained in a similar manner as was used to obtain Compound A1(2) in Synthesis Example 2, except that Compound B6(1) was used instead of Compound A1(1). The obtained Compound B6(2) was used in the next reaction step without an additional purification process.

### Synthesis of Compound 4

1.10 g (yield of 36%) of Compound 4 was obtained in a similar manner as was used to obtain Compound 3 in Synthesis Example 3, except that Compound B6(2) (3.20 g, 2.77 mmol) was used instead of compound B2(2), and Compound A215 (4-(methyl-d3)-2-phenylpyridine) (0.477 g, 2.77 mmol) was used instead of Compound A1 (2-phenyl-5-(trimethylsilyl)pyridine).

HRMS (MALDI) calculated for C₅₂H₄₅D₃Ge₂IrN₅O₂: m/z 1118.2049 g/mol, found: 1118.2047 g/mol.

### Synthesis Example 5 (Compound 5)

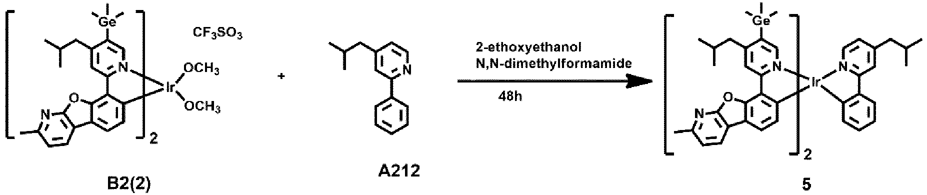

0.98 g (yield of 31%) of Compound 5 was obtained in a similar manner as was used to obtain Compound 3 in Synthesis Example 3, except that Compound A212 (4-isobutyl-2-phenylpyridine) was used instead of Compound A1 (2-phenyl-5-(trimethylsilyl)pyridine).

HRMS (MALDI) calculated for C₆₃H₇₀Ge₂IrN₅O₂: m/z 1269.3582 g/mol, found: 1269.3583 g/mol.

### Synthesis Example 6 (Compound 6)

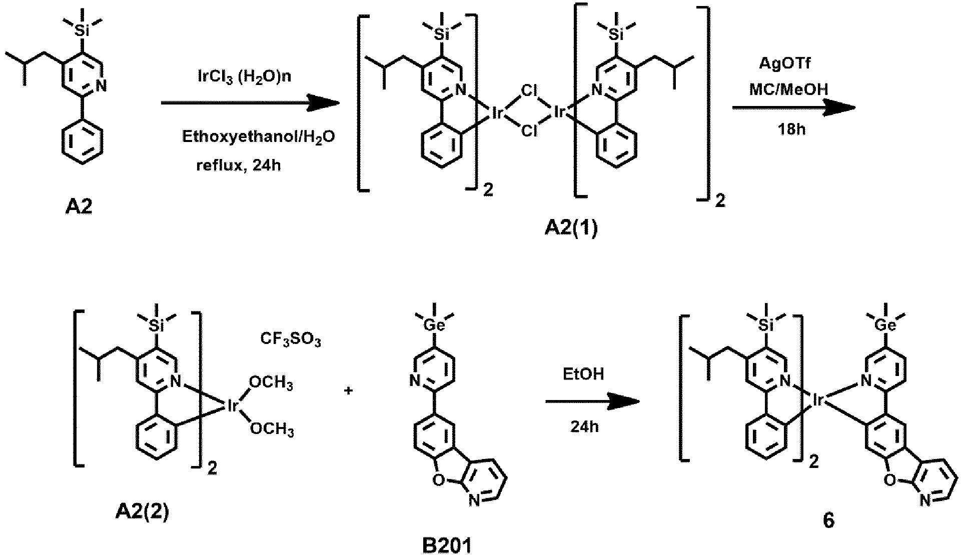

### Synthesis of Compound A2(1)

7.94 g (yield of 74 %) of Compound A2(1) was obtained in a similar manner as was used to obtain Compound A1(1) in Synthesis Example 2, except that Compound A2 (4-isobutyl-2-phenyl-5-(trimethylsilyl)pyridine) (8.00 g, 28.22 mmol) was used instead of Compound A1 (2-phenyl-5-(trimethylsilyl)pyridine).

### Synthesis of Compound A2(2)

Compound A2(2) was obtained in a similar manner as was used to obtain Compound A1(2) in Synthesis Example 2, except that Compound A2(1) was used instead of Compound A1(1). The obtained Compound A2(2) was used in the next reaction step without an additional purification process.

### Synthesis of Compound 6

1.35 g (yield of 37 %) of Compound 6 was obtained in a similar manner as was used to obtain Compound 2 in Synthesis Example 2, except that Compound A2(2) (3.15 g, 3.25 mmol) was used instead of Compound A1(2), and Compound B201 (6-(5-(trimethylgermyl)pyridin-2-yl)benzofuro[2,3-b]pyridine) (3.25 mmol) was used instead of Compound B22 (8-(4-isobutyl-5-(trimethylgermyl)pyridine-2-yl)-2-(methyl-d3)benzofuro[2,3-b]pyridine).

HRMS (MALDI) calculated for C₅₅H₆₅GeIrN₄OSi₂: m/z 1120.3538 g/mol, found: 1120.3536 g/mol.

### Synthesis Example 7 (Compound 7)

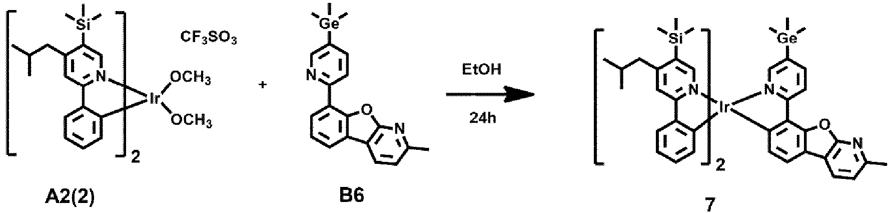

1.49 g (yield of 40 %) of Compound 7 was obtained in a similar manner as was used to obtain Compound 2 in Synthesis Example 2, except that Compound A2(2) (3.18 g, 3.28 mmol) was used instead of Compound A1(2), and Compound B6 (2-methyl-8-(5-(trimethylgermyl)pyridin-2-yl)benzofuro[2,3-b]pyridine) (1.236 g, 3.28 mmol) was used instead of Compound B22 (8-(4-isobutyl-5-(trimethylgermyl)pyridine-2-yl)-2-(methyl-d3)benzofuro[2,3-b]pyridine).

HRMS (MALDI) calculated for C₅₆H₆₇GeIrN₄OSi₂: m/z 1134.3694 g/mol, found: 1134.3694 g/mol.

### Synthesis Example 8 (Compound 8)

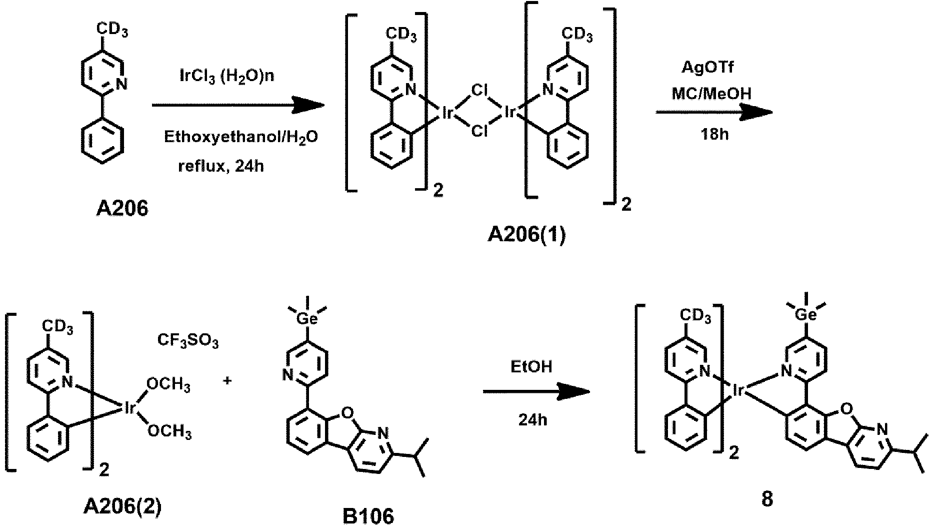

### Synthesis of Compound A206(1)

6.50 g (yield of 82%) of Compound A206 (1) was obtained in a similar manner as was used to obtain Compound A1(1) in Synthesis Example 2, except that Compound A206 (5-(methyl-d3)-2-phenylpyridine) (5.00 g, 29.03 mmol) was used instead of Compound A1 (2-phenyl-5-(trimethylsilyl)pyridine).

### Synthesis of Compound A206(2)

Compound A206(2) was obtained in a similar manner as used to obtain Compound A1(2) in Synthesis Example 2, except that Compound A206(1) was used instead of Compound A1(1). The obtained Compound A206(2) was used in the next reaction step without an additional purification process.

### Synthesis of Compound 8

1.32 g (yield of 35 %) of Compound 8 was obtained in a similar manner as was used to obtain Compound 2 in Synthesis Example 2, except that Compound A206(2) (3.00 g, 4.01 mmol) was used instead of Compound A1(2), and Compound B106 (2-isopropyl-8-(5-(trimethylgermyl)pyridin-2-yl)benzofuro[2,3-b]pyridine) (1.625 g, 4.01 mmol) was used instead of Compound B22(8-(4-isobutyl-5-(trimethylgermyl)pyridine-2-yl)-2-(methyl-d3)benzofuro[2,3-b]pyridine).
HRMS (MALDI) calculated for C₄₆H₃₇D₆GeIrN₄O: m/z 940.2654 g/mol, found: 940.2656 g/mol.

### Synthesis Example 9 (Compound 9)

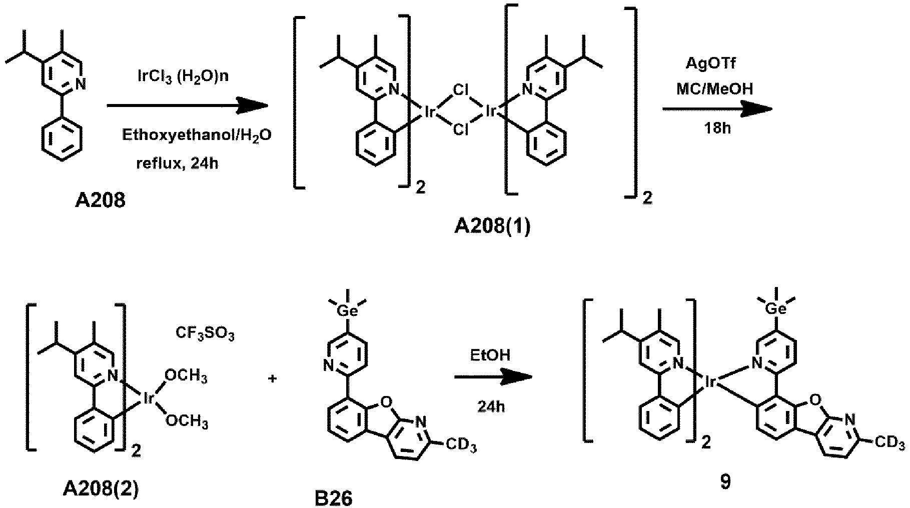

### Synthesis of Compound A208(1)

6.82 g (yield of 77 %) of Compound A208(1) was obtained in a similar manner as was used to obtain Compound A1(1) in Synthesis Example 2, except that Compound A208 (4-isopropyl-5-methyl-2-phenylpyridine) (6.00 g, 28.39 mmol) was used instead of Compound A1 (2-phenyl-5-(trimethylsilyl)pyridine).

### Synthesis of Compound A208(2)

Compound A208(2) was obtained in a similar manner as was used to obtain Compound A1(2) in Synthesis Example 2, except that Compound A208(1) was used instead of Compound A(1). The obtained Compound A208(2) was used in the next reaction step without an additional purification process.

### Synthesis of Compound 9

1.38 g (yield of 35 %) of Compound 9 was obtained in a similar manner as was used to obtain Compound 2 in Synthesis Example 2, except that Compound A208(2) (3.25 g, 3.93 mmol) was used instead of Compound A1(2), and Compound B26 (2-(methyl-d3)-8-(5-(trimethylgermyl)pyridin-2-yl)benzofuro[2,3-b]pyridine) (1.495 g, 3.93 mmol) was used instead of Compound B22 (8-(4-isobutyl-5-(trimethylgermyl)pyridine-2-yl)-2-(methyl-d3)benzofuro[2,3-b]pyridine).

HRMS (MALDI) calculated for C₅₀H₄₈D₃GeIrN₄O: m/z : 993.3092 g/mol, found: 993.3091 g/mol.

### Synthesis Example 10 (Compound 10)

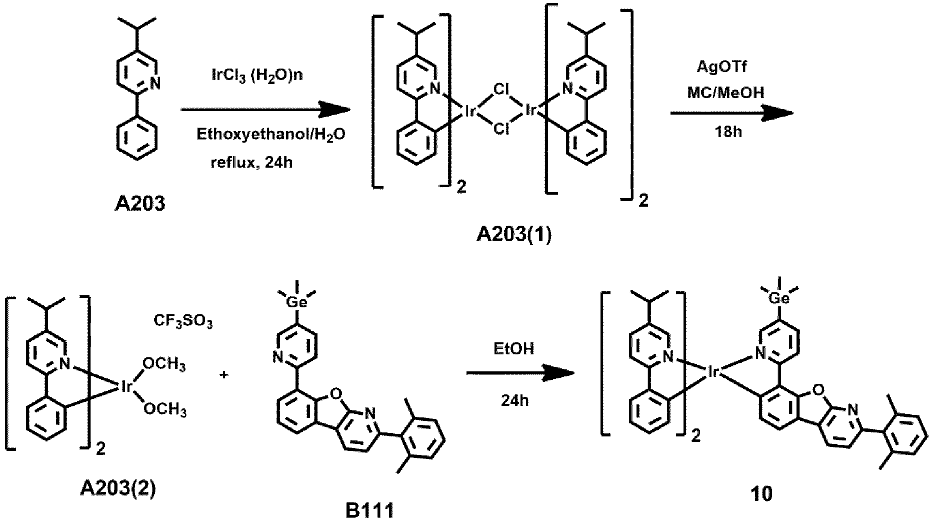

### Synthesis of Compound A203(1)

6.67g (yield of 74 %) of Compound A203(1) was obtained in a similar manner as was used to obtain Compound A1(1) in Synthesis Example 2, except that Compound A203 (5-isopropyl-2-phenylpyridine) (6.00 g, 30.41 mmol) was used instead of Compound A1 (2-phenyl-5-(trimethylsilyl)pyridine).

### Synthesis of Compound A203(2)

Compound A203(2) was obtained in a similar manner as was used to obtain Compound A1(2) in Synthesis Example 2, except that Compound A203(1) was used instead of Compound A1(1). The obtained Compound A203(2) was used in the next reaction step without an additional purification process.

### Synthesis of Compound 10

1.25 g (yield of 32 %) of Compound 10 was obtained in a similar manner as was used to obtain Compound 2 in Synthesis Example 2, except that Compound A203(2) (3.00 g, 3.76 mmol) was used instead of Compound A1(2), and Compound B111 (2-(2,6-dimethylphenyl)-8-(5-(trimethylgermyl)pyridin-2-yl)benzofuro[2,3-b]pyridine) (1.756 g, 3.76 mmol) was used instead of Compound B22 (8-(4-isobutyl-5-(trimethylgermyl)pyridine-2-yl)-2-(methyl-d3)benzofuro[2,3-b]pyridine).

HRMS (MALDI) calculated for C₅₅H₅₃GeIrN₄O: m/z : 1052.30604 g/mol, found: 1052.30604 g/mol.

### Synthesis Example 11 (Compound 11)

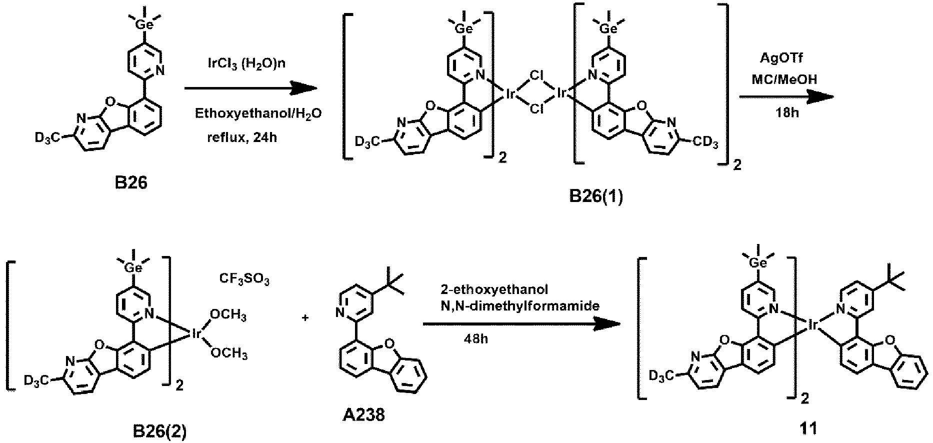

### Synthesis of Compound B26(1)

4.87 g (yield of 78 %) of Compound B26(1) was obtained in a similar manner as was used to obtain Compound A1(1) in Synthesis Example 2, except that Compound B26 (2-(methyl-d3)-8-(5-(trimethylgermyl)pyridin-2-yl)benzofuro[2,3-b]pyridine) (5 g, 13.16 mmol) was used instead of Compound A1 (2-phenyl-5-(trimethylsilyl)pyridine).

### Synthesis of Compound B26(2)

Compound B26(2) was obtained in a similar manner as was used to obtain Compound B2(2) in Synthesis Example 3, except that Compound B26(1) was used instead of Compound B2(1). The obtained Compound B26(2) was used in the next reaction step without an additional purification process.

### Synthesis of Compound 11

1.12 g (yield of 35 %) of Compound 11 was obtained in a similar manner as was used to obtain Compound 3 in Synthesis Example 3, except that Compound B26(2) (3.00 g, 2.58 mmol) was used instead of Compound B2(2), and Compound A238 (4-(tert-butyl)-2-(dibenzo[b,d]furan-4-yl)pyridine) (0.779 g, 2.58 mmol) was used instead of Compound A1 (2-phenyl-5-(trimethylsilyl)pyridine).

HRMS (MALDI) calculated for C₆₁H₅₀D₆Ge₂IrN₅O₃: m/z : 1253.2813 g/mol, found: 1253.2815 g/mol.

### Synthesis Example 12 (Compound 12)

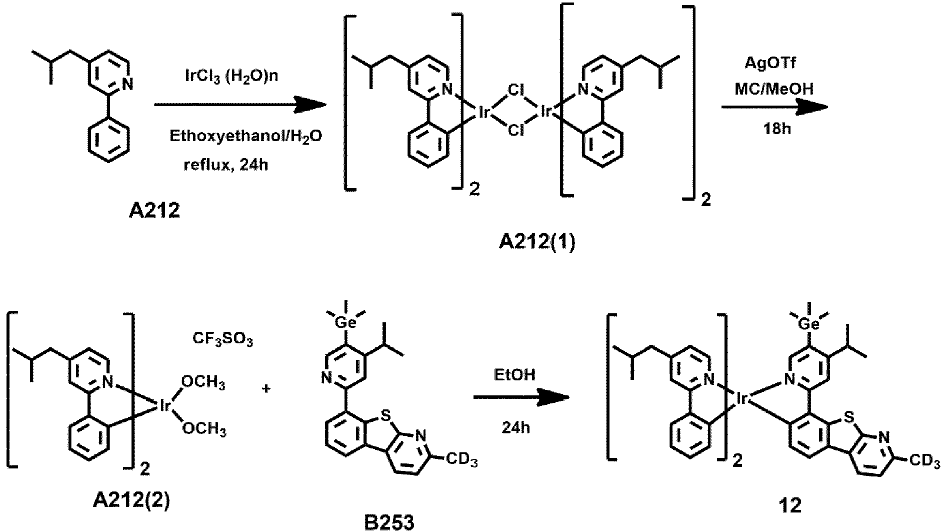

### Synthesis of Compound A212(1)

5.62 g (yield of 76 %) of Compound A212(1) was obtained in a similar manner as was used to obtain Compound A1(1) in Synthesis Example 2, except that Compound A212 (4-isobutyl-2-phenylpyridine) (5 g, 23.66 mmol) was used instead of Compound A1 (2-phenyl-5-(trimethylsilyl)pyridine).

### Synthesis of Compound A212(2)

Compound A212(2) was obtained in a similar manner as was used to obtain Compound A1(2) in Synthesis Example 2, except that Compound A212(1) was used instead of Compound A1(1). The obtained Compound A212(2) was used in the next reaction step without an additional purification process.

### Synthesis of Compound 12

1.35 g (yield of 35 %) of Compound 12 was obtained in a similar manner as was used to obtain Compound 2 in Synthesis Example 2, except that Compound A212(2) (3.00 g, 3.63 mmol) was used instead of Compound A1(2), and Compound B253 (2-(methyl-d3)-8-(4-isopropyl-5-(trimethylgermyl)pyridin-2-yl)benzothieno[2,3-b]pyridine) (1.59 g, 3.63 mmol) was used instead of Compound B22 (8-(4-isobutyl-5-(trimethylgermyl)pyridine-2-yl)-2-(methyl-d3)benzofuro[2,3-b]pyridine).

HRMS (MALDI) calculated for C₅₃H₅₄D₃GeIrN₄S: m/z : 1051.3333 g/mol, found: 1051.3334 g/mol.

### Synthesis Example 13 (Compound 13)

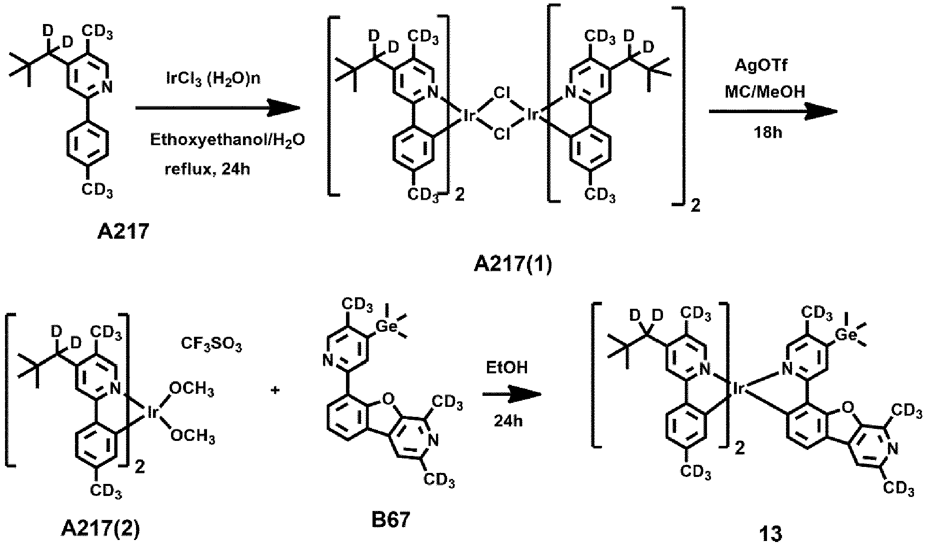

### Synthesis of Compound A217(1)

5.73 g (yield of 82 %) of Compound A217(1) was obtained in a similar manner as was used to obtain Compound A1(1) in Synthesis Example 2, except that Compound A217 (4-(2,2-dimethylpropyl-1,1-d2)-5-(methyl-d3)-2-(4-(methyl-d3)phenyl)pyridin) (5 g, 19.13 mmol) was used instead of Compound A1 (2-phenyl-5-(trimethylsilyl)pyridine).

### Synthesis of Compound A217(2)

Compound A217(2) was obtained in a similar manner as was used to obtain Compound A1(2) in Synthesis Example 2, except that Compound A217(1) was used instead of Compound A1(1). The obtained Compound A217(2) was used in the next reaction step without an additional purification process.

### Synthesis of Compound 13

1.44 g (yield of 34 %) of Compound 13 was obtained in a similar manner as was used to obtain Compound 2 in Synthesis Example 2, except that Compound A217(2) (3.50 g, 3.78 mmol) was used instead of Compound A1(2)and Compound B67 (1,3-bis(methyl-d3)-8-(5-(methyl-d3)-4-(trimethylgermyl)pyridin-2-yl)benzofuro[2,3-c]pyridine) (1.57 g, 3.78 mmol) was used instead of Compound B22 (8-(4-isobutyl-5-(trimethylgermyl)pyridine-2-yl)-2-(methyl-d3)benzofuro[2,3-b]pyridine).

HRMS (MALDI) calculated for C₅₈H₄₂D₂₅GeIrN₄O: m/z : 1127.5725 g/mol, found: 1127.5727 g/mol.

### Synthesis Example 14 (Compound 14)

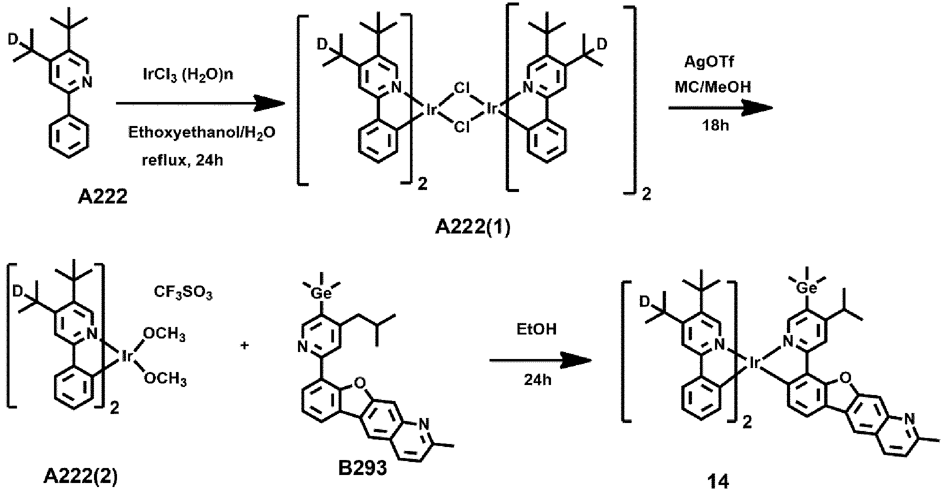

### Synthesis of Compound A222(1)

5.58 g (yield of 81 %) of Compound A222(1) was obtained in a similar manner as was used to obtain Compound A1(1) in Synthesis Example 2, except that Compound A222 (5-(tert-butyl)-2-phenyl-4-(propan-2-yl-2-d)pyridine) (5 g, 19.65 mmol) was used instead of Compound A1 (2-phenyl-5-(trimethylsilyl)pyridine).

### Synthesis of Compound A222(2)

Compound A222(2) was obtained in a similar manner as was used to obtain Compound A1(2) in Synthesis Example 2, except that Compound A222(1) was used instead of Compound A1(1). The obtained Compound A222(2) was used in the next reaction step without an additional purification process.

### Synthesis of Compound 14

1.35 g (yield of 31 %) of Compound 14 was obtained in a similar manner as was used to obtain Compound 2 in Synthesis Example 2, except that Compound A222(2) (3.43 g, 3.76 mmol) was used instead of Compound A1(2), and Compound B293 (9-(4-isopropyl-5-(trimethylgermyl)pyridin-2-yl)-2-methylbenzofuro[3,2-g]quinoline) (1.76 g, 3.76 mmol) was used instead of Compound B22 (8-(4-isobutyl-5-(trimethylgermyl)pyridine-2-nyl)-2-(methyl-d3)benzofuro[2,3-b]pyridine).

HRMS (MALDI) calculated for C₆₃H₆₉O₂GeIrN₄O: m/z : 1168.4594 g/mol, found: 1168.4595 g/mol.

### Example 1

A glass substrate with ITO/Ag/ITO (as a anode) deposited thereon to a thickness of 70/1000/70 Å was cut to a size of 50 millimeters (mm) x 50 mm x 0.5 mm, sonicated with isopropyl alcohol and DI water each for 5 minutes, and then cleaned by exposure to ultraviolet rays and ozone for 30 minutes each. Then, the resultant glass substrate was loaded onto a vacuum deposition apparatus.

Compound HT3 and Compound F6-TCNNQ were vacuum-deposited on the anode at the weight ratio of 98:2 to form a hole injection layer having a thickness of 100 Å, and, on the hole injection layer, Compound HT3 was vacuum-deposited to form a hole transport layer having a thickness of 1350 Å. Then, Compound H-H1 was deposited on the hole transport layer to form an electron-blocking layer having a thickness of 300 Å.

Then, Compound H-H1, Compound H-E43, and Compound 1 (dopant) were co-deposited on the electron-blocking layer at a weight ratio of 57:38:5 to form an emission layer having a thickness of 400 Å.

Then, Compound ET3 and Compound ET-D1 were co-deposited on the emission layer at a volume ratio of 50:50 to form an electron transport layer with a thickness of 350 Å, and LiF was vacuum-deposited on the electron transport layer to form an electron injection layer having a thickness of 1 nm, and both Mg and Ag were co-deposited at a weight ratio of 90:10 on the electron injection layer to form a cathode having a thickness of 120 Å, thereby completing the manufacture of an organic light-emitting device.

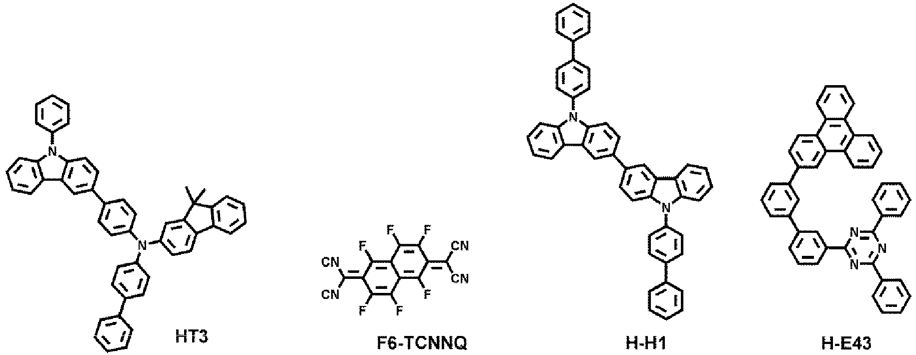

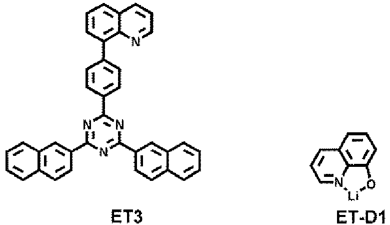

### Examples 2 to 4 and Comparative Examples R1 to R4

Organic light-emitting devices were manufactured using a similar method as was used in Example 1, except that the compounds listed in Table 58 were each used instead of Compound 1 as a dopant when forming the emission layer.

### Evaluation Example 1

The maximum current efficiency (Max cd/A, %) and lifespan (LT₉₇, %) at target color coordinates CIEx = 0.245 were evaluated for each of the organic light-emitting devices manufactured in Examples 1 to 4 and Comparative Examples R1 to R4. Results thereof are shown in Table 58. As an evaluation device, a current-voltmeter (Keithley 2400) and a luminance meter (Minolta Cs-1000A) were used, and the lifespan (T₉₇) (at 15,000 candela per square meter (cd/m²)) was evaluated as the time (hr) taken for luminance to reduce to 97 % from 100 % of the initial luminance. Each of the maximum current efficiency and lifespan was expressed as a relative value (%).

Meanwhile, Compound H-H1, Compound H-E43 and Compound 1 were co-deposited on a quartz substrate at a weight ratio of 57:38:5 to produce a film with a thickness of 40 nm, and then the emission spectrum of the film was measured by using the Quantaurus-QY absolute PL quantum yield spectrometer (on which a xenon light source, a monochromator, a photonic multichannel analyzer, and an integrating sphere (C11347-12) are mounted and which includes PLQY measurement software (Hamamatsu Photonics, Ltd., Shizuoka) manufactured by Hamamatsu Inc.). At the time of measurement, the excitation wavelength was measured by scanning from 320 nm to 380 nm at intervals of 10 nm, and a spectrum measured at the excitation wavelength of 340 nm was used to evaluate the emission peak wavelength of Compound 1 in Table 58. The emission peak wavelength evaluation was similarly performed for the remaining compounds shown in Table 58, and the results are shown in Table 58.

**Table 58**

| | Dopant in emission layer Compound No. | Maximum current efficiency (relative %) | LT₉₇ (relative %) | Emission peak wavelength (nm) |
|---|---|---|---|---|
| Example 1 | 1 | 93 | 69 | 525 |
| Comparative Example R1 | R1 | 91 | 62 | 528 |
| Example 2 | 2 | 100 | 94 | 528 |
| Comparative Example R2 | R2 | 97 | 80 | 530 |
| Example 3 | 3 | 91 | 93 | 534 |
| Comparative Example R3 | R3 | 68 | 48 | 539 |
| Example 4 | 4 | 97 | 100 | 532 |
| Comparative Example R4 | R4 | 81 | 67 | 536 |

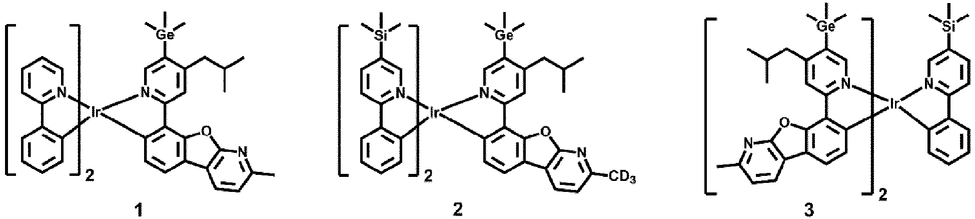

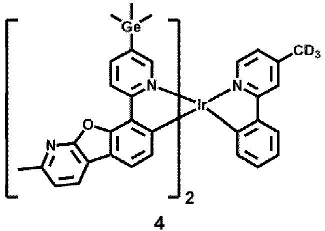

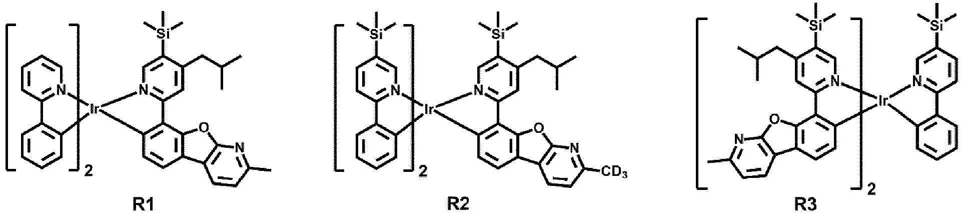

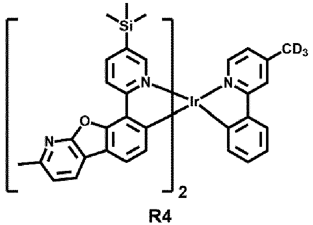

From Table 58, it was confirmed that each of the organic light-emitting devices of Examples 1 to 4 emits a green light while having improved maximum current efficiency and improved lifespan characteristics compared to the organic light-emitting devices of Comparative Examples R1 to R4.

### Example 5 and Comparative Example R5

Organic light-emitting devices were manufactured using a similar method as was used in Example 1, except that the compounds listed in Table 59 were used instead of Compound 1 as a dopant when forming the emission layer.

### Evaluation Example 2

The maximum current efficiency (Max cd/A, %) and lifespan (LT₉₇, %) at target color coordinates CIEx = 0.245 were evaluated for each of the organic light-emitting devices manufactured in Example 5 and Comparative Example R5 and the emission peak wavelength of Compound 5 and Compound R5 were evaluated by using a similar method as Evaluation Example 1. The results are shown in Table 59.

**Table 59**

| | Dopant in emission layer Compound No. | Maximum current efficiency (relative %) | LT₉₇ (relative %) | Emission peak wavelength (nm) |
|---|---|---|---|---|
| Example 5 | 5 | 100 | 100 | 527 |
| Comparative Example R5 | R5 | 95 | 66 | 524 |

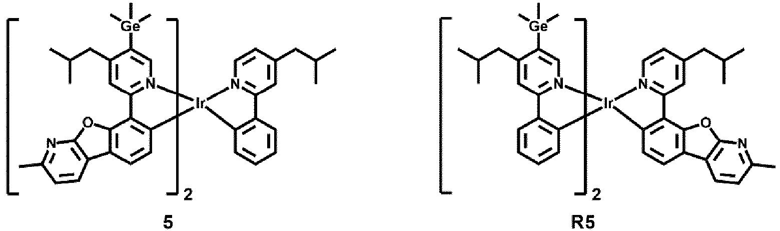

From Table 59, it was confirmed that the organic light-emitting device of Example 5 emits a green light while having improved maximum current efficiency and improved lifespan characteristics compared to the organic light-emitting device of Comparative Example R5.

### Example 6 and Comparative Example R6

Organic light-emitting devices were manufactured using a similar method as was used in Example 1, except that the compounds listed in Table 60 were used instead of Compound 1 as a dopant when forming the emission layer.

### Evaluation Example 3

The maximum current efficiency (Max cd/A, %) and lifespan (LT₉₇, %) at target color coordinates CIEx = 0.245 were evaluated for each of the organic light-emitting devices manufactured in Example 6 and Comparative Example R6 and the emission peak wavelength of Compound 6 and Compound R6 were evaluated by using a similar method as Evaluation Example 1. The results are shown in Table 60.

**Table 60**

| | Dopant in emission layer Compound No. | Maximum current efficiency (relative %) | LT₉₇ (relative %) | Emission peak wavelength (nm) |
|---|---|---|---|---|
| Example 6 | 6 | 100 | 100 | 519 |
| Comparative Example R6 | R6 | 97 | 89 | 520 |

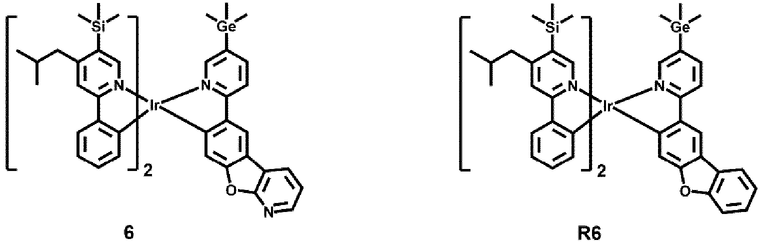

From Table 60, it was confirmed that the organic light-emitting device of Example 6 emits a green light while having improved maximum current efficiency and improved lifespan characteristics compared to the organic light-emitting device of Comparative Example R6.

### Examples 7 to 14

Organic light-emitting devices were manufactured using a similar method as was used in Example 1, except that the compounds listed in Table 61 were used instead of Compound 1 as a dopant when forming the emission layer.

### Evaluation Example 4

The maximum current efficiency (Max cd/A, %) and lifespan (LT₉₇, %) at target color coordinates CIEx = 0.245 were evaluated for each of the organic light-emitting devices manufactured in Examples 7 to 14 and the emission peak wavelength of Compound 7 to Compound 14 were evaluated by using a similar method as Evaluation Example 1. The results are shown in Table 61. For comparison, the data of Comparative Example R1 is also shown in Table 61.

**Table 61**

| | Dopant in emission layer Compound No. | Maximum current efficiency (relative %) | LT₉₇ (relative %) | Emission peak wavelength (nm) |
|---|---|---|---|---|
| Example 7 | 7 | 88 | 100 | 531 |
| Example 8 | 8 | 81 | 69 | 529 |
| Example 9 | 9 | 87 | 80 | 526 |
| Example 10 | 10 | 88 | 70 | 528 |
| Example 11 | 11 | 88 | 98 | 531 |
| Example 12 | 12 | 87 | 81 | 526 |
| Example 13 | 13 | 83 | 74 | 526 |
| Example 14 | 14 | 100 | 71 | 532 |
| Comparative Example R1 | R1 | 77 | 60 | 528 |

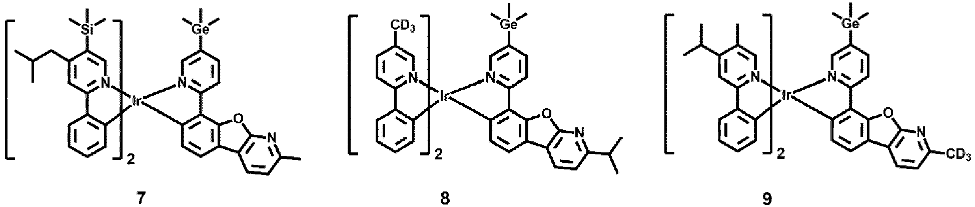

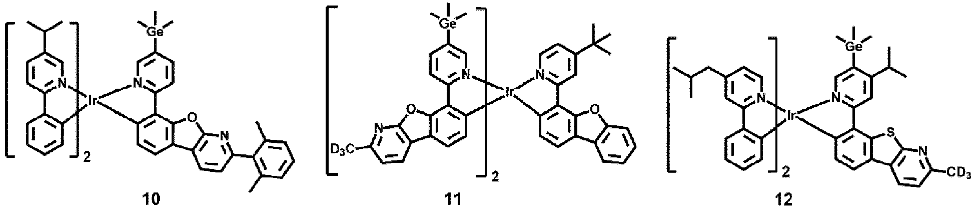

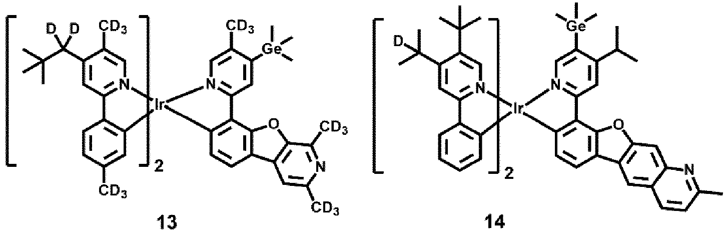

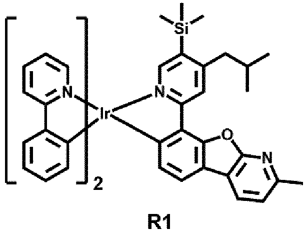

From Table 61, it was confirmed that the organic light-emitting devices of Example 7 to 14 emit a green light while having improved maximum current efficiency and improved lifespan characteristics compared to the organic light-emitting device of Comparative Example R1.

Since the organometallic compounds have excellent thermal stability and/or electric characteristics, an electronic device using the organometallic compounds, for example, an organic light-emitting device using one or more of the organometallic compounds can have improved current efficiency and improved lifespan characteristics, and a high-quality electronic apparatus can be manufactured using the organic light-emitting device.

It should be understood that exemplary embodiments described herein should be considered in a descriptive sense only and not for purposes of limitation. Descriptions of features or aspects within each exemplary embodiment should typically be considered as available for other similar features or aspects in other embodiments.

While one or more exemplary embodiments have been described with reference to the figure, it will be understood by those of ordinary skill in the art that various changes in form and details may be made therein without departing from the scope as defined by the following claims.

## Claims

1. An organometallic compound represented by Formula 1:
Formula 1 M(L₁)ₙ₁(L₂)ₙ₂
wherein, in Formula 1,
M is a transition metal,
L₁ is a ligand represented by Formula 2-1,
L₂ is a ligand represented by Formula 2-2,
n1 and n2 are each independently 1 or 2, when n1 is 2, two L₁ are identical to or different from each other, and when n2 is 2, two L₂ are identical to or different from each other, and
L₁ and L₂ are different from each other, 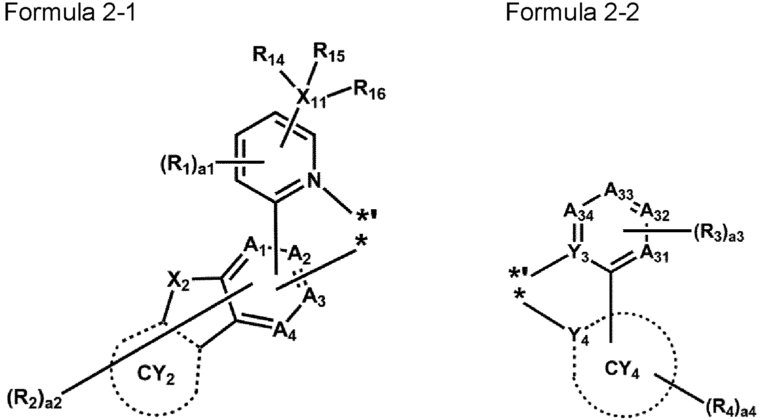
wherein, in Formulae 2-1 and 2-2,
X₁₁ is Ge,
X₂ is O, S, Se, N(R₂₉), C(R₂₉ₐ)(R_{29b}), or Si(R₂₉ₐ)(R_{29b}),
A₁ is C or N, A₂ is C or N, A₃ is C or N, and A₄ is C or N, wherein one of A₁ to A₄ is C bonded to a neighboring pyridine group, and another of A₁ to A₄ is C bonded to M in Formula 1,
Y₃ is N,
A₃₁ is C or N, A₃₂ is C or N, A₃₃ is C or N, and A₃₄ is C or N,
Y₄ is C or N,
ring CY₂ and ring CY₄ are each independently a C₅-C₃₀ carbocyclic group or a C₁-C₃₀ heterocyclic group, wherein i) ring CY₂ is a C₃-C₃₀ heterocyclic group comprising at least one N as a ring-forming atom; ii) at least one of A₁ to A₄ is N; or iii) ring CY₂ is a C₃-C₃₀ heterocyclic group comprising at least one N as a ring-forming atom, and at least one of A₁ to A₄ is N,
R₁ to R₄, R₁₄ to R₁₆, R₂₉, R₂₉ₐ, and R_{29b} are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), - B(Q₆)(Q₇), -P(=O)(Q₈)(Q₉), or -P(Q₈)(Q₉),
a1 is an integer from 0 to 3,
a2 is an integer from 0 to 6,
a3 is an integer from 0 to 4, and
a4 is an integer from 0 to 20,
two or more of a plurality of R₁ are optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
two or more of a plurality of R₂ are optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
two or more of a plurality of R₃ are optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
two or more of a plurality of R₄ are optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
two or more of R₁ to R₄ are optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
R₁₀ₐ is as described in connection with R₂,
* and *' each indicate a binding site to M in Formula 1,
at least one, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group is:
deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), - Ge(Q₁₃)(Q₁₄)(Q₁₅), -B(Q₁₆)(Q₁₇), -P(=O)(Q₁₈)(Q₁₉), -P(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₂₁)(Q₂₂), - Si(Q₂₃)(Q₂₄)(Q₂₅), -Ge(Q₂₃)(Q₂₄)(Q₂₅), -B(Q₂₆)(Q₂₇), -P(=O)(Q₂₈)(Q₂₉), -P(Q₂₈)(Q₂₉), or a combination thereof;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), - P(=O)(Q₃₈)(Q₃₉), or -P(Q₃₈)(Q₃₉); or
a combination thereof,
wherein Q₁ to Q₉, Q₁₁ to Q₁₉, Q₂₁ to Q₂₉, and Q₃₁ to Q₃₉ are each independently hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group;
wherein the organometallic compound is not the following compound:

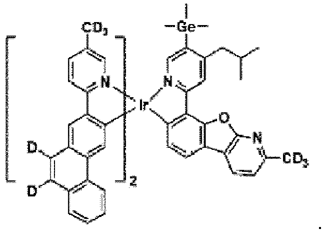

2. The organometallic compound of claim 1, wherein X₂ is O or S.

3. The organometallic compound of claims 1 or 2, wherein, in Formula 2-1,
A₁ is C bonded to a neighboring pyridine group, and A₂ is C bonded to M in Formula 1, or
A₃ is C bonded to a neighboring pyridine group, and A₂ is C bonded to M in Formula 1.

4. The organometallic compound of any of claims 1-3, wherein ring CY₂ is a pyridine group, a pyrimidine group, a pyridazine group, a pyrazine group, a quinoline group, an isoquinoline group, a quinoxaline group, a quinazoline group, a phenanthridine group, a phenanthroline group, a benzoquinoline group, a benzoisoquinoline group, an azacarbazole group, an azafluorene group, an azadibenzosilole group, an azadibenzothiophene group, an azadibenzofuran group, or an azadibenzoselenophene group; and/or
wherein ring CY₄ is a benzene group, a naphthalene group, an anthracene group, a phenanthrene group, a 1,2,3,4-tetrahydronaphthalene group, a benzene group that is condensed with a norbornane group, a carbazole group, a fluorene group, a dibenzosilole group, a dibenzothiophene group, a dibenzofuran group, a dibenzoselenophene group, a benzocarbazole group, a benzofluorene group, a naphthobenzosilole group, a naphthobenzothiophene group, a naphthobenzofuran group, a naphthobenzoselenophene group, a dibenzocarbazole group, a dibenzofluorene group, a dinaphthosilole group, a dinaphthothiophene group, a dinaphthofuran group, a dinaphthoselenophene group, a naphthocarbazole group, a naphthofluorene group, a phenanthrobenzosilole group, a phenanthrobenzothiophene group, a phenanthrobenzofuran group, a phenanthrobenzoselenophene group, an azacarbazole group, an azafluorene group, an azadibenzosilole group, an azadibenzothiophene group, an azadibenzofuran group, an azadibenzoselenophene group, an azabenzocarbazole group, an azabenzofluorene group, an azanaphthobenzosilole group, an azanaphthobenzothiophene group, an azanaphthobenzofuran group, an azanaphthobenzoselenophene group, an azadibenzocarbazole group, an azadibenzofluorene group, an azadinaphthosilole group, an azadinaphthothiophene group, an azadinaphthofuran group, an azadinaphthoselenophene group, an azanaphthocarbazole group, an azanaphthofluorene group, an azaphenanthrobenzosilole group, an azaphenanthrobenzothiophene group, an azaphenanthrobenzofuran group, or an azaphenanthrobenzoselenophene group.

5. The organometallic compound of any of claims 1-4, wherein R₁ to R₄, R₂₉, R₂₉ₐ, and R_{29b} are each independently:
hydrogen, deuterium, -F, or a cyano group;
a C₁-C₂₀ alkyl group, a C₃-C₁₀ cycloalkyl group, a phenyl group, a naphthyl group, a pyridinyl group, a furanyl group, a thiophenyl group, a benzofuranyl group, a benzothiophenyl group, a dibenzofuranyl group, or a dibenzothiophenyl group, each unsubstituted or substituted with at least one of deuterium, -F, cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, -Si(Q₃₃)(Q₃₄)(Q₃₅), - Ge(Q₃₃)(Q₃₄)(Q₃₅), or a combination thereof; or
-Si(Q₃)(Q₄)(Q₅), and
R₁₄ to R₁₆ are each independently a C₁-C₂₀ alkyl group, a C₃-C₁₀ cycloalkyl group, a phenyl group, a naphthyl group, a pyridinyl group, a furanyl group, a thiophenyl group, a benzofuranyl group, a benzothiophenyl group, a dibenzofuranyl group, or a dibenzothiophenyl group, each unsubstituted or substituted with at least one of deuterium, -F, cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or a combination thereof.

6. The organometallic compound of any of claims 1-5, wherein, in Formula 2-1, a2 is not 0, and R₂ is not hydrogen; and/or
wherein, in Formula 2-2, a3 is not 0, and R₃ is not hydrogen; and/or
wherein the organometallic compound comprises deuterium, a fluoro group, or a combination thereof.

7. The organometallic compound of any of claims 1-6, wherein a group represented by 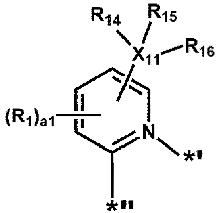 in Formula 2-1 is a group represented by one of Formulae CY1-1 to CY1-6: 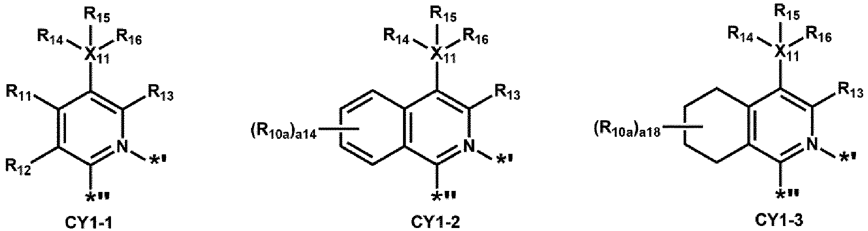 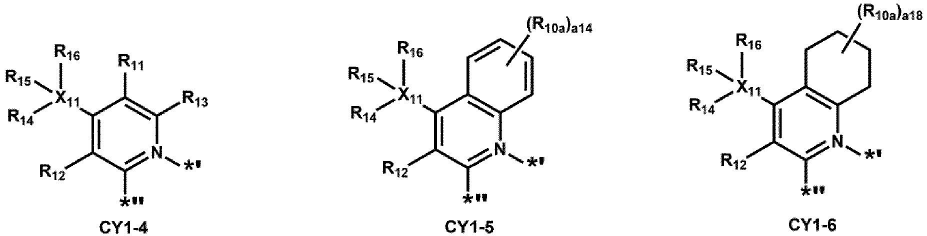 wherein, in Formulae CY1-1 to CY1-6,
X₁₁, R₁₄ to R₁₆, and R₁₀ₐ are each as described in claim 1,
R₁₁ to R₁₃ are each independently as described in connection with R₁ in claim 1,
a14 is an integer from 0 to 4,
a18 is an integer from 0 to 8,
*' indicates a binding site to M in Formula 1, and
*" indicates a binding site to one of A₁ to A₄ in Formula 2-1.

8. The organometallic compound of any of claims 1-7, wherein a group represented by 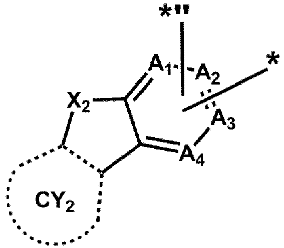 in Formula 2-1 is a group represented by one of Formulae CY2-1 to CY2-14: 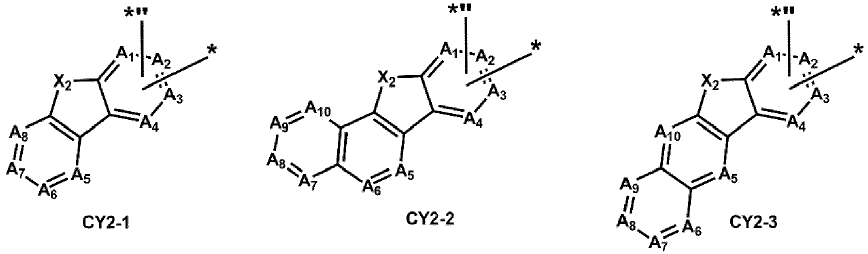 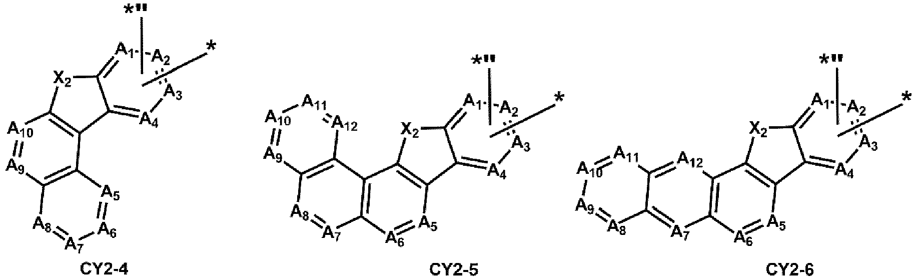 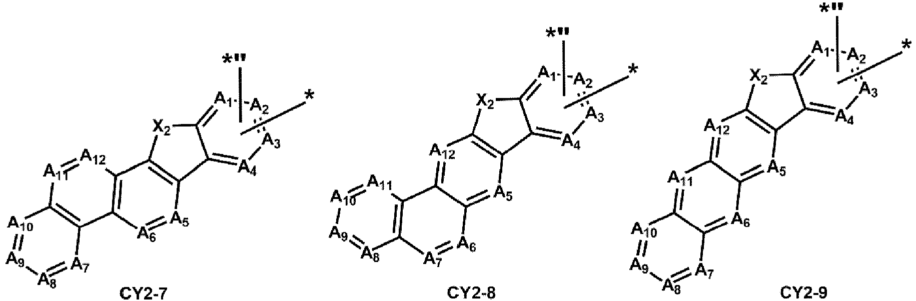 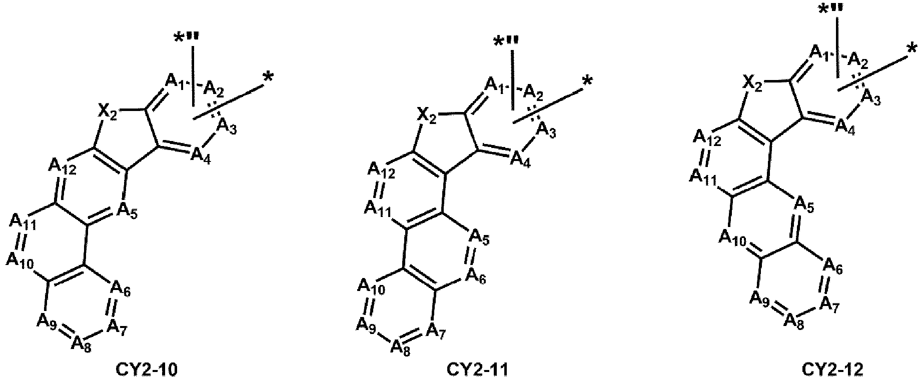 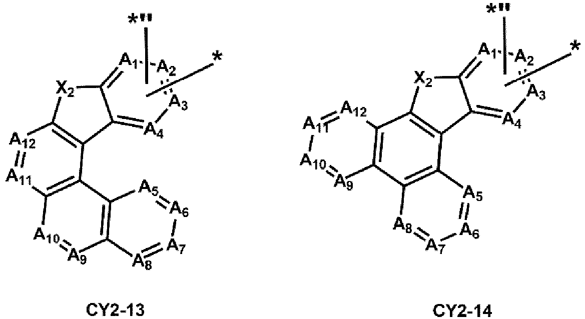 wherein, in Formulae CY2-1 to CY2-14,
X₂ is as described in claim 1,
A₁ to A₁₂ are each independently C or N, and at least one of A₁ to A₈ of Formula CY2-1 is N, at least one of A₁ to A₁₀ of Formulae CY2-2 to CY2-4 is N, and at least one of A₁ to A₁₂ of Formulae CY2-5 to CY2-14 is N,
*" indicates a binding site to a neighboring pyridine group in Formula 2-1, and
* is a binding site to M in Formula 1;
preferably wherein
at least one of A₄ to A₈ in Formula CY2-1 is N,
at least one of A₄ to A₁₀ in Formulae CY2-2 to CY2-4 is N, and
at least one of A₄ to A₁₂ in Formulae CY2-5 to CY2-14 is N.

9. The organometallic compound of any of claims 1-8, wherein a group represented by 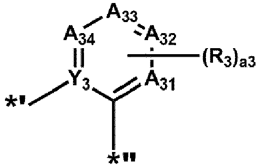 in Formula 2-2 is a group represented by one of Formulae CY3(1) to CY3(16): 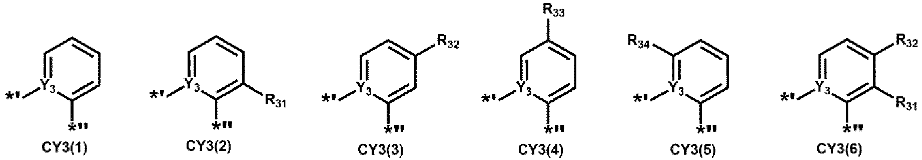 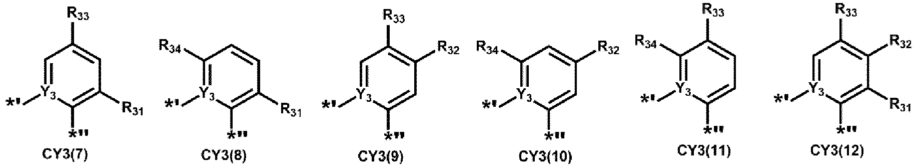 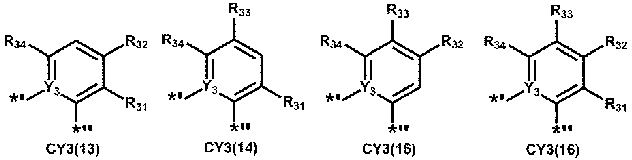 wherein, in Formulae CY3(1) to CY3(16),
Y₃ is as described in claim 1,
R₃₁ to R₃₄ are each independently as described in connection with R₃ in claim 1, provided that each of R₃₁ to R₃₄ is not hydrogen,
*' indicates a binding site to M in Formula 1, and
*" is a binding site to a neighboring atom in Formula 2-2.

10. The organometallic compound of any of claims 1-9, wherein a group represented by 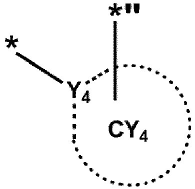 in Formula 2-2 is a group represented by one of Formulae CY4-1 to CY4-21: 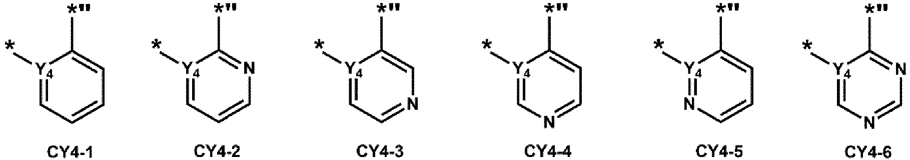 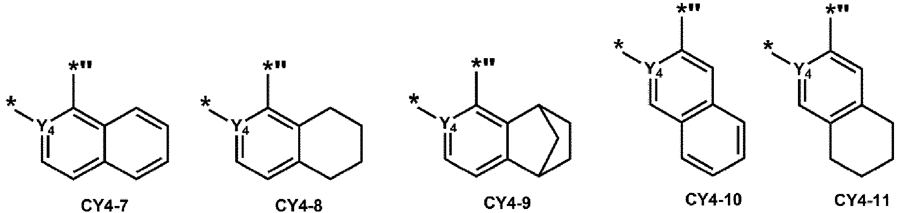 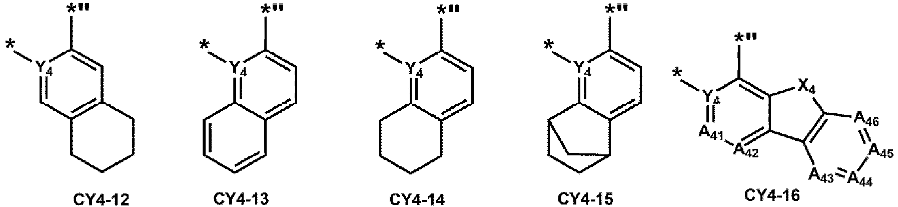 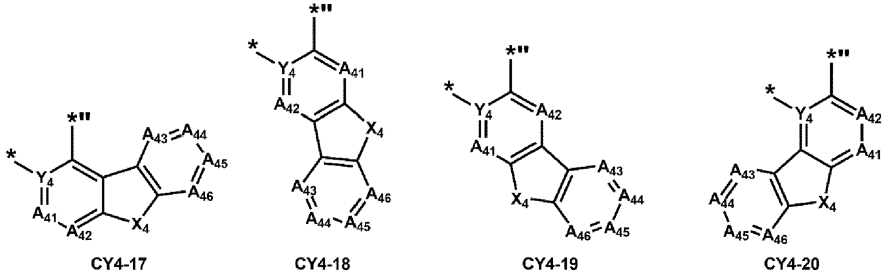 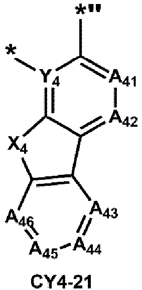 wherein, in Formulae CY4-1 to CY4-21,
Y₄ is C,
A₄₁ to A₄₆ are each independently C or N,
X₄ is O, S, Se, N(R₄₉), C(R₄₉ₐ)(R_{49b}), or Si(R₄₉ₐ)(R_{49b}),
R₄₉, R₄₉ₐ, and R_{49b} are each independently as described in connection with R₄ in claim 1,
* indicates a binding site to M in Formula 1, and
*" indicates a binding site to a neighboring atom in Formula 2-2.

11. An organic light-emitting device, comprising:
a first electrode;
a second electrode; and
an organic layer located between the first electrode and the second electrode,
wherein the organic layer comprises an emission layer, and
wherein the organic layer comprises at least one organometallic compound of any of claims 1-10.

12. The organic light-emitting device of claim 11, wherein
the first electrode is an anode,
the second electrode is a cathode, and
the organic layer further comprises a hole transport region located between the first electrode and the emission layer, and an electron transport region located between the emission layer and the second electrode,
wherein the hole transport region comprises a hole injection layer, a hole transport layer, an electron-blocking layer, a buffer layer, or a combination thereof, and
the electron transport region comprises a hole-blocking layer, an electron transport layer, an electron injection layer, or a combination thereof.

13. The organic light-emitting device of claims 11 or 12, wherein the emission layer comprises the at least one organometallic compound.

14. The organic light-emitting device of claim 13, wherein the emission layer emits a green light; and/or
wherein the emission layer further comprises a host, and the amount of the host in the emission layer is greater than the amount of the organometallic compound in the emission layer.

15. An electronic apparatus, comprising the organic light-emitting device of any of claims 11-14.

## Patentansprüche

1. Organometallische Verbindung dargestellt durch Formel 1:
Formel 1 M(L₁)ₙ₁(L₂)ₙ₂
wobei in Formel 1
M ein Übergangsmetall ist,
L₁ ein Ligand dargestellt durch Formel 2-1 ist,
L₂ ein Ligand dargestellt durch Formel 2-2 ist,
n1 und n2 jeweils unabhängig 1 oder 2 sind, wenn n1 2 ist, zwei L₁ identisch miteinander oder verschieden voneinander sind, und wenn n2 2 ist, zwei L₂ identisch miteinander oder verschieden voneinander sind, und
L₁ und L₂ verschieden voneinander sind, 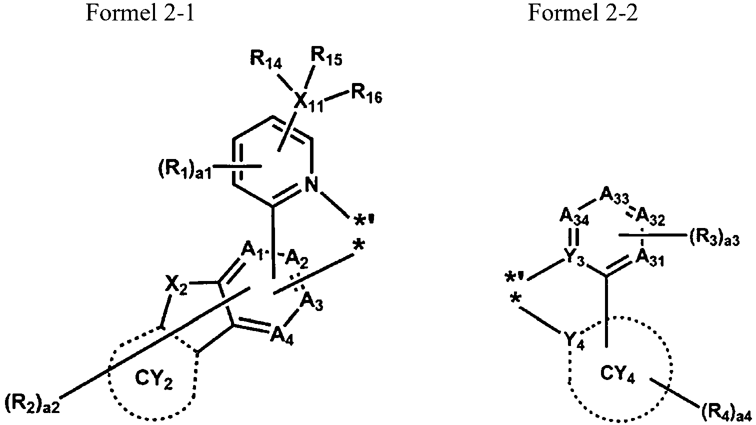
wobei, in Formel 2-1 und 2-2
X₁₁ Ge ist,
X₂ O, S, Se, N(R₂₉), C(R₂₉ₐ)(R_{29b}) oder Si(R₂₉ₐ)(R_{29b}) ist,
A₁ C oder N ist, A₂ C oder N ist, A₃ C oder N ist und A₄ C oder N ist, wobei eines von A₁ bis A₄ C gebunden an eine benachbarte Pyridingruppe ist und ein anderes von A₁ bis A₄ C gebunden an M in Formel 1 ist,
Y₃ N ist,
A₃₁ C oder N ist, A₃₂ C oder N ist, A₃₃ C oder N ist und A₃₄ C oder N ist,
Y₄ C oder N ist,
Ring CY₂ und Ring CY₄ jeweils unabhängig eine carbocyclische C₅-C₃₀-Gruppe oder eine heterocyclische C₁-C₃₀-Gruppe sind, wobei i) Ring CY₂ eine heterocyclische C₃-C₃₀-Gruppe ist, die zumindest ein N als ringbildendes Atom umfasst; ii) zumindest eines von A₁ bis A₄ N ist; oder iii) Ring CY₂ eine heterocyclische C₃-C₃₀-Gruppe ist, die zumindest ein N als ringbildendes Atom umfasst, und zumindest eines von A₁ bis A₄ N ist,
R₁ bis R₄, R₁₄ bis R₁₆, R₂₉, R₂₉ₐ und R_{29b} jeweils unabhängig Wasserstoff, Deuterium, -F, - Cl, -Br, -I, -SF₅, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine substituierte oder unsubstituierte C₁-C₆₀-Alkylgruppe, eine substituierte oder unsubstituierte C₂-C₆₀-Alkenylgruppe, eine substituierte oder unsubstituierte C₂-C₆₀-Alkinylgruppe, eine substituierte oder unsubstituierte C₁-C₆₀-Alkoxygruppe, eine substituierte oder unsubstituierte C₁-C₆₀-Alkylthiogruppe, eine substituierte oder unsubstituierte C₃-C₁₀-Cycloalkylgruppe, eine substituierte oder unsubstituierte C₁-C₁₀-Heterocycloalkylgruppe, eine substituierte oder unsubstituierte C₃-C₁₀-Cycloalkenylgruppe, eine substituierte oder unsubstituierte C₁-C₁₀-Heterocycloalkenylgruppe, eine substituierte oder unsubstituierte C₆-C₆₀-Arylgruppe, eine substituierte oder unsubstituierte C₇-C₆₀-Alkylarylgruppe, eine substituierte oder unsubstituierte C₇-C₆₀-Arylalkylgruppe, eine substituierte oder unsubstituierte C₆-C₆₀-Aryloxygruppe, eine substituierte oder unsubstituierte C₆-C₆₀-Arylthiogruppe, eine substituierte oder unsubstituierte C₁-C₆₀-Heteroarylgruppe, eine substituierte oder unsubstituierte C₂-C₆₀-Alkylheteroarylgruppe, eine substituierte oder unsubstituierte C₂-C₆₀-Heteroarylalkylgruppe, eine substituierte oder unsubstituierte C₁-C₆₀-Heteroaryloxygruppe, eine substituierte oder unsubstituierte C₁-C₆₀-Heteroarylthiogruppe, eine substituierte oder unsubstituierte monovalente nichtaromatische kondensierte polycyclische Gruppe, eine substituierte oder unsubstituierte monovalente nichtaromatische kondensierte heteropolycyclische Gruppe, -N(Q₁)(Q₂), - Si(Q₃)(Q₄)(Q₅), -Ge(Q₃)(Q₄)(Q₅), -B(Q₆)(Q₇), -P(=O)(Q₈)(Q₉) oder -P(Q₈)(Q₉) sind,
a1 eine ganze Zahl von 0 bis 3 ist,
a2 eine ganze Zahl von 0 bis 6 ist,
a3 eine ganze Zahl von 0 bis 4 ist, und
a4 eine ganze Zahl von 0 bis 20 ist,
zwei oder mehr aus einer Vielzahl von R₁ optional miteinander verknüpft sind, um eine carbocyclische C₅-C₃₀-Gruppe, die unsubstituiert oder substituiert ist mit zumindest einem R₁₀ₐ, oder eine heterocyclische C₁-C₃₀-Gruppe, die unsubstituiert oder substituiert ist mit zumindest einem R₁₀ₐ, zu bilden,
zwei oder mehr aus einer Vielzahl von R₂ optional miteinander verknüpft sind, um eine carbocyclische C₅-C₃₀-Gruppe, die unsubstituiert oder substituiert ist mit zumindest einem R₁₀ₐ, oder eine heterocyclische C₁-C₃₀-Gruppe, die unsubstituiert oder substituiert ist mit zumindest einem R₁₀ₐ, zu bilden,
zwei oder mehr aus einer Vielzahl von R₃ optional miteinander verknüpft sind, um eine carbocyclische C₅-C₃₀-Gruppe, die unsubstituiert oder substituiert ist mit zumindest einem R₁₀ₐ, oder eine heterocyclische C₁-C₃₀-Gruppe, die unsubstituiert oder substituiert ist mit zumindest einem R₁₀ₐ, zu bilden,
zwei oder mehr aus einer Vielzahl von R₄ optional miteinander verknüpft sind, um eine carbocyclische C₅-C₃₀-Gruppe, die unsubstituiert oder substituiert ist mit zumindest einem R₁₀ₐ, oder eine heterocyclische C₁-C₃₀-Gruppe, die unsubstituiert oder substituiert ist mit zumindest einem R₁₀ₐ, zu bilden,
zwei oder mehr von R₁ bis R₄ optional miteinander verknüpft sind, um eine carbocyclische C₅-C₃₀-Gruppe, die unsubstituiert oder substituiert ist mit zumindest einem R₁₀ₐ, oder eine heterocyclische C₁-C₃₀-Gruppe, die unsubstituiert oder substituiert ist mit zumindest einem R₁₀ₐ, zu bilden,
R₁₀ₐ wie beschrieben in Verbindung mit R₂ ist,
* und *' jeweils eine Bindungsstelle an M in Formel 1 angeben,
zumindest eines, die substituierte C₁-C₆₀-Alkylgruppe, die substituierte C₂-C₆₀-Alkenylgruppe, die substituierte C₂-C₆₀-Alkinylgruppe, die substituierte C₁-C₆₀-Alkoxygruppe, die substituierte C₁-C₆₀-Alkylthiogruppe, die substituierte C₃-C₁₀-Cycloalkylgruppe, die substituierte C₁-C₁₀-Heterocycloalkylgruppe, die substituierte C₃-C₁₀-Cycloalkenylgruppe, die substituierte C₁-C₁₀-Heterocycloalkenylgruppe, die substituierte C₆-C₆₀-Arylgruppe, die substituierte C₇-C₆₀-Alkylarylgruppe, die substituierte C₇-C₆₀-Arylalkylgruppe, die substituierte C₆-C₆₀-Aryloxygruppe, die substituierte C₆-C₆₀-Arylthiogruppe, die substituierte C₁-C₆₀-Heteroarylgruppe, die substituierte C₂-C₆₀-Alkylheteroarylgruppe, die substituierte C₂-C₆₀-Heteroarylalkylgruppe, die substituierte C₁-C₆₀-Heteroaryloxygruppe, die substituierte C₁-C₆₀-Heteroarylthiogruppe, die substituierte monovalente nichtaromatische kondensierte polycyclische Gruppe und die substituierte monovalente nichtaromatische kondensierte heteropolycyclische Gruppe wie folgt ist:
Deuterium, -F, -Cl, -Br, -I, -SF₅, -CD₃, -CD₂H, -CDH₂, -CF₃, -CF₂H, -CFH₂, eine Hydroxylgruppe, eine Cyanogruppe, eine Nitrogruppe, eine Aminogruppe, eine Amidinogruppe, eine Hydrazingruppe, eine Hydrazongruppe, einer Carbonsäuregruppe oder ein Salz davon, eine Sulfonsäuregruppe oder ein Salz davon, eine Phosphorsäuregruppe oder ein Salz davon, eine C₁-C₆₀-Alkylgruppe, eine C₂-C₆₀-Alkenylgruppe, eine C₂-C₆₀-Alkinylgruppe, eine C₁-C₆₀-Alkoxygruppe oder eine C₁-C₆₀-Alkylthiogruppe;
eine C₁-C₆₀-Alkylgruppe, eine C₂-C₆₀-Alkenylgruppe, eine C₂-C₆₀-Alkinylgruppe, eine C₁-C₆₀-Alkoxygruppe oder eine C₁-C₆₀-Alkylthiogruppe, jeweils substituiert mit zumindest einem von Deuterium, -F, -Cl, -Br, -I, -SF₅, -CD₃, -CD₂H, -CDH₂, -CF₃, -CF₂H, -CFH₂, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₇-C₆₀-Alkylarylgruppe, einer C₇-C₆₀-Arylalkylgruppe, einer C₆-C₆₀-Aryloxygruppe, einer C₆-C₆₀-Arylthiogruppe, einer C₁-C₆₀-Heteroarylgruppe, einer C₂-C₆₀-Alkylheteroarylgruppe, einer C₂-C₆₀-Heteroarylalkylgruppe, einer C₁-C₆₀-Heteroaryloxygruppe, einer C₁-C₆₀-Heteroarylthiogruppe, einer monovalenten nichtaromatischen kondensierten polycyclischen Gruppe, einer monovalenten nichtaromatischen kondensierten heteropolycyclischen Gruppe, -N(Q₁₁)(Q₁₂), -Si(Q₁₃)(Q₁₄)(Q₁₅), -Ge(Q₁₃)(Q₁₄)(Q₁₅), -B(Q₁₆)(Q₁₇), -P(=O)(Q₁₈)(Q₁₉), -P(Q₁₈)(Q₁₉) oder einer Kombination davon;
eine C₃-C₁₀-Cycloalkylgruppe, eine C₁-C₁₀-Heterocycloalkylgruppe, eine C₃-C₁₀-Cycloalkenylgruppe, eine C₁-C₁₀-Heterocycloalkenylgruppe, eine C₆-C₆₀-Arylgruppe, eine C₇-C₆₀-Alkylarylgruppe, eine C₆-C₆₀-Aryloxygruppe, eine C₆-C₆₀-Arylthiogruppe, eine C₁-C₆₀-Heteroarylgruppe, eine C₂-C₆₀-Alkylheteroarylgruppe, eine C₁-C₆₀-Heteroaryloxygruppe, eine C₁-C₆₀-Heteroarylthiogruppe, eine monovalente nichtaromatische kondensierte polycyclische Gruppe oder eine monovalente nichtaromatische kondensierte heteropolycyclische Gruppe, jeweils unsubstituiert oder substituiert mit zumindest einem von Deuterium, -F, -Cl, -Br, -I, -SF₅, -CD₃, - CD₂H, -CDH₂, -CF₃, -CF₂H, -CFH₂, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₁-C₆₀-Alkylthiogruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₇-C₆₀-Alkylarylgruppe, einer C₇-C₆₀-Arylalkylgruppe, einer C₆-C₆₀-Aryloxygruppe, einer C₆-C₆₀-Arylthiogruppe, einer C₁-C₆₀-Heteroarylgruppe, einer C₂-C₆₀-Alkylheteroarylgruppe, einer C₂-C₆₀-Heteroarylalkylgruppe, einer C₁-C₆₀-Heteroaryloxygruppe, einer C₁-C₆₀-Heteroarylthiogruppe, einer monovalenten nichtaromatischen kondensierten polycyclischen Gruppe, einer monovalenten nichtaromatischen kondensierten heteropolycyclischen Gruppe, - N(Q₂₁)(Q₂₂), -Si(Q₂₃)(Q₂₄)(Q₂₅), -Ge(Q₂₃)(Q₂₄)(Q₂₅), -B(Q₂₆)(Q₂₇), -P(=O)(Q₂₈)(Q₂₉), - P(Q₂₈)(Q₂₉) oder einer Kombination davon;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), -P(=O)(Q₃₈)(Q₃₉) oder -P(Q₃₈)(Q₃₉); oder
eine Kombination davon,
wobei Q₁ bis Q₉, Q₁₁ bis Q₁₉, Q₂₁ bis Q₂₉ und Q₃₁ bis Q₃₉ jeweils unabhängig Wasserstoff, Deuterium, -F, -Cl, -Br, -I, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine substituierte oder unsubstituierte C₁-C₆₀-Alkylgruppe, eine substituierte oder unsubstituierte C₂-C₆₀-Alkenylgruppe, eine substituierte oder unsubstituierte C₂-C₆₀-Alkinylgruppe, eine substituierte oder unsubstituierte C₃-C₁₀-Cycloalkylgruppe, eine substituierte oder unsubstituierte C₁-C₁₀-Heterocycloalkylgruppe, eine substituierte oder unsubstituierte C₃-C₁₀-Cycloalkenylgruppe, eine substituierte oder unsubstituierte C₁-C₁₀-Heterocycloalkenylgruppe, eine substituierte oder unsubstituierte C₆-C₆₀-Arylgruppe, eine substituierte oder unsubstituierte C₇-C₆₀-Alkylarylgruppe, eine substituierte oder unsubstituierte C₇-C₆₀-Arylalkylgruppe, eine substituierte oder unsubstituierte C₆-C₆₀-Aryloxygruppe, eine substituierte oder unsubstituierte C₆-C₆₀-Arylthiogruppe, eine substituierte oder unsubstituierte C₁-C₆₀-Heteroarylgruppe, eine substituierte oder unsubstituierte C₂-C₆₀-Alkylheteroarylgruppe, eine substituierte oder unsubstituierte C₂-C₆₀-Heteroarylalkylgruppe, eine substituierte oder unsubstituierte C₁-C₆₀-Heteroaryloxygruppe, eine substituierte oder unsubstituierte C₁-C₆₀-Heteroarylthiogruppe, eine substituierte oder unsubstituierte monovalente nichtaromatische kondensierte polycyclische Gruppe oder eine substituierte oder unsubstituierte monovalente nichtaromatische kondensierte heteropolycyclische Gruppe sind;
wobei die organometallische Verbindung nicht die folgende Verbindung ist:

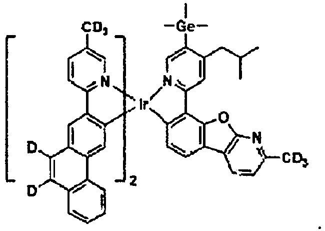

2. Organometallische Verbindung nach Anspruch 1, wobei X₂ O oder S ist.

3. Organometallische Verbindung nach Anspruch 1 oder 2, wobei in Formel 2-1
A₁ C gebunden an eine benachbarte Pyridingruppe ist, und A₂ C gebunden an M in Formel 1 ist, oder
A₃ C gebunden an eine benachbarte Pyridingruppe ist, und A₂ C gebunden an M in Formel 1 ist.

4. Organometallische Verbindung nach einem der Ansprüche 1-3, wobei Ring CY₂ eine Pyridingruppe, eine Pyrimidingruppe, eine Pyridazingruppe, eine Pyrazingruppe, eine Chinolingruppe, eine Isochinolingruppe, eine Chinoxalingruppe, eine Chinazolingruppe, eine Phenanthridingruppe, eine Phenanthrolingruppe, eine Benzochinolingruppe, eine Benzoisochinolingruppe, eine Azacarbazolgruppe, eine Azafluorengruppe, eine Azadibenzosilolgruppe, eine Azadibenzothiophengruppe, eine Azadibenzofurangruppe oder eine Azadibenzoselenophengruppe ist; und/oder
wobei Ring CY₄ eine Benzolgruppe, eine Naphthalengruppe, eine Anthracengruppe, eine Phenanthrengruppe, eine 1,2,3,4-Tetrahydronaphthalengruppe, eine Benzolgruppe, die kondensiert ist mit einer Norbornangruppe, eine Carbazolgruppe, eine Fluorengruppe, eine Dibenzosilolgruppe, eine Dibenzothiophengruppe, eine Dibenzofurangruppe, eine Dibenzoselenophengruppe, eine Benzocarbazolgruppe, eine Benzofluorengruppe, eine Naphthobenzosilolgruppe, eine Naphthobenzothiophengruppe, eine Naphthobenzofurangruppe, eine Naphthobenzoselenophengruppe, eine Dibenzocarbazolgruppe, eine Dibenzofluorengruppe, eine Dinaphthosilolgruppe, eine Dinaphthothiophengruppe, eine Dinaphthofurangruppe, eine Dinaphthoselenophengruppe, eine Naphthocarbazolgruppe, eine Naphthofluorengruppe, eine Phenanthrobenzosilolgruppe, eine Phenanthrobenzothiophengruppe, eine Phenanthrobenzofurangruppe, eine Phenanthrobenzoselenophengruppe, eine Azacarbazolgruppe, eine Azafluorengruppe, eine Azadibenzosilolgruppe, eine Azadibenzothiophengruppe, eine Azadibenzofurangruppe, eine Azadibenzoselenophengruppe, eine Azabenzocarbazolgruppe, eine Azabenzofluorengruppe, eine Azanaphthobenzosilolgruppe, eine Azanaphthobenzothiophengruppe, eine Azanaphthobenzofurangruppe, eine Azanaphthobenzoselenophengruppe, eine Azadibenzocarbazolgruppe, eine Azadibenzofluorengruppe, eine Azadinaphthosilolgruppe, eine Azadinaphthothiophengruppe, eine Azadinaphthofurangruppe, eine Azadinaphthoselenophengruppe, eine Azanaphthocarbazolgruppe, eine Azanaphthofluorengruppe, eine Azaphenanthrobenzosilolgruppe, eine Azaphenanthrobenzothiophengruppe, eine Azaphenanthrobenzofurangruppe oder eine Azaphenanthrobenzoselenophengruppe ist.

5. Organometallische Verbindung nach einem der Ansprüche 1-4, wobei R₁ bis R₄, R₂₉, R₂₉ₐ und R_{29b} jeweils unabhängig wie folgt sind:
Wasserstoff, Deuterium, -F oder eine Cyanogruppe;
eine C₁-C₂₀-Alkylgruppe, eine C₃-C₁₀-Cycloalkylgruppe, eine Phenylgruppe, eine Naphthylgruppe, eine Pyridinylgruppe, eine Furanylgruppe, eine Thiophenylgruppe, eine Benzofuranylgruppe, eine Benzothiophenylgruppe, eine Dibenzofuranylgruppe oder eine Dibenzothiophenylgruppe, jeweils unsubstituiert oder substituiert mit zumindest einem von Deuterium, -F, Cyanogruppe, einer C₁-C₂₀-Alkylgruppe, einer deuterierten C₁-C₂₀-Alkylgruppe, einer fluorierten C₁-C₂₀-Alkylgruppe, einer C₃-C₁₀-Cycloalkylgruppe, einer deuterierten C₃-C₁₀-Cycloalkylgruppe, einer fluorierten C₃-C₁₀-Cycloalkylgruppe, einer (C₁-C₂₀-Alkyl)C₃-C₁₀-Cycloalkylgruppe, einer Phenylgruppe, einer deuterierten Phenylgruppe, einer fluorierten Phenylgruppe, einer (C₁-C₂₀-Alkyl)phenylgruppe, einer Naphthylgruppe, einer Pyridinylgruppe, einer Furanylgruppe, einer Thiophenylgruppe, einer Benzofuranylgruppe, einer Benzothiophenylgruppe, einer Dibenzofuranylgruppe, einer Dibenzothiophenylgruppe, - Si(Q₃₃)(Q₃₄)(Q₃₅), -Ge(Q₃₃)(Q₃₄)(Q₃₅) oder einer Kombination davon; oder
-Si(Q₃)(Q₄)(Q₅), und
R₁₄ bis R₁₆ jeweils unabhängig eine C₁-C₂₀-Alkylgruppe, eine C₃-C₁₀-Cycloalkylgruppe, eine Phenylgruppe, eine Naphthylgruppe, eine Pyridinylgruppe, eine Furanylgruppe, eine Thiophenylgruppe, eine Benzofuranylgruppe, eine Benzothiophenylgruppe, eine Dibenzofuranylgruppe oder eine Dibenzothiophenylgruppe sind, jeweils unsubstituiert oder substituiert mit zumindest einem von Deuterium, -F, Cyanogruppe, einer C₁-C₂₀-Alkylgruppe, einer deuterierten C₁-C₂₀-Alkylgruppe, einer fluorierten C₁-C₂₀-Alkylgruppe, einer C₃-C₁₀-Cycloalkylgruppe, einer deuterierten C₃-C₁₀-Cycloalkylgruppe, einer fluorierten C₃-C₁₀-Cycloalkylgruppe, einer (C₁-C₂₀-Alkyl)C₃-C₁₀-Cycloalkylgruppe, einer Phenylgruppe, einer deuterierten Phenylgruppe, einer fluorierten Phenylgruppe, einer (C₁-C₂₀-Alkyl)phenylgruppe, einer Naphthylgruppe, einer Pyridinylgruppe, einer Furanylgruppe, einer Thiophenylgruppe, einer Benzofuranylgruppe, einer Benzothiophenylgruppe, einer Dibenzofuranylgruppe, einer Dibenzothiophenylgruppe oder einer Kombination davon.

6. Organometallische Verbindung nach einem der Ansprüche 1-5, wobei in Formel 2-1 a2 nicht 0 ist und R₂ nicht Wasserstoff ist; und/oder
wobei in Formel 2-2 a3 nicht 0 ist und R₃ nicht Wasserstoff ist; und/oder
wobei die organometallische Verbindung Deuterium, eine Fluorgruppe oder eine Kombination davon umfasst.

7. Organometallische Verbindung nach einem der Ansprüche 1-6, wobei eine Gruppe dargestellt durch 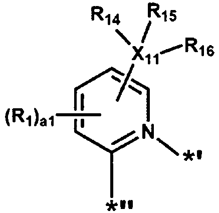 in Formel 2-1 eine Gruppe dargestellt durch eine von Formel CY1-1 bis CY1-6 ist: 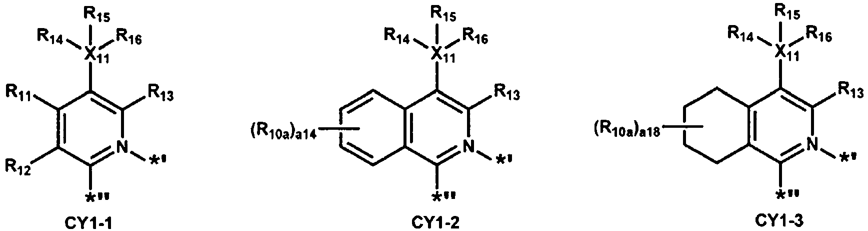 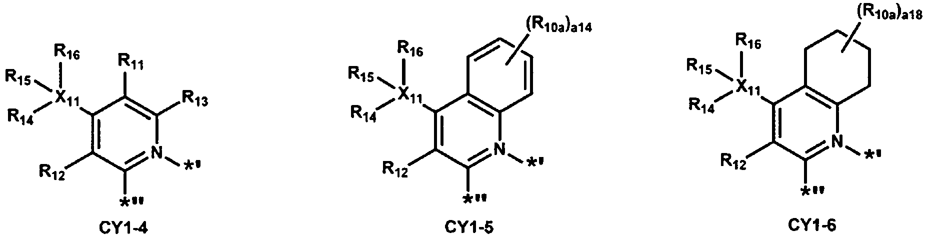 wobei in Formel CY1-1 bis CY1-6
X₁₁, R₁₄ bis R₁₆ und R₁₀ₐ jeweils wie in Anspruch 1 beschrieben sind,
R₁₁ bis R₁₃ jeweils unabhängig wie in Verbindung mit R₁ in Anspruch 1 beschrieben sind, a14 eine ganze Zahl von 0 bis 4 ist,
a18 eine ganze Zahl von 0 bis 8 ist,
*' eine Bindungsstelle an M in Formel 1 angibt, und
*" eine Bindungsstelle an eines von A₁ bis A₄ in Formel 2-1 angibt.

8. Organometallische Verbindung nach einem der Ansprüche 1-7, wobei eine Gruppe dargestellt durch 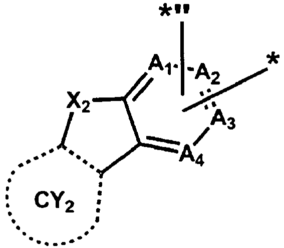 in Formel 2-1 eine Gruppe dargestellt durch eine von Formel CY2-1 bis CY2-14 ist: 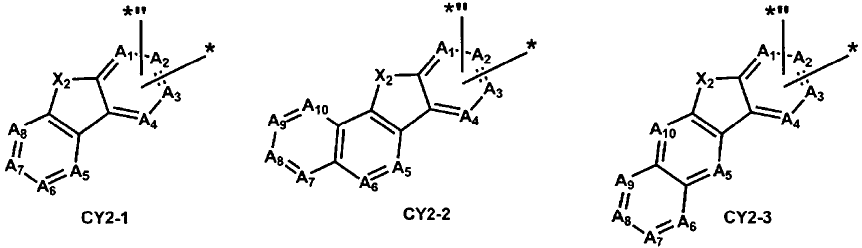 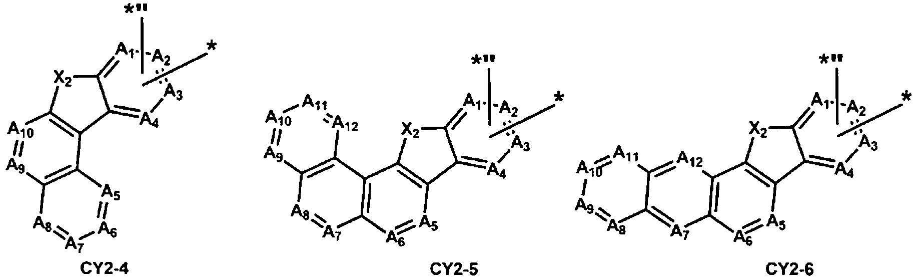 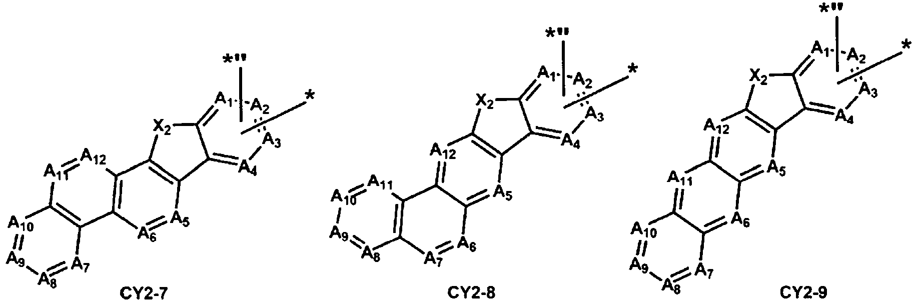 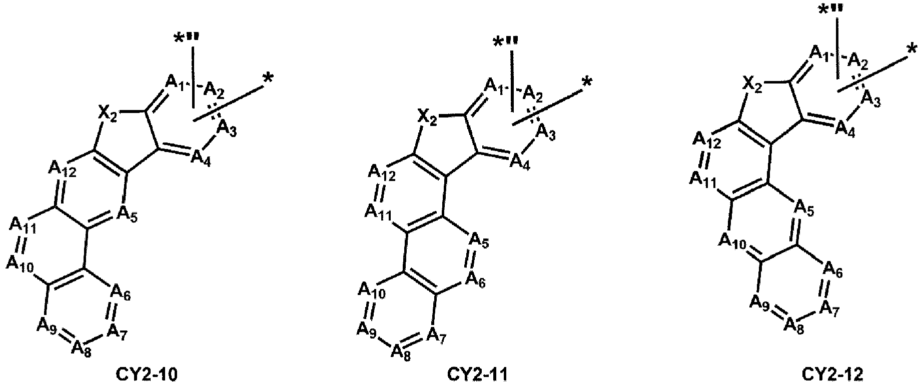 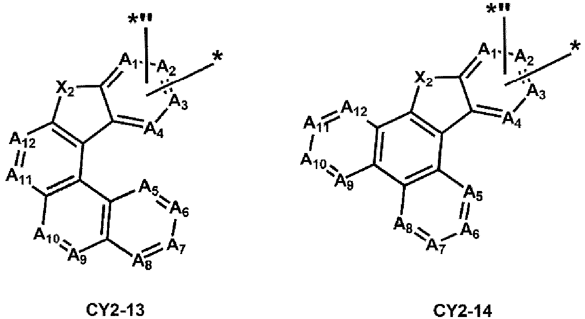 wobei in Formel CY2-1 bis CY2-14
X₂ wie in Anspruch 1 beschrieben ist,
A₁ bis A₁₂ jeweils unabhängig C oder N sind und zumindest eines von A₁ bis A₈ von Formel CY2-1 N ist, zumindest eines von A₁ bis A₁₀ von Formel CY2-2 bis CY2-4 N ist und zumindest eines von A₁ bis A₁₂ von Formel CY2-5 bis CY2-14 N ist,
*" eine Bindungsstelle an eine benachbarte Pyridingruppe in Formel 2-1 angibt, und
* eine Bindungsstelle an M in Formel 1 ist;
wobei bevorzugt
zumindest eines von A₄ bis A₈ in Formel CY2-1 N ist,
zumindest eines von A₄ bis A₁₀ in Formel CY2-2 bis CY2-4 N ist, und
zumindest eines von A₄ bis A₁₂ in Formel CY2-5 bis CY2-14 N ist.

9. Organometallische Verbindung nach einem der Ansprüche 1-8, wobei eine Gruppe dargestellt durch 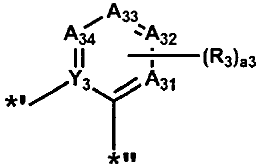 in Formel 2-2 eine Gruppe dargestellt durch eine von Formel CY3(1) bis CY3(16) ist: 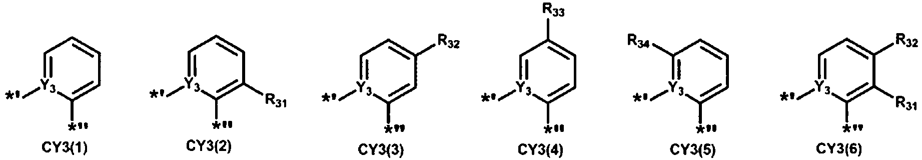 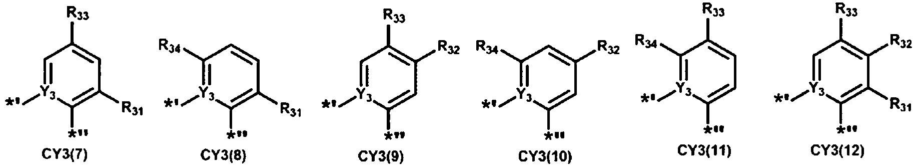 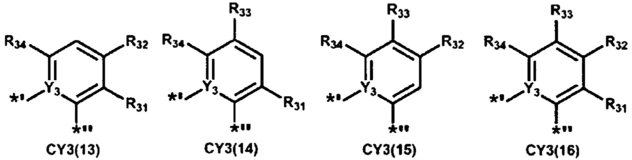 wobei in Formel CY3(1) bis CY3(16)
Y₃ wie in Anspruch 1 beschrieben ist,
R₃₁ bis R₃₄ jeweils unabhängig wie in Verbindung mit R₃ in Anspruch 1 beschrieben sind, vorausgesetzt, dass jedes von R₃₁ bis R₃₄ nicht Wasserstoff ist,
*' eine Bindungsstelle an M in Formel 1 angibt, und
*" eine Bindungsstelle an ein benachbartes Atom in Formel 2-2 ist.

10. Organometallische Verbindung nach einem der Ansprüche 1-9, wobei eine Gruppe dargestellt durch 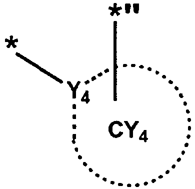 in Formel 2-2 eine Gruppe dargestellt durch eine von Formel CY4-1 bis CY4-21 ist: 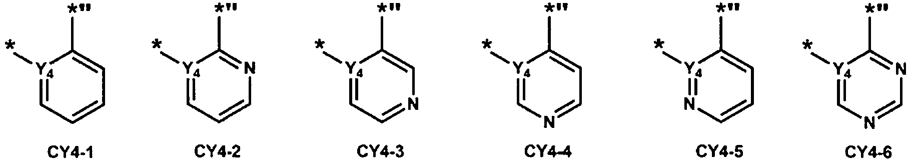 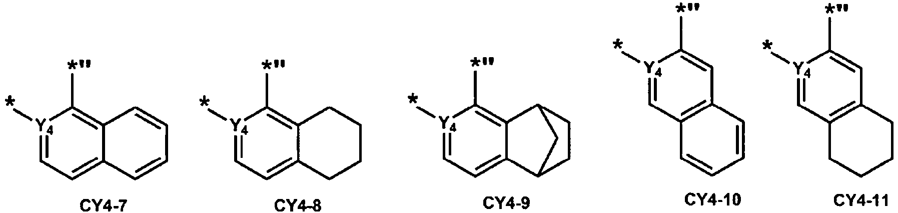 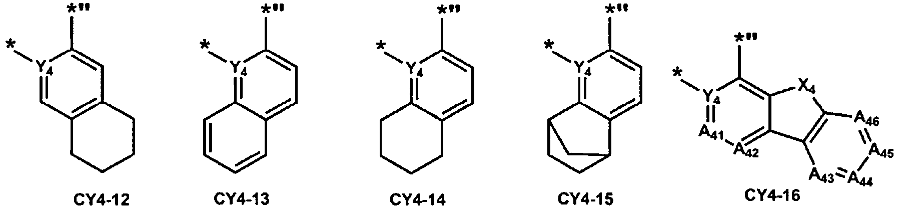 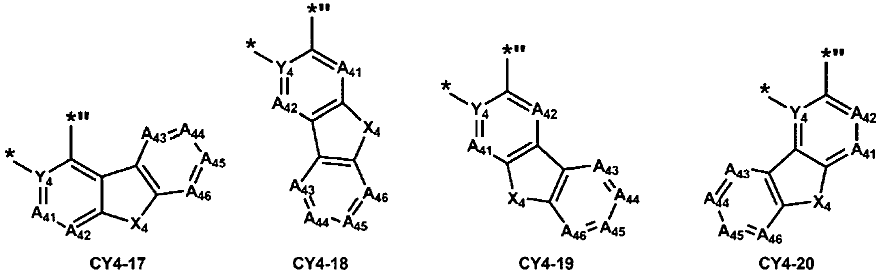 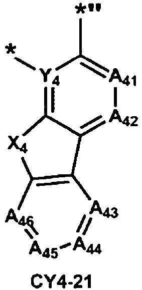 wobei in Formel CY4-1 bis CY4-21
Y₄ C ist,
A₄₁ bis A₄₆ jeweils unabhängig C oder N sind,
X₄ O, S, Se, N(R₄₉), C(R₄₉ₐ)(R_{49b}) oder Si(R₄₉ₐ)(R_{49b}) ist,
R₄₉, R₄₉ₐ und R_{49b} jeweils unabhängig wie in Verbindung mit R₄ in Anspruch 1 beschrieben sind,
* eine Bindungsstelle an M in Formel 1 angibt, und
*"eine Bindungsstelle an ein benachbartes Atom in Formel 2-2 angibt.

11. Organische lichtemittierende Vorrichtung, umfassend:
eine erste Elektrode;
eine zweite Elektrode; und
eine organische Schicht, die sich zwischen der ersten Elektrode und der zweiten Elektrode befindet,
wobei die organische Schicht eine Emissionsschicht umfasst, und
wobei die organische Schicht zumindest eine organometallische Verbindung nach einem der Ansprüche 1-10 umfasst.

12. Organische lichtemittierende Vorrichtung nach Anspruch 11, wobei
die erste Elektrode eine Anode ist,
die zweite Elektrode eine Kathode ist, und
die organische Schicht ferner eine Lochtransportregion, die sich zwischen der ersten Elektrode und der Emissionsschicht befindet, und eine Elektronentransportregion, die sich zwischen der Emissionsschicht und der zweiten Elektrode befindet, umfasst,
wobei die Lochtransportregion eine Locheinspritzschicht, eine Lochtransportschicht, eine Elektronenblockierschicht, eine Pufferschicht oder eine beliebige Kombination davon umfasst, und
die Elektronentransportregion eine Lochblockierschicht, eine Elektronentransportschicht, eine Elektroneneinspritzschicht oder eine Kombination davon umfasst.

13. Organische lichtemittierende Vorrichtung nach Anspruch 11 oder 12, wobei die Emissionsschicht die zumindest eine organometallische Verbindung umfasst.

14. Organische lichtemittierende Vorrichtung nach Anspruch 13, wobei die Emissionsschicht ein grünes Licht emittiert, und/oder
wobei die Emissionsschicht ferner einen Wirt umfasst und die Menge des Wirts in der Emissionsschicht größer als die Menge der organometallischen Verbindung in der Emissionsschicht ist.

15. Elektronisches Gerät, umfassend die organische lichtemittierende Vorrichtung nach einem der Ansprüche 11-14.

## Revendications

1. Composé organométallique représenté par la Formule 1 :
Formule 1 M(L₁)ₙ₁(L₂)ₙ₂
dans lequel, dans la Formule 1,
M est un métal de transition,
L₁ est un ligand représenté par la Formule 2-1,
L₂ est un ligand représenté par la Formule 2-2,
n1 et n2 valent chacun indépendamment 1 ou 2, lorsque n1 vaut 2, deux L₁ sont identiques ou différents l'un de l'autre, et lorsque n2 vaut 2, deux L₂ sont identiques ou différents l'un de l'autre, et
L₁ et L₂ sont différents l'un de l'autre, 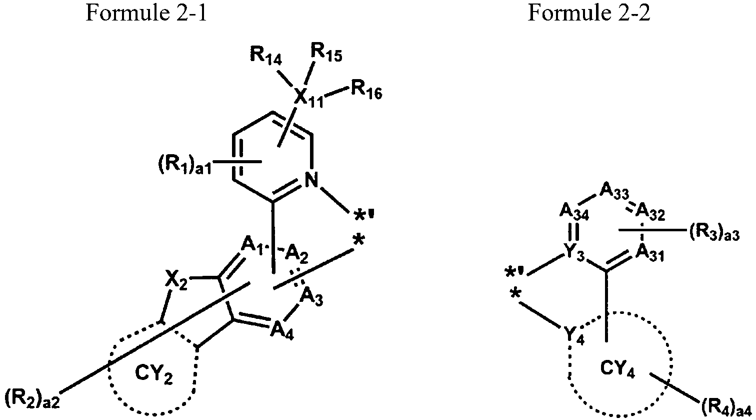
dans lequel, dans les Formules 2-1 et 2-2,
X₁₁ est Ge,
X₂ est O, S, Se, N(R₂₉), C(R₂₉ₐ)(R_{29b}), ou Si(R₂₉ₐ)(R_{29b}),
A₁ est C ou N, A₂ est C ou N, A₃ est C ou N, et A₄ est C ou N, où l'un de A₁ à A₄ est C lié à un groupe pyridine voisin, et un autre de A₁ à A₄ est C lié à M dans la Formule 1,
Y₃ est N,
A₃₁ est C ou N, A₃₂ est C ou N, A₃₃ est C ou N, et A₃₄ est C ou N,
Y₄ est C ou N,
le cycle CY₂ et le cycle CY₄ sont chacun indépendamment un groupe carbocyclique en C₅-C₃₀ ou un groupe hétérocyclique en C₁-C₃₀, où i) le cycle CY₂ est un groupe hétérocyclique en C₃-C₃₀ comprenant au moins un N comme atome formant le cycle ; ii) au moins l'un de A₁ à A₄ est N ; ou iii) le cycle CY₂ est un groupe hétérocyclique en C₃-C₃₀ comprenant au moins un N comme atome formant le cycle, et au moins l'un de A₁ à A₄ est N,
R₁ à R₄, R₁₄ à R₁₆, R₂₉, R₂₉ₐ et R_{29b} sont chacun indépendamment un hydrogène, un deutérium, -F, -Cl, -Br, -I, -SF₅, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₆₀ substitué ou non substitué, un groupe alcényle en C₂-C₆₀ substitué ou non substitué, un groupe alcynyle en C₂-C₆₀ substitué ou non substitué, un groupe alcoxy en C₁-C₆₀ substitué ou non substitué, un groupe alkylthio en C₁-C₆₀ substitué ou non substitué, un groupe cycloalkyle en C₃-C₁₀ substitué ou non substitué, un groupe hétérocycloalkyle en C₁-C₁₀ substitué ou non substitué, un groupe cycloalcényle en C₃-C₁₀ substitué ou non substitué, un groupe hétérocycloalcényle en C₁-C₁₀ substitué ou non substitué, un groupe aryle en C₆-C₆₀ substitué ou non substitué, un groupe alkylaryle en C₇-C₆₀ substitué ou non substitué, un groupe arylalkyle en C₇-C₆₀ substitué ou non substitué, un groupe aryloxy en C₆-C₆₀ substitué ou non substitué, un groupe arylthio en C₆-C₆₀ substitué ou non substitué, un groupe hétéroaryle en C₁-C₆₀ substitué ou non substitué, un groupe alkylhétéroaryle en C₂-C₆₀ substitué ou non substitué, un groupe hétéroarylalkyle en C₂-C₆₀ substitué ou non substitué, un groupe hétéroaryloxy en C₁-C₆₀ substitué ou non substitué, un groupe hétéroarylthio en C₁-C₆₀ substitué ou non substitué, un groupe polycyclique condensé non aromatique monovalent substitué ou non substitué, un groupe hétéropolycyclique condensé non aromatique monovalent substitué ou non substitué, -N(Q₁)(Q₂), -Si(Q₃)(Q₄)(Q₅), -Ge(Q₃)(Q₄)(Q₅), -B(Q₆)(Q₇), -P(=O)(Q₈)(Q₉) ou - P(Q₈)(Q₉),
a1 est un nombre entier de 0 à 3,
a2 est un nombre entier de 0 à 6,
a3 est un nombre entier de 0 à 4, et
a4 est un nombre entier de 0 à 20,
deux d'une pluralité de R₁ ou plus sont éventuellement liés l'un à l'autre pour former un groupe carbocyclique en C₅-C₃₀ qui est non substitué ou substitué par au moins un R₁₀ₐ ou un groupe hétérocyclique en C₁-C₃₀ qui est non substitué ou substitué par au moins un R₁₀ₐ,
deux d'une pluralité de R₂ ou plus sont éventuellement liés l'un à l'autre pour former un groupe carbocyclique en C₅-C₃₀ qui est non substitué ou substitué par au moins un R₁₀ₐ ou un groupe hétérocyclique en C₁-C₃₀ qui est non substitué ou substitué par au moins un R₁₀ₐ,
deux d'une pluralité de R₃ ou plus sont éventuellement liés l'un à l'autre pour former un groupe carbocyclique en C₅-C₃₀ qui est non substitué ou substitué par au moins un R₁₀ₐ ou un groupe hétérocyclique en C₁-C₃₀ qui est non substitué ou substitué par au moins un R₁₀ₐ,
deux d'une pluralité de R₄ ou plus sont éventuellement liés l'un à l'autre pour former un groupe carbocyclique en C₅-C₃₀ qui est non substitué ou substitué par au moins un R₁₀ₐ ou un groupe hétérocyclique en C₁-C₃₀ qui est non substitué ou substitué par au moins un R₁₀ₐ,
deux de R₁ à R₄ ou plus sont éventuellement liés l'un à l'autre pour former un groupe carbocyclique en C₅-C₃₀ qui est non substitué ou substitué par au moins un R₁₀ₐ ou un groupe hétérocyclique en C₁-C₃₀ qui est non substitué ou substitué par au moins un R₁₀ₐ,
R₁₀ₐ est tel que décrit en relation avec R₂,
* et *' indiquent chacun un site de liaison à M dans la Formule 1,
au moins un, le groupe alkyle en C₁-C₆₀ substitué, le groupe alcényle en C₂-C₆₀ substitué, le groupe alcynyle en C₂-C₆₀ substitué, le groupe alcoxy en C₁-C₆₀ substitué, le groupe alkylthio en C₁-C₆₀ substitué, le groupe cycloalkyle en C₃-C₁₀ substitué, le groupe hétérocycloalkyle en C₁-C₁₀ substitué, le groupe cycloalcényle en C₃-C₁₀ substitué, le groupe hétérocycloalcényle en C₁-C₁₀ substitué, le groupe aryle en C₆-C₆₀ substitué, le groupe alkylaryle en C₇-C₆₀ substitué, le groupe arylalkyle en C₇-C₆₀ substitué, le groupe aryloxy en C₆-C₆₀ substitué, le groupe arylthio en C₆-C₆₀ substitué, le groupe hétéroaryle en C₁-C₆₀ substitué, le groupe alkylhétéroaryle en C₂-C₆₀ substitué, le groupe hétéroarylalkyle en C₂-C₆₀ substitué, le groupe hétéroaryloxy en C₁-C₆₀ substitué, le groupe hétéroarylthio en C₁-C₆₀ substitué, le groupe polycyclique condensé non aromatique monovalent substitué et le groupe hétéropolycyclique condensé non aromatique monovalent substitué est :
un deutérium, -F, -Cl, -Br, -I, -SF₅, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₆₀, un groupe alcényle en C₂-C₆₀, un groupe alcynyle en C₂-C₆₀, un groupe alcoxy en C₁-C₆₀ ou un groupe alkylthio en C₁-C₆₀ ;
un groupe alkyle en C₁-C₆₀, un groupe alcényle en C₂-C₆₀, un groupe alcynyle en C₂-C₆₀, un groupe alcoxy en C₁-C₆₀, ou un groupe alkylthio en C₁-C₆₀, chacun étant substitué par au moins l'un parmi un deutérium, -F, -Cl, -Br, -I, -SF₅, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe alkylaryle en C₇-C₆₀, un groupe arylalkyle en C₇-C₆₀, un groupe aryloxy en C₆-C₆₀, un groupe arylthio en C₆-C₆₀, un groupe hétéroaryle en C₁-C₆₀, un groupe alkylhétéroaryle en C₂-C₆₀, un groupe hétéroarylalkyle en C₂-C₆₀, un groupe hétéroaryloxy en C₁-C₆₀, un groupe hétéroarylthio en C₁-C₆₀, un groupe polycyclique condensé non aromatique monovalent, un groupe hétéropolycyclique condensé non aromatique monovalent, -N(Q₁₁)(Q₁₂), -Si(Q₁₃)(Q₁₄)(Q₁₅), - Ge(Q₁₃)(Q₁₄)(Q₁₅), -B(Q₁₆)(Q₁₇), -P(=O)(Q₁₈)(Q₁₉), -P(Q₁₈)(Q₁₉), ou une combinaison de ceux-ci ;
un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe alkylaryle en C₇-C₆₀, un groupe aryloxy en C₆-C₆₀, un groupe arylthio en C₆-C₆₀, un groupe hétéroaryle en C₁-C₆₀, un groupe alkylhétéroaryle en C₂-C₆₀, un groupe hétéroaryloxy en C₁-C₆₀, un groupe hétéroarylthio en C₁-C₆₀, un groupe polycyclique condensé non aromatique monovalent ou un groupe hétéropolycyclique condensé non aromatique monovalent, chacun étant non substitué ou substitué par au moins l'un parmi un deutérium, -F, -Cl, -Br, -I, -SF₅, -CD₃, -CD₂H, - CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₆₀, un groupe alcényle en C₂-C₆₀, un groupe alcynyle en C₂-C₆₀, un groupe alcoxy en C₁-C₆₀, un groupe alkylthio en C₁-C₆₀, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe alkylaryle en C₇-C₆₀, un groupe arylalkyle en C₇-C₆₀, un groupe aryloxy en C₆-C₆₀, un groupe arylthio en C₆-C₆₀, un groupe hétéroaryle en C₁-C₆₀, un groupe alkylhétéroaryle en C₂-C₆₀, un groupe hétéroarylalkyle en C₂-C₆₀, un groupe hétéroaryloxy en C₁-C₆₀, un groupe hétéroarylthio en C₁-C₆₀, un groupe polycyclique condensé non aromatique monovalent, un groupe hétéropolycyclique condensé non aromatique monovalent, -N(Q₂₁)(Q₂₂), -Si(Q₂₃)(Q₂₄)(Q₂₅), -Ge(Q₂₃)(Q₂₄)(Q₂₅), - B(Q₂₆)(Q₂₇), -P(=O)(Q₂₈)(Q₂₉), -P(Q₂₈)(Q₂₉) ou une combinaison de ceux-ci ;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), -P(=O)(Q₃₈)(Q₃₉) où - P(Q₃₈)(Q₃₉) ; ou
une combinaison de ceux-ci,
dans lequel Q₁ à Q₉, Q₁₁ à Q₁₉, Q₂₁ à Q₂₉, et Q₃₁ à Q₃₉ sont chacun indépendamment un hydrogène, un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₆₀ substitué ou non substitué, un groupe alcényle en C₂-C₆₀ substitué ou non substitué, un groupe alcynyle en C₂-C₆₀ substitué ou non substitué, un groupe cycloalkyle en C₃-C₁₀ substitué ou non substitué, un groupe hétérocycloalkyle en C₁-C₁₀ substitué ou non substitué, un groupe cycloalcényle en C₃-C₁₀ substitué ou non substitué, un groupe hétérocycloalcényle en C₁-C₁₀ substitué ou non substitué, un groupe aryle en C₆-C₆₀ substitué ou non substitué, un groupe alkylaryle en C₇-C₆₀ substitué ou non substitué, un groupe arylalkyle en C₇-C₆₀ substitué ou non substitué, un groupe aryloxy en C₆-C₆₀ substitué ou non substitué, un groupe arylthio en C₆-C₆₀ substitué ou non substitué, un groupe hétéroaryle en C₁-C₆₀ substitué ou non substitué, un groupe alkylhétéroaryle en C₂-C₆₀ substitué ou non substitué, un groupe hétéroarylalkyle en C₂-C₆₀ substitué ou non substitué, un groupe hétéroaryloxy en C₁-C₆₀ substitué ou non substitué, un groupe hétéroarylthio en C₁-C₆₀ substitué ou non substitué, un groupe polycyclique condensé non aromatique monovalent substitué ou non substitué, ou un groupe hétéropolycyclique condensé non aromatique monovalent substitué ou non substitué ;
dans lequel le composé organométallique n'est pas le composé suivant :

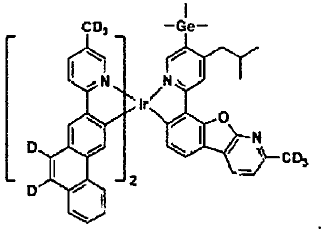

2. Composé organométallique de la revendication 1, dans lequel X₂ est O ou S.

3. Composé organométallique de l'une des revendications 1 ou 2, dans lequel, dans la Formule 2-1,
A₁ est C lié à un groupe pyridine voisin, et A₂ est C lié à M dans la Formule 1, ou
A₃ est C lié à un groupe pyridine voisin, et A₂ est C lié à M dans la Formule 1.

4. Composé organométallique de l'une quelconque des revendications 1 à 3, dans lequel le cycle CY₂ est un groupe pyridine, un groupe pyrimidine, un groupe pyridazine, un groupe pyrazine, un groupe quinoléine, un groupe isoquinoléine, un groupe quinoxaline, un groupe quinazoline, un groupe phénanthridine, un groupe phénanthroline, un groupe benzoquinoléine, un groupe benzoisoquinoléine, un groupe azacarbazole, un groupe azafluorène, un groupe azadibenzosilole, un groupe azadibenzothiophène, un groupe azadibenzofurane ou un groupe azadibenzosélénophène ; et/ou
dans lequel le cycle CY₄ est un groupe benzène, un groupe naphtalène, un groupe anthracène, un groupe phénanthrène, un groupe 1,2,3,4-tétrahydronaphtalène, un groupe benzène qui est condensé avec un groupe norbornane, un groupe carbazole, un groupe fluorène, un groupe dibenzosilole, un groupe dibenzothiophène, un groupe dibenzofurane, un groupe dibenzosélénophène, un groupe benzocarbazole, un groupe benzofluorène, un groupe naphtobenzosilole, un groupe naphtobenzothiophène, un groupe naphtobenzofurane, un groupe naphtobenzosélénophène, un groupe dibenzocarbazole, un groupe dibenzofluorène, un groupe dinaphtosilole, un groupe dinaphtothiophène, un groupe dinaphtofurane, un groupe dinaphtosélénophène, un groupe naphtocarbazole, un groupe naphtofluorène, un groupe phénanthrobenzosilole, un groupe phénanthrobenzothiophène, un groupe phénanthrobenzofurane, un groupe phénanthrobenzosélénophène, un groupe azacarbazole, un groupe azafluorène, un groupe azadibenzosilole, un groupe azadibenzothiophène, un groupe azadibenzofurane, un groupe azadibenzosélénophène, un groupe azabenzocarbazole, un groupe azabenzofluorène, un groupe azanaphtobenzosilole, un groupe azanaphtobenzothiophène, un groupe azanaphtobenzofurane, un groupe azanaphtobenzosélénophène, un groupe azadibenzocarbazole, un groupe azadibenzofluorène, un groupe azadinaphtosilole, un groupe azadinaphtothiophène, un groupe azadinaphtofurane, un groupe azadinaphtosélénophène, un groupe azanaphtocarbazole, un groupe azanaphtofluorène, un groupe azaphénanthrobenzosilole, un groupe azaphénanthrobenzothiophène, un groupe azaphénanthrobenzofurane ou un groupe azaphénanthrobenzosélénophène.

5. Composé organométallique de l'une quelconque des revendications 1 à 4, dans lequel R₁ à R₄, R₂₉, R₂₉ₐ et R_{29b} sont chacun indépendamment :
un hydrogène, un deutérium, -F ou un groupe cyano ;
un groupe alkyle en C₁-C₂₀, un groupe cycloalkyle en C₃-C₁₀, un groupe phényle, un groupe naphtyle, un groupe pyridinyle, un groupe furanyle, un groupe thiophényle, un groupe benzofuranyle, un groupe benzothiophényle, un groupe dibenzofuranyle ou un groupe dibenzothiophényle, chacun étant non substitué ou substitué par au moins l'un parmi un deutérium, -F, un groupe cyano, un groupe alkyle en C₁-C₂₀, un groupe alkyle en C₁-C₂₀ deutéré, un groupe alkyle en C₁-C₂₀ fluoré, un groupe cycloalkyle en C₃-C₁₀, un groupe cycloalkyle en C₃-C₁₀ deutéré, un groupe cycloalkyle en C₃-C₁₀ fluoré, un groupe (alkyle en C₁-C₂₀)-cycloalkyle en C₃-C₁₀, un groupe phényle, un groupe phényle deutéré, un groupe phényle fluoré, un groupe (alkyle en C₁-C₂₀)phényle, un groupe naphtyle, un groupe pyridinyle, un groupe furanyle, un groupe thiophényle, un groupe benzofuranyle, un groupe benzothiophényle, un groupe dibenzofuranyle, un groupe dibenzothiophényle, -Si(Q₃₃)(Q₃₄)(Q₃₅), -Ge(Q₃₃)(Q₃₄)(Q₃₅) ou une combinaison de ceux-ci ; ou
-Si(Q₃)(Q₄)(Q₅), et
R₁₄ à R₁₆ sont chacun indépendamment un groupe alkyle en C₁-C₂₀, un groupe cycloalkyle en C₃-C₁₀, un groupe phényle, un groupe naphtyle, un groupe pyridinyle, un groupe furanyle, un groupe thiophényle, un groupe benzofuranyle, un groupe benzothiophényle, un groupe dibenzofuranyle ou un groupe dibenzothiophényle, chacun étant non substitué ou substitué par au moins l'un parmi un deutérium, -F, un groupe cyano, un groupe alkyle en C₁-C₂₀, un groupe alkyle en C₁-C₂₀ deutéré, un groupe alkyle en C₁-C₂₀ fluoré, un groupe cycloalkyle en C₃-C₁₀, un groupe cycloalkyle en C₃-C₁₀ deutéré, un groupe cycloalkyle en C₃-C₁₀ fluoré, un groupe (alkyle en C₁-C₂₀)cycloalkyle en C₃-C₁₀, un groupe phényle, un groupe phényle deutéré, un groupe phényle fluoré, un groupe (alkyle en C₁-C₂₀)phényle, un groupe naphtyle, un groupe pyridinyle, un groupe furanyle, un groupe thiophényle, un groupe benzofuranyle, un groupe benzothiophényle, un groupe dibenzofuranyle, un groupe dibenzothiophényle ou une combinaison de ceux-ci.

6. Composé organométallique de l'une quelconque des revendications 1 à 5, dans lequel, dans la Formule 2-1, a2 n'est pas 0 et R₂ n'est pas un hydrogène ; et/ou
dans lequel, dans la Formule 2-2, a3 n'est pas 0, et R₃ n'est pas un hydrogène ; et/ou
dans lequel le composé organométallique comprend un deutérium, un groupe fluoro, ou une combinaison de ceux-ci.

7. Composé organométallique de l'une quelconque des revendications 1 à 6, dans lequel un groupe représenté par 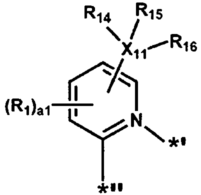 dans la Formule 2-1 est un groupe représenté par l'une des Formules CY1-1 à CY1-6 : 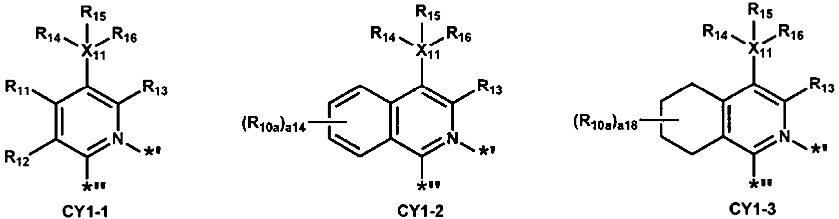 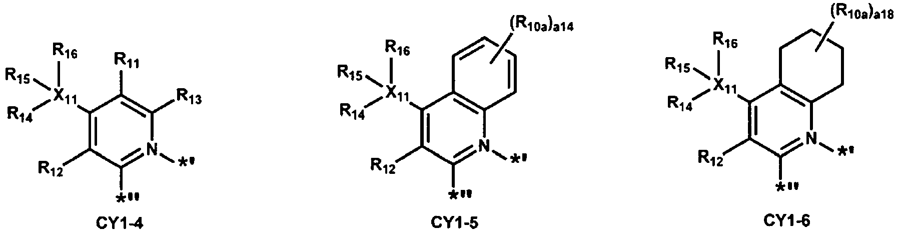 dans lequel, dans les Formules CY1-1 à CY1-6,
X₁₁, R₁₄ à R₁₆ et R₁₀ₐ, sont chacun tels que décrits dans la revendication 1,
R₁₁ à R₁₃ sont chacun indépendamment tels que décrits en relation avec R₁ dans la revendication 1,
a14 est un nombre entier de 0 à 4,
a18 est un nombre entier de 0 à 8,
*' indique un site de liaison à M dans la Formule 1, et
*" indique un site de liaison à l'un de A₁ à A₄ dans la Formule 2-1.

8. Composé organométallique de l'une quelconque des revendications 1 à 7, dans lequel un groupe représenté par 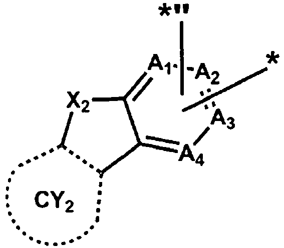 dans la Formule 2-1 est un groupe représenté par l'une des Formules CY2-1 à CY2-14 : 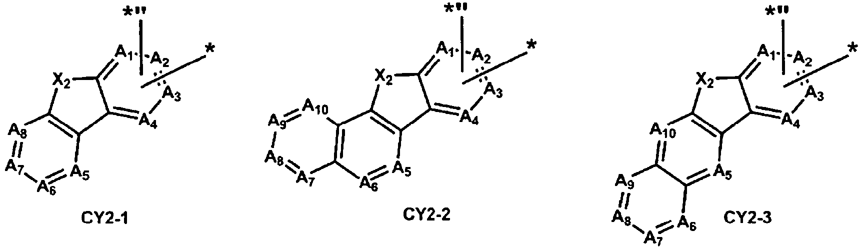 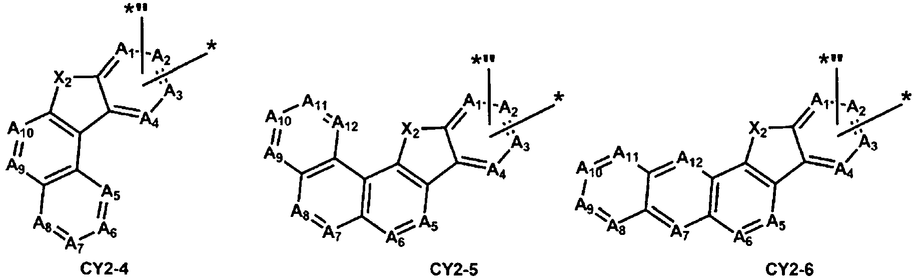 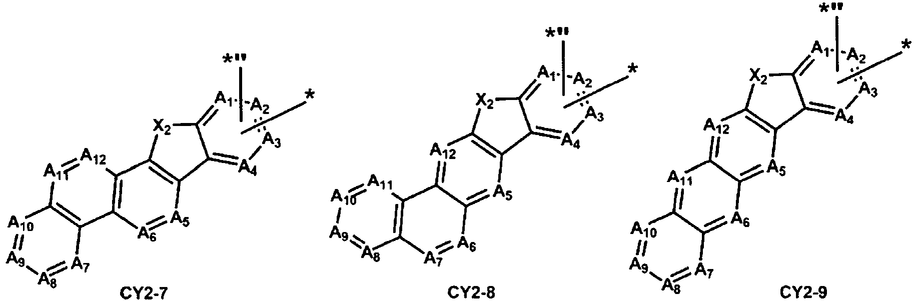 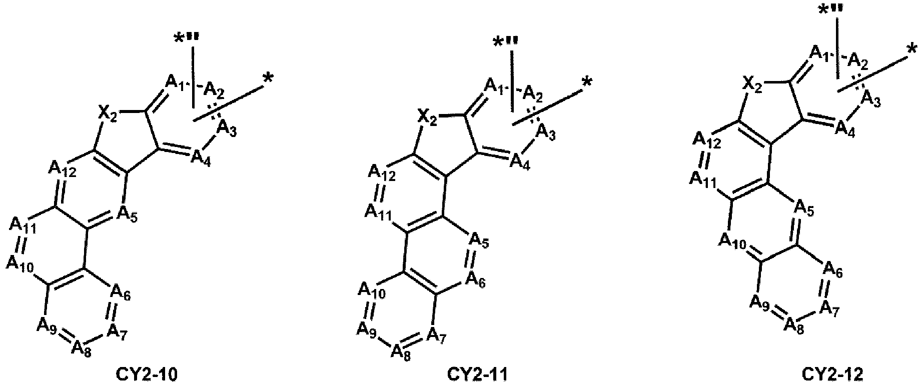 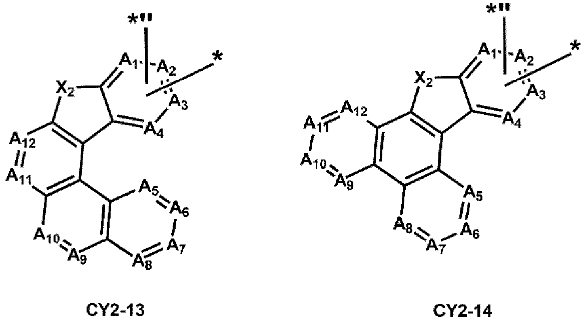 dans lequel, dans les Formules CY2-1 à CY2-14,
X₂ est tel que décrit dans la revendication 1,
A₁ à A₁₂ sont chacun indépendamment C ou N, et au moins l'un de A₁ à A₈ de la Formule CY2-1 est N, au moins l'un de A₁ à A₁₀ des Formules CY2-2 à CY2-4 est N, et au moins l'un de A₁ à A₁₂ des Formules CY2-5 à CY2-14 est N,
*" indique un site de liaison à un groupe pyridine voisin dans la Formule 2-1, et
* indique un site de liaison à M dans la Formule 1 ;
de préférence dans lequel
au moins l'un de A₄ à A₈ dans la Formule CY2-1 est N,
au moins l'un de A₄ à A₁₀ dans les Formules CY2-2 à CY2-4 est N, et
au moins l'un de A₄ à A₁₂ dans les Formules CY2-5 à CY2-14 est N.

9. Composé organométallique de l'une quelconque des revendications 1 à 8, dans lequel un groupe représenté par 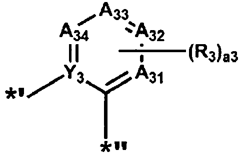 dans la Formule 2-2 est un groupe représenté par l'une des Formules CY3(1) à CY3(16) : 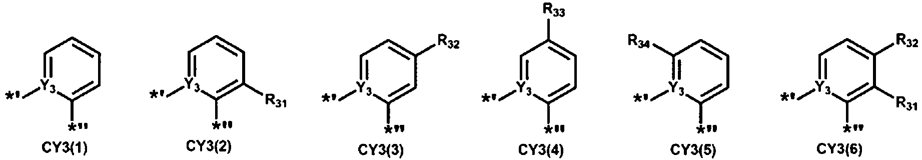 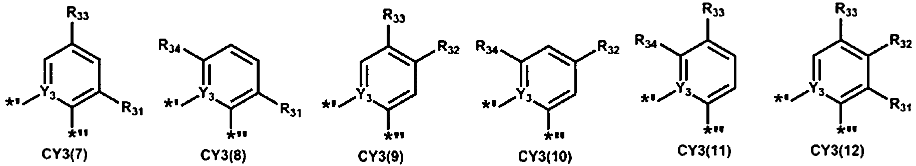 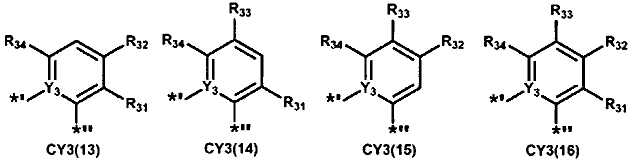 dans lequel, dans les Formules CY3(1) à CY3(16),
Y₃ est tel que décrit dans la revendication 1,
R₃₁ à R₃₄ sont chacun indépendamment tels que décrits en relation avec R₃ dans la revendication 1, à condition que chacun de R₃₁ à R₃₄ ne soit pas un hydrogène,
*' indique un site de liaison à M dans la Formule 1, et
*'' est un site de liaison à un atome voisin dans la Formule 2-2.

10. Composé organométallique de l'une quelconque des revendications 1 à 9, dans lequel un groupe représenté par 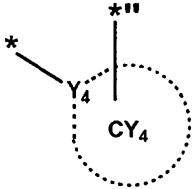 dans la Formule 2-2 est un groupe représenté par l'une des Formules CY4-1 à CY4-21 : 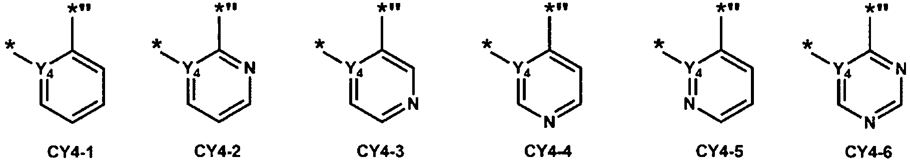 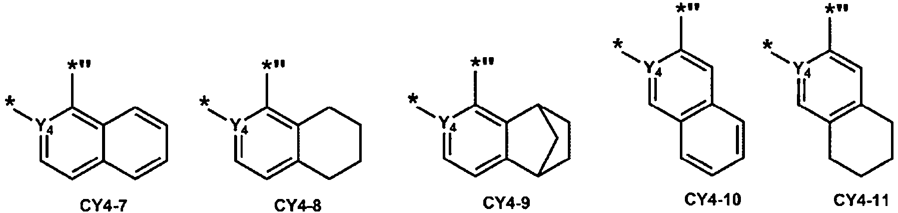 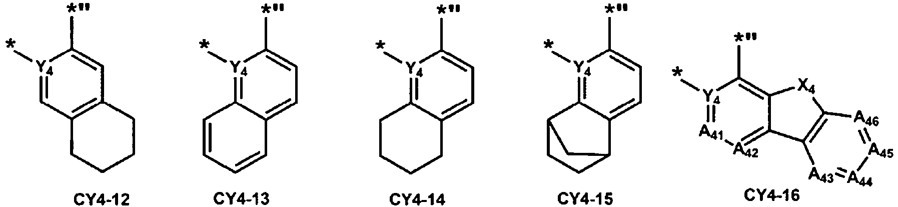 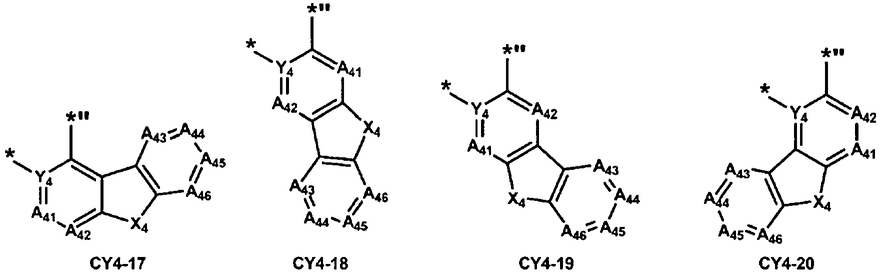 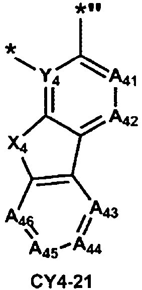 dans lequel, dans les Formules CY4-1 à CY4-21,
Y₄ est C,
A₄₁ à A₄₆ sont chacun indépendamment C ou N,
X₄ est O, S, Se, N(R₄₉), C(R₄₉ₐ)(R_{49b}) ou Si(R₄₉ₐ)(R_{49b}),
R₄₉, R₄₉ₐ et R_{49b} sont chacun indépendamment tels que décrits en relation avec R₄ dans la revendication 1,
* indique un site de liaison à M dans la Formule 1, et
*" indique un site de liaison à un atome voisin dans la Formule 2-2.

11. Dispositif électroluminescent organique, comprenant :
une première électrode ;
une seconde électrode ; et
une couche organique située entre la première électrode et la seconde électrode,
dans lequel la couche organique comprend une couche d'émission, et
dans lequel la couche organique comprend au moins un composé organométallique de l'une quelconque des revendications 1 à 10.

12. Dispositif électroluminescent organique de la revendication 11, dans lequel
la première électrode est une anode,
la seconde électrode est une cathode, et
la couche organique comprend en outre une région de transport de trous située entre la première électrode et la couche d'émission, et une région de transport d'électrons située entre la couche d'émission et la seconde électrode,
dans lequel la région de transport de trous comprend une couche d'injection de trous, une couche de transport de trous, une couche de blocage d'électrons, une couche tampon, ou une combinaison de celles-ci, et
la région de transport d'électrons comprend une couche de blocage de trous, une couche de transport d'électrons, une couche d'injection d'électrons ou une combinaison de celles-ci.

13. Dispositif électroluminescent organique de l'une des revendications 11 ou 12, dans lequel la couche d'émission comprend l'au moins un composé organométallique.

14. Dispositif électroluminescent organique de la revendication 13, dans lequel la couche d'émission émet une lumière verte ; et/ou
dans lequel la couche d'émission comprend en outre un hôte, et la quantité de l'hôte dans la couche d'émission est supérieure à la quantité du composé organométallique dans la couche d'émission.

15. Appareil électronique, comprenant le dispositif électroluminescent organique de l'une quelconque des revendications 11 à 14.
